(19) Europäisches Patentamt
European Patent Office
Office européen des brevets

(11) EP 4 362 630 A2

(12) # EUROPEAN PATENT APPLICATION

(43) Date of publication:
**01.05.2024 Bulletin 2024/18**

(21) Application number: **23206051.7**

(22) Date of filing: **26.10.2023**

(51) International Patent Classification (IPC):
***H10K 50/12*** *(2023.01)*

(52) Cooperative Patent Classification (CPC):
**H10K 50/121**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority:
**27.10.2022 US 202263419782 P**
**02.11.2022 US 202263421804 P**
**13.12.2022 US 202263387166 P**
**21.12.2022 US 202263434161 P**
**07.02.2023 US 202363483647 P**
**14.02.2023 US 202363484757 P**
**14.02.2023 US 202363484786 P**
**27.02.2023 US 202363487055 P**
**14.03.2023 US 202363490065 P**
**13.04.2023 US 202363459091 P**
**17.05.2023 US 202318319182**
**20.10.2023 US 202318491028**

(71) Applicant: **Universal Display Corporation**
**Ewing, NJ 08618 (US)**

(72) Inventors:
- **FELDMAN, Jerald**
  **Ewing, 08618 (US)**
- **THOMPSON, Nicholas J.**
  **Ewing, 08618 (US)**
- **WEAVER, Michael S.**
  **Ewing, 08618 (US)**
- **LIN, Chun**
  **Ewing, 08618 (US)**
- **FLEETHAM, Tyler**
  **Ewing, 08618 (US)**
- **SHEINA, Elena**
  **Ewing, 08618 (US)**
- **HAMZE, Rasha**
  **Ewing, 08618 (US)**

(74) Representative: **Dragotti & Associati S.R.L. et al**
**Via Nino Bixio, 7**
**20129 Milano (IT)**

(54) **ORGANIC ELECTROLUMINESCENT MATERIALS AND DEVICES**

(57) Provided is a full-color pixel arrangement of a device comprising at least one pixel: wherein the at least one pixel comprises: a first subpixel comprising a first OLED comprising a first emissive region; a second subpixel comprising a second OLED comprising a second emissive region; wherein the first emissive region comprises: a compound SI; a compound Al; and a compound H1; wherein the second emissive region comprises:
a compound A2; and a compound H2; wherein the compound S1 is a sensitizer that transfers energy to the compound Al; wherein the compound Al is an acceptor that is an emitter; wherein the compound H1 is a host,
and at least one of the compounds SI and Al is doped with the compound H1; wherein the compound A2 is an emitter;
wherein the compound H2 is a host, and the compound A2 is doped with the compound H2.

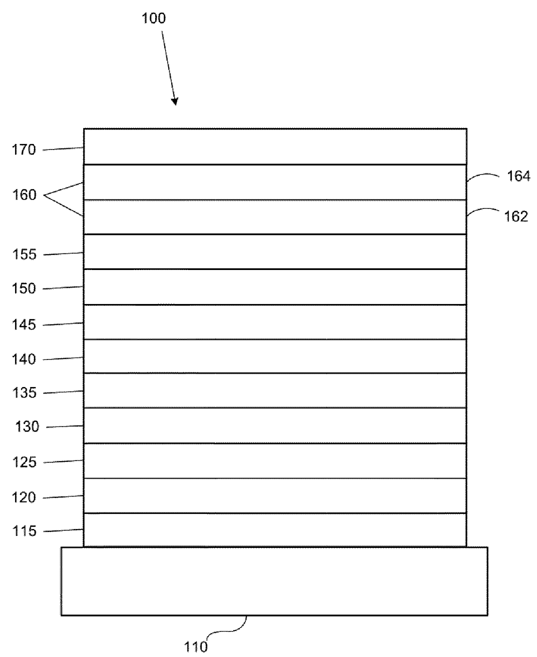


Figure 1

EP 4 362 630 A2

## Description

### CROSS-REFERENCE TO RELATED APPLICATIONS

This application is a continuation-in-part of co-pending U.S. patent Application No. 18/319,182, filed May 17, 2023. This application also claims priority under 35 U.S.C. § 119(e) to U.S. Provisional Applications No. 63/419,782, filed on October 27, 2022, No. 63/421,804, filed November 2, 2022, No. 63/387,166, filed December 13, 2022, No. 63/483,647, filed February 7, 2023, No. 63/487,055, filed February 27, 2023, No. 63/459,091, filed April 13, 2023, No. 63/434,161, filed December 21, 2022, No. 63/484,757, filed February 14, 2023, No. 63/484,786, filed February 14, 2023, and No. 63/490,065, filed March 14, 2023, the entire contents of all the above referenced applications are incorporated herein by reference.

### FIELD

The present disclosure generally relates to novel device architectures and the OLED devices having those novel architectures and their uses.

### BACKGROUND

Opto-electronic devices that make use of organic materials are becoming increasingly desirable for various reasons. Many of the materials used to make such devices are relatively inexpensive, so organic opto-electronic devices have the potential for cost advantages over inorganic devices. In addition, the inherent properties of organic materials, such as their flexibility, may make them well suited for particular applications such as fabrication on a flexible substrate. Examples of organic opto-electronic devices include organic light emitting diodes/devices (OLEDs), organic phototransistors, organic photovoltaic cells, organic scintillators, and organic photodetectors. For OLEDs, the organic materials may have performance advantages over conventional materials.

OLEDs make use of thin organic films that emit light when voltage is applied across the device. OLEDs are becoming an increasingly interesting technology for use in applications such as displays, illumination, and backlighting.

One application for emissive molecules is a full color display. Industry standards for such a display call for pixels adapted to emit particular colors, referred to as "saturated" colors. In particular, these standards call for saturated red, green, and blue pixels. Alternatively, the OLED can be designed to emit white light. In conventional liquid crystal displays emission from a white backlight is filtered using absorption filters to produce red, green and blue emission. The same technique can also be used with OLEDs. The white OLED can be either a single emissive layer (EML) device or a stack structure. Color may be measured using CIE coordinates, which are well known to the art.

### SUMMARY

In one aspect, the present disclosure provides a full-color pixel arrangement of a device comprising at least one pixel: wherein the at least one pixel comprises: a first subpixel comprising a first OLED comprising a first emissive region; a second subpixel comprising a second OLED comprising a second emissive region; wherein the first emissive region comprises: a compound S1; a compound A1; and a compound H1; wherein the second emissive region comprises: a compound A2; and a compound H2; wherein the compound S1 is a sensitizer that transfers energy to the compound A1; wherein the compound A1 is an acceptor that is an emitter; wherein the compound H1 is a host, and at least one of the compounds S1 and A1 is doped with the compound H1; wherein the compound A2 is an emitter; wherein the compound H2 is a host, and the compound A2 is doped with the compound H2.

In another aspect, the present disclosure also provides an organic light emitting device (OLED) comprising: a first electrode; a first emissive region disposed over the first electrode; a first charge generation layer (CGL) disposed over the first emissive region; a second emissive region disposed over the first CGL; and a second electrode disposed over the second emissive region; wherein the first emissive region comprises: a compound S1; a compound A1; and a compound H1; wherein the second emissive region comprises: a compound A2; and a compound H2; wherein the compound S1 is a sensitizer that transfers energy to the compound A1; wherein the compound A1 is an acceptor that is an emitter; wherein the compound H1 is a host, and at least one of the compounds S1 and A1 is doped with the compound H1; wherein the compound A2 is an emitter; wherein the compound H2 is a host, and the compound A2 is doped with the compound H2.

In yet another aspect, the present disclosure also provides an OLED comprising: an anode; a cathode; and an emissive region disposed between the anode and the cathode; wherein the emissive region comprises: a compound S1; a compound A1; a compound H1; wherein the compound S1 is a sensitizer that transfers energy to the compound A1; wherein the compound A1 is an acceptor that is an emitter; wherein the compound H1 is a host, and at least one of

the compounds S1 and A1 is doped with the compound H1; wherein at least one of the following conditions is true: (1) the emissive region consists of one or more organic layers, wherein at least one of the one or more organic layers has a minimum thickness selected from the group consisting of 250, 300, 350, 400, 450, 500, 550, 600, 650 and 700 Å; (2) the OLED further comprises a layer comprising quantum dot; (3) the compound S1 is capable of functioning as a doublet emitter in an OLED at room temperature, or the compound S1 has a first excited state energy that is less than its energy of the lowest excited triplet state $T_1$; (4) the compound A1 is a doublet emitter; or the compound A1 has a first excited state energy that is less than its energy of the lowest excited triplet state $T_1$; (5) at least one of the compounds S1 and A1 is a triplet-triplet annihilation upconversion (TTA-UC) material; (6) at least one of the compounds S1 and A1 is chiral; (7) the compound S1 is a metal coordination complex having at least one feature selected from the group consisting of at least two metals, three different bidentate ligands, three same bidentate ligands, a tetradentate or hexadentate ligand coordinating to Ir or Os, a Ir-carbene bond, Os-carbene bond, M-K bond wherein K is a non-ring atom and M is the metal, a ligand comprising a five-membered heteroaryl ring coordinating to the metal through M-N bond, a ligand comprising a six-membered heteroaryl ring having at least two heteroatoms with one of them coordinating to the metal, a ligand comprising a fused ring system having at least four rings, at least 25% deuterated of the metal complex, and combinations thereof; (8) the compound S1 is a Au(III) coordination complex having a bidentate, tridentate, or tetradentate ligand and capable of functioning as a phosphorescent or delayed fluorescent emitter in an OLED at room templerature; (9) the compound S1 is a Zn(II) coordination complex having a bidentate ligand and capable of functioning as a phosphorescent or delayed fluorescence emitter in an OLED at room temperature; (10) the compound S1 comprises at least one electron-withdrawing group; (11) the compound A1 comprises at least one electron-withdrawing group; (12) any combination of two or more conditions of (1) through (11) listed above.

In yet another aspect, the present disclosure further provides a consumer product comprising an OLED as described herein.

## BRIEF DESCRIPTION OF THE DRAWINGS

FIG. 1 shows an organic light emitting device.

FIG. 2 shows an inverted organic light emitting device that does not have a separate electron transport layer.

FIG. 3 shows a graph of modeled P-polarized photoluminescence as a function of angle for emitters with different vertical dipole ratio (VDR) values.

## DETAILED DESCRIPTION

### A. Terminology

Unless otherwise specified, the below terms used herein are defined as follows:

As used herein, "top" means furthest away from the substrate, while "bottom" means closest to the substrate. Where a first layer is described as "disposed over" a second layer, the first layer is disposed further away from substrate. There may be other layers between the first and second layer, unless it is specified that the first layer is "in contact with" the second layer. For example, a cathode may be described as "disposed over" an anode, even though there are various organic layers in between.

As used herein, "solution processable" means capable of being dissolved, dispersed, or transported in and/or deposited from a liquid medium, either in solution or suspension form.

As used herein, and as would be generally understood by one skilled in the art, a first "Highest Occupied Molecular Orbital" (HOMO) or "Lowest Unoccupied Molecular Orbital" (LUMO) energy level is "greater than" or "higher than" a second HOMO or LUMO energy level if the first energy level is closer to the vacuum energy level. Since ionization potentials (IP) are measured as a negative energy relative to a vacuum level, a higher HOMO energy level corresponds to an IP having a smaller absolute value (an IP that is less negative). Similarly, a higher LUMO energy level corresponds to an electron affinity (EA) having a smaller absolute value (an EA that is less negative). On a conventional energy level diagram, with the vacuum level at the top, the LUMO energy level of a material is higher than the HOMO energy level of the same material. A "higher" HOMO or LUMO energy level appears closer to the top of such a diagram than a "lower" HOMO or LUMO energy level.

As used herein, and as would be generally understood by one skilled in the art, a first work function is "greater than" or "higher than" a second work function if the first work function has a higher absolute value. Because work functions are generally measured as negative numbers relative to vacuum level, this means that a "higher" work function is more negative. On a conventional energy level diagram, with the vacuum level at the top, a "higher" work function is illustrated as further away from the vacuum level in the downward direction. Thus, the definitions of HOMO and LUMO energy

levels follow a different convention than work functions.

The terms "halo," "halogen," and "halide" are used interchangeably and refer to fluorine, chlorine, bromine, and iodine.

The term "acyl" refers to a substituted carbonyl group (-C(O)-$R_s$).

The term "ester" refers to a substituted oxycarbonyl (-O-C(O)-$R_s$ or -C(O)-O-$R_s$) group.

The term "ether" refers to an -O$R_s$ group.

The terms "sulfanyl" or "thio-ether" are used interchangeably and refer to a -S$R_s$ group.

The term "selenyl" refers to a -Se$R_s$ group.

The term "sulfinyl" refers to a -S(O)-$R_s$ group.

The term "sulfonyl" refers to a -$SO_2$-$R_s$ group.

The term "phosphino" refers to a group containing at least one phosphorus atom used to be bonded to the relevant molecule, common examples such as, but not limited to, a -P$(R_s)_2$ group or a -PO$(R_s)_2$ group, wherein each $R_s$ can be same or different.

The term "silyl" refers to a group containing at least one silicon atom used to be bonded to the relevant molecule, common examples, but not limited to, such as a -Si$(R_s)_3$ group, wherein each $R_s$ can be same or different.

The term "germyl" refers to a group containing at least one germanium atom used to be bonded to the relevant molecule, common examples such as, but not limited to, a -Ge$(R_s)_3$ group, wherein each $R_s$ can be same or different.

The term "boryl" refers to a group containing at least one boron atom used to be bonded to the relevant molecule, common examples such as, but not limited to, a -B$(R_s)_2$ group or its Lewis adduct -B$(R_s)_3$ group, wherein $R_s$ can be same or different.

In each of the above, $R_s$ can be hydrogen or the general substituents as defined in this application. Preferred $R_s$ is selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, and combination thereof. More preferably $R_s$ is selected from the group consisting of alkyl, cycloalkyl, aryl, heteroaryl, and combination thereof.

The term "alkyl" refers to and includes both straight and branched chain alkyl groups. Preferred alkyl groups are those containing from one to fifteen carbon atoms, preferably one to nine carbon atoms, and includes methyl, ethyl, propyl, 1-methylethyl, butyl, 1-methylpropyl, 2-methylpropyl, pentyl, 1-methylbutyl, 2-methylbutyl, 3-methylbutyl, 1,1-dimethylpropyl, 1,2-dimethylpropyl, 2,2-dimethylpropyl, and the like. Additionally, the alkyl group can be further substituted.

The term "cycloalkyl" refers to and includes monocyclic, polycyclic, and spiro alkyl groups. Preferred cycloalkyl groups are those containing 3 to 12 ring carbon atoms and includes cyclopropyl, cyclopentyl, cyclohexyl, bicyclo[3.1.1]heptyl, spiro[4.5]decyl, spiro[5.5]undecyl, adamantyl, and the like. Additionally, the cycloalkyl group can be further substituted.

The terms "heteroalkyl" or "heterocycloalkyl" refer to an alkyl or a cycloalkyl group, respectively, having at least one carbon atom replaced by a heteroatom. Optionally the at least one heteroatom is selected from O, S, N, P, B, Si, Ge and Se, preferably, O, S or N. Additionally, the heteroalkyl or heterocycloalkyl group can be further substituted.

The term "alkenyl" refers to and includes both straight and branched chain alkene groups. Alkenyl groups are essentially alkyl groups that include at least one carbon-carbon double bond in the alkyl chain. Cycloalkenyl groups are essentially cycloalkyl groups that include at least one carbon-carbon double bond in the cycloalkyl ring. The term "heteroalkenyl" as used herein refers to an alkenyl group having at least one carbon atom replaced by a heteroatom. Optionally the at least one heteroatom is selected from O, S, N, P, B, Si, Ge, and Se, preferably, O, S, or N. Preferred alkenyl, cycloalkenyl, or heteroalkenyl groups are those containing two to fifteen carbon atoms. Additionally, the alkenyl, cycloalkenyl, or heteroalkenyl group can be further substituted.

The term "alkynyl" refers to and includes both straight and branched chain alkyne groups. Alkynyl groups are essentially alkyl groups that include at least one carbon-carbon triple bond in the alkyl chain. Preferred alkynyl groups are those containing two to fifteen carbon atoms. Additionally, the alkynyl group can be further substituted.

The terms "aralkyl" or "arylalkyl" are used interchangeably and refer to an alkyl group that is substituted with an aryl group. Additionally, the aralkyl group can be further substituted.

The term "heterocyclic group" refers to and includes aromatic and non-aromatic cyclic groups containing at least one heteroatom. Optionally the at least one heteroatom is selected from O, S, Se, N, P, B, Si, Ge, and Se, preferably, O, S, N, or B. Hetero-aromatic cyclic groups may be used interchangeably with heteroaryl. Preferred hetero-non-aromatic cyclic groups are those containing 3 to 10 ring atoms, preferably those containing 3 to 7 ring atoms, which includes at least one hetero atom, and includes cyclic amines such as morpholino, piperidino, pyrrolidino, and the like, and cyclic ethers/thio-ethers, such as tetrahydrofuran, tetrahydropyran, tetrahydrothiophene, and the like. Additionally, the heterocyclic group can be further substituted or fused.

The term "aryl" refers to and includes both single-ring and polycyclic aromatic hydrocarbyl groups. The polycyclic rings may have two or more rings in which two carbons are common to two adjoining rings (the rings are "fused"). Preferred aryl groups are those containing six to thirty carbon atoms, preferably six to twenty-four carbon atoms, six to

eighteen carbon atoms, and more preferably six to twelve carbon atoms. Especially preferred is an aryl group having six carbons, ten carbons, twelve carbons, fourteen carbons, or eighteen carbons. Suitable aryl groups include phenyl, biphenyl, triphenyl, triphenylene, tetraphenylene, naphthalene, anthracene, phenalene, phenanthrene, pyrene, chrysene, perylene, and azulene, preferably phenyl, biphenyl, triphenyl, triphenylene, and naphthalene. Additionally, the aryl group can be further substituted or fused such as, but not limited to, fluorene.

The term "heteroaryl" refers to and includes both single-ring aromatic groups and polycyclic aromatic ring systems that include at least one heteroatom. The heteroatoms include, but are not limited to O, S, Se, N, P, B, Si, Ge, and Se. In many instances, O, S, N, or B are the preferred heteroatoms. Hetero-single ring aromatic systems are preferably single rings with 5 or 6 ring atoms, and the ring can have from one to six heteroatoms. The hetero-polycyclic ring systems can have two or more aromatic rings in which two atoms are common to two adjoining rings (the rings are "fused") wherein at least one of the rings is a heteroaryl. The hetero-polycyclic aromatic ring systems can have from one to six heteroatoms per ring of the polycyclic aromatic ring system. Preferred heteroaryl groups are those containing three to thirty carbon atoms, preferably three to twenty-four carbon atoms, three to eighteen carbon atoms, and more preferably three to twelve carbon atoms. Suitable heteroaryl groups include dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine, preferably dibenzothiophene, dibenzofuran, dibenzoselenophene, carbazole, indolocarbazole, imidazole, pyridine, triazine, benzimidazole, 1,2-azaborine, 1,3-azaborine, 1,4-azaborine, borazine, and aza-analogs thereof. Additionally, the heteroaryl group can be further substituted or fused.

Of the aryl and heteroaryl groups listed above, the groups of triphenylene, naphthalene, anthracene, dibenzothiophene, dibenzofuran, dibenzoselenophene, carbazole, indolocarbazole, imidazole, pyridine, pyrazine, pyrimidine, triazine, and benzimidazole, and the respective aza-analogs of each thereof are of particular interest.

In many instances, the general substituents are selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, selenyl, sulfinyl, sulfonyl, phosphino, and combinations thereof.

In some instances, the preferred general substituents are selected from the group consisting of deuterium, fluorine, alkyl, cycloalkyl, heteroalkyl, alkoxy, aryloxy, amino, silyl, germyl, boryl, alkenyl, cycloalkenyl, heteroalkenyl, aryl, heteroaryl, nitrile, isonitrile, sulfanyl, and combinations thereof.

In some instances, the more preferred general substituents are selected from the group consisting of deuterium, fluorine, alkyl, cycloalkyl, alkoxy, aryloxy, amino, silyl, aryl, heteroaryl, nitrile, sulfanyl, and combinations thereof.

In some instances, the more preferred general substituents are selected from the group consisting of deuterium, fluorine, alkyl, cycloalkyl, silyl, aryl, heteroaryl, nitrile, and combinations thereof.

In yet other instances, the most preferred general substituents are selected from the group consisting of deuterium, alkyl, cycloalkyl, aryl, heteroaryl, and combinations thereof.

The terms "substituted" and "substitution" refer to a substituent other than H that is bonded to the relevant position, e.g., a carbon or nitrogen. For example, when $R^1$ represents mono-substitution, then one $R^1$ must be other than H (i.e., a substitution). Similarly, when $R^1$ represents di-substitution, then two of $R^1$ must be other than H. Similarly, when $R^1$ represents zero or no substitution, $R^1$, for example, can be a hydrogen for available valencies of ring atoms, as in carbon atoms for benzene and the nitrogen atom in pyrrole, or simply represents nothing for ring atoms with fully filled valencies, e.g., the nitrogen atom in pyridine. The maximum number of substitutions possible in a ring structure will depend on the total number of available valencies in the ring atoms.

As used herein, "combinations thereof' indicates that one or more members of the applicable list are combined to form a known or chemically stable arrangement that one of ordinary skill in the art can envision from the applicable list. For example, an alkyl and deuterium can be combined to form a partial or fully deuterated alkyl group; a halogen and alkyl can be combined to form a halogenated alkyl substituent; and a halogen, alkyl, and aryl can be combined to form a halogenated arylalkyl. In one instance, the term substitution includes a combination of two to four of the listed groups. In another instance, the term substitution includes a combination of two to three groups. In yet another instance, the term substitution includes a combination of two groups. Preferred combinations of substituent groups are those that contain up to fifty atoms that are not hydrogen or deuterium, or those which include up to forty atoms that are not hydrogen or deuterium, or those that include up to thirty atoms that are not hydrogen or deuterium. In many instances, a preferred combination of substituent groups will include up to twenty atoms that are not hydrogen or deuterium.

The "aza" designation in the fragments described herein, i.e. aza-dibenzofuran, aza-dibenzothiophene, etc. means that one or more of the C-H groups in the respective aromatic ring can be replaced by a nitrogen atom, for

example, but not limited to, azatriphenylene encompasses both dibenzo[*f,h*]quinoxaline and dibenzo[*f,h*]quinoline. One of ordinary skill in the art can readily envision other nitrogen analogs of the azaderivatives described above, and all such analogs are intended to be encompassed by the terms as set forth herein.

As used herein, "deuterium" refers to an isotope of hydrogen. Deuterated compounds can be readily prepared using methods known in the art. For example, U.S. Pat. No. 8,557,400, Patent Pub. No. WO 2006/095951, and U.S. Pat. Application Pub. No. US 2011/0037057, which are hereby incorporated by reference in their entireties, describe the making of deuterium-substituted organometallic complexes. Further reference is made to Ming Yan, et al., Tetrahedron 2015, 71, 1425-30 and Atzrodt et al., Angew. Chem. Int. Ed. (Reviews) 2007, 46, 7744-65, which are incorporated by reference in their entireties, describe the deuteration of the methylene hydrogens in benzyl amines and efficient pathways to replace aromatic ring hydrogens with deuterium, respectively.

As used herein, any specifically listed substituent such as, but not limited to, methyl, phenyl, pyridyl, etc. includes undeuterated, partially deuterated, and fully deuterated versions thereof. Similarly, classes of substituents such as, but not limited to, alkyl, aryl, cycloalkyl, heteroaryl, etc. also include undeuterated, partially deuterated, and fully deuterated versions thereof. A chemical structure without further specified H or D should be considered to include undeuterated, partially deuterated, and fully deuterated versions thereof. Some common smallest partially or fully deuterated group such as, but not limited to, $CD_3$, $CD_2C(CH_3)_3$, $C(CD_3)_3$, and $C_6D_5$.

It is to be understood that when a molecular fragment is described as being a substituent or otherwise attached to another moiety, its name may be written as if it were a fragment (e.g. phenyl, phenylene, naphthyl, dibenzofuryl) or as if it were the whole molecule (e.g. benzene, naphthalene, dibenzofuran). As used herein, these different ways of designating a substituent or attached fragment are considered to be equivalent.

In some instances, a pair of substituents in the molecule can be optionally joined or fused into a ring. The preferred ring is a five to nine-membered carbocyclic or heterocyclic ring, includes both instances where the portion of the ring formed by the pair of substituents is saturated and where the portion of the ring formed by the pair of substituents is unsaturated. In yet other instances, a pair of adjacent substituents can be optionally joined or fused into a ring. As used herein, "adjacent" means that the two substituents involved can be on the same ring next to each other, or on two neighboring rings having the two closest available substitutable positions, such as 2, 2' positions in a biphenyl, or 1, 8 position in a naphthalene.

Layers, materials, regions, and devices may be described herein in reference to the color of light they emit. In general, as used herein, an emissive region that is described as producing a specific color of light may include one or more emissive layers disposed over each other in a stack.

As used herein, a "red" layer, material, region, or device refers to one that emits light in the range of about 580-700nm or having a highest peak in its emission spectrum in that region. Similarly, a "green" layer, material, region, or device refers to one that emits or has an emission spectrum with a peak wavelength in the range of about 500-600nm; a "blue" layer, material, or device refers to one that emits or has an emission spectrum with a peak wavelength in the range of about 400-500nm; and a "yellow" layer, material, region, or device refers to one that has an emission spectrum with a peak wavelength in the range of about 540-600nm. In some arrangements, separate regions, layers, materials, regions, or devices may provide separate "deep blue" and a "light blue" light. As used herein, in arrangements that provide separate "light blue" and "deep blue", the "deep blue" component refers to one having a peak emission wavelength that is at least about 4nm less than the peak emission wavelength of the "light blue" component. Typically, a "light blue" component has a peak emission wavelength in the range of about 465-500nm, and a "deep blue" component has a peak emission wavelength in the range of about 400-470nm, though these ranges may vary for some configurations. Similarly, a color altering layer refers to a layer that converts or modifies another color of light to light having a wavelength as specified for that color. For example, a "red" color filter refers to a filter that results in light having a wavelength in the range of about 580-700nm. In general, there are two classes of color altering layers: color filters that modify a spectrum by removing unwanted wavelengths of light, and color changing layers that convert photons of higher energy to lower energy. A component "of a color" refers to a component that, when activated or used, produces or otherwise emits light having a particular color as previously described. For example, a "first emissive region of a first color" and a "second emissive region of a second color different than the first color" describes two emissive regions that, when activated within a device, emit two different colors as previously described.

As used herein, emissive materials, layers, and regions may be distinguished from one another and from other structures based upon light initially generated by the material, layer or region, as opposed to light eventually emitted by the same or a different structure. The initial light generation typically is the result of an energy level change resulting in emission of a photon. For example, an organic emissive material may initially generate blue light, which may be converted by a color filter, quantum dot or other structure to red or green light, such that a complete emissive stack or sub-pixel emits the red or green light. In this case the initial emissive material or layer may be referred to as a "blue" component, even though the sub-pixel is a "red" or "green" component.

In some cases, it may be preferable to describe the color of a component such as an emissive region, sub-pixel, color altering layer, or the like, in terms of 1931 CIE coordinates. For example, a yellow emissive material may

have multiple peak emission wavelengths, one in or near an edge of the "green" region, and one within or near an edge of the "red" region as previously described. Accordingly, as used herein, each color term also corresponds to a shape in the 1931 CIE coordinate color space. The shape in 1931 CIE color space is constructed by following the locus between two color points and any additional interior points. For example, interior shape parameters for red, green, blue, and yellow may be defined as shown below:

| Color | CIE Shape Parameters |
|---|---|
| Central Red | Locus: [0.6270,0.3725];[0.7347,0.2653]; Interior:[0.5086,0.2657] |
| Central Green | Locus: [0.0326,0.3530];[0.3731,0.6245]; Interior:[0.2268,0.3321 |
| Central Blue | Locus: [0.1746,0.0052];[0.0326,0.3530]; Interior:[0.2268,0.3321] |
| Central Yellow | Locus: [0.373 1,0.6245];[0.6270,0.3725]; Interior: [0.3 700,0.4087];[0.2886,0.4572] |

More details on OLEDs, and the definitions described above, can be found in US Pat. No. 7,279,704, which is incorporated herein by reference in its entirety.

As disclosed herein, emissive layers or materials, such as emissive layer 135 and emissive layer 220 shown in FIGS. 1-2, respectively, may include quantum dots. An "emissive layer" or "emissive material" as disclosed herein may include an organic emissive material and/or an emissive material that contains quantum dots or equivalent structures, unless indicated to the contrary explicitly or by context according to the understanding of one of skill in the art. In general, an emissive layer includes emissive material within a host matrix. Such an emissive layer may include only a quantum dot material which converts light emitted by a separate emissive material or other emitter, or it may also include the separate emissive material or other emitter, or it may emit light itself directly from the application of an electric current. Similarly, a color altering layer, color filter, upconversion, or downconversion layer or structure may include a material containing quantum dots, though such layer may not be considered an "emissive layer" as disclosed herein. In general, an "emissive layer" or material is one that emits an initial light based on an injected electrical charge, where the initial light may be altered by another layer such as a color filter or other color altering layer that does not itself emit an initial light within the device, but may re-emit altered light of a different spectra content based upon absorption of the initial light emitted by the emissive layer and downconversion to a lower energy light emission. In some embodiments disclosed herein, the color altering layer, color filter, upconversion, and/or downconversion layer may be disposed outside of an OLED device, such as above or below an electrode of the OLED device.

Unless otherwise specified, any of the layers of the various embodiments may be deposited by any suitable method. For the organic layers, preferred methods include thermal evaporation, ink jet, such as described in U.S. Pat. Nos. 6,013,982 and 6,087,196, which are incorporated by reference in their entireties, organic vapor phase deposition (OVPD), such as described in U.S. Pat. No. 6,337,102 to Forrest et al., which is incorporated by reference in its entirety, and deposition by organic vapor jet printing (OVJP), such as described in U.S. Pat. No. 7,431,968, which is incorporated by reference in its entirety. Other suitable deposition methods include spin coating and other solution based processes. Solution based processes are preferably carried out in nitrogen or an inert atmosphere. For the other layers, preferred methods include thermal evaporation. Preferred patterning methods include deposition through a mask, cold welding such as described in U.S. Pat. Nos. 6,294,398 and 6,468,819, which are incorporated by reference in their entireties, and patterning associated with some of the deposition methods such as ink-jet and OVJD. Other methods may also be used. The materials to be deposited may be modified to make them compatible with a particular deposition method. For example, substituents such as alkyl and aryl groups, branched or unbranched, and preferably containing at least 3 carbons, may be used in small molecules to enhance their ability to undergo solution processing. Substituents having 20 carbons or more may be used, and 3-20 carbons is a preferred range. Materials with asymmetric structures may have better solution processibility than those having symmetric structures, because asymmetric materials may have a lower tendency to recrystallize. Dendrimer substituents may be used to enhance the ability of small molecules to undergo solution processing.

Devices fabricated in accordance with embodiments of the present disclosure may further optionally comprise a barrier layer. One purpose of the barrier layer is to protect the electrodes and organic layers from damaging exposure to harmful species in the environment including moisture, vapor and/or gases, etc. The barrier layer may be deposited over, under or next to a substrate, an electrode, or over any other parts of a device including an edge. The barrier layer may comprise a single layer, or multiple layers. The barrier layer may be formed by various

known chemical vapor deposition techniques and may include compositions having a single phase as well as compositions having multiple phases. Any suitable material or combination of materials may be used for the barrier layer. The barrier layer may incorporate an inorganic or an organic compound or both. The preferred barrier layer comprises a mixture of a polymeric material and a non-polymeric material as described in U.S. Pat. No. 7,968,146, PCT Pat. Application Nos. PCT/US2007/023098 and PCT/US2009/042829, which are herein incorporated by reference in their entireties. To be considered a "mixture", the aforesaid polymeric and non-polymeric materials comprising the barrier layer should be deposited under the same reaction conditions and/or at the same time. The weight ratio of polymeric to non-polymeric material may be in the range of 95:5 to 5:95. The polymeric material and the non-polymeric material may be created from the same precursor material. In one example, the mixture of a polymeric material and a non-polymeric material consists essentially of polymeric silicon and inorganic silicon.

It is believed that the internal quantum efficiency (IQE) of fluorescent OLEDs can exceed the 25% spin statistics limit through delayed fluorescence. As used herein, there are two types of delayed fluorescence, i.e. P-type delayed fluorescence and E-type delayed fluorescence. P-type delayed fluorescence is generated from triplet-triplet annihilation (TTA).

On the other hand, E-type delayed fluorescence does not rely on the collision of two triplets, but rather on the thermal population between the triplet states and the singlet excited states. Compounds that are capable of generating E-type delayed fluorescence are required to have very small singlet-triplet gaps. Thermal energy can activate the transition from the triplet state back to the singlet state. This type of delayed fluorescence is also known as thermally activated delayed fluorescence (TADF). A distinctive feature of TADF is that the delayed component increases as temperature rises due to the increased thermal energy. If the reverse intersystem crossing rate is fast enough to minimize the non-radiative decay from the triplet state, the fraction of back populated singlet excited states can potentially reach 75%. The total singlet fraction can be 100%, far exceeding the spin statistics limit for electrically generated excitons.

E-type delayed fluorescence characteristics can be found in an exciplex system or in a single compound. Without being bound by theory, it is believed that E-type delayed fluorescence requires the luminescent material to have a small singlet-triplet energy gap (∆ES-T). Organic, non-metal containing, donor-acceptor luminescent materials may be able to achieve this. The emission in these materials is often characterized as a donor-acceptor charge-transfer (CT) type emission. The spatial separation of the HOMO and LUMO in these donor-acceptor type compounds often results in small ∆ES-T. These states may involve CT states. Often, donor-acceptor luminescent materials are constructed by connecting an electron donor moiety such as amino- or carbazole-derivatives and an electron acceptor moiety such as N-containing six-membered aromatic ring.

Devices fabricated in accordance with embodiments of the disclosure can be incorporated into a wide variety of electronic component modules (or units) that can be incorporated into a variety of electronic products or intermediate components. Examples of such electronic products or intermediate components include display screens, lighting devices such as discrete light source devices or lighting panels, etc. that can be utilized by the end-user product manufacturers. Such electronic component modules can optionally include the driving electronics and/or power source(s). Devices fabricated in accordance with embodiments of the disclosure can be incorporated into a wide variety of consumer products that have one or more of the electronic component modules (or units) incorporated therein. A consumer product comprising an OLED that includes the compound of the present disclosure in the organic layer in the OLED is disclosed. Such consumer products would include any kind of products that include one or more light source(s) and/or one or more of some type of visual displays. Some examples of such consumer products include a flat panel display, a curved display, a computer monitor, a medical monitor, a television, a billboard, a light for interior or exterior illumination and/or signaling, a heads-up display, a fully or partially transparent display, a flexible display, a rollable display, a foldable display, a stretchable display, a laser printer, a telephone, a cell phone, tablet, a phablet, a personal digital assistant (PDA), a wearable device, a laptop computer, a digital camera, a camcorder, a viewfinder, a micro -display that is less than 2 inches diagonal, a 3-D display, a virtual reality or augmented reality display, a vehicle, a video walls comprising multiple displays tiled together, a theater or stadium screen, and a sign. Various control mechanisms may be used to control devices fabricated in accordance with the present disclosure, including passive matrix and active matrix. Many of the devices are intended for use in a temperature range comfortable to humans, such as 18 C to 30 C, and more preferably at room temperature (20-25 C), but could be used outside this temperature range, for example, from -40 C to 80 C.

The materials and structures described herein may have applications in devices other than OLEDs. For example, other optoelectronic devices such as organic solar cells and organic photodetectors may employ the materials and structures. More generally, organic devices, such as organic transistors, may employ the materials and structures.

In general parlance in the art, a "sub-pixel" may refer to the emissive region, which may be a single-layer EML, a stacked device, or the like, in conjunction with any color altering layer that is used to modify the color emitted by the emissive region.

As used herein, the "emissive region" of a sub-pixel refers to any and all emissive layers, regions, and devices that are used initially to generate light for the sub-pixel. A sub-pixel also may include additional layers disposed in a stack with the emissive region that affect the color ultimately produced by the sub -pixel, such as color altering layers

disclosed herein, though such color altering layers typically are not considered "emissive layers" as disclosed herein. An unfiltered sub-pixel is one that excludes a color modifying component such as a color altering layer, but may include one or more emissive regions, layers, or devices.

In some configurations, an "emissive region" may include emissive materials that emit light of multiple colors. For example, a yellow emissive region may include multiple materials that emit red and green light when each material is used in an OLED device alone. When used in a yellow device, the individual materials typically are not arranged such that they can be individually activated or addressed. That is, the "yellow" OLED stack containing the materials cannot be driven to produce red, green, or yellow light; rather, the stack can be driven as a whole to produce yellow light. Such an emissive region may be referred to as a yellow emissive region even though, at the level of individual emitters, the stack does not directly produce yellow light. As described in further detail below, the individual emissive materials used in an emissive region (if more than one), may be placed in the same emissive layer within the device, or in multiple emissive layers within an OLED device comprising an emissive region. As described in further detail below, embodiments disclosed herein may allow for OLED devices such as displays that include a limited number of colors of emissive regions, while including more colors of sub-pixels or other OLED devices than the number of colors of emissive regions. For example, a device as disclosed herein may include only blue and yellow emissive regions. Additional colors of sub-pixels may be achieved by the use of color altering layers, such as color altering layers disposed in a stack with yellow or blue emissive regions, or more generally through the use of color altering layers, electrodes or other structures that form a microcavity as disclosed herein, or any other suitable configuration. In some cases, the general color provided by a sub-pixel may be the same as the color provided by the emissive region in the stack that defines the sub-pixel, such as where a deep blue color altering layer is disposed in a stack with a light blue emissive region to produce a deep blue sub-pixel. Similarly, the color provided by a sub-pixel may be different than the color provided by an emissive region in the stack that defines the sub-pixel, such as where a green color altering layer is disposed in a stack with a yellow emissive region to product a green sub-pixel.

In some configurations, emissive regions and/or emissive layers may span multiple sub-pixels, such as where additional layers and circuitry are fabricated to allow portions of an emissive region or layer to be separately addressable.

An emissive region as disclosed herein may be distinguished from an emissive "layer" as typically referred to in the art and as used herein. In some cases, a single emissive region may include multiple layers, such as where a yellow emissive region is fabricated by sequentially red and green emissive layers to form the yellow emissive region. As previously described, when such layers occur in an emissive region as disclosed herein, the layers are not individually addressable within a single emissive stack; rather, the layers are activated or driven concurrently to produce the desired color of light for the emissive region. In other configurations, an emissive region may include a single emissive layer of a single color, or multiple emissive layers of the same color, in which case the color of such an emissive layer will be the same as, or in the same region of the spectrum as, the color of the emissive region in which the emissive layer is disposed.

**B. The OLEDs and the Devices of the Present Disclosure**

The present disclosure provides novel device architectures that comprise emissive layers comprising phosphorescent and phosphorescence-sensitized fluorescent emitters. These novel architectures offer improved device efficiency and stability.

In one aspect, the present disclosure also provides a full-color pixel arrangement of a device comprising at least one pixel:
wherein the at least one pixel comprises:

a first subpixel comprising a first OLED comprising a first emissive region; a second subpixel comprising a second OLED comprising a second emissive region;
wherein the first emissive region comprises:

a compound S1;
a compound A1; and
a compound H1;

wherein the second emissive region comprises:

a compound A2; and
a compound H2;

wherein the compound S1 is a sensitizer that transfers energy to the compound A1;

wherein the compound A1 is an acceptor that is an emitter;
wherein the compound H1 is a host, and at least one of the compounds S1 and A1 is doped with the compound H1;
wherein the compound A2 is an emitter;
wherein the compound H2 is a host, and the compound A2 is doped with the compound H2;
wherein at least one of the following conditions is true:

(1) the first emissive region is configured to emit a light having a peak wavelength $\lambda_{max1}$ in the visible spectrum of 400-500 nm; the second emissive region is configured to emit a light having a peak wavelength $\lambda_{max2}$ in the visible spectrum of 400-500 nm; wherein the difference between $\lambda_{max1}$ and $\lambda_{max2}$ is at least 4 nm;
(2) the first emissive region is configured to emit a light having a peak wavelength $\lambda_{max1}$; the second emissive region is configured to emit a light having a peak wavelength $\lambda_{max2}$; wherein the difference between $\lambda_{max1}$ and $\lambda_{max2}$ is at least 4 nm; wherein the at least one pixel consists of a total of *N* subpixels; wherein the *N* subpixels comprises the first subpixel and the second subpixel; wherein each of the *N* subpixels comprises an emissive region; wherein the total number of the emissive regions within the at least one pixel is equal or less than *N-1*;
(3) the first emissive region comprises a first number of emissive layers that is deposited one over the other if more than one; the second emissive region comprises a second number of emissive layers that is deposited one over the other if more than one; and the first number is different from the second number;
(4) the second emissive region is exactly the same as the first emissive region; each subpixel of the at least one pixel comprises exactly the same one emissive region as the first emissive region. It should be understood for this condition that the first and second sub-pixels contain the same emissive region, but the two sub-pixels emit different colors.

In some embodiments, compounds A1 can be same or different from A2. In some embodiments, compound H1 can be same or different from H2.

In some embodiments, the first emissive region is configured to emit light in the near IR region with a peak wavelength. In some embodiments, the second emissive region is configured to emit light in the near IR region with a wavelength. In such embodiments, the difference between the two wavelengths is at least 4 nm.

It should be understood that the wavelength range can be any number between the range including the end numbers. For example, a spectrum range of 400-500 nm means any number between 400 and 500 including 400 and 500.

In some embodiments, the compound S1 is capable of functioning as a phosphorescent emitter, a TADF emitter, or a doublet emitter in an OLED at room temperature.

In some embodiments, the compounds A1 is selected from the group consisting of: a delayed-fluorescent compound functioning as a TADF emitter in the first OLED at room temperature, a fluorescent compound functioning as a fluorescent emitter in the first OLED at room temperature.

In some embodiments, the fluorescent emitter can be a singlet or doublet emitter. In some such embodiments, the singlet emitter can also include a TADF emitter.

In some embodiments, the compounds A2 is selected from the group consisting of: a phosphorescent compound functioning as a phosphorescent emitter in the second OLED at room temperature, a delayed-fluorescent compound functioning as a TADF emitter in the second OLED at room temperature, a fluorescent compound functioning as a fluorescent emitter in the second OLED at room temperature.

In some embodiments, the compound S1 and A1 are in a separate layer within the first emissive region.

In some embodiments, the compound S1, A1, and H1 are mixed together in one layer within the first emissive region. In some such embodiment, the mixture can be a homogeneous mixture or the compounds in the mixture can be in graded concentrations through the thickness of the layer. The concentration grading can be linear, non-linear, or sinusoidal. In addition to the compounds S1, A1, and H1, there can be one or more other functional compounds, such as but not limit to, a second host, a second sensitizer, or a second acceptor, also mixed into the mixture.

In some embodiments, $S_1$-$T_1$ energy gap of the compound S1 is less than 300 meV. In some embodiments, $S_1$-$T_1$ energy gap of the compound S1 is less than 250 meV. In some embodiments, $S_1$-$T_1$ energy gap of the compound S1 is less than 200 meV. In some embodiments, $S_1$-$T_1$ energy gap of the compound S1 is less than 150 meV. In some embodiments, $S_1$-$T_1$ energy gap of the compound S1 is less than 100 meV.

In some embodiments, $S_1$-$T_1$ energy gap of the compound A1 is less than 300 meV. In some embodiments, $S_1$-$T_1$ energy gap of the compound A1 is less than 250 meV. In some embodiments, $S_1$-$T_1$ energy gap of the compound A1 is less than 200 meV. In some embodiments, $S_1$-$T_1$ energy gap of the compound A1 is less than 150 meV. In some embodiments, $S_1$-$T_1$ energy gap of the compound A1 is less than 100 meV.

In some embodiments, the second OLED is not a sensitized device.

In some embodiments, the second OLED is a sensitized device; the second emissive region further comprises a compound S2; and wherein the compound S2 is a sensitizer that transfers energy to the compound A2. In some embodiments, compound S2 can be same or different from S1.

In some embodiments, each of the first and second emissive regions comprises only one emissive layer.

In some embodiments, at least one of the first and second emissive regions comprises two or more stacked emissive layers.

In some embodiments, the at least one pixel further comprises a third subpixel and a fourth subpixel; wherein each of the first to the fourth subpixels is configured to emit in a different color selected from the group consisting of deep blue, light blue, green, yellow, red, and NIR. In some embodiments, each of the first to the fourth subpixels is configured to emit in a white color.

In some embodiments, the first emissive region is configured to emit a deep blue or light blue color.

In some embodiments, the second emissive region is configured to emit a color selected from the group consisting of blue, green, yellow, red, and NIR.

In some embodiments, the first subpixel has at least one common layer with the second subpixel.

In some embodiments, the first subpixel is disposed over a region of the substrate that does not overlap any region of the substrate over which the second subpixel is disposed.

In some embodiments, each of the first subpixel and the second subpixel is individually addressable.

In some embodiments, the pixel arrangement further comprises quantum dot.

In some embodiments, the pixel arrangement further comprises a color filter or a color altering layer.

In some embodiments, the pixel arrangement provides a Rec2020 color gamut.

In some embodiments, the pixel arrangement further comprises a subpixel comprising an emissive region being configured to emit a NIR color. This subpixel can be under the at least one pixel or another independent pixel solely designated/designed for NIR.

In some embodiments, the pixel arrangement further comprises a color altering layer.

It should be understood that the color altering layer can be a color conversion layer, a color filter, a downconversion filter, a band-pass filter, or a cut-off filter.

In some embodiments, the full-color pixel arrangement comprises plurality of pixels; wherein at least two of the plurality of pixels comprises the first emissive region.

In some embodiments, the first subpixel has a first optical path length, the second subpixel has a second optical path length different than the first optical path length. The optical pathlength is modified by one of the following: patterning of an electrode thickness, addition of an optical metamaterial, or modification of composition or thickness for layers that are not in the emissive region.

In some embodiments, the at least one pixel comprises a plurality of subpixels; wherein only one of the plurality of subpixels has a color altering layer.

In some embodiments, the condition (1) is true. In some such embodiments, $\lambda_{max1}$ is less than $\lambda_{max2}$ by at least 4 nm. In some such embodiments, $\lambda_{max2}$ is less than $\lambda_{max1}$ by at least 4 nm.

In some such embodiments, the first emissive region is configured to emit a light having a CIE y-coordinate less than 0.15; and the second emissive region is configured to emit a light having a CIE x-coordinate less than 0.2.

In some such embodiments, the CIE coordinates of light emitted by the first emissive region and the CIE coordinates of light emitted by the second emissive region are sufficiently different that the difference in the CIE x-coordinates plus the difference in the CIE y-coordinates is at least > 0.01.

In some such embodiments, the pixel arrangement further comprises a third subpixel and a fourth subpixel; wherein the third subpixel comprising a third OLED comprising a third emissive region that is configured to emit a light having a peak wavelength in the visible spectrum of 500-600 nm; and the fourth subpixel comprising a fourth OLED comprising a fourth emissive region that is configured to emit a light having a peak wavelength in the visible spectrum of 600-700 nm.

In some embodiments, the condition (2) is true. In some such embodiments, the pixel arrangement comprises not more than *N*-1 color altering layers. In some such embodiments, the color altering layer can be a color conversion layer, a color filter, a downconversion filter, a band-pass filter, a cut-off filter, or any two or more combinations (stacked together) thereof. In some such embodiments, the pixel arrangement comprises not more than two color altering layers. In some such embodiments, $\lambda_{max1}$ is less than $\lambda_{max2}$ by at least 4 nm. In some such embodiments, $\lambda_{max1}$ is 400-500 nm; $\lambda_{max2}$ is 500-600 nm. In some such embodiments, the pixel arrangement further comprises a third subpixel and a fourth subpixel; wherein each of the third subpixel and the fourth subpixel comprises exact the same second OLED comprising the second emissive region as in the second subpixel; and wherein each of the first to the fourth subpixels are configured to emit in a different color.

In some such embodiments, the pixel arrangement further comprises a third subpixel and a fourth subpixel; wherein each of the third subpixel and the fourth subpixel comprises exact the same first OLED comprising the first emissive region as in the first subpixel; and wherein each of the first to the fourth subpixels are configured to emit in a different color.

In some such embodiments, $\lambda_{max1}$ is greater than 500 nm and $\lambda_{max2}$ is less than 496 nm.

In some such embodiments, the $S_1$-$T_1$ energy gap of the compound A1 is less than 300 meV.

In some such embodiments, each of the N subpixels comprises an emissive region only selected from the group consisting of the first emissive region, and the second emissive region.

In some embodiments, the condition (3) is true. In some such embodiments, the first number is larger than the second number. In some such embodiments, the second number is larger than the first number.
In some such embodiments, the first emissive region comprises at least two emissive layers, each of the at least two emissive layers can be same or different. In some such embodiments, the first emissive region comprises one sensitizing layer and one non-sensitizing emissive layer. In some such embodiments, the first emissive region comprises two sensitizing emissive layers.

In some embodiments, the condition (4) is true. In some such embodiments, the exact same one emissive region is configured to emit a light blue color having a peak wavelength selected from the group consisting of: greater than or equal to 460 nm, greater than or equal to 465 nm, and greater than or equal to 470 nm.

In some such embodiments, the full-color pixel arrangement comprises a plurality of sub-pixels; and wherein the exact same one emissive region is configured to emit a red-shifted color of a deep blue sub-pixel of the plurality of sub-pixels.

In some such embodiments, the exact same one emissive region is configured to emit a light blue color having 1931 CIE coordinates with CIEy selected from the group consisting of: greater than or equal to 0.20, greater than or equal to 0.15, and greater than or equal to 0.10.

In some such embodiments, the full-color pixel arrangement comprises a plurality of sub-pixels; wherein the plurality of sub-pixels comprise: a light blue sub-pixel, the deep blue sub-pixel, a red sub-pixel, and a green sub-pixel.

In another aspect, the present disclosure also provides an organic light emitting device (OLED) comprising:

a first electrode;
a first emissive region disposed over the first electrode;
a first charge generation layer (CGL) disposed over the first emissive region;
a second emissive region disposed over the first CGL; and
a second electrode disposed over the second emissive region;
wherein the first emissive region comprises:

a compound S1;
a compound A1; and
a compound H1;

wherein the second emissive region comprises:

a compound A2; and
a compound H2;

wherein the compound S1 is a sensitizer that transfers energy to the compound A1;
wherein the compound A1 is an acceptor that is an emitter;
wherein the compound H1 is a host, and at least one of the compounds S1 and A1 is doped with the compound H1;
wherein the compound A2 is an emitter;
wherein the compound H2 is a host, and the compound A2 is doped with the compound H2;

wherein at least one of the following conditions is true:

(1) the first emissive region is configured to emit a light having a peak wavelength $\lambda_{max1}$ in the visible spectrum of 400-500 nm; the second emissive region is configured to emit a light having a peak wavelength $\lambda_{max2}$ in the visible spectrum of 400-500 nm.
(2) the first emissive region is configured to emit a light having a peak wavelength $\lambda_{max1}$ in one of the visible spectrum of 400-500 nm, 500-600 nm, 600-700 nm; the second emissive region is configured to emit a light having a peak wavelength $\lambda_{max2}$ in one of the remaining ones of the visible spectrum of 400-500 nm, 500-600 nm, 600-700 nm; or
(3) the first emissive region comprises a first number of emissive layers that is deposited one over the other if more than one; the second emissive region comprises a second number of emissive layers that is deposited one over the other if more than one; and the first number is different from the second number.

In some embodiments, the OLED is configured to emit white color.

In some embodiments, the compound S1 is capable of functioning as a phosphorescent emitter, a TADF emitter, or a doublet emitter in an OLED at room temperature.

In some embodiments, the compounds A1 is selected from the group consisting of: a delayed-fluorescent compound functioning as a TADF emitter in the first OLED at room temperature, a fluorescent compound functioning as a fluorescent emitter in the first OLED at room temperature.

In some embodiments, the compounds A2 is selected from the group consisting of: a phosphorescent compound functioning as a phosphorescent emitter in the second OLED at room temperature, a delayed-fluorescent compound functioning as a TADF emitter in the second OLED at room temperature, a fluorescent compound functioning as a fluorescent emitter in the second OLED at room temperature.

In some embodiments, the compound S1 and A1 are in a separate layer within the first emissive region.

In some embodiments, the compound S1, A1, and H1 are mixed together in one layer within the first emissive region.

In some embodiments, $S_1$-$T_1$ energy gap of the compound S1 is less than 300 meV. In some embodiments, $S_1$-$T_1$ energy gap of the compound S 1 is less than 250 meV. In some embodiments, $S_1$-$T_1$ energy gap of the compound S 1 is less than 200 meV. In some embodiments, $S_1$-$T_1$ energy gap of the compound S 1 is less than 150 meV. In some embodiments, $S_1$-$T_1$ energy gap of the compound S1 is less than 100 meV.

In some embodiments, $S_1$-$T_1$ energy gap of the compound A1 is less than 300 meV. In some embodiments, $S_1$-$T_1$ energy gap of the compound A1 is less than 250 meV. In some embodiments, $S_1$-$T_1$ energy gap of the compound A1 is less than 200 meV. In some embodiments, $S_1$-$T_1$ energy gap of the compound A1 is less than 150 meV. In some embodiments, $S_1$-$T_1$ energy gap of the compound A1 is less than 100 meV.

In some embodiments, the second emissive region does not comprise a sensitizer.

In some embodiments, the second emissive region further comprises a compound S2; and wherein the compound S2 is a sensitizer that transfers energy to the compound A2.

In some embodiments, when condition (1) or (2) is true, each of the first and second emissive region comprises only one emissive layer.

In some embodiments, condition (1) or (2) is true, at least one of the first and second emissive region comprises two or more stacked emissive layers.

In some embodiments, the OLED comprises plurality of emissive regions disposed between the first and second electrodes, and separated by plurality of CGLs from each other; wherein each of the emissive regions is configured to emit in a different color selected from the group consisting of deep blue, light blue, green, yellow, red, and NIR.

In some embodiments, the first emissive region is configured to emit a deep blue or light blue color.

In some embodiments, the second emissive region is configured to emit a color selected from the group consisting of blue, green, yellow, red, and NIR.

In some embodiments, the OLED further comprises quantum dots.

In some embodiments, the OLED comprises plurality of emissive regions disposed between the first and second electrodes, and separated by plurality of CGLs from each other; wherein at least two of the emissive regions comprises an emissive material of blue color, and at least one of the emissive regions comprises an emissive material of green and/or yellow color.

In some embodiments, there are total of four emissive regions, three of them comprises an emissive material of blue color, and the remaining one comprises an emissive material of green and/or yellow color. In some embodiments, there are total of five emissive regions, four of them comprises an emissive material of blue color, and the remaining one comprises an emissive material of green and/or yellow color. In some embodiments, the plurality of the emissive regions comprising the emissive material of blue are disposed next to each other and separated by a plurality of CGLs. In some embodiments, the OLED further comprises quantum dots, which down convert the color to green and/or red.

In some embodiments, the condition (1) is true. In some such embodiments, the difference between $\lambda_{max1}$ and $\lambda_{max2}$ is at least 4 nm. In some such embodiments, the difference between $\lambda_{max1}$ and $\lambda_{max2}$ is less than 4 nm.

In some such embodiments, the OLED further comprises a third emissive region disposed over the first CGL but under the second emissive region; and a second CGL disposed over the third emissive region but under the second emissive region.

In some such embodiments, the third emissive region comprises an emissive material of yellow color.

In some such embodiments, the third emissive region comprises an emissive material of yellow color, and an emissive material of red color.

In some such embodiments, the third emissive region comprises an emissive material of yellow color, an emissive material of green color, and an emissive material of red color.

In some such embodiments, the third emissive region comprises an emissive material of green color, and an emissive material of red color.

In some embodiments, the condition (2) is true.

In some such embodiments, the first emissive region is configured to emit a light having a peak wavelength $\lambda_{max1}$ in the visible spectrum of 400-500 nm; the second emissive region is configured to emit a light having a peak wavelength $\lambda_{max2}$ in the visible spectrum of 500-700 nm.

In some such embodiments, the second emissive region is configured to emit a light having a peak wavelength $\lambda_{max1}$ in the visible spectrum of 400-500 nm; the first emissive region is configured to emit a light having a peak wavelength $\lambda_{max2}$ in the visible spectrum of 500-700 nm.

In some such embodiments, one of the first and second emissive regions is configured to emit a light having a peak wavelength $\lambda_{max1}$ in the visible spectrum of 400-500 nm; the other one of the first and second emissive regions comprises an emissive material of green and an emissive material of red, and is configured to emit a light having a peak wavelength $\lambda_{max2}$ in the visible spectrum of 500-700 nm.

In some such embodiments, one of the first and second emissive regions is configured to emit a light having a peak wavelength $\lambda_{max1}$ in the visible spectrum of 400-500 nm; the other one of the first and second emissive regions comprises an emissive material of green, an emissive material of yellow, and an emissive material of red, and is configured to emit a light having a peak wavelength $\lambda_{max2}$ in the visible spectrum of 500-700 nm.

In some embodiments, the condition (3) is true. In some such embodiments, the first number is larger than the second number. In some such embodiments, the second number is larger than the first number. In some such embodiments, the second emissive region comprises at least two emissive layers.

In some embodiments, the OLED containing the stacked hybrid architecture as described herein comprises a light blue phosphorescent emissive unit and a deep blue phosphorescence sensitized fluorescent unit. In some embodiments, the OLED device as described herein comprises a light blue subpixel and a deep blue subpixel; the light blue subpixel comprises a phosphorescent emitter, whereas the deep blue subpixel comprises a phosphorescent sensitizer and a fluorescent emitter.

In some embodiments, the sensitizer compound is capable of functioning as a phosphorescent emitter, a TADF emitter, or a doublet emitter in an OLED at room temperature. In some embodiments, the acceptor compound is selected from the group consisting of: a delayed-fluorescent compound functioning as a TADF emitter in said OLED at room temperature, a fluorescent compound functioning as a fluorescent emitter in said OLED at room temperature. In some embodiments, the fluorescent emitter can be a singlet or doublet emitters. In some of such embodiments, the singlet emitter can also include a TADF emitter, furthermore, a multi-resonant MR-TADF emitter. As used herein, the description of the delayed fluorescence can be found in US application publication US20200373510A1 col. 0083-0084, the entire contents of which are incorporated herein by reference.

In some embodiments, the sensitizer and acceptor compounds are in a separate layer within the emissive region. In some embodiments, the sensitizer and the acceptor compounds are present as a mixture in one layer in the emissive region. It should be understood that the mixture can be a homogeneous mixture or the compounds in the mixture can be in graded concentrations through the thickness of the layer. The concentration grading can be linear, non-linear, sinusoidal, etc. In addition to the sensitizer and the acceptor compounds, there can be one or more other functional compounds, such as but not limit to, hosts, also mixed into the mixture. In some embodiments, the acceptor compound can be in two or more layers with the same or different concentration. In some embodiments, the concentration of sensitizer compound in the layer containing the sensitizer compound is in the range of 1 to 50 %, 10 to 20 %, or 12-15 % by weight. In some embodiments, the concentration of the acceptor compound in the layer containing the acceptor compound is in the range of 0.1 to 10 %, 0.5 to 5 %, or 1 to 3 % by weight.

In some embodiments, the emissive region contains *N* layers and $N > 2$. In some embodiments, the sensitizer compound is contained in each of the *N* layers, the acceptor compound is contained in less than or equal to $N$-1 layers. In some embodiments, the acceptor compound is contained within less than or equal to $N/2$ layers.
In some embodiments, the OLED emits a luminescent emission comprising an emission component from the $S_1$ energy of the acceptor compound when a voltage is applied across the OLED.

In some embodiments, at least 65%, 75%, 85%, or 95% of the emission from the emissive region is produced from the acceptor compound with a luminance of at least 100 $cd/m^2$. In some embodiments, $S_1$ energy of the acceptor compound is lower than that of the sensitizer compound.

In some embodiments, $S_1$-$T_1$ energy gap of the sensitizer compound and/or acceptor compound is less than 400, 300, 250, 200, 150, 100, or 50 meV.

In some embodiments, the acceptor compound has a Stokes shift of 30, 25, 20, 15, or 10 nm or less. In some embodiments, the acceptor compound has a Stokes shift of 30, 40, 60, 80, or 100 nm or more.

In some embodiments, the sensitizer compound has an emission maximum of $\lambda_{max1}$ in a monochromic OLED having a host at room temperature; wherein the acceptor compound has an emission maximum of $\lambda_{max2}$ in said monochromic OLED by replacing the sensitizer compound with the acceptor compound; wherein $\Delta\lambda = \lambda_{max1} - \lambda_{max2}$; and wherein $\Delta\lambda$ is equal to or less than the number selected from the group consisting of 15, 12, 10, 8, 6, 4, 2, 0, -2, -4, -6, -8, and -10 nm. In some embodiments, $\Delta\lambda$ is equal to or greater than the number selected from the group consisting of 20, 30, 40, 60, 80, 100 nm.

In some embodiments, the sensitizer compound is capable of functioning as a phosphorescent emitter in an OLED at room temperature. In some embodiments, the sensitizer compound is capable of emitting light from a triplet excited state to a ground singlet state in an OLED at room temperature. In some embodiments, the sensitizer compound

is a metal coordination complex having a metal-carbon bond, a metal-nitrogen bond, or a metal-oxygen bond. In some embodiments, the metal is selected from the group consisting of Ir, Rh, Re, Ru, Os, Pt, Zn, Zr, Au, Ag, and Cu. In some embodiments, the metal is Ir. In some embodiments, the metal is Pt. In some embodiments, the sensitizer compound has the formula of $M(L^1)_x(L^2)_y(L^3)_z$;

wherein $L^1$, $L^2$, and $L^3$ can be the same or different;
wherein x is 1, 2, or 3;
wherein y is 0, 1, or 2;
wherein z is 0, 1, or 2;
wherein x+y+z is the oxidation state of the metal M;
wherein $L^1$ is selected from the group consisting of the structures of LIGAND LIST:

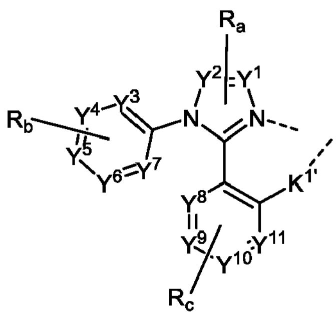,
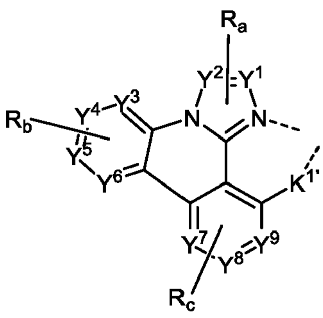,
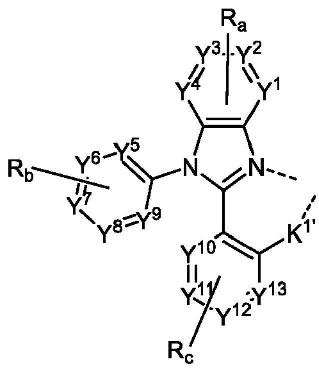,
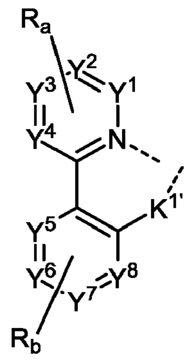

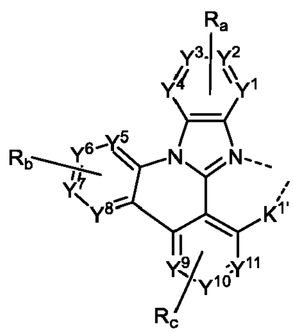,
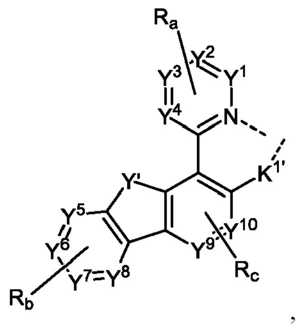,
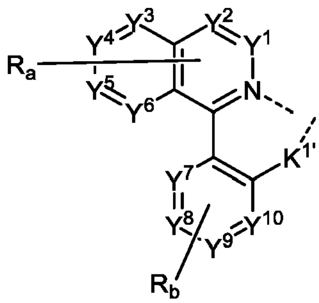,

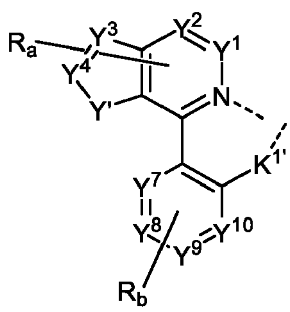,
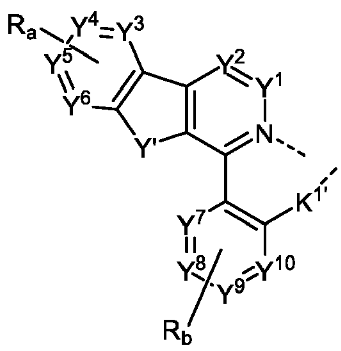,
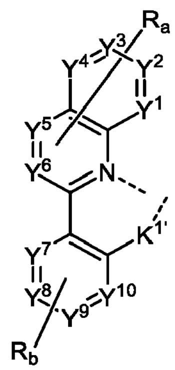,
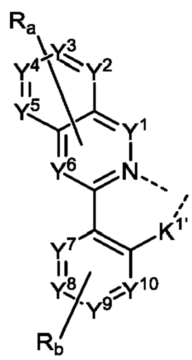,

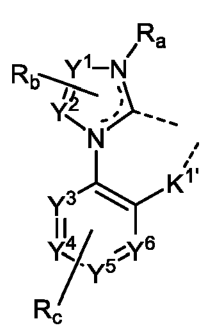 , 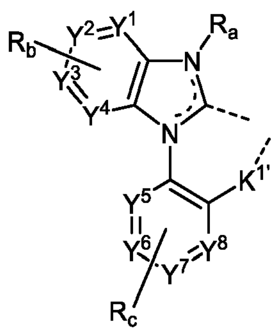 , 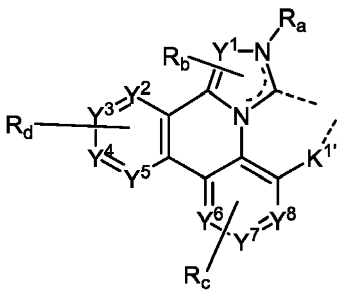 , 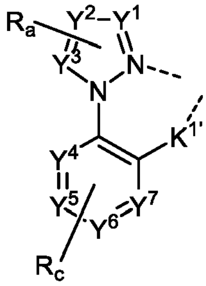 ,

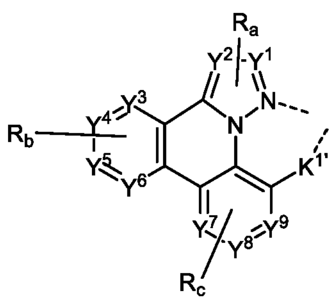 , 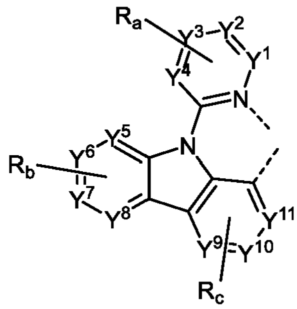 , 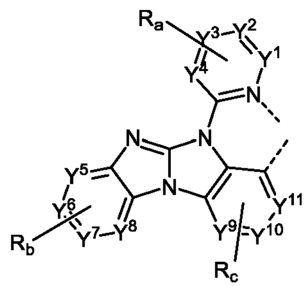 ,

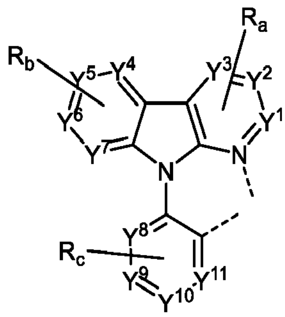 , 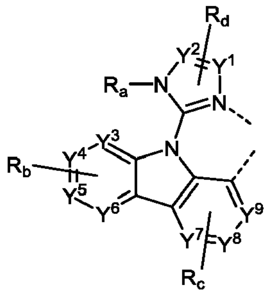 , 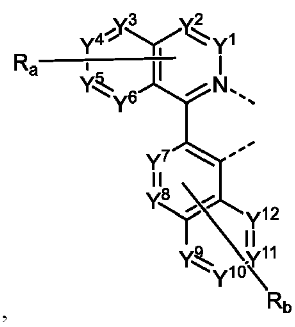 , 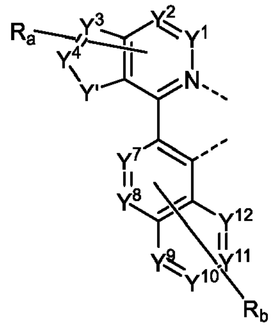 ,

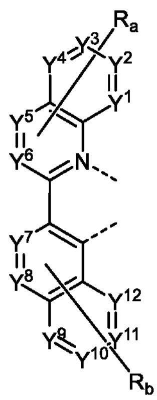 , 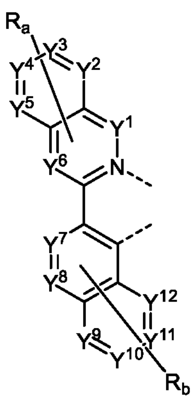 , 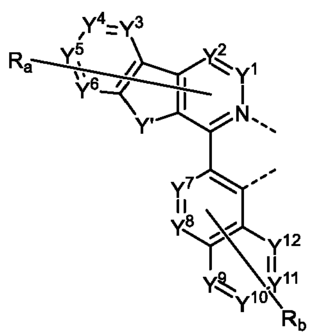 , 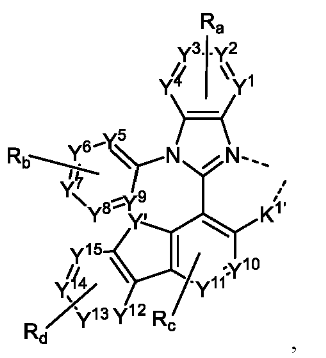 ,

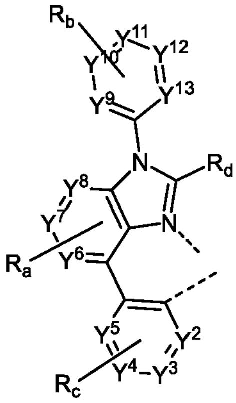, 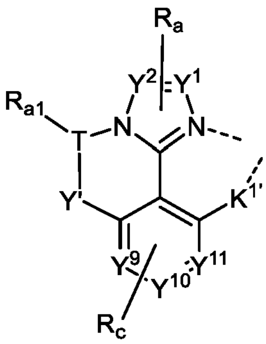, 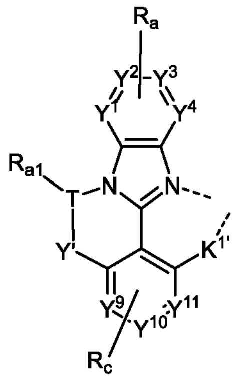, 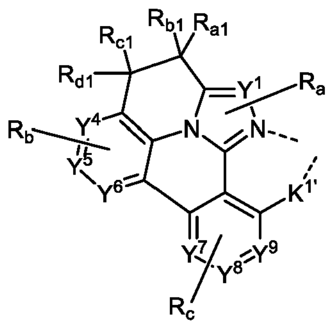,

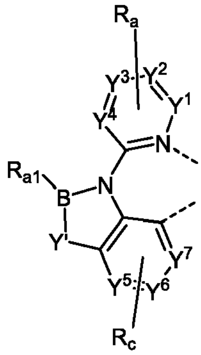, 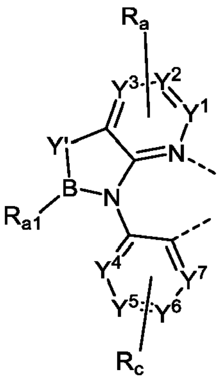, 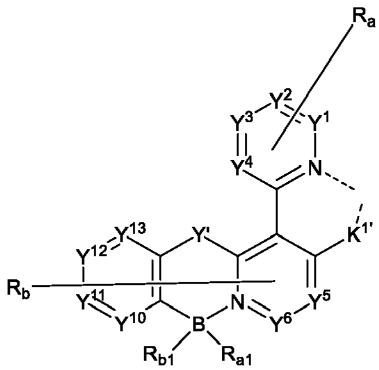, and 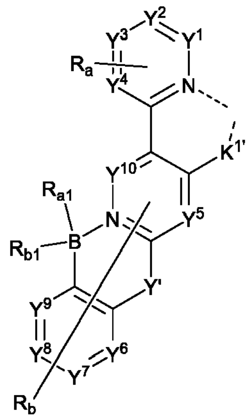;

wherein $L^2$ and $L^3$ are independently selected from the group consisting of

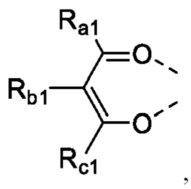,

and the structures of LIGAND LIST; wherein:

T is selected from the group consisting of B, Al, Ga, and In;
$K^{1'}$ is a direct bond or is selected from the group consisting of $NR_e$, $PR_e$, O, S, and Se;
each $Y^1$ to $Y^{13}$ are independently selected from the group consisting of carbon and nitrogen;
Y' is selected from the group consisting of $BR_e$, $NR_e$, $PR_e$, O, S, Se, C=O, S=O, $SO_2$, $CR_eR_f$, $SiR_eR_f$, and $GeR_eR_f$;
$R_e$ and $R_f$ can be fused or joined to form a ring;
each $R_a$, $R_b$, $R_c$, and $R_d$ can independently represent from mono to the maximum possible number of substitutions, or no substitution;
each $R_{a1}$, $R_{b1}$, $R_{c1}$, $R_{d1}$, $R_a$, $R_b$, $R_c$, $R_d$, $R_e$, and $R_f$ is independently a hydrogen or a substituent selected from the group consisting of the General Substituents as defined herein; and
any two of $R_{a1}$, $R_{b1}$, $R_{c1}$, $R_{d1}$, $R_a$, $R_b$, $R_c$, and $R_d$ can be fused or joined to form a ring or form a multidentate ligand.

In some embodiments, the metal in formula $M(L^1)_x(L^2)_y(L^3)_z$ is selected from the group consisting of Cu, Ag, or Au.

In some embodiments, the sensitizer compound has a formula selected from the group consisting of $Ir(L_A)_3$, $Ir(L_A)(L_B)_2$, $Ir(L_A)_2(L_B)$, $Ir(L_A)_2(L_C)$, $Ir(L_A)(L_B)(L_C)$, and $Pt(L_A)(L_B)$;

wherein $L_A$, $L_B$, and $L_C$ are different from each other in the Ir compounds;

wherein $L_A$ and $L_B$ can be the same or different in the Pt compounds; and
wherein $L_A$ and $L_B$ can be connected to form a tetradentate ligand in the Pt compounds.

In some embodiments, at least one of the compounds S1 and S2 comprises at least one electron-withdrawing group. In some such embodiments, the electron-withdrawing groups commonly comprise one or more highly electronegative elements including but not limited to fluorine, oxygen, sulfur, nitrogen, chlorine, and bromine. In some such embodiments, the electron-withdrawing group has a Hammett constant larger than 0. In some such embodiments, the electron-withdrawing group has a Hammett constant equal or larger than 0.1, 0.2, 0.3, 0.4, 0.5, 0.6, 0.7, 0.8, 0.9, 1.0, or 1.1.

In some such embodiments, the electron-withdrawn group is selected from the group consisting of the structures in the following LIST EWG 1: F, $CF_3$, CN, $COCH_3$, CHO, $COCF_3$, COOMe, $COOCF_3$, $NO_2$, $SF_3$, $SiF_3$, $PF_4$, $SF_5$, $OCF_3$, $SCF_3$, $SeCF_3$, $SOCF_3$, $SeOCF_3$, $SO_2F$, $SO_2CF_3$, $SeO_2CF_3$, $OSeO_2CF_3$, OCN, SCN, SeCN, NC, $^+N(R^{k2})_3$, $(R^{k2})_2CCN$, $(R^{k2})_2CCF_3$, $CNC(CF_3)_2$, $BR^{k3}R^{k2}$, substituted or unsubstituted dibenzoborole, 1-substituted carbazole, 1,9-substituted carbazole, substituted or unsubstituted carbazole, substituted or unsubstituted pyridine, substituted or unsubstituted pyrimidine, substituted or unsubstituted pyrazine, substituted or unsubstituted pyridoxine, substituted or unsubstituted triazine, substituted or unsubstituted oxazole, substituted or unsubstituted benzoxazole, substituted or unsubstituted thiazole, substituted or unsubstituted benzothiazole, substituted or unsubstituted imidazole, substituted or unsubstituted benzimidazole, ketone, carboxylic acid, ester, nitrile, isonitrile, sulfinyl, sulfonyl, partially and fully fluorinated alkyl, partially and fully fluorinated aryl, partially and fully fluorinated heteroaryl, cyano-containing alkyl, cyano-containing aryl, cyano-containing heteroaryl, isocyanate,

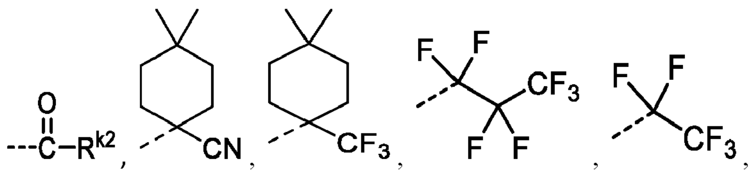
, , , , ,

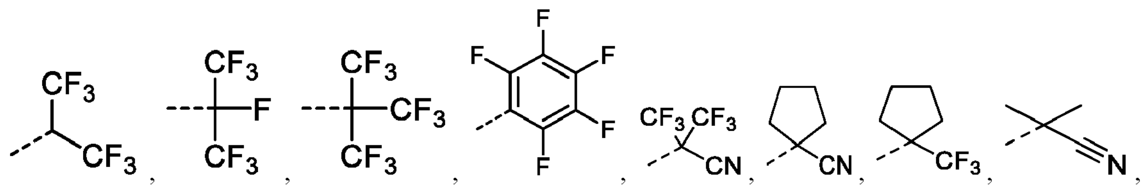
, , , , , , , , ,

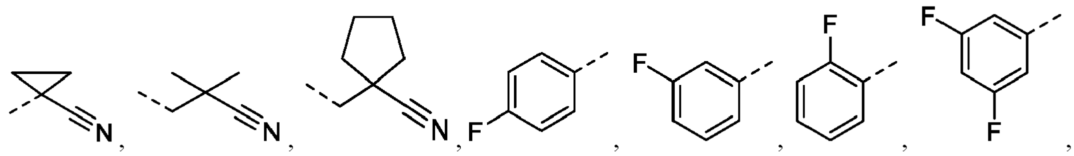
, , , , , , ,

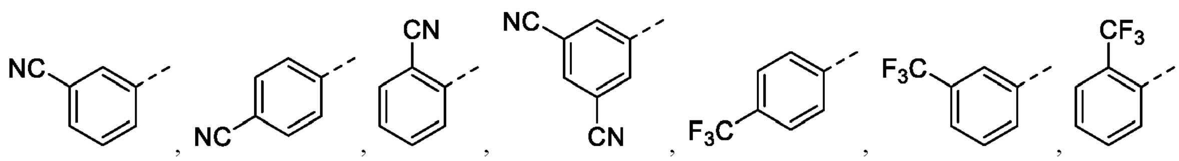
, , , , , , , ,

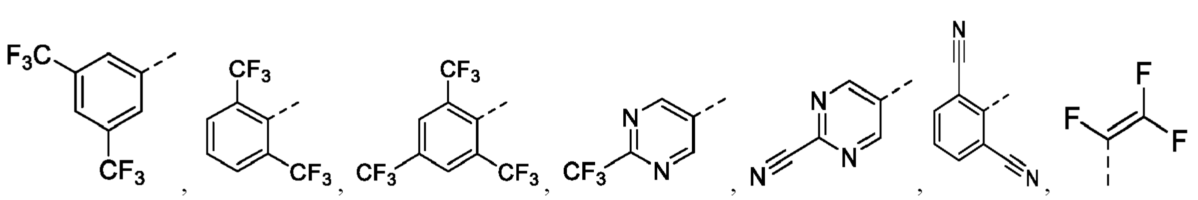
, , , , , , ,

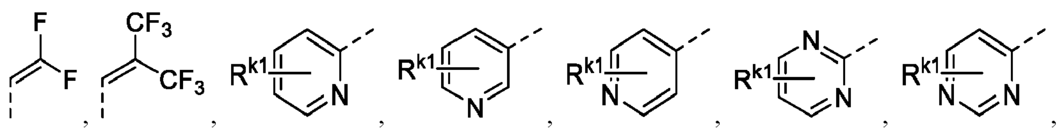
, , , , , , ,

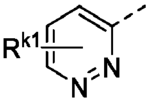, 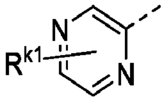, 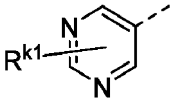, 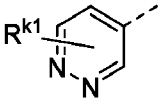, 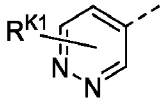, 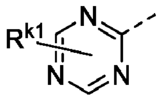, 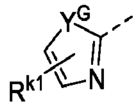

, 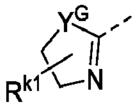, 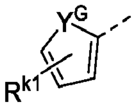, and 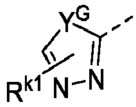;

wherein $Y^G$ is selected from the group consisting of $BR_e$, $NR_e$, $PR_e$, O, S, Se, C=O, S=O, $SO_2$, $CR_eR_f$, $SiR_eR_f$, and $GeR_eR_f$; and

$R^{k1}$ each independently represents mono to the maximum allowable substitutions, or no substitution;

wherein each of $R^{k1}$, $R^{k2}$, $R^{k3}$, $R_e$, and $R_f$ is independently a hydrogen or a substituent selected from the group consisting of the General Substituents defined herein.

In some embodiments of the OLED, the sensitizer compound is selected from the group consisting of the compounds in the following SENSITIZER LIST:

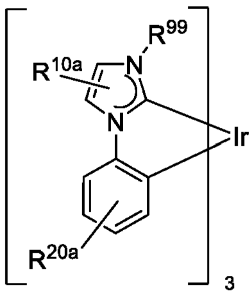, 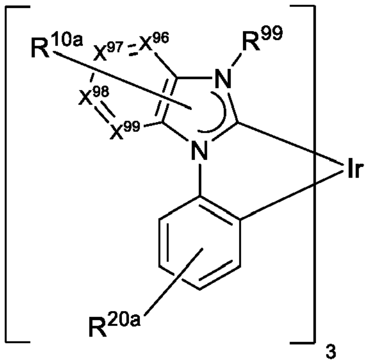, 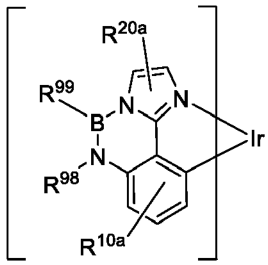,

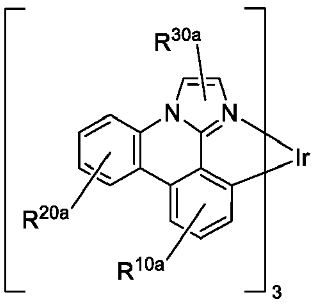, 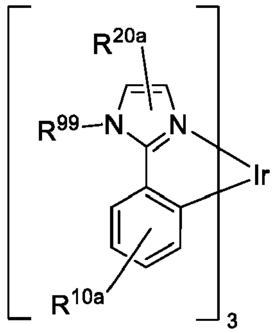, 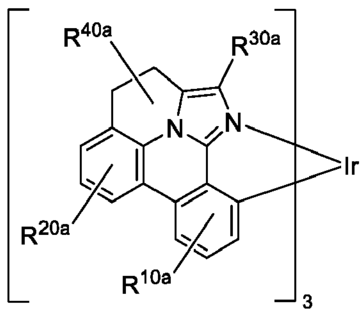,

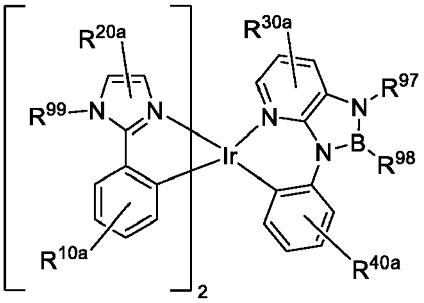, 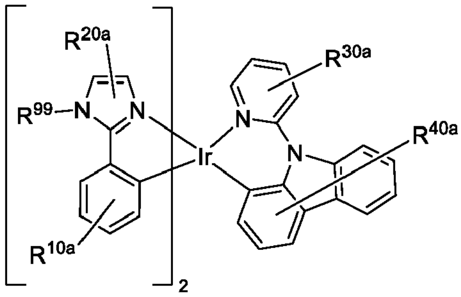,

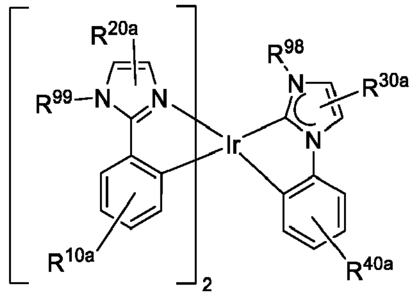,
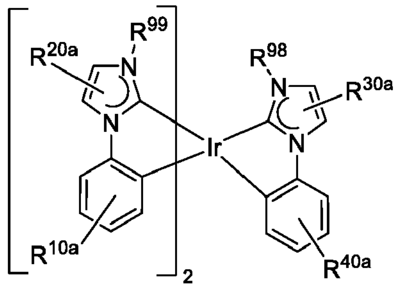,

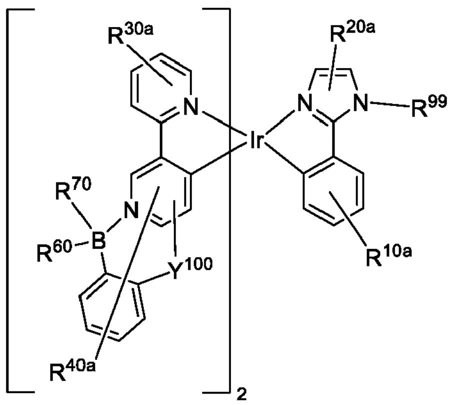,
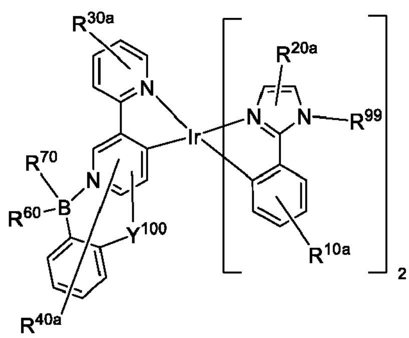,

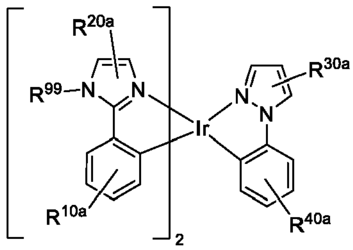,
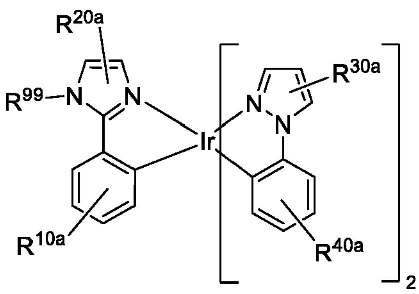,

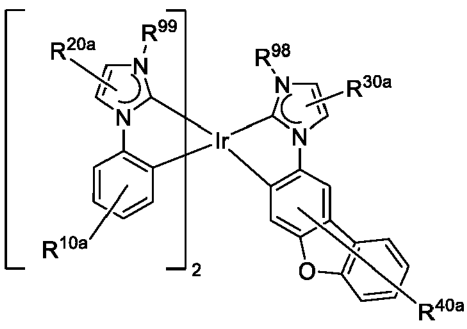,
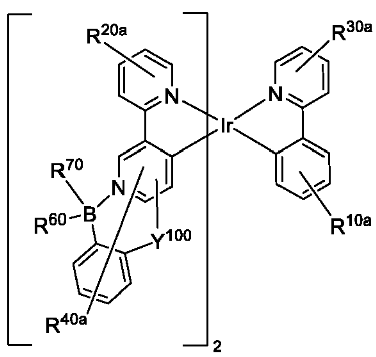,

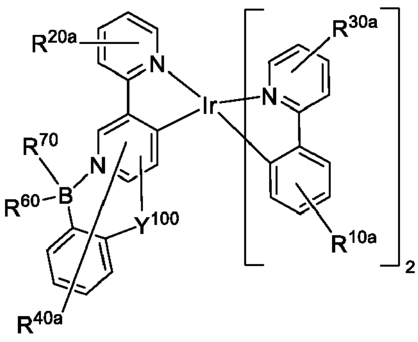, 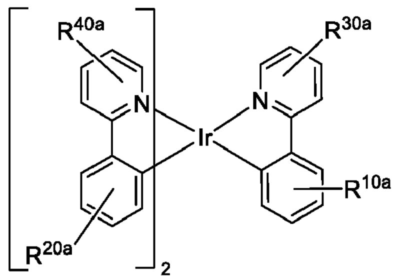,

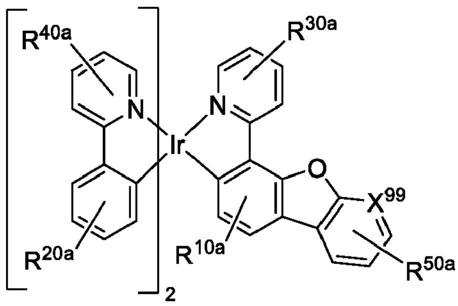, 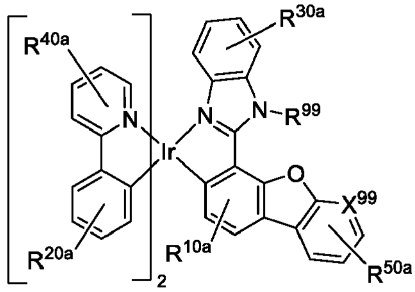,

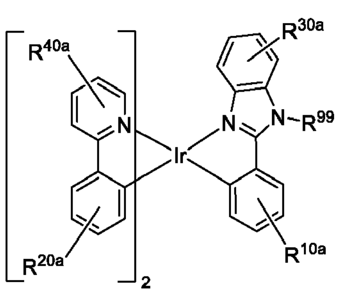, 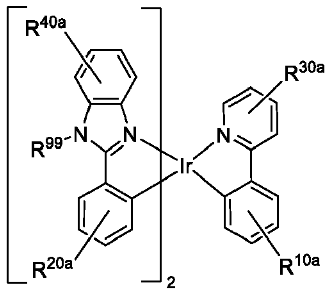, 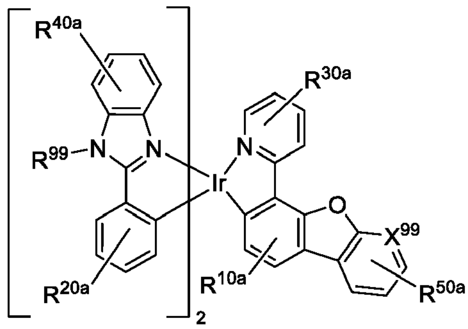,

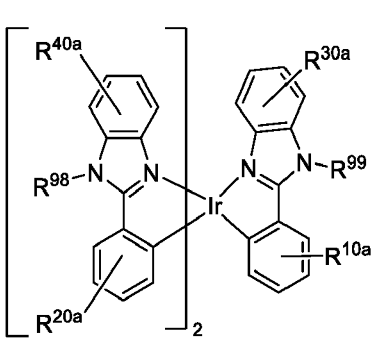, 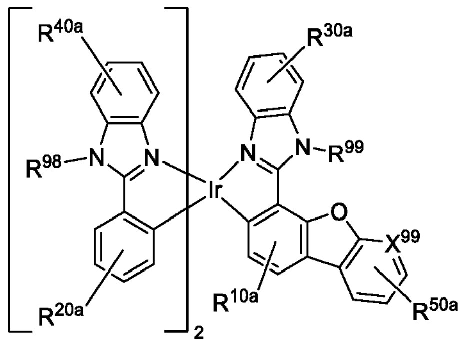,

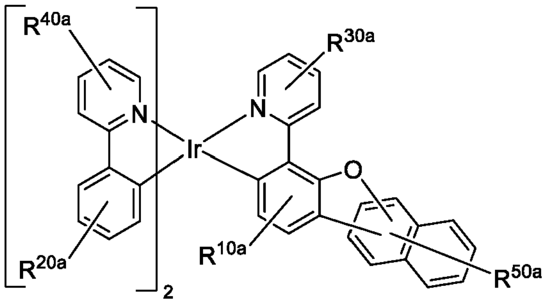 , 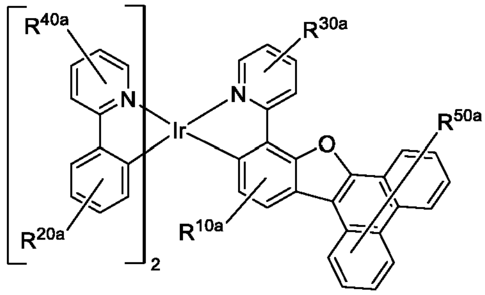 ,

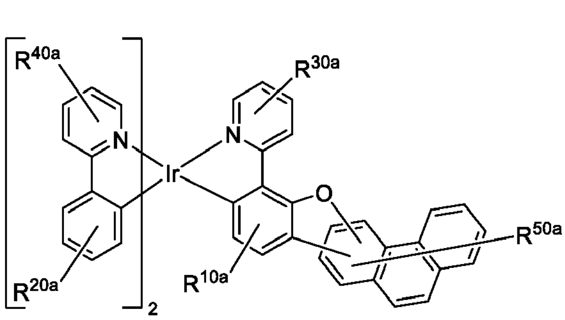 , 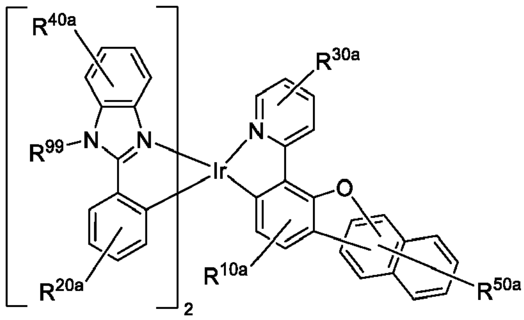 ,

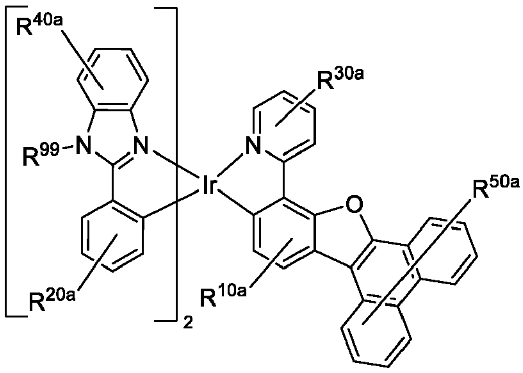 , 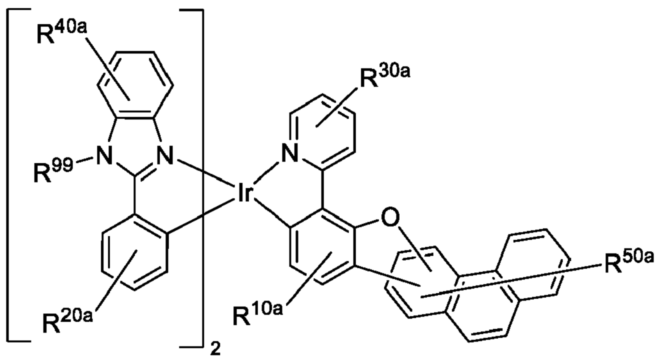 ,

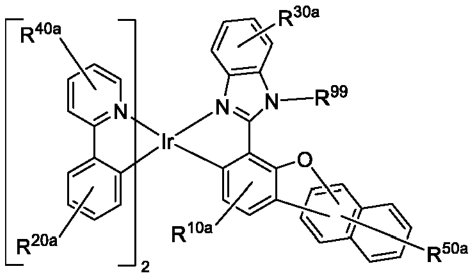 , 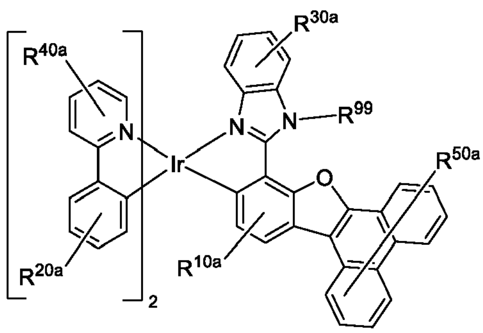 ,

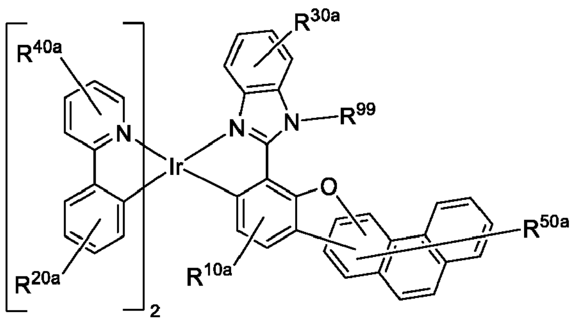
,
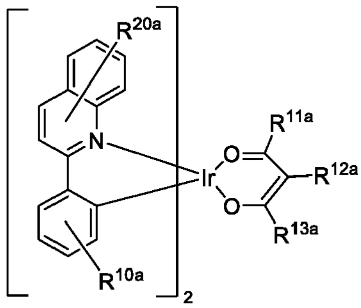
,

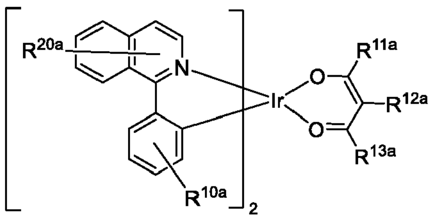
,
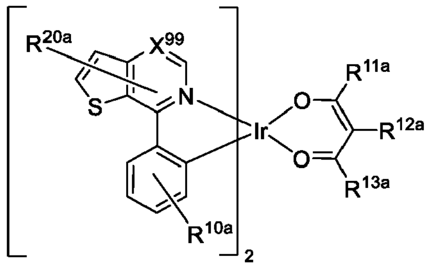
,

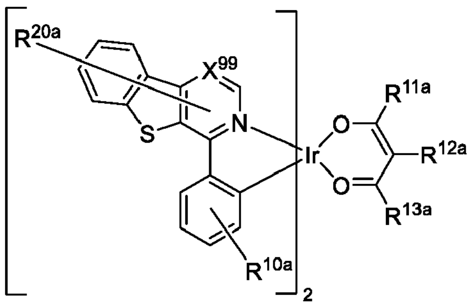
,
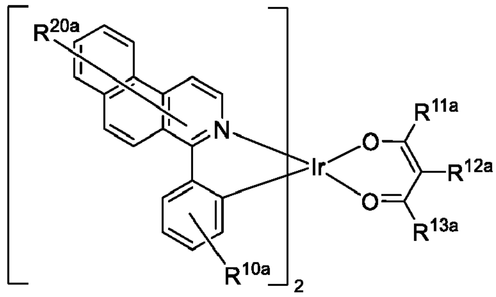

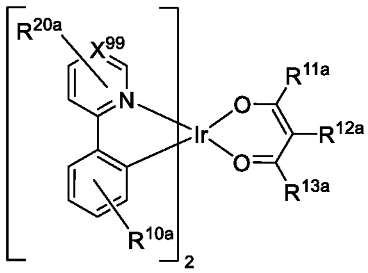
,
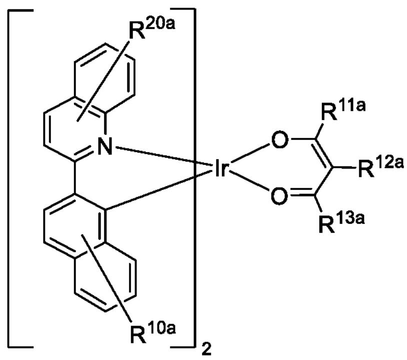
,

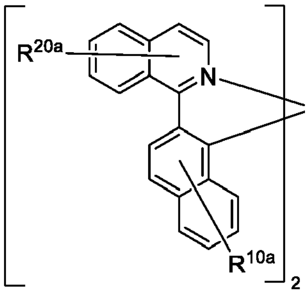,

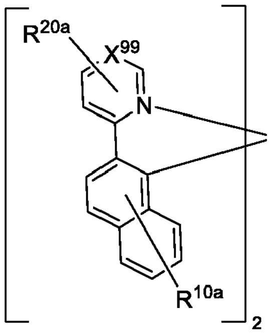,

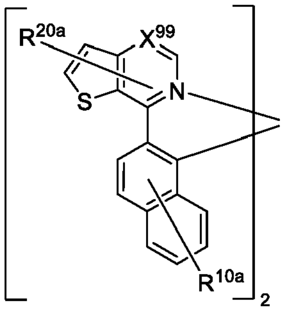,

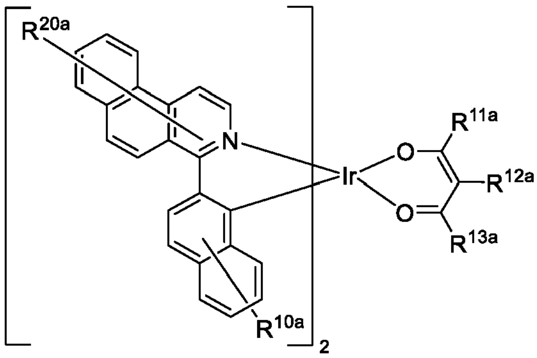,

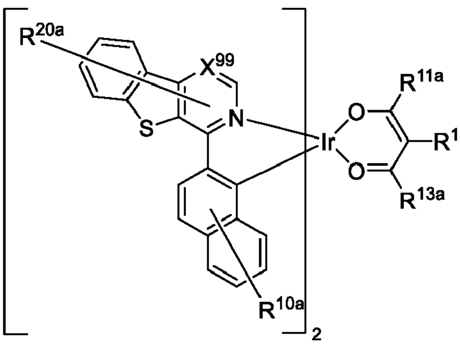,

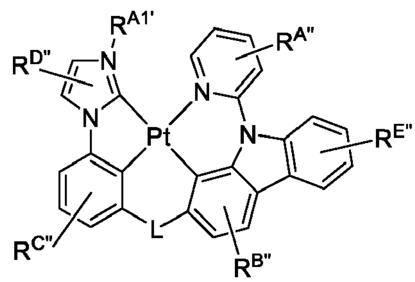,

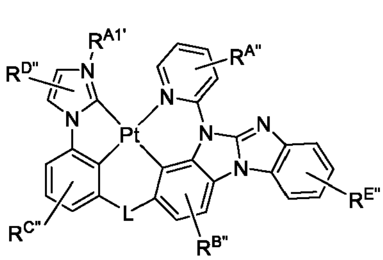,

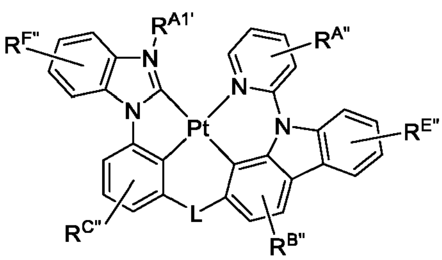,

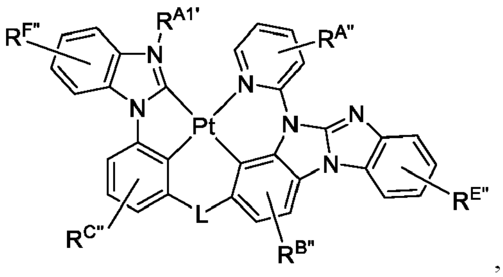,
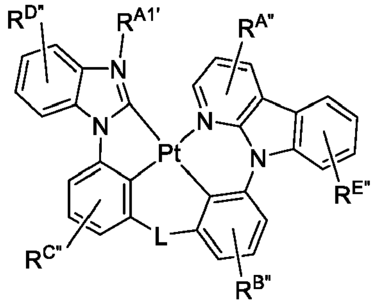,

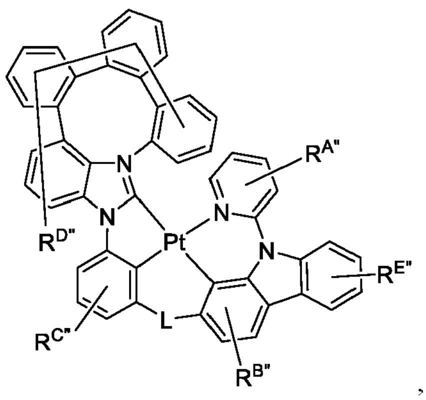,
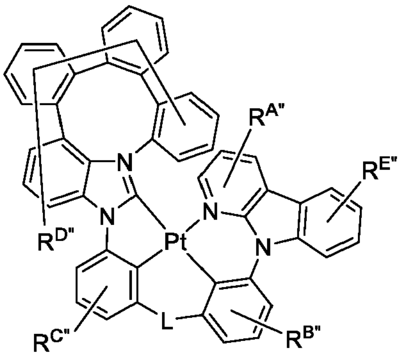,

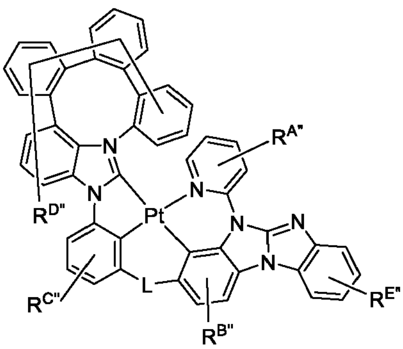,
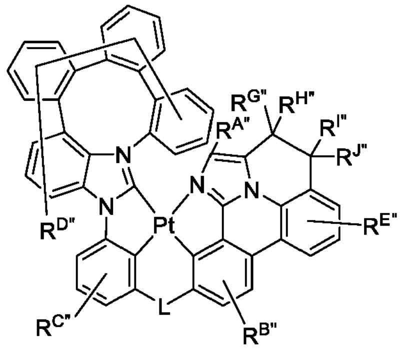,
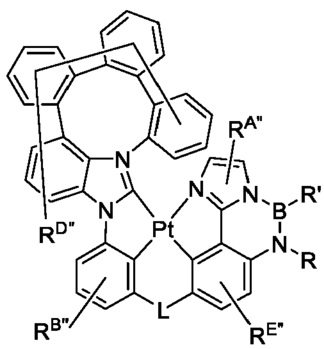,

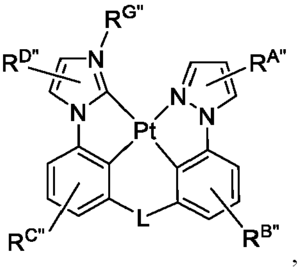,
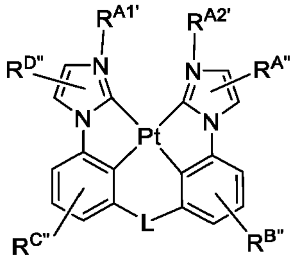,
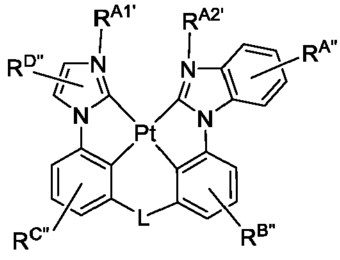,

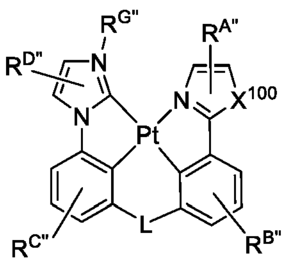 , 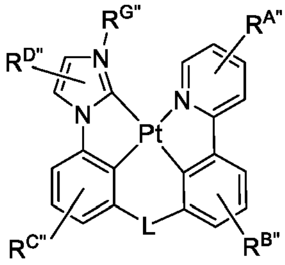 , 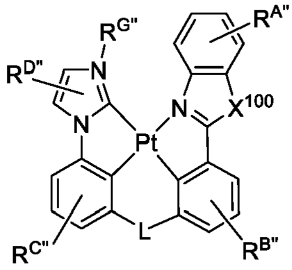 ,

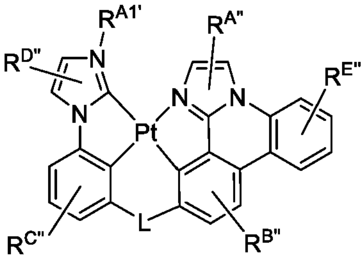 , 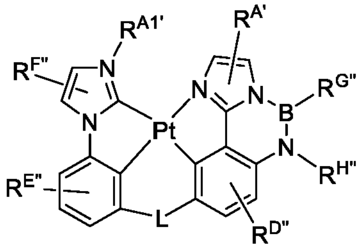 , 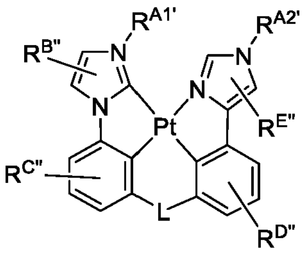 ,

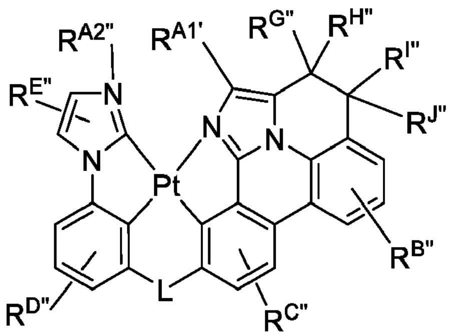 , 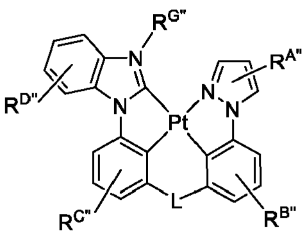 , 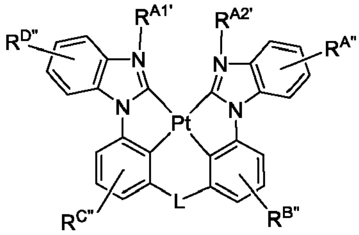 ,

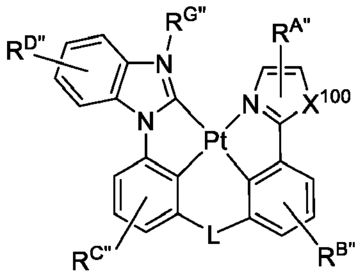 , 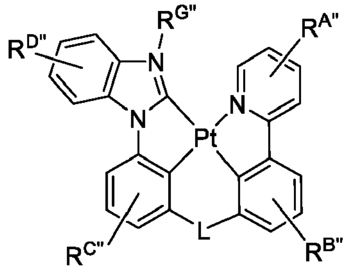 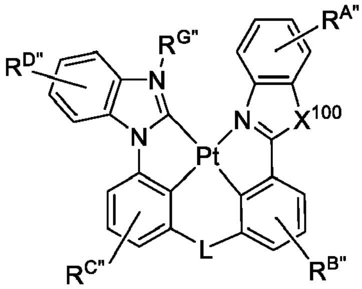 ,

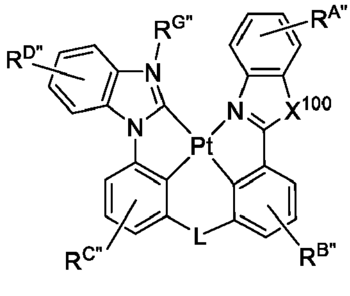 , 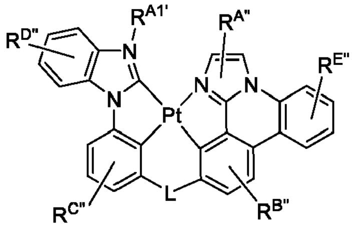 , 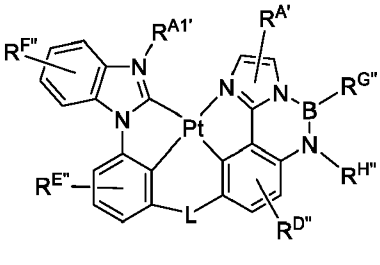 ,

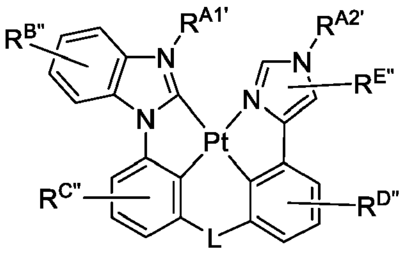,
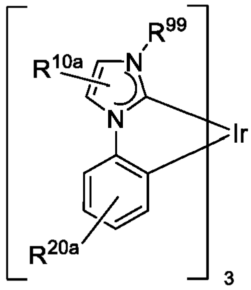,
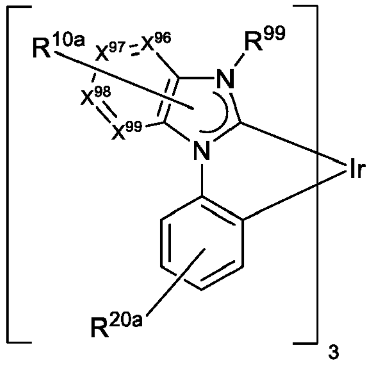,

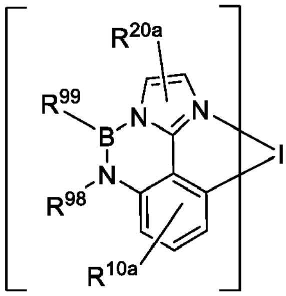,
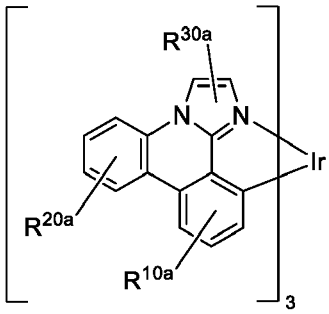,
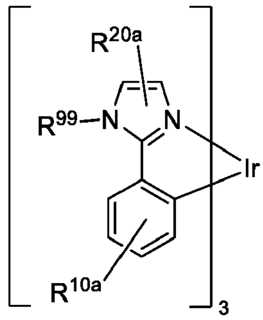,

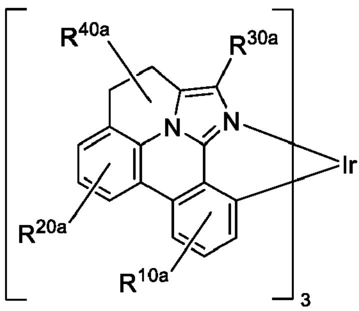,
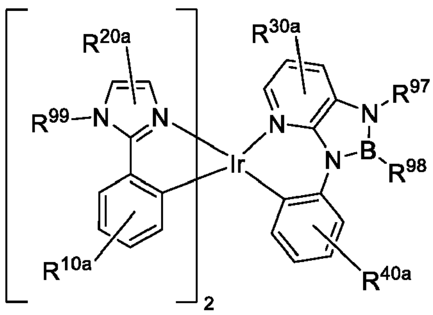,

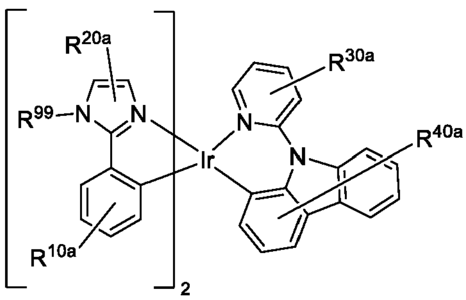,
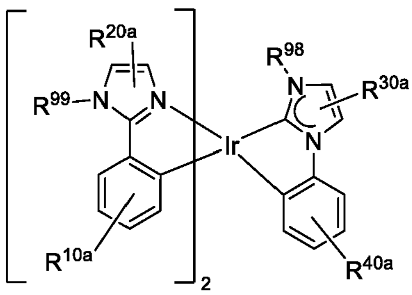,

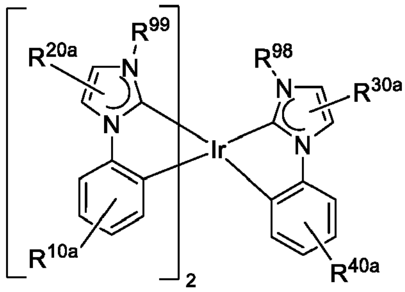, 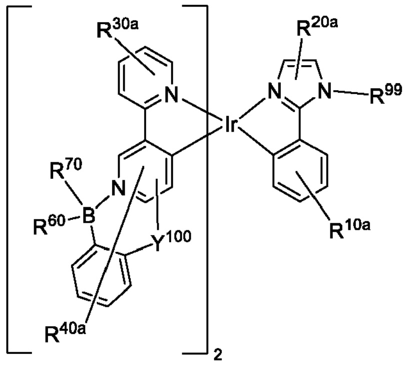,

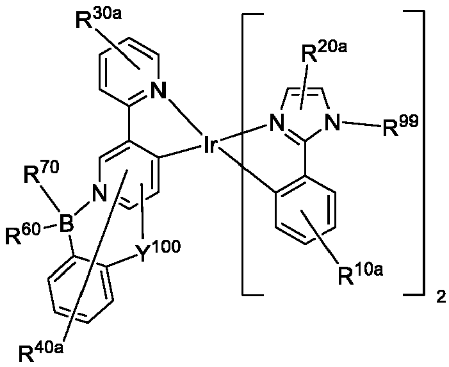, 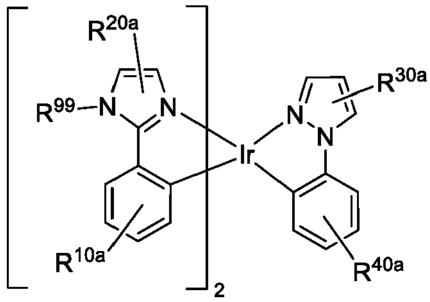,

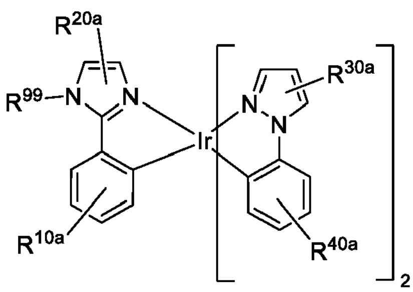, 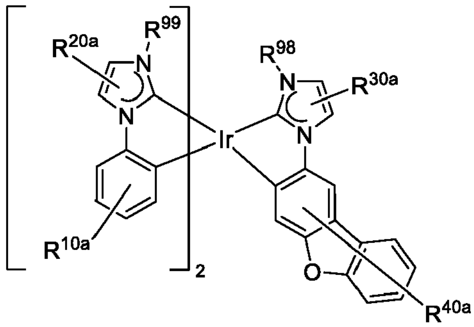,

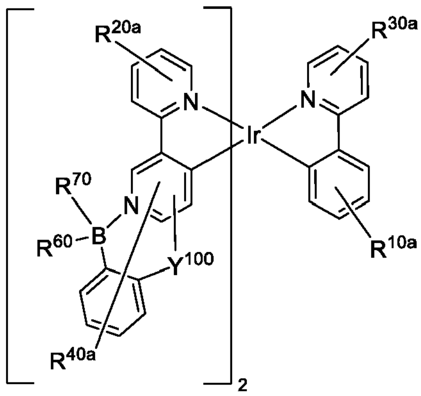, 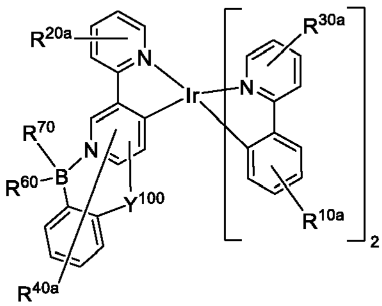,

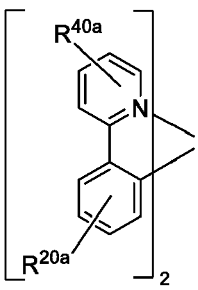 , 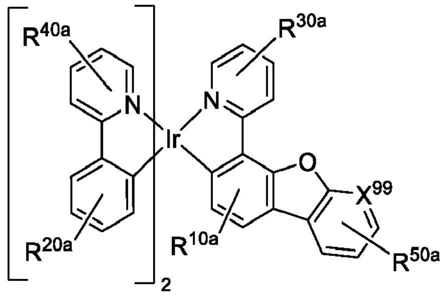 ,

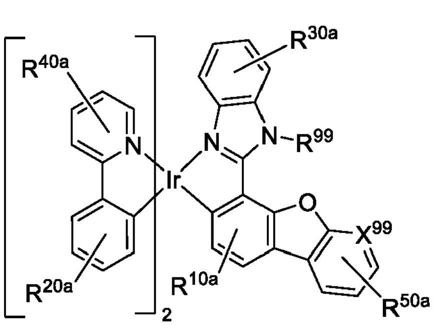 , 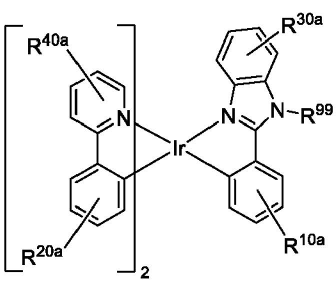 , 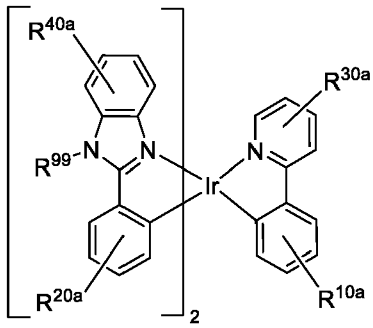 ,

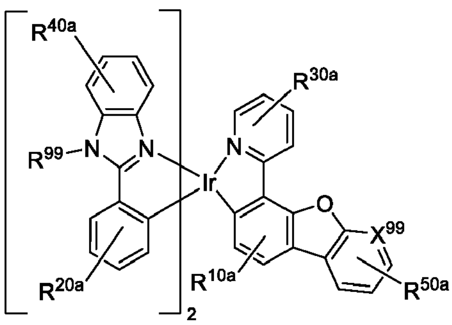 , 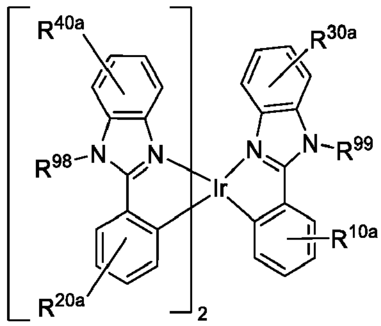 ,

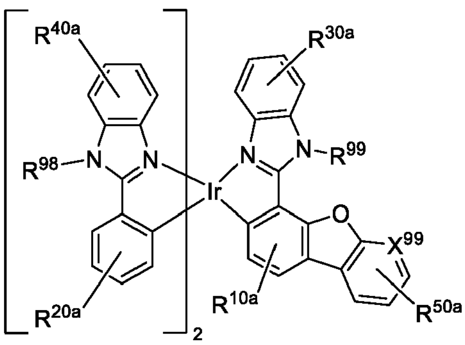 , 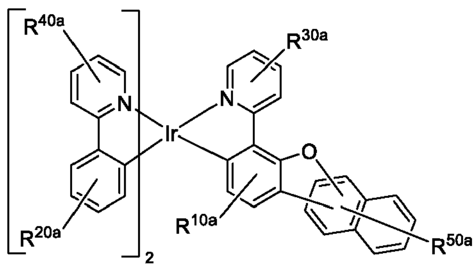 ,

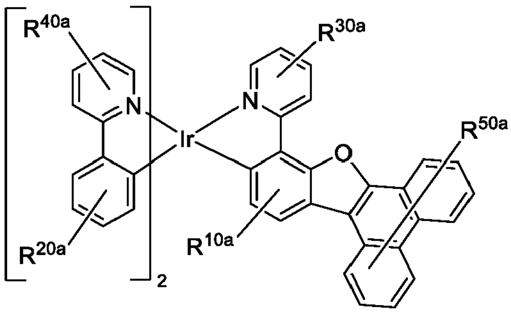
,
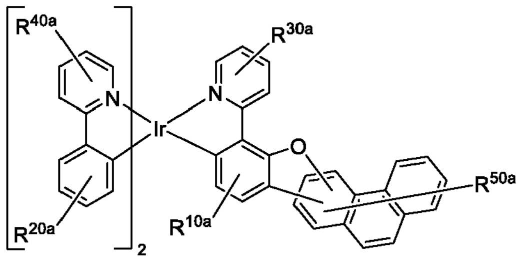
,

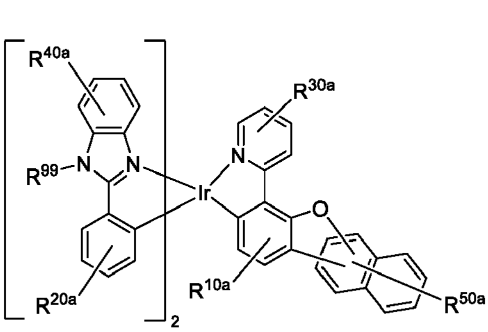
,
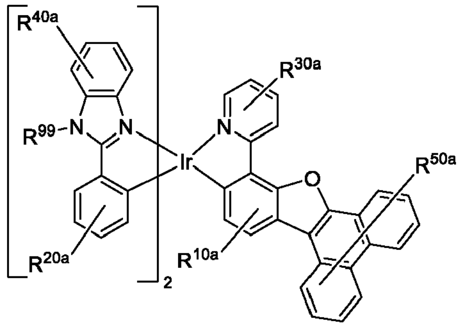
,

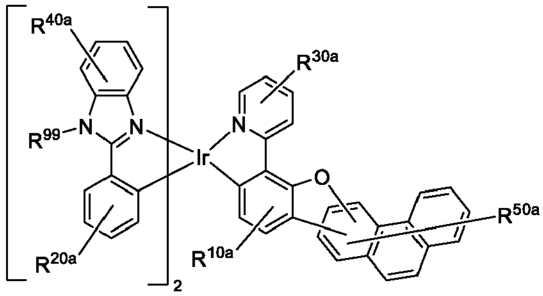
,
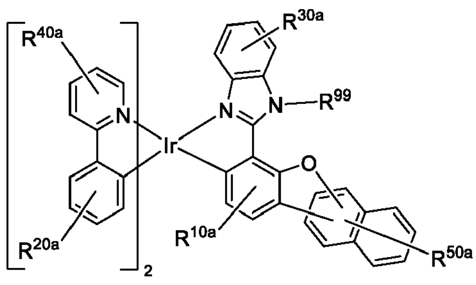
,

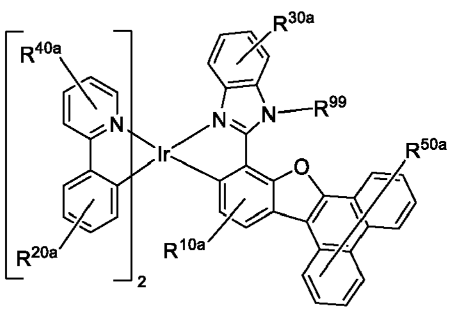
,
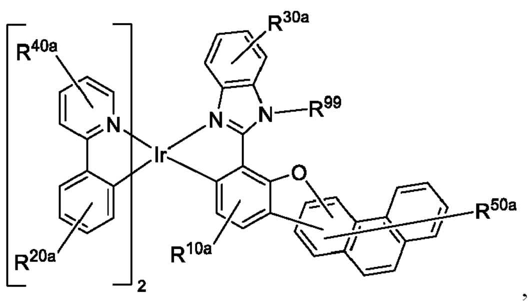
,

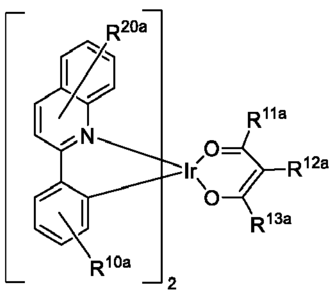
,
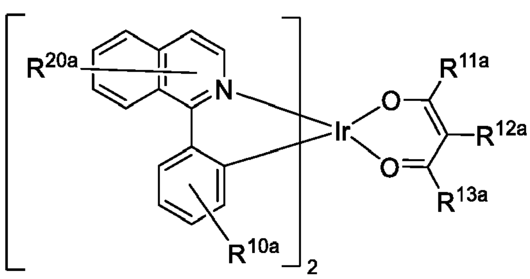
,

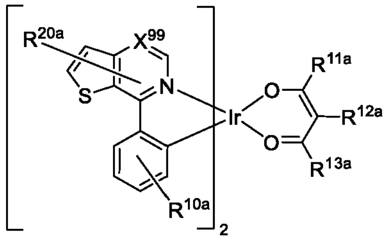
,
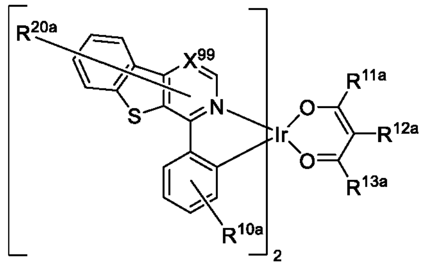
,

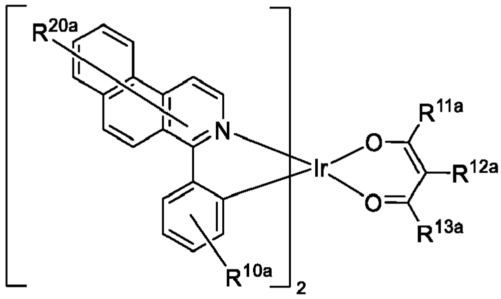
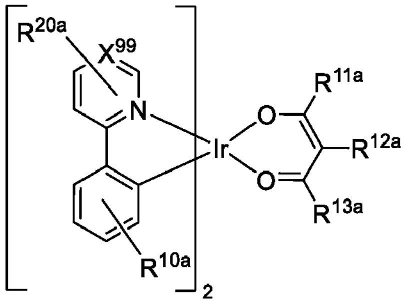
,

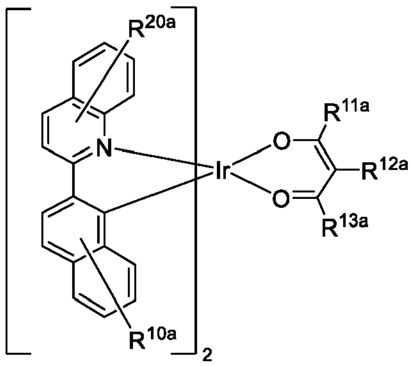
,
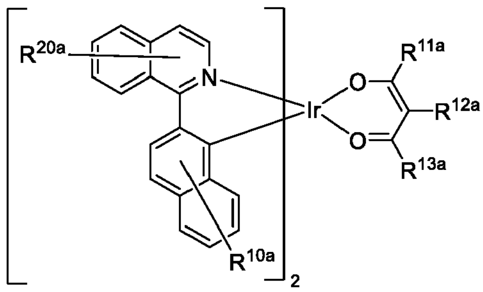
,

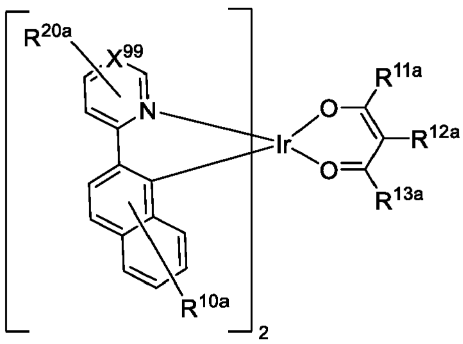
,
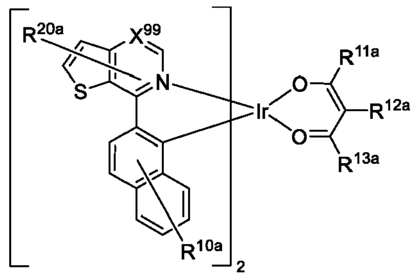
,

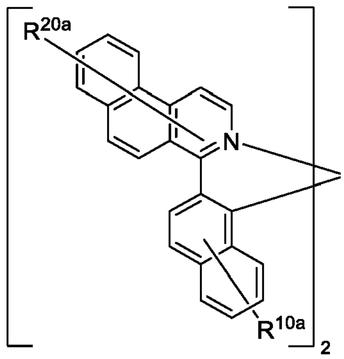

,

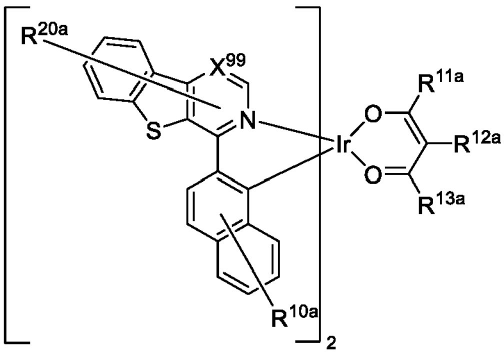

,

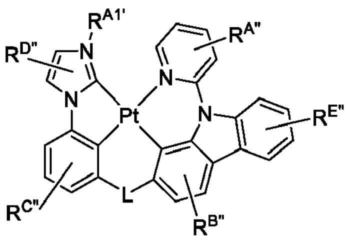

,

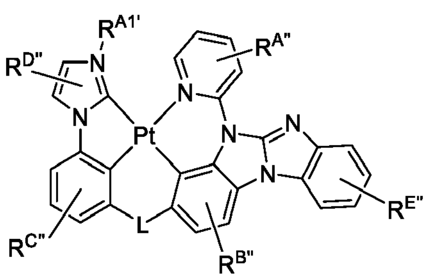

,

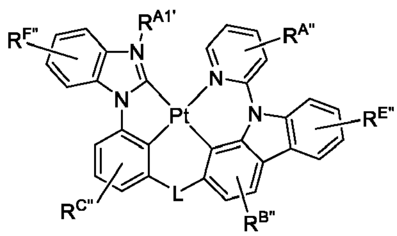

,

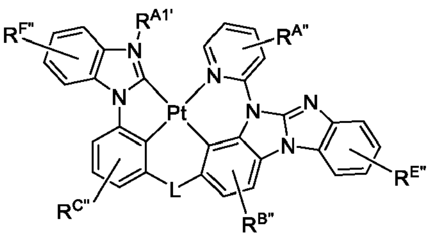

,

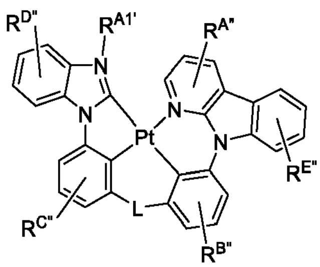

,

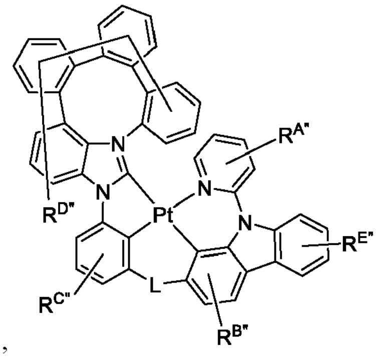

,

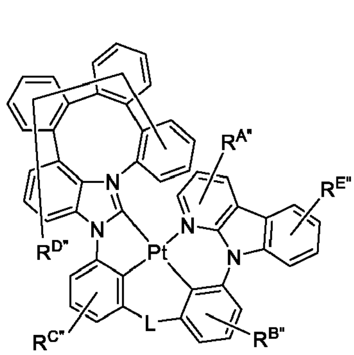

,

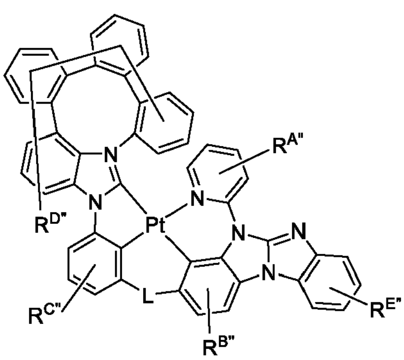

,

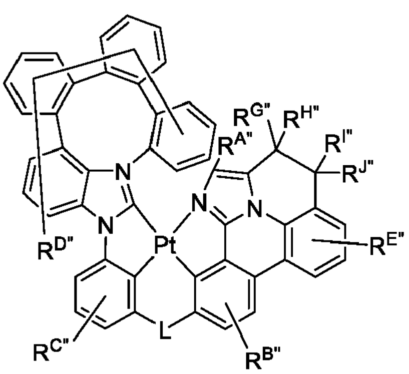

,

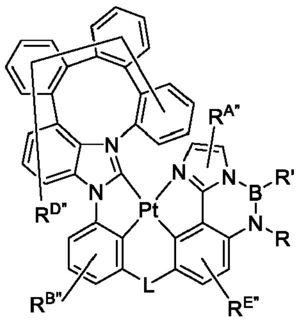,
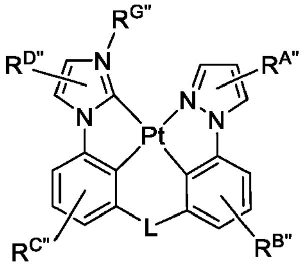,
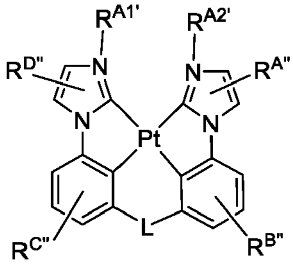,

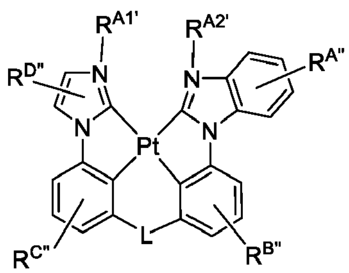,
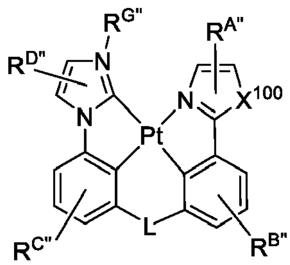,
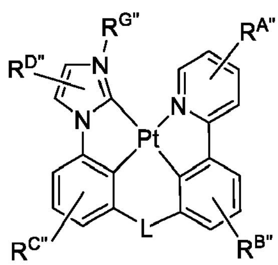,

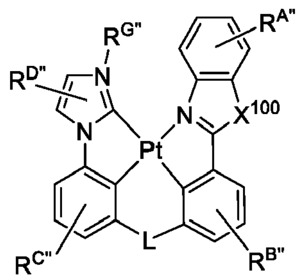,
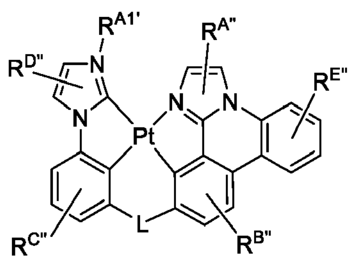,
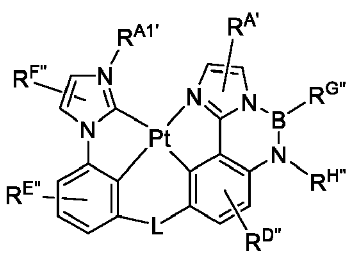,

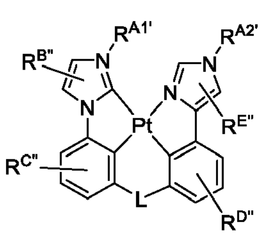,
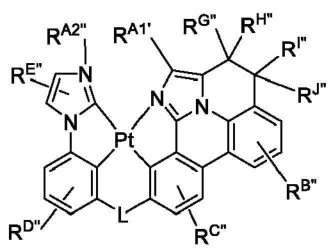,
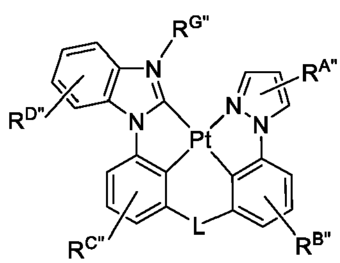,

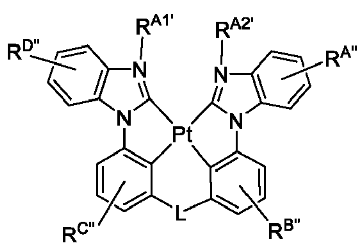,
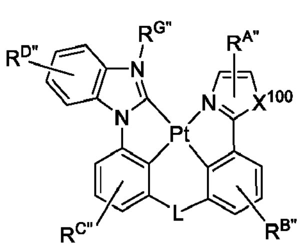,
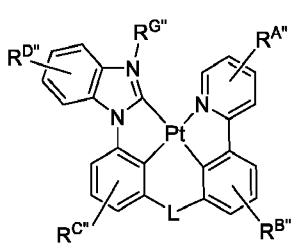

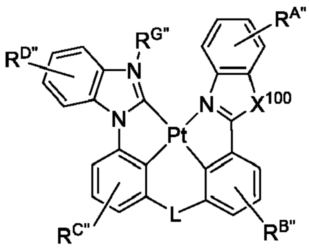,
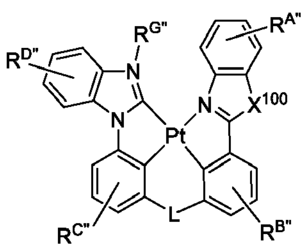,
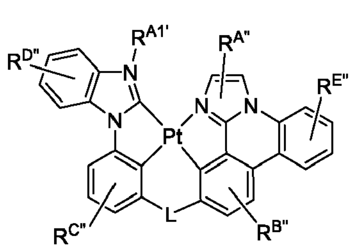,

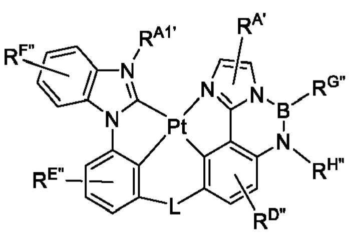,
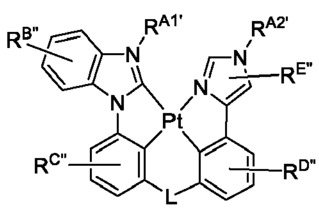,
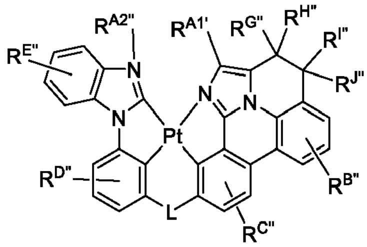,

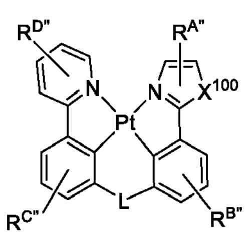,
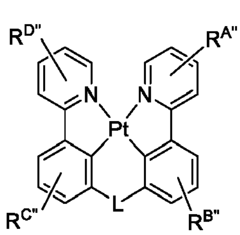,
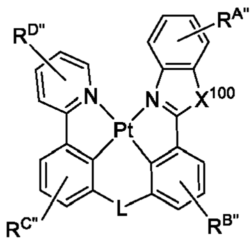,
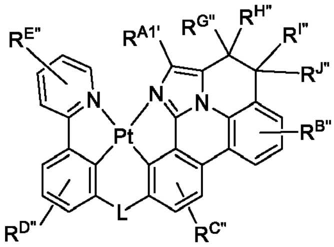,

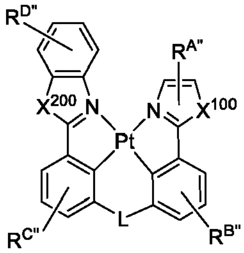,
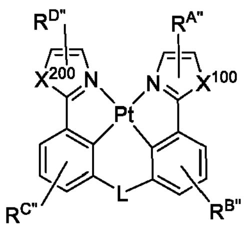,
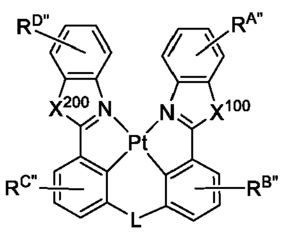,
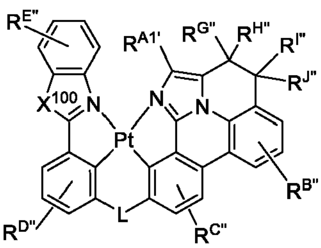,

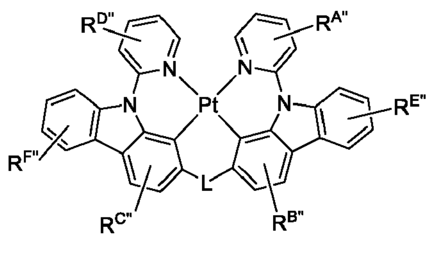,
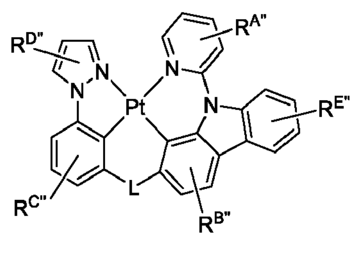,

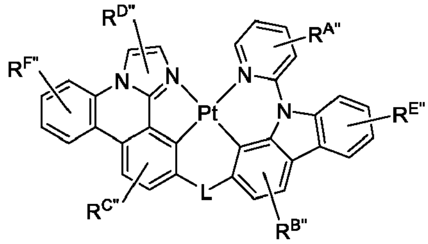,
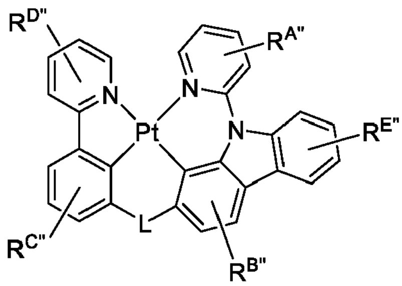,

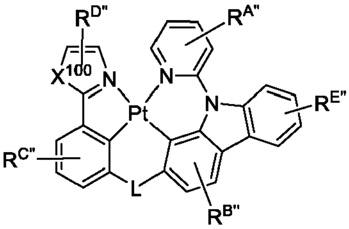,
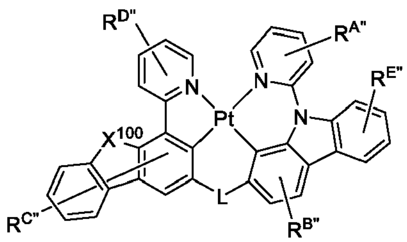,
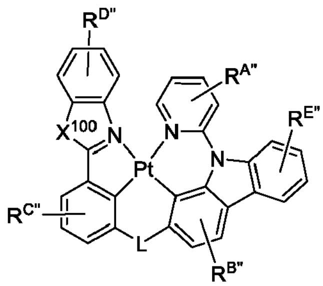,

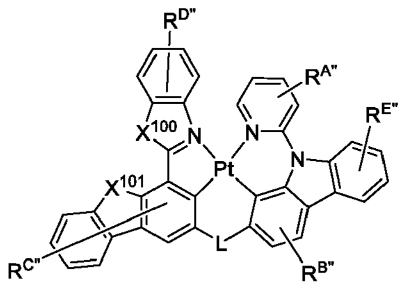,
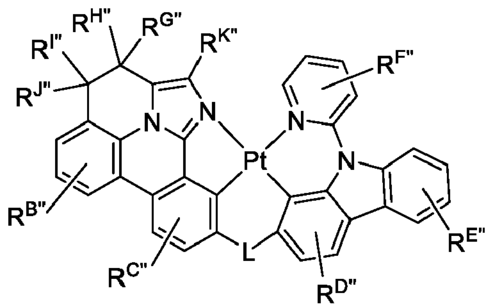,

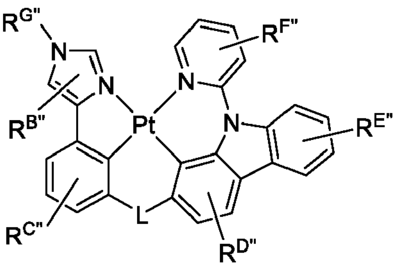,
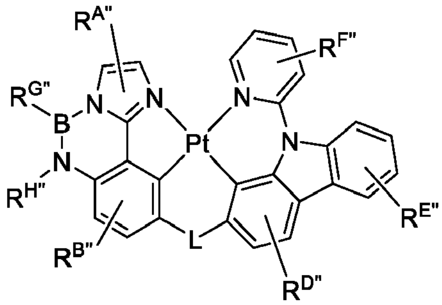,

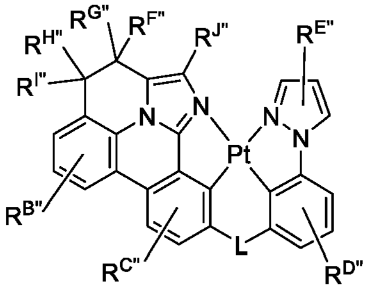,
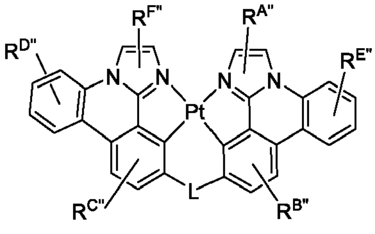,
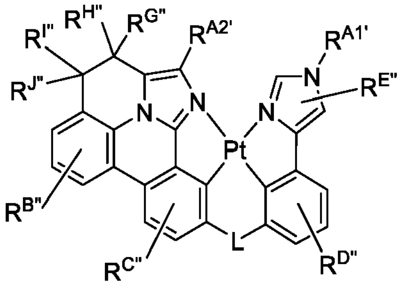,

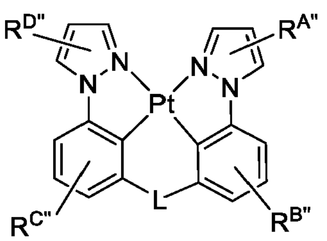,
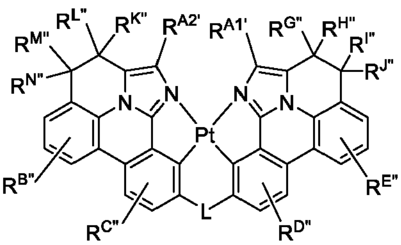,
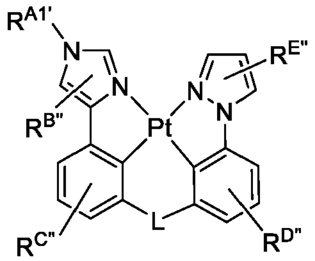,

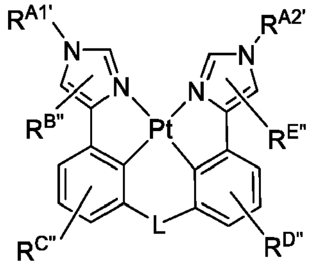,
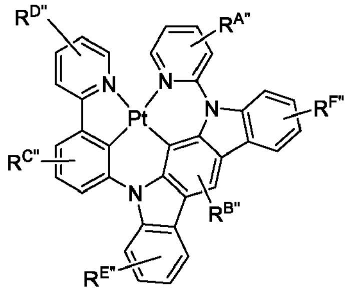,
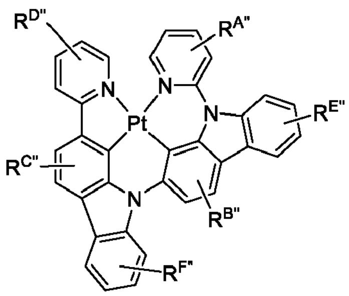,

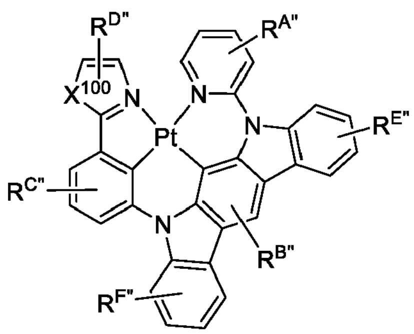,
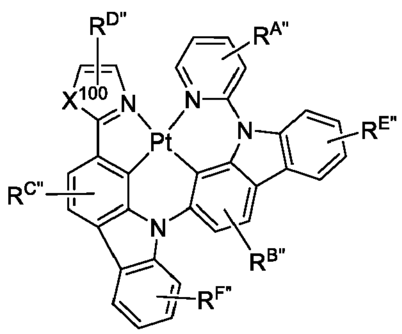,

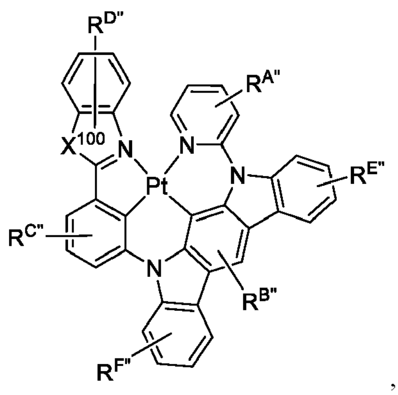,
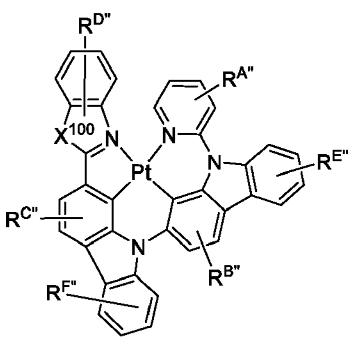,
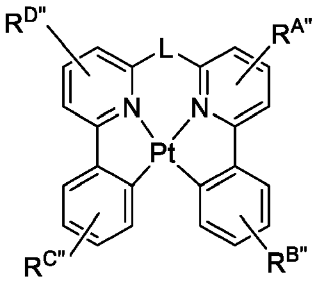,

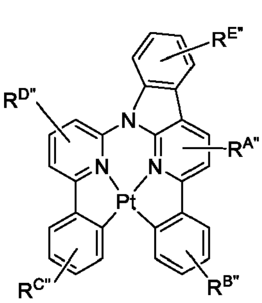,
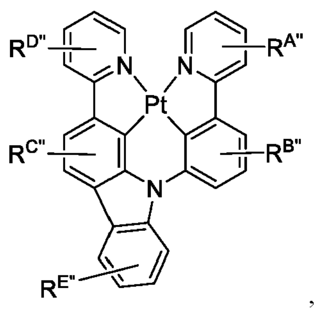,
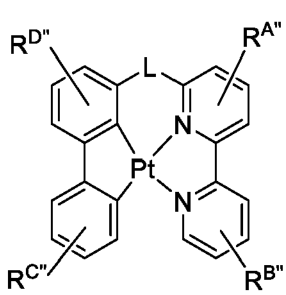,
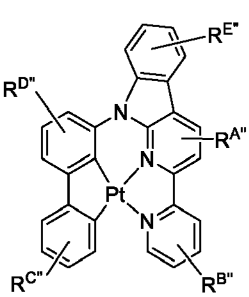,

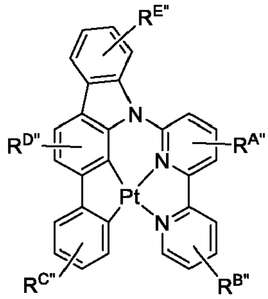 , 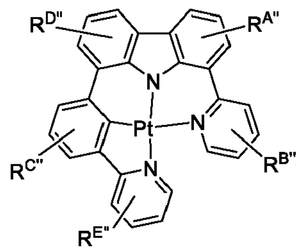 , 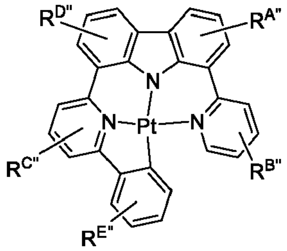 ,

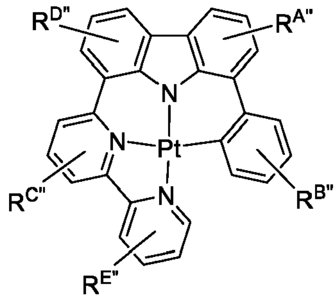 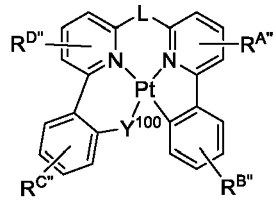 , 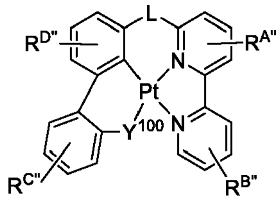 , ,

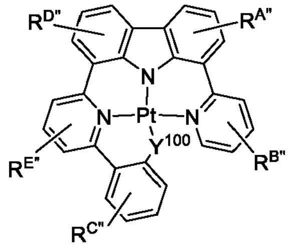 , 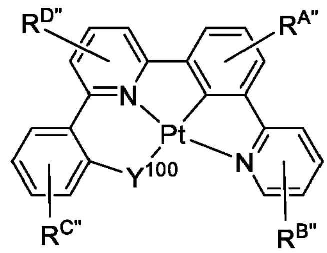 , 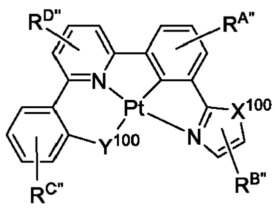 ,

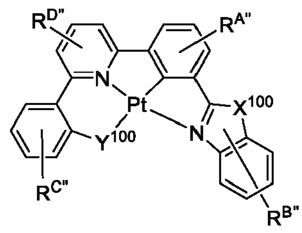 , 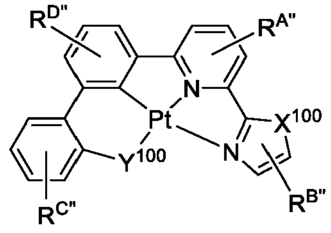 , 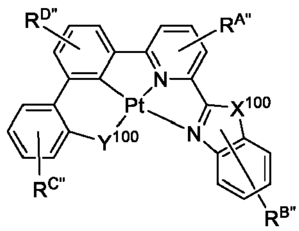 ,

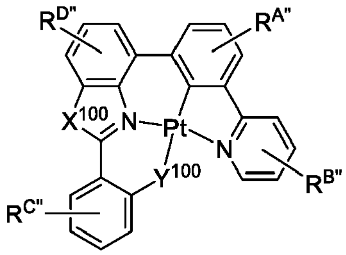 , 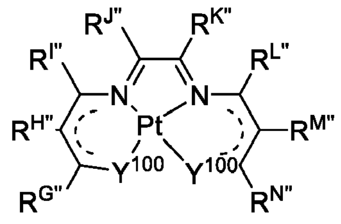 , 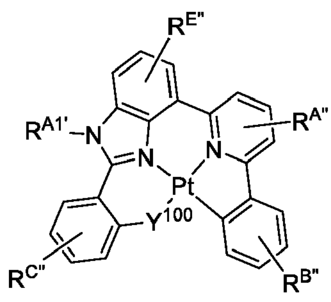 ,

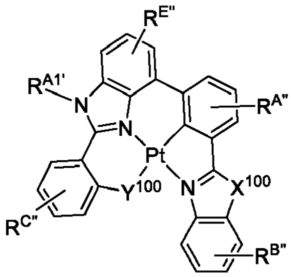,
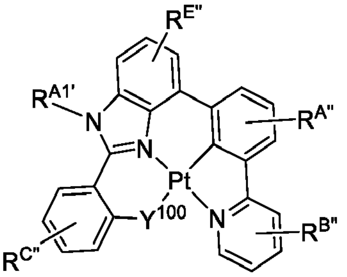,
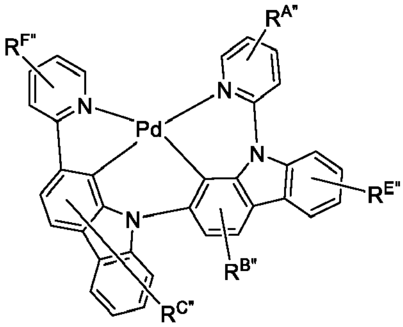,

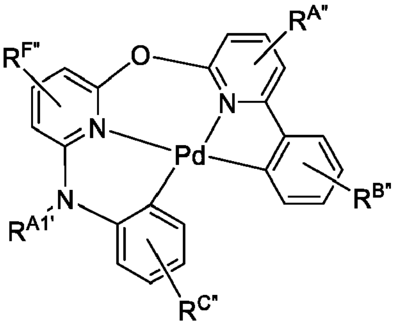, and
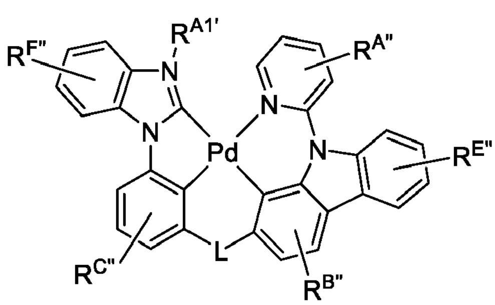,

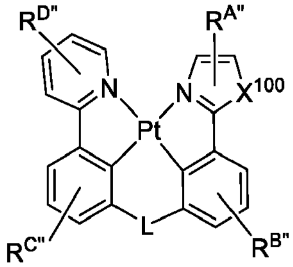,
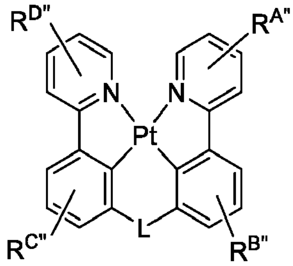,
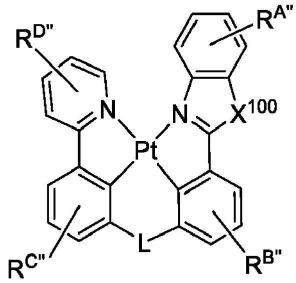,

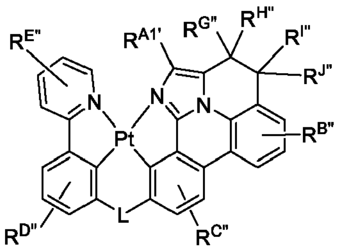,
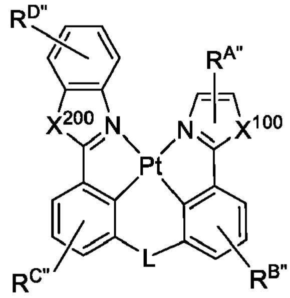,
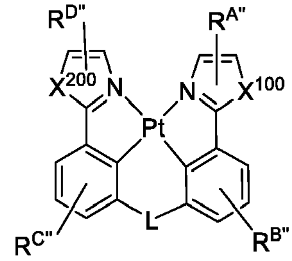,

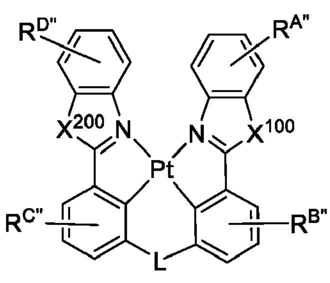,
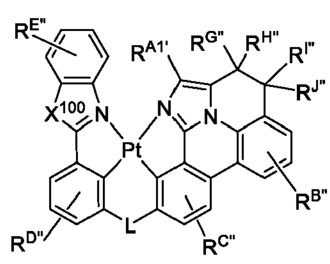,
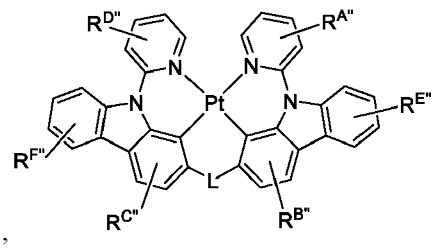,

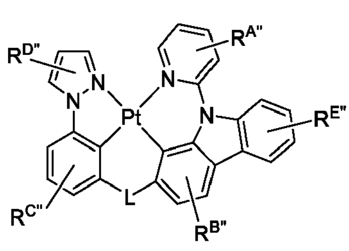 , 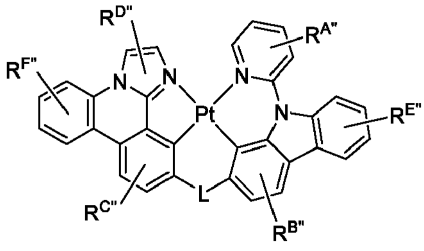 , 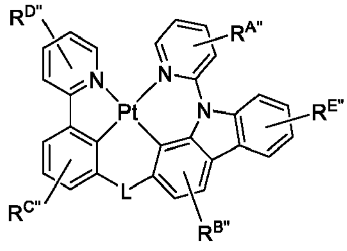 ,

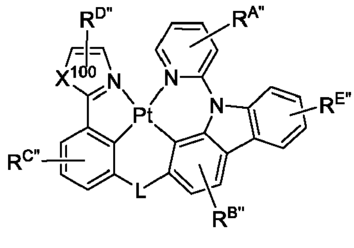 , 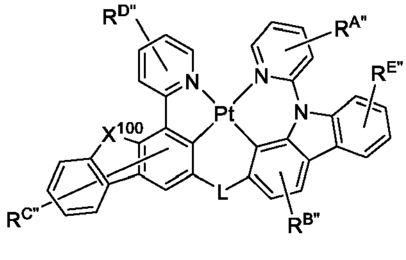 , 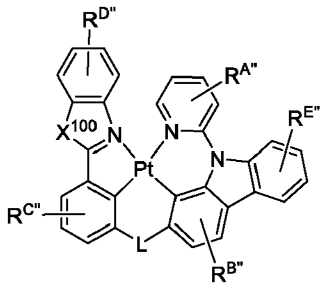 ,

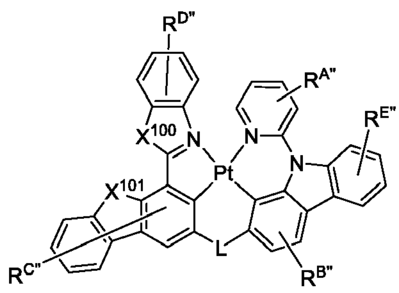 , 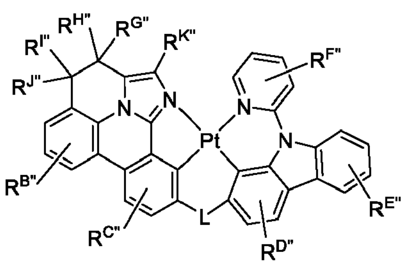 , 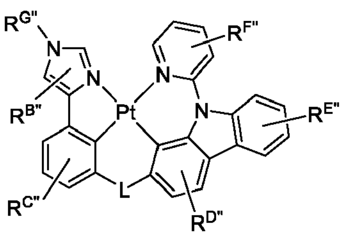 ,

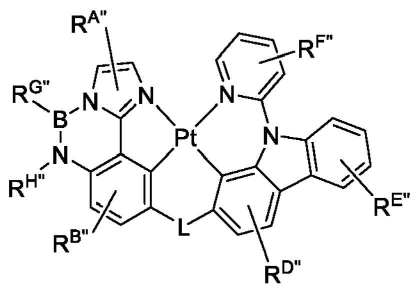 , 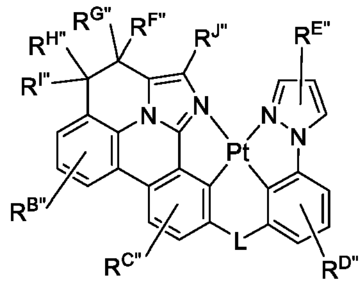 , 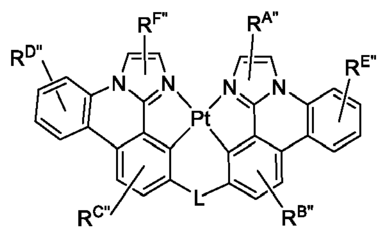 ,

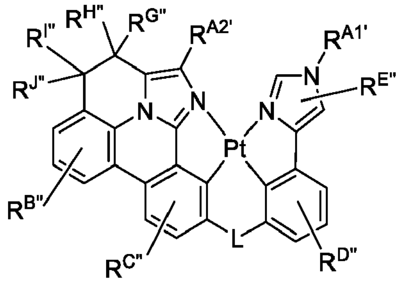 , 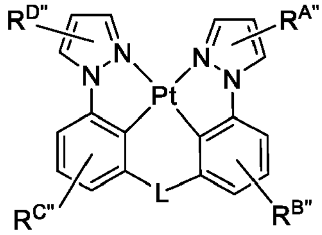 ,

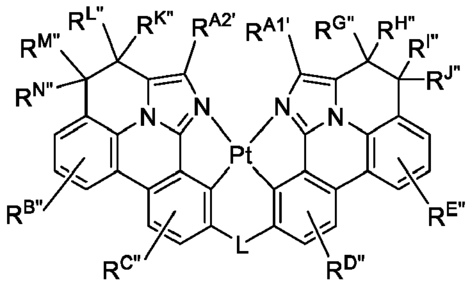 , 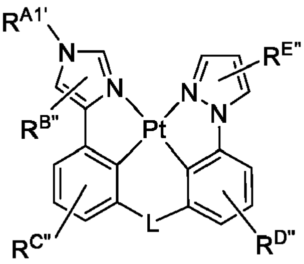 , 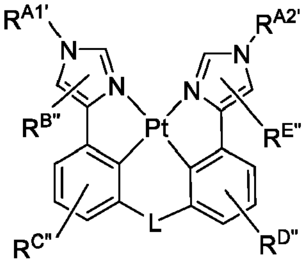 ,

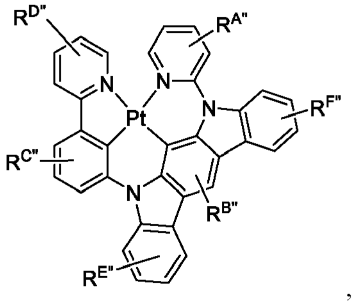 , 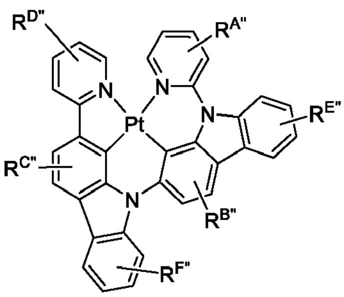 , 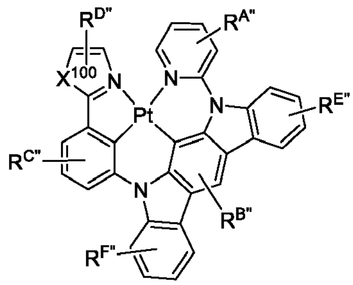 ,

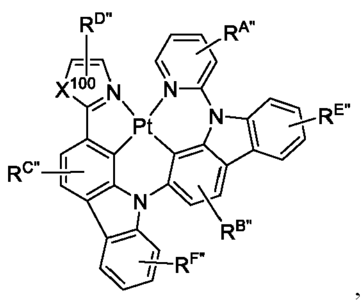 , 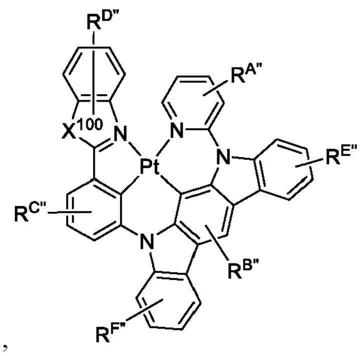 , 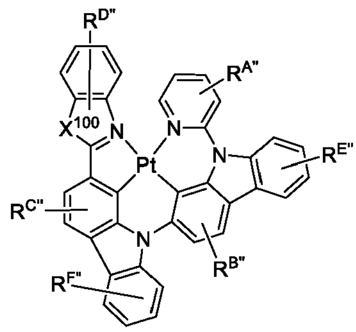 ,

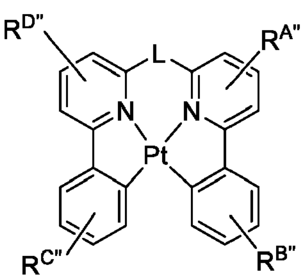 , 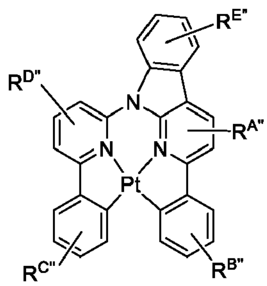 , 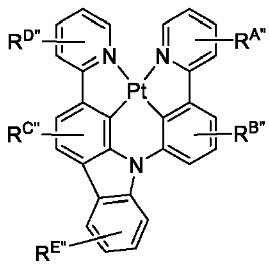 , 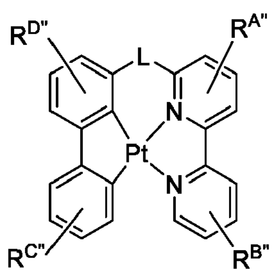 ,

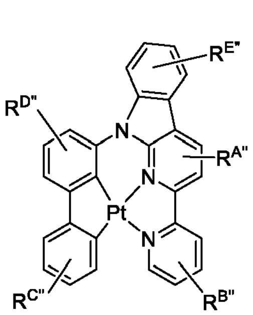 , 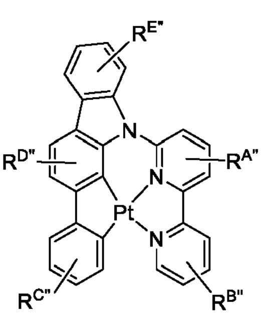 , 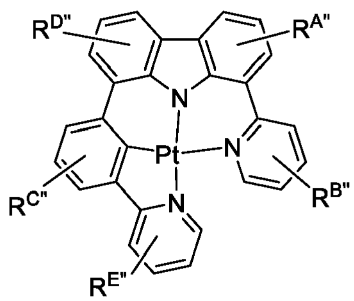 , 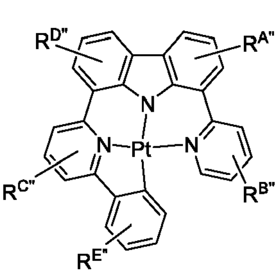 ,

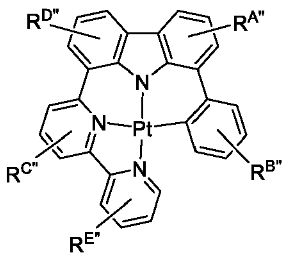
,
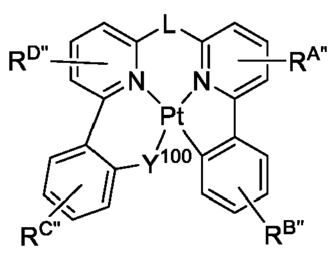
,
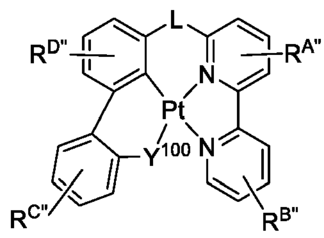
,

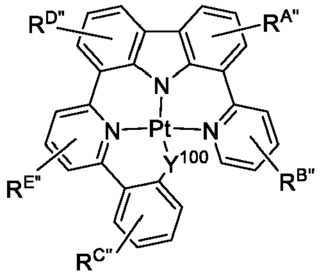
,
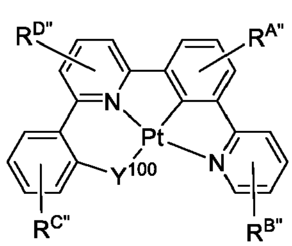
,
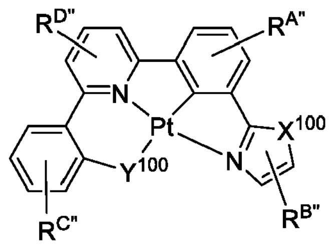
,

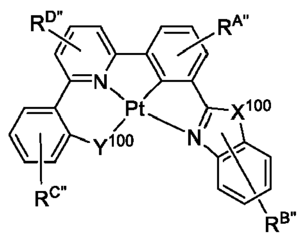
,
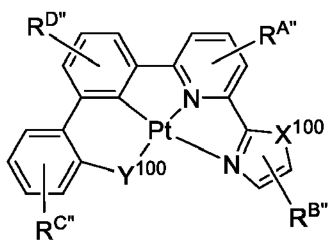
,
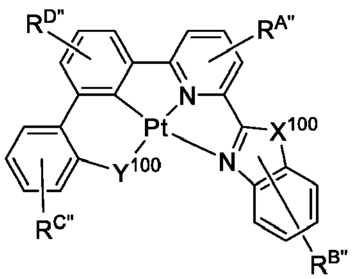
,

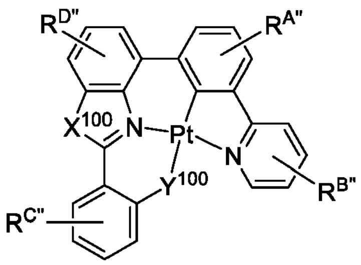
,
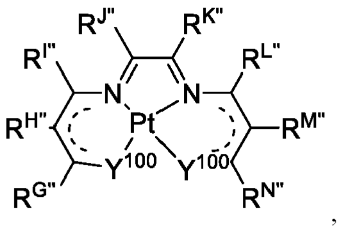
,
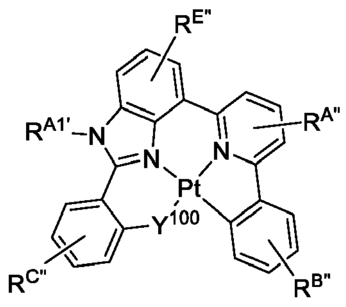
,

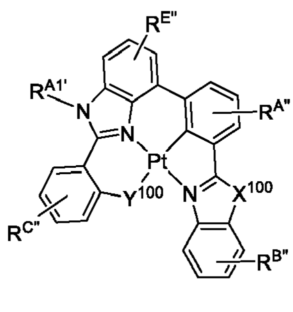
,
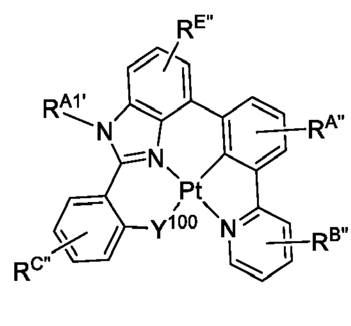
,
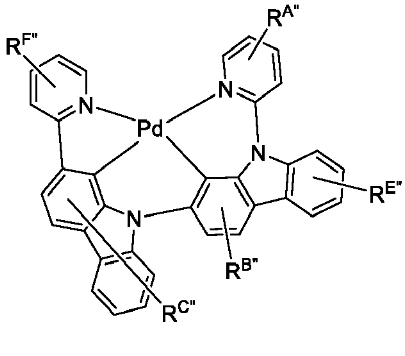
,

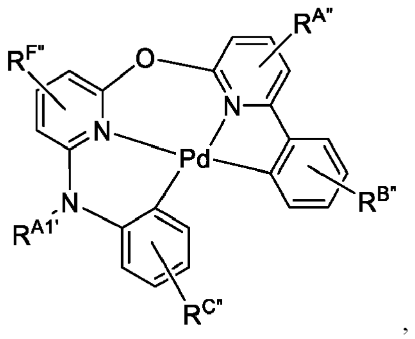, and 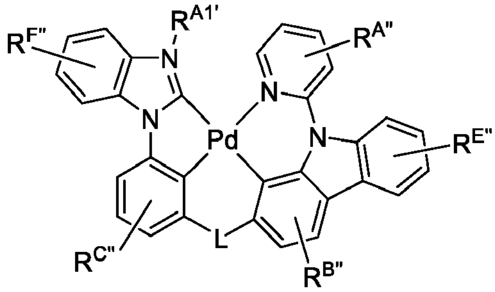,

wherein:

each of $X^{96}$ to $X^{99}$ is independently C or N;
each $Y^{100}$ is independently selected from the group consisting of a NR", O, S, and Se;
L is independently selected from the group consisting of a direct bond, BR", BR"R‴, NR", PR", O, S, Se, C=O, C=S, C=Se, C=NR", C=CR"R‴, S=O, $SO_2$, CR", CR"R‴, SiR"R‴, GeR"R‴, alkyl, cycloalkyl, aryl, heteroaryl, and combinations thereof;
$X^{100}$ and $X^{200}$for each occurrence is selected from the group consisting of O, S, Se, NR", and CR"R‴;
each $R^{10a}$, $R^{20a}$, $R^{30a}$, $R^{40a}$, and $R^{50a}$, $R^{A''}$, $R^{B''}$, $R^{C''}$, $R^{D''}$, $R^{E''}$, and $R^{F''}$ independently represents mono-, up to the maximum substitutions, or no substitutions;
each of R, R', R", R‴, $R^{10a}$, $R^{11a}$, $R^{12a}$, $R^{13a}$, $R^{20a}$, $R^{30a}$, $R^{40a}$, $R^{50a}$, $R^{60}$, $R^{70}$, $R^{97}$, $R^{98}$, $R^{99}$, $R^{A1'}$, $R^{A2'}$, $R^{A''}$, $R^{B''}$, $R^{C''}$, $R^{D''}$, $R^{E''}$, $R^{F''}$, $R^{G''}$, $R^{H''}$, $R^{I''}$, $R^{J''}$, $R^{K''}$, $R^{L''}$, $R^{M''}$, and $R^{N''}$ is independently a hydrogen or a substituent selected from the group consisting of the general substituents as defined herein; wherein any two substituents can be fused or joined to form into a ring.

In some of the above embodiments, at least one of R, R', R", R‴, $R^{10a}$, $R^{11a}$, $R^{12a}$, $R^{13a}$, $R^{10a}$, $R^{30a}$, $R^{40a}$, $R^{50a}$, $R^{60}$, $R^{70}$, $R^{97}$, $R^{98}$, $R^{99}$, $R^{A1'}$, $R^{A2'}$, $R^{A''}$, $R^{B''}$, $R^{C''}$, $R^{D''}$, $R^{E''}$, $R^{F''}$, $R^{G''}$, $R^{H''}$, $R^{I''}$, $R^{J''}$, $R^{K''}$, $R^{L''}$, $R^{M''}$, and $R^{N''}$ comprises or is a electron-withdrawing group as defined herein.

In some of the above embodiments, at least one of R, R', R", R‴, $R^{10a}$, $R^{11a}$, $R^{12a}$, $R^{13a}$, $R^{20a}$, $R^{30a}$, $R^{40a}$, $R^{50a}$, $R^{60}$, $R^{70}$, $R^{97}$, $R^{98}$, $R^{99}$, $R^{A1'}$, $R^{A2'}$, $R^{A''}$, $R^{B''}$, $R^{C''}$, $R^{D''}$, $R^{E''}$, $R^{F''}$, $R^{G''}$, $R^{H''}$, $R^{I''}$, $R^{J''}$, $R^{K''}$, $R^{L''}$, $R^{M''}$, and $R^{N''}$ comprises a moiety selected from the group consisting of fully or partially deuterated aryl, fully or partially deuterated alkyl, boryl, silyl, germyl, 2,6-terphenyl, 2-biphenyl, 2-(tert-butyl)phenyl, tetraphenylene, tetrahydronaphthalene, and combinations thereof.

It should be understood that the metal Pt of each of those compounds in the SENSITIZER COMPOUND above can be replaced by Pd, and those derived Pd compounds are also intended to be specifically covered.

In some embodiments, the sensitizer is capable of functioning as a phosphorescent emitter, a TADF emitter, or a doublet emitter in an OLED at room temperature. In some embodiments, the acceptor is selected from the group consisting of a delayed-fluorescent compound functioning as a TADF emitter in the OLED at room temperature, a fluorescent compound functioning as a fluorescent emitter in the OLED at room temperature. In some embodiments, the fluorescent emitter can be a singlet or doublet emitters. In some of such embodiments, the singlet emitter can also include a TADF emitter, furthermore, a multi-resonant MR-TADF emitter. Description of the delayed fluorescence as used herein can be found in U.S. application publication US20200373510A1, at paragraphs 0083-0084, the entire contents of which are incorporated herein by reference.

In some embodiments of the OLED, the sensitizer and the acceptor are in separate layers within the emissive region.

In some embodiments, the sensitizer and the acceptor are present as a mixture in one or more layers in the emissive region. It should be understood that the mixture in a given layer can be a homogeneous mixture or the compounds in the mixture can be in graded concentrations through the thickness of the given layer. The concentration grading can be linear, non-linear, sinusoidal, etc. When there are more than one layer in the emissive region having a mixture of the sensitizer and the acceptor compounds, the type of mixture (i.e., homogeneous or graded concentration) and the concentration levels of the compounds in the mixture in each of the more than one layer can be the same or different. In addition to the sensitizer and the acceptor compounds, there can be one or more other functional compounds such as, but not limit to, hosts also mixed into the mixture.

In some embodiments, the acceptor can be in two or more layers with the same or different concentration. In some embodiments, when two or more layers contain the acceptor, the concentration of the acceptor in at least two of the two or more layers are different. In some embodiments, the concentration of the sensitizer in the layer containing

the sensitizer is in the range of 1 to 50 %, 10 to 20 %, or 12-15 % by weight. In some embodiments, the concentration of the acceptor in the layer containing the acceptor is in the range of 0.1 to 10 %, 0.5 to 5 %, or 1 to 3 % by weight.

In some embodiments, the emissive region contains *N* layers where $N > 2$. In some embodiments, the sensitizer is present in each of the *N* layers, and the acceptor is contained in fewer than or equal to *N*-1 layers. In some embodiments, the sensitizer is present in each of the *N* layers, and the acceptor is contained in fewer than or equal to *N*/2 layers. In some embodiments, the acceptor is present in each of the *N* layers, and the sensitizer is contained in fewer than or equal to *N*-1 layers. In some embodiments, the acceptor is present in each of the *N* layers, and the sensitizer is contained in fewere than or equal to *N*/2 layers.

In some embodiments, the OLED emits a luminescent emission comprising an emission component from the $S_1$ energy (the first singlet energy) of the acceptor when a voltage is applied across the OLED. In some embodiments, at least 65%, 75%, 85%, or 95% of the emission from the emissive region is produced from the acceptor with a luminance of at least 10 cd/$m^2$. In some embodiments, $S_1$ energy of the acceptor is lower than that of the sensitizer.

In some embodiments, a $T_1$ energy (the first triplet energy) of the host compound is greater than or equal to the $T_1$ energies of the sensitizer and the acceptor, and the $T_1$ energy of the sensitizer is greater than or equal to the $S_1$ energy (the first singlet energy) of the acceptor. In some embodiments, $S_1$-$T_1$ energy gap of the sensitizer, and/or the acceptor, and/or first host compound, and/or second host compound is less than 400, 300, 250, 200, 150, 100, or 50 meV. In some embodiments, the absolute energy difference between the HOMO of the sensitizer and the HOMO of the acceptor is less than 0.6, 0.5, 0.4, 0.3, or 0.2 eV. In some embodiments, the absolute energy difference between the LUMO of the sensitizer and the LUMO of the acceptor is less than 0.6, 0.5, 0.4, 0.3, or 0.2 eV.

In some embodiments where the sensitizer provides unicolored sensitization (i.e., minimal loss in energy upon energy transfer to the acceptor), the acceptor has a Stokes shift of 30, 25, 20, 15, or 10 nm or less. An example would be a broad blue phosphor sensitizing a narrow blue emitting acceptor.

In some embodiments where the sensitizer provides a down conversion process (e.g., a blue emitter being used to sensitize a green emitter, or a green emitter being used to sensitize a red emitter), the acceptor has a Stokes shift of 30, 40, 60, 80, or 100 nm or more.

In some embodiments, the difference between λmax of the emission spectrum of the sensitizer and λmax of the absorption spectrum of the acceptor is 50, 40, 30, or 20 nm or less. In some embodiments, the spectral overlap of the light absorbing area of the acceptor and the light emitting area of the sensitizer relative to the light emitting area of the sensitizer, is greater than 5%, 10%, 15%, 20%, 30%, 40%, 50%, or more.

One way to quantify the qualitative relationship between a sensitizer compound (a compound to be used as the sensitizer in the emissive region of the OLED of the present disclosure) and an acceptor compound (a compound to be used as the acceptor in the emissive region of the OLED of the present disclosure) is by determining a value $\Delta\lambda = \lambda_{max1} - \lambda_{max2}$, where $\lambda_{max1}$ and $\lambda_{max2}$ are defined as follows. $\lambda_{max1}$ is the emission maximum of the sensitizer compound at room temperature when the sensitizer compound is used as the sole emitter in a first monochromic OLED (an OLED that emits only one color) that has a first host. $\lambda_{max2}$ is the emission maximum of the acceptor compound at room temperature when the acceptor compound is used as the sole emitter in a second monochromic OLED that has the same first host.

In some embodiments of the OLED of the present disclosure where the sensitizer provides unicolored sensitization (i.e., minimal loss in energy upon energy transfer to the acceptor), $\Delta\lambda$ (determined as described above) is equal to or less than the number selected from the group consisting of 15, 12, 10, 8, 6, 4, 2, 0, -2, -4, - 6, -8, and -10 nm.

In some embodiments, a spectral overlap integral of the sensitizer and the acceptor is at least $10^{14}$ $nm^{4*}$L/cm*mol. In some embodiments, a spectral overlap integral of the sensitizer and the acceptor is at least $5 \times 10^{14}$ $nm^{4*}$L/cm*mol. In some embodiments, a spectral overlap integral of the sensitizer and the acceptor is at least $10^{15}$ $nm^{4*}$L/cm*mol.

As used herein, "spectral overlap integral" is determined by multiplying the acceptor extinction spectrum by the sensitizer emission spectrum normalized with respect to the area under the curve. The higher the spectral overlap, the better the Förster Resonance Energy Transfer (FRET) efficiency. The rate of FRET is proportional to the spectral overlap integral. Therefore, a high spectral overlap can help improve the FRET efficiency and reduce the exciton lifetime in an OLED.

In some embodiments, the acceptor and the sensitizer are selected in order to increase the spectral overlap. Increasing the spectral overlap can be achieved in several ways, for example, increasing the oscillator strength of the acceptor, minimizing the distance between the sensitizer peak emission intensity and the acceptor absorption peak, and narrowing the line shape of the sensitizer emission or the acceptor absorption. In some embodiments, the oscillator strength of the acceptor is greater than or equal to 0.1.

In some embodiments where the emission of the acceptor is redshifted by the sensitization, the absolute value of $\Delta\lambda$ is equal to or greater than the number selected from the group consisting of 20, 30, 40, 60, 80, 100 nm.

In some embodiments, the sensitizer and/or the acceptor can be a phosphorescent or fluorescent emitter. Phosphorescence generally refers to emission of a photon with a change in electron spin quantum number, i.e., the

initial and final states of the emission have different electron spin quantum numbers, such as from T1 to S0 state. Ir and Pt complexes currently widely used in the OLED belong to phosphorescent emitters. In some embodiments, if an exciplex formation involves a triplet emitter, such exciplex can also emit phosphorescent light. On the other hand, fluorescent emitters generally refer to emission of a photon without a change in electron spin quantum number, such as from S1 to S0 state, or from D1 to D0 state. Fluorescent emitters can be delayed fluorescent or non-delayed fluorescent emitters. Depending on the spin state, fluorescent emitter can be a singlet emitter or a doublet emitter, or other multiplet emitter. It is believed that the internal quantum efficiency (IQE) of fluorescent OLEDs can exceed the 25% spin statistics limit through delayed fluorescence. There are two types of delayed fluorescence, i.e. P-type and E-type delayed fluorescence. P-type delayed fluorescence is generated from triplet-triplet annihilation (TTA). On the other hand, E-type delayed fluorescence does not rely on the collision of two triplets, but rather on the thermal population between the triplet states and the singlet excited states. Thermal energy can activate the transition from the triplet state back to the singlet state. This type of delayed fluorescence is also known as thermally activated delayed fluorescence (TADF). E-type delayed fluorescence characteristics can be found in an exciplex system or in a single compound. Without being bound by theory, it is believed that TADF requires a compound or an exciplex having a small singlet-triplet energy gap ($\Delta E_{S-T}$) less than or equal to 400, 350, 300, 250, 200, 150, 100, or 50 meV. There are two major types of TADF emitters, one is called donor-acceptor type TADF, the other one is called multiple resonance (MR) TADF. Often, donor-acceptor single compounds are constructed by connecting an electron donor moiety such as amino- or carbazole-derivatives and an electron acceptor moiety such as N-containing six-membered aromatic rings or cyano-substituted aromatic rings. Donor-acceptor exciplex can be formed between a hole transporting compound and an electron transporting compound. The examples for MR-TADF include highly conjugated fused ring systems. In some embodiments, MR-TADF materials comprising boron, carbon, and nitrogen atoms. They may comprise other atoms as well, for example oxygen. In some embodiments, the reverse intersystem crossing time from T1 to S1 of the delayed fluorescent emission at 293K is less than or equal to 10 microseconds. In some embodiments, such time can be greater than 10 microseconds and less than 100 microseconds.

In some embodiments of the OLED, at least one of the following conditions is true:

(1) the sensitizer compound is capable of functioning as a TADF emitter in an OLED at room temperature;
(2) the acceptor compound is a delayed-fluorescent compound functioning as a TADF emitter in said OLED at room temperature.

In some embodiments of the OLED, the TADF emitter comprises at least one donor group and at least one acceptor group. In some embodiments, the TADF emitter is a metal complex. In some embodiments, the TADF emitter is a non-metal complex. In some embodiments, the TADF emitter is a boron-containing compound. In some embodiments, the TADF emitter is a Cu, Ag, or Au complex.

In some embodiments of the OLED, the TADF emitter has the formula of $M(L^5)(L^6)$, wherein M is Cu, Ag, or Au, $L^5$ and $L^6$ are different, and $L^5$ and $L^6$ are independently selected from the group consisting of:

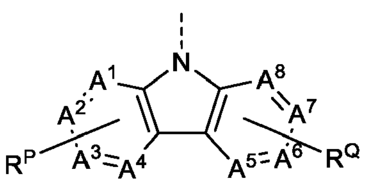
,
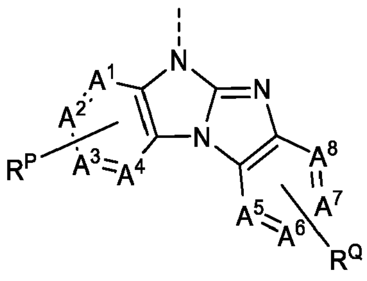
,
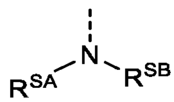
,
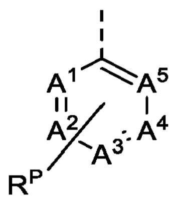
,

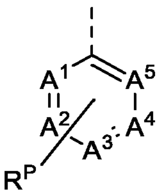, 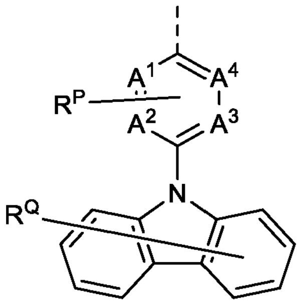, 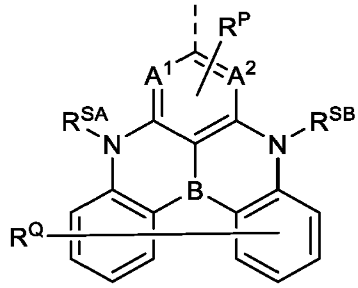,

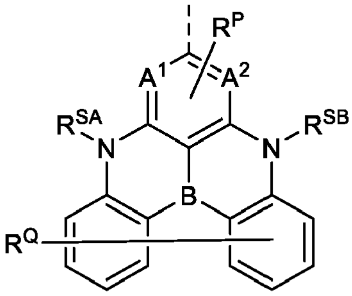, 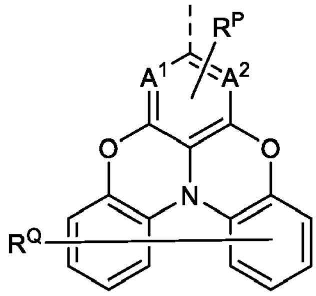, 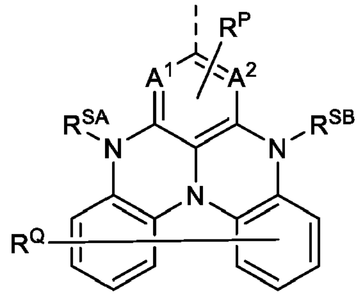,

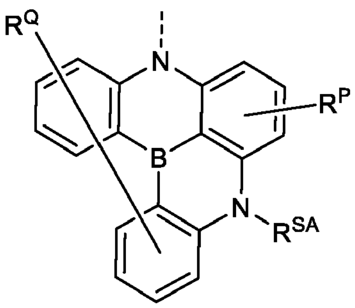, 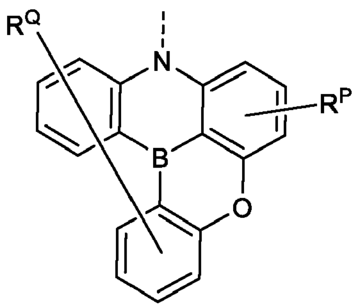, 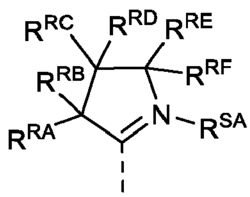,

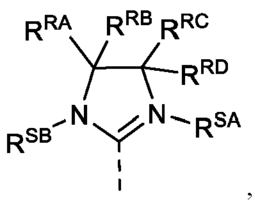, 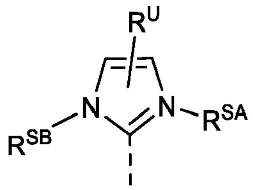, 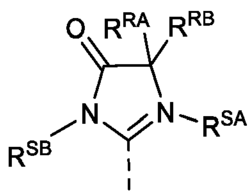, 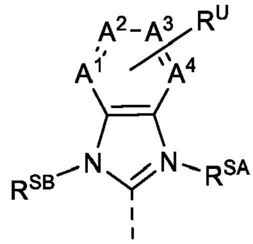,

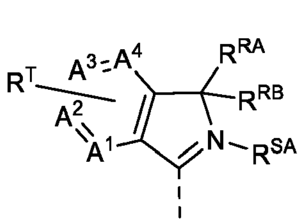, 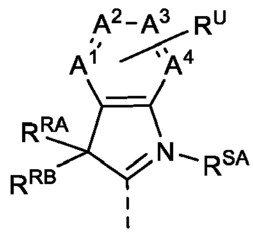, 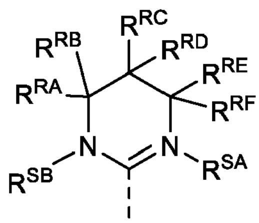, 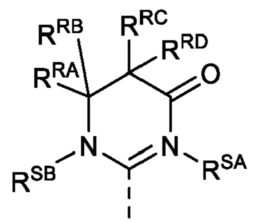,

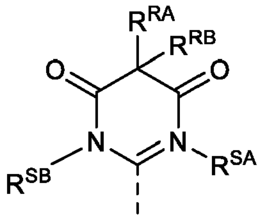, 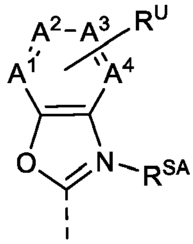, 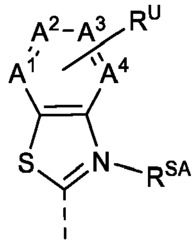, 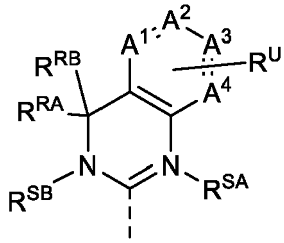,

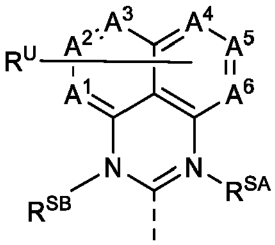, 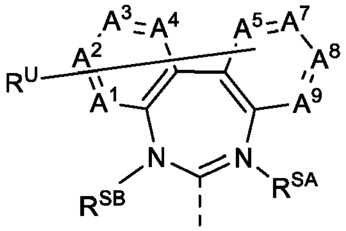, 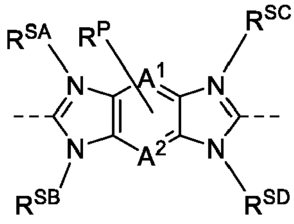, and

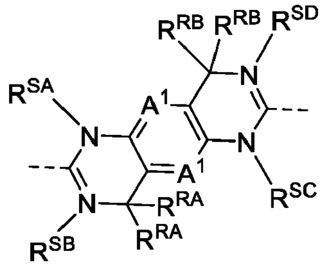;

wherein $A^1$ - $A^9$ are each independently selected from C or N;
each $R^P$, $R^Q$, and $R^U$ independently represents mono-, up to the maximum substitutions, or no substitutions;
wherein each $R^P$, $R^P$, $R^U$, $R^{SA}$, $R^{SB}$, $R^{RA}$, $R^{RB}$, $R^{RC}$, $R^{RD}$, $R^{RE}$, and $R^{RF}$ is independently a hydrogen or a substituent selected from the group consisting of the general substituents as defined herein; any two substituents can be joined or fused to form a ring.

In some embodiments of the OLED, the TADF emitter may be one of the following:

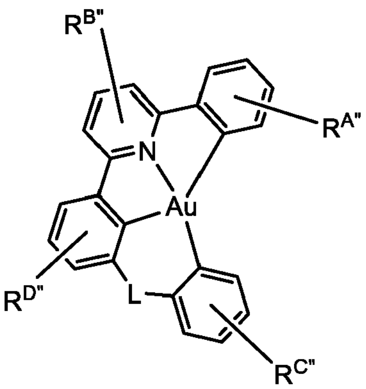, 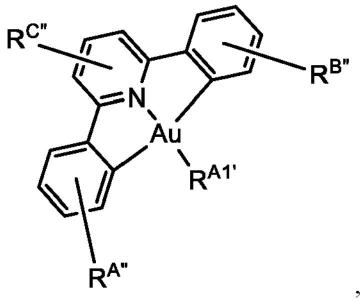, 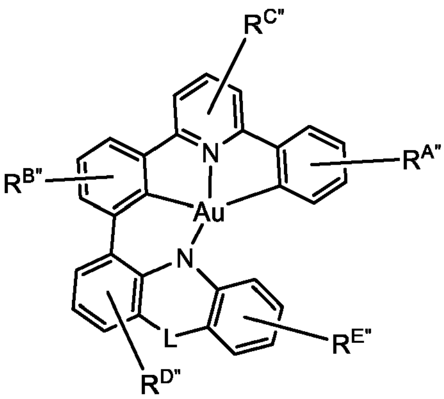,

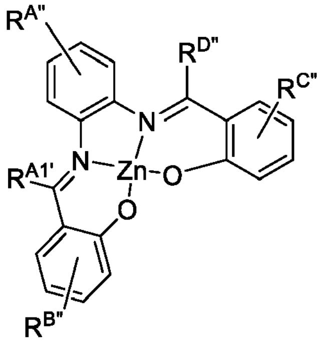
,
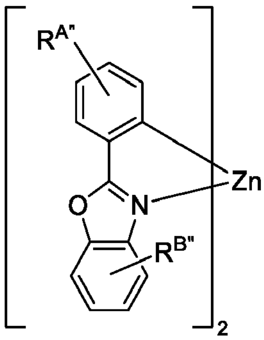
,
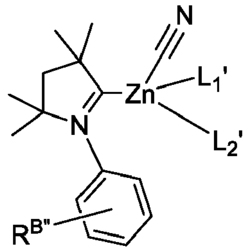
,

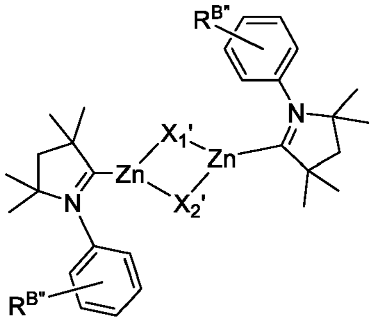
, and
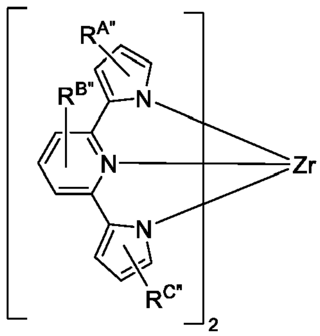
,

wherein each $R^{A''}$, $R^{B''}$, $R^{C''}$, $R^{D''}$, $R^{E''}$, and $R^{F''}$ can independently represent from mono to the maximum possible number of substitutions, or no substitution;

each R", R‴, $R^{A1}$, $R^{A''}$, $R^{B''}$, $R^{C''}$, $R^{D''}$, $R^{E''}$, and $R^{F''}$ is independently a hydrogen or a substituent selected from the group consisting of the general substituents as defined herein; wherein any two substituents can be fused or joined to form into a ring.

wherein L is independently selected from the group consisting of a direct bond, BR", BR"R‴, NR", PR", O, S, Se, C=O, C=S, C=Se, C=NR", C=CR"R‴, S=O, $SO_2$, CR", CR"R‴, SiR"R‴, GeR"R‴, alkyl, cycloalkyl, aryl, heteroaryl, and combinations thereof;

wherein each of $L_1$' and $L_2$' is a monodentate anionic ligand,

wherein each of $X_1$' and $X_2$' is a halide; and

wherein any two substituents can be fused or joined to form a ring.

In some embodiments of the OLED, the TADF emitter is selected from the group consisting of the structures in the following TADF LIST:

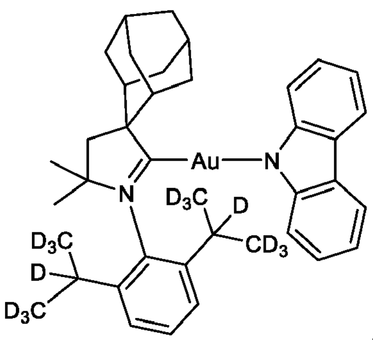
,
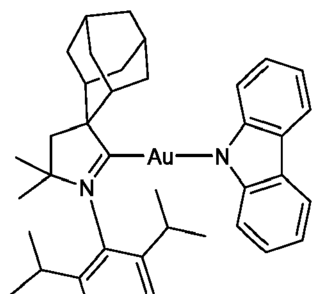
,
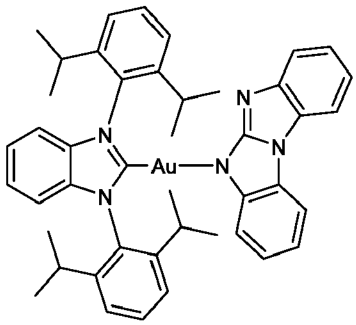
,

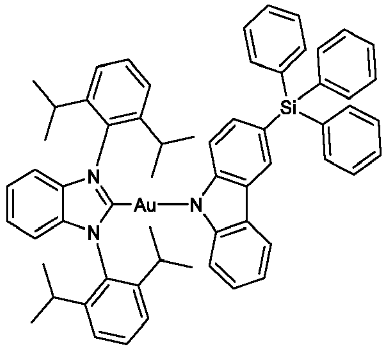

,

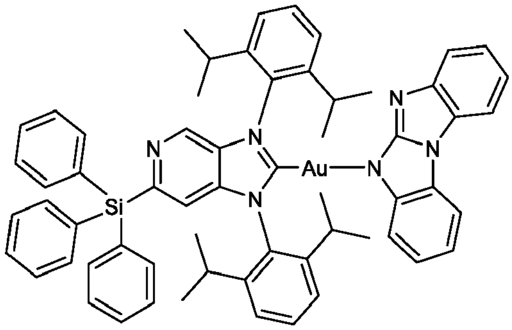

,

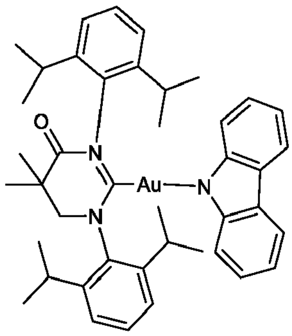

,

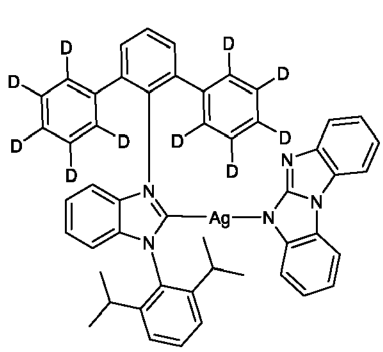

,

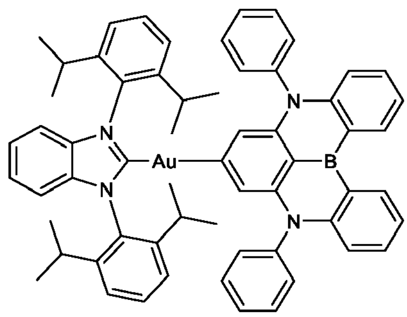

,

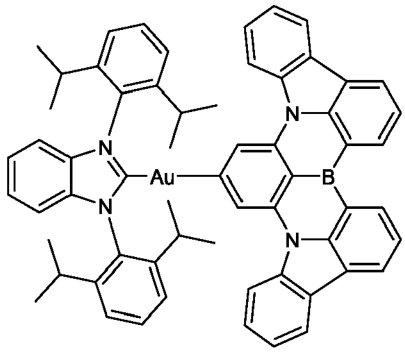

,

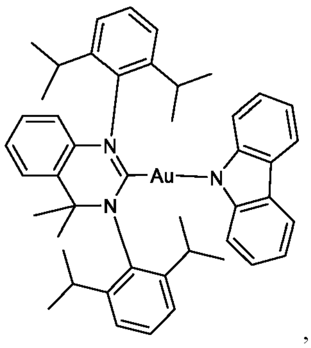

,

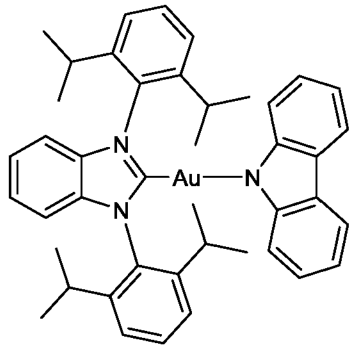

,

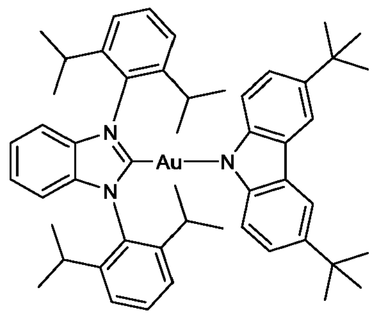

,

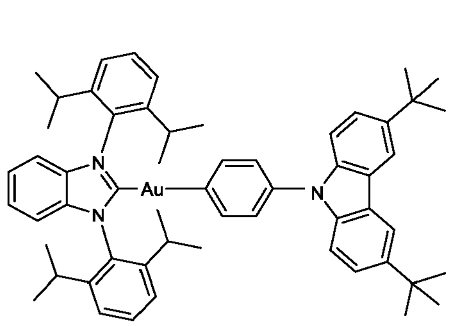

,

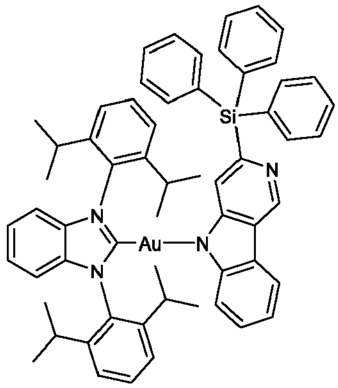

,

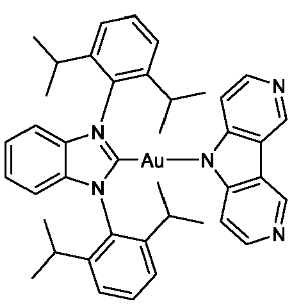

,

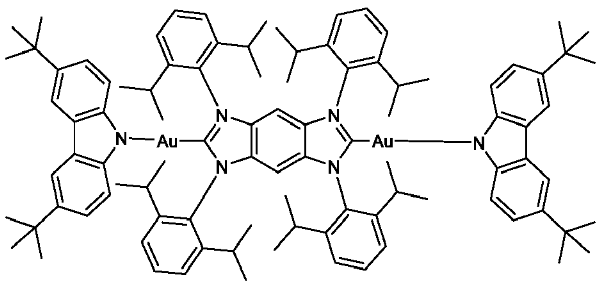 , 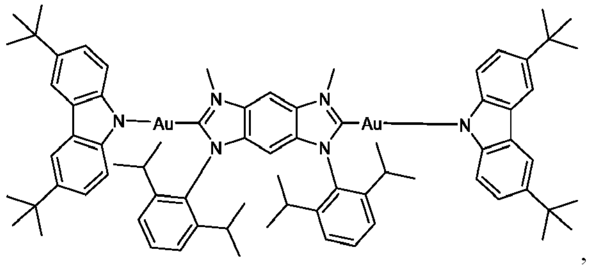 ,

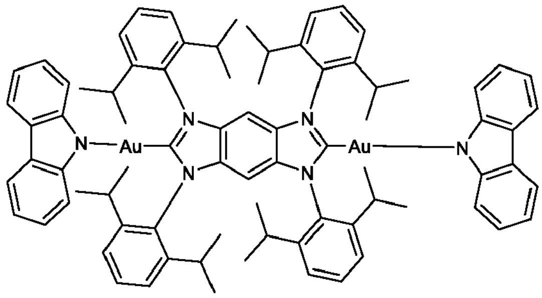 , 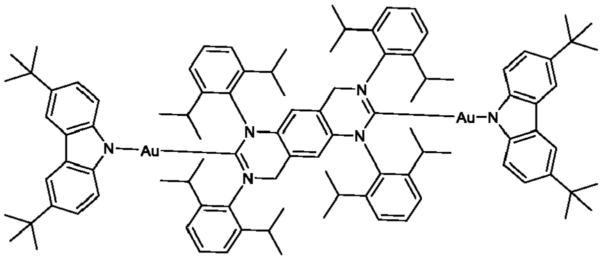 ,

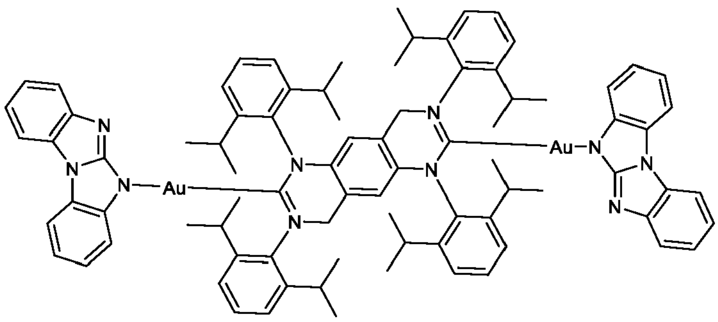 , 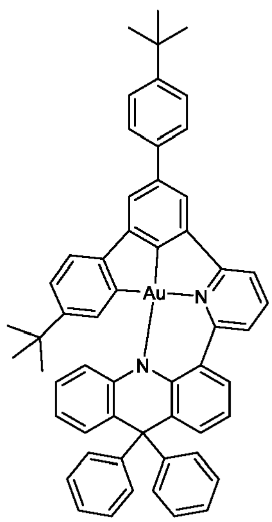 ,

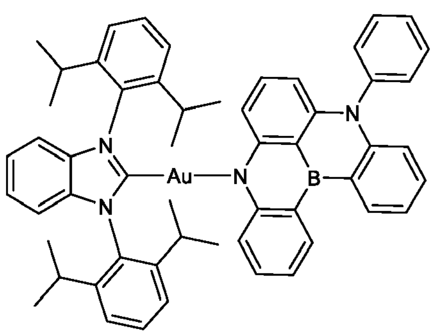 , 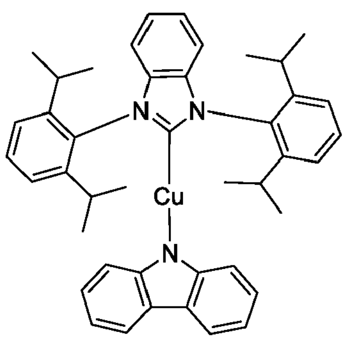 , 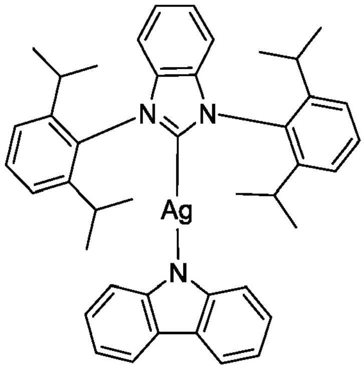 ,

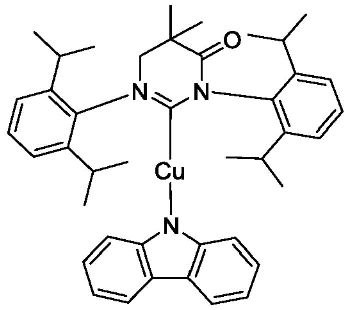, and 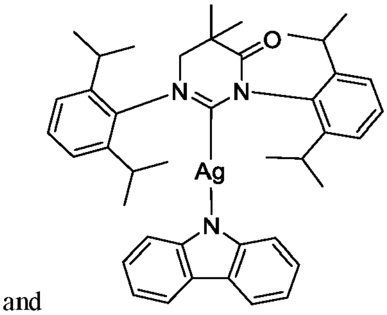.

In some embodiments of the OLED, the TADF emitter comprises a boron atom. In some embodiments, the TADF emitter comprises at least one of the chemical moieties selected from the group consisting of:

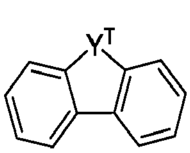, 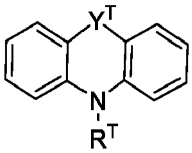, 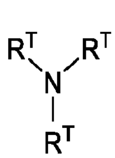, 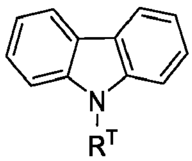, 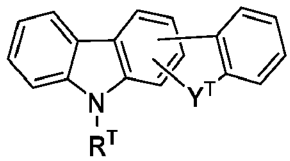,

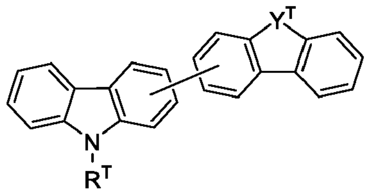, 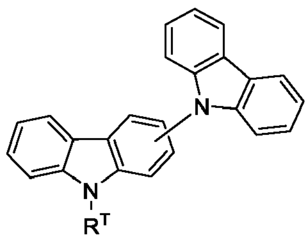, 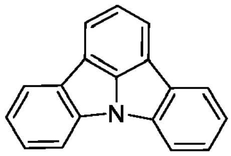, 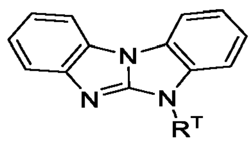,

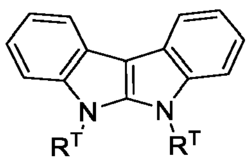, 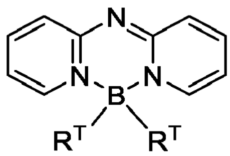, 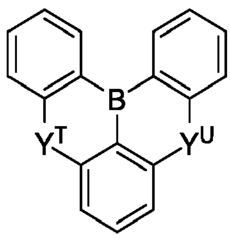, 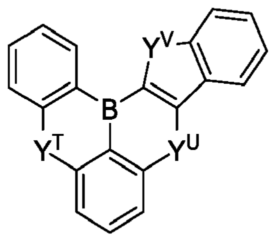,

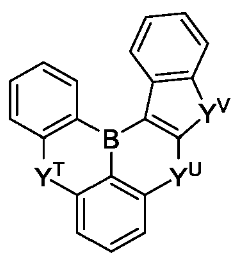, 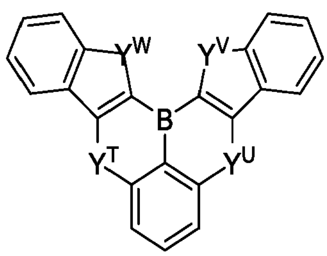, 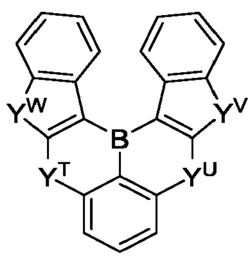, 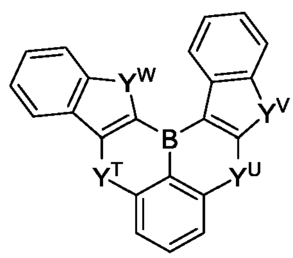,

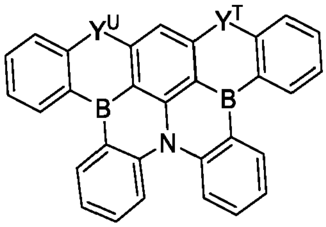, 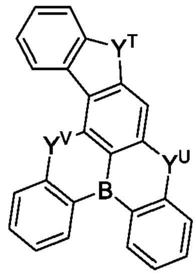, 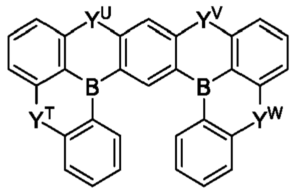, and 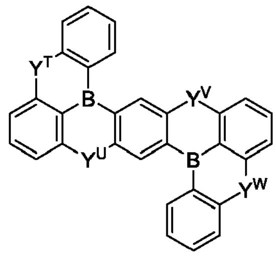;

wherein $Y^T$, $Y^U$, $Y^V$, and $Y^W$ are each independently selected from the group consisting of BR, NR, PR, O, S, Se, C=O, S=O, $SO_2$, BRR', CRR', SiRR', and GeRR';
wherein each $R^T$ can be the same or different and each $R^T$ is independently a donor, an acceptor group, an organic linker bonded to a donor, an organic linker bonded to an acceptor group, or a terminal group selected from the group consisting of alkyl, cycloalkyl, heteroalkyl, heterocycloalkyl, arylalkyl, aryl, heteroaryl, and combinations thereof; and R, and R' are each independently a hydrogen or a substituent selected from the group consisting of the general substituents as defined herein.

In some of the above embodiments, any carbon ring atoms up to maximum of a total number of three, together with their substituents, in each phenyl ring of any of above structures can be replaced with N.

In some embodiments, the TADF emitter comprises at least one of the acceptor moieties selected from the group consisting of nitrile, isonitrile, borane, fluoride, pyridine, pyrimidine, pyrazine, triazine, aza-carbazole, aza-dibenzothiophene, aza-dibenzofuran, aza-dibenzoselenophene, aza-triphenylene, imidazole, pyrazole, oxazole, thiazole, isoxazole, isothiazole, triazole, thiadiazole, and oxadiazole. In some embodiments, the acceptor moieties and the donor moieties as described herein can be connected directly, through a conjugated linker, or a non-conjugated linker, such as a sp3 carbon or silicon atom.

In some embodiments, the acceptor is a fluorescent compound functioning as an emitter in said OLED at room temperature. In some embodiments, the fluorescent compound comprises at least one of the chemical moieties selected from the group consisting of:

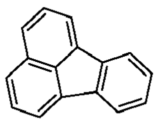, 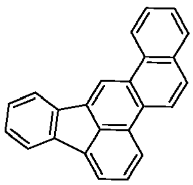, 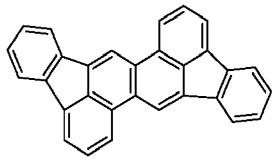, 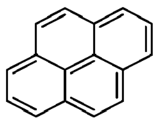, 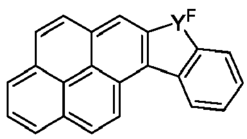,

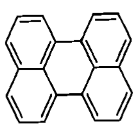, 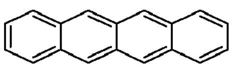, 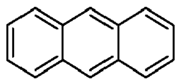, 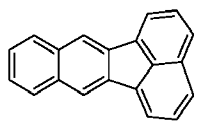, 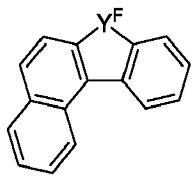,

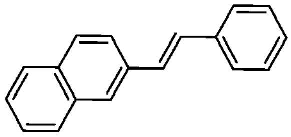, 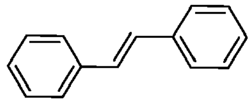, 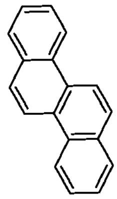, 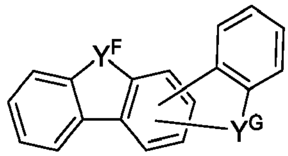,

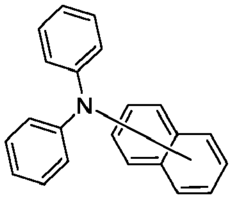, 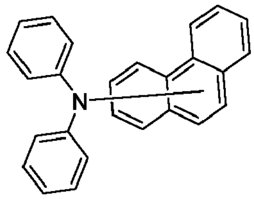, 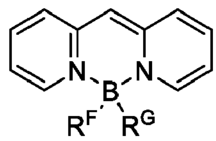, 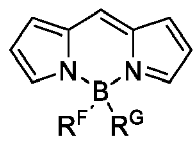, 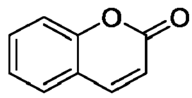,

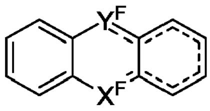, 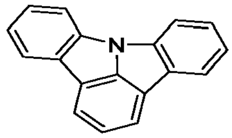, 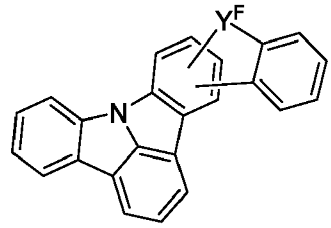,

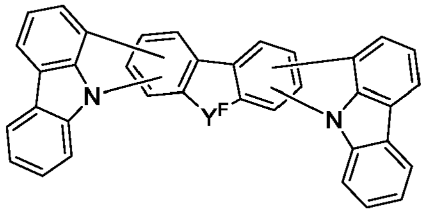, 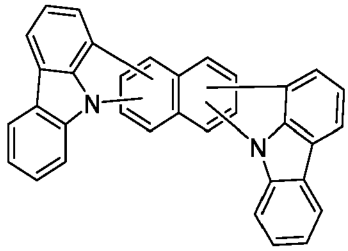, 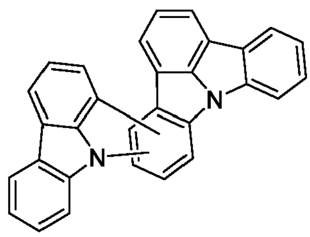,

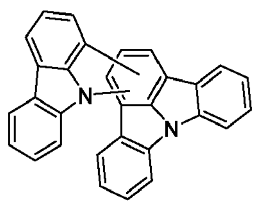, 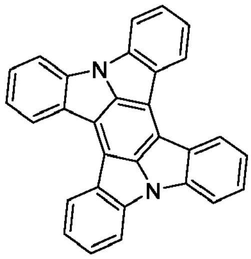, 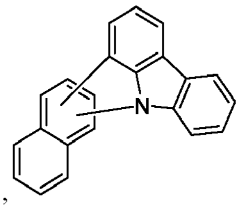, 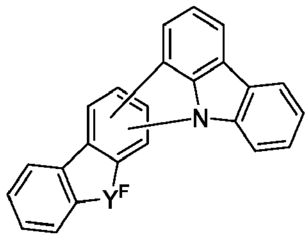,

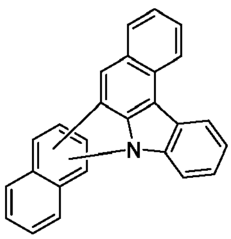, 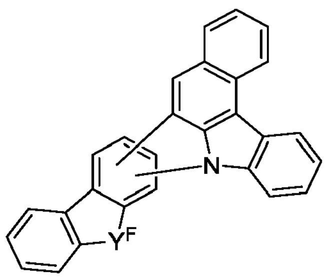, 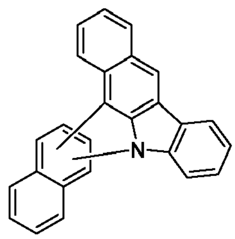, 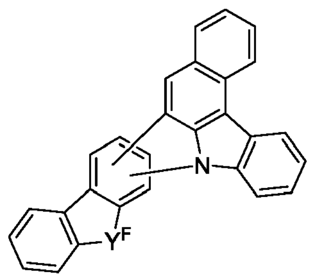,

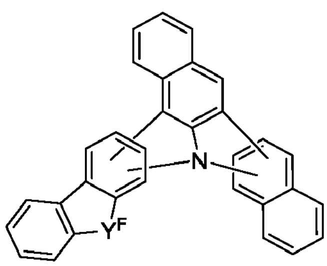, 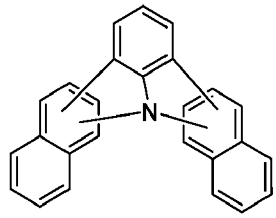, 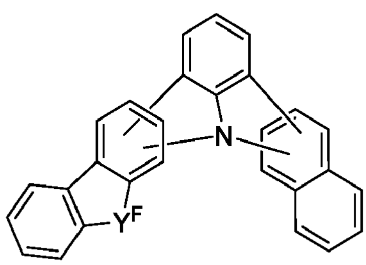,

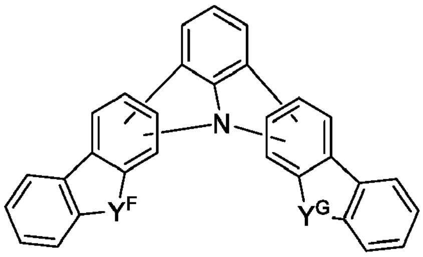, 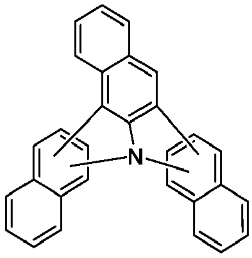, 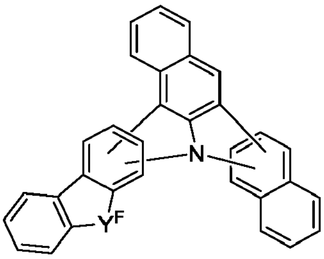,

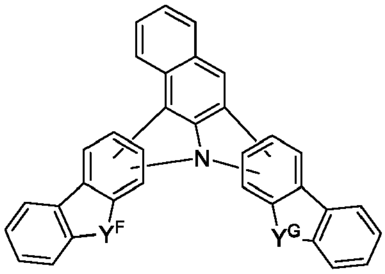, 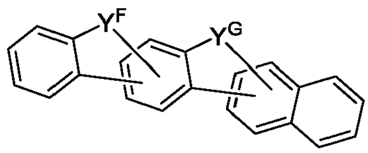, 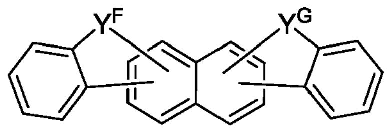,

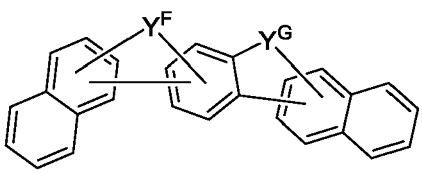, 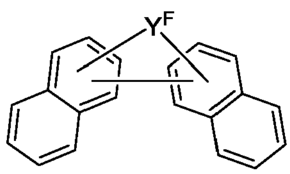, 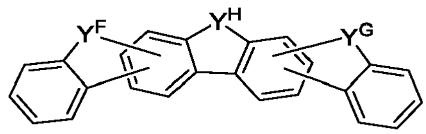,

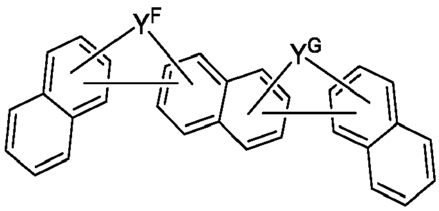, 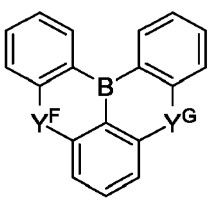, 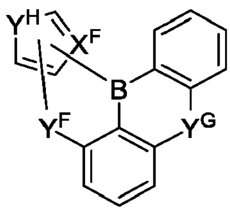 and 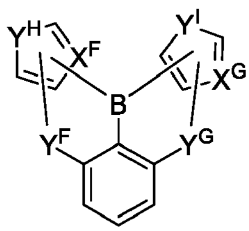

;

wherein $Y^F$, $Y^G$, $Y^H$, and $Y^I$ are each independently selected from the group consisting of BR, NR, PR, O, S, Se, C=O, S=O, $SO_2$, BRR', CRR', SiRR', and GeRR';
wherein $X^F$ and $Y^G$ are each independently selected from the group consisting of C and N; and
wherein $R^F$, $R^G$, R, and R' are each independently a hydrogen or a substituent selected from the group consisting of then general substituents as defined herein.

In some of the above embodiments, any carbon ring atoms up to maximum of a total number of three, together with their substituents, in each phenyl ring of any of above structures can be replaced with N.
In some embodiments of the OLED, the fluorescent compound is selected from the group consisting of:

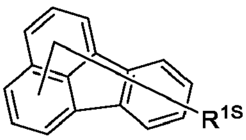,
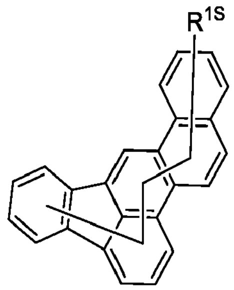,
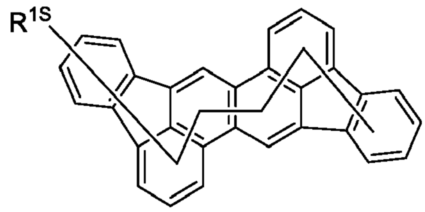,

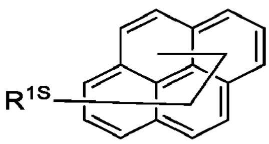,
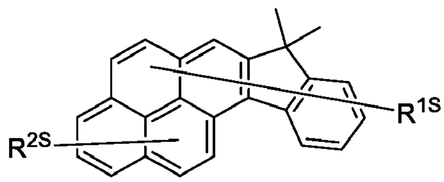,
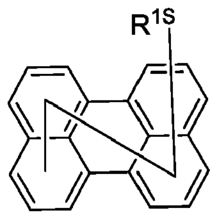,

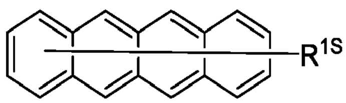,
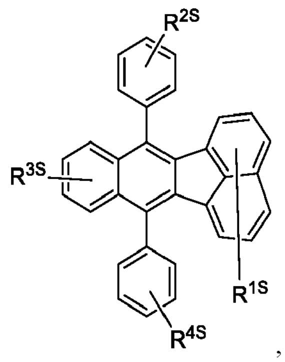,
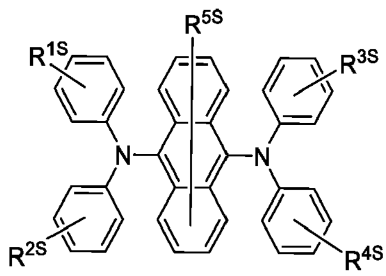,

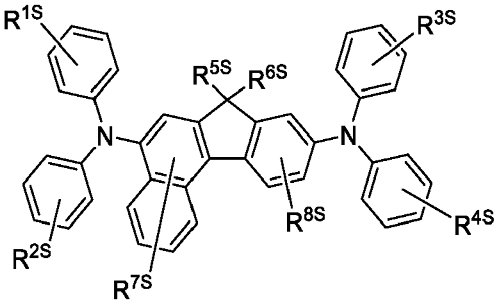,
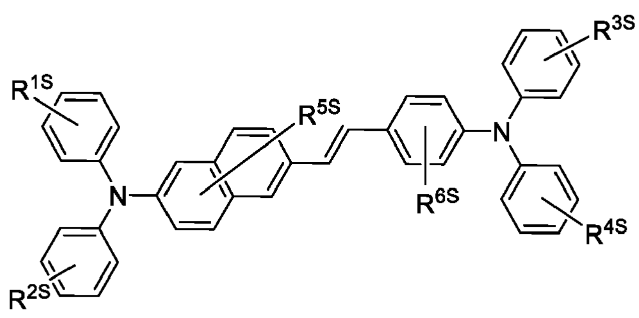,

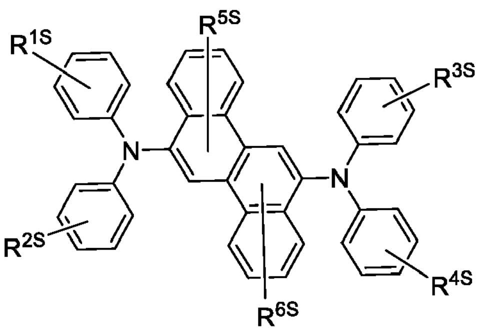,
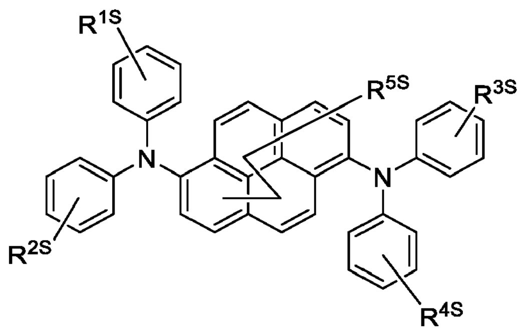,

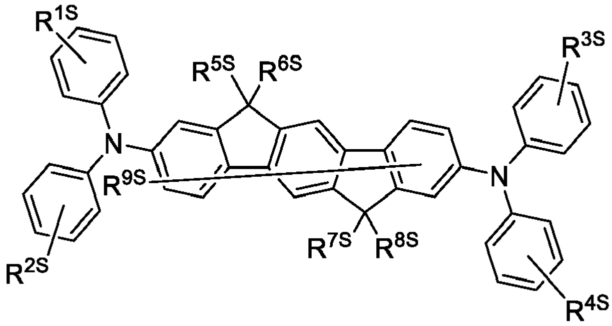,
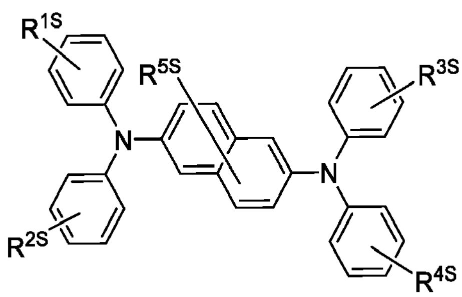,

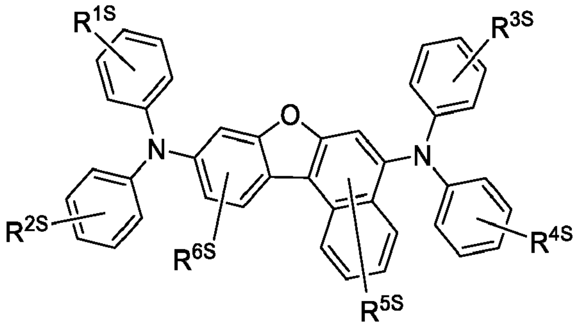,
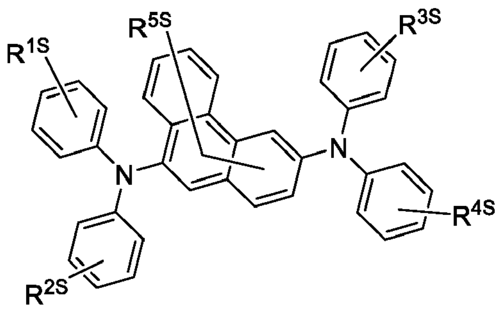,

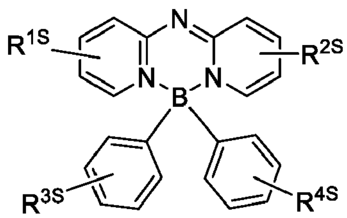,
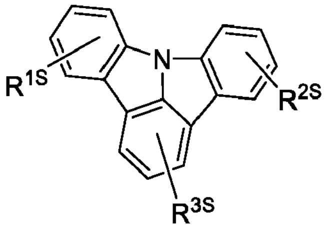,
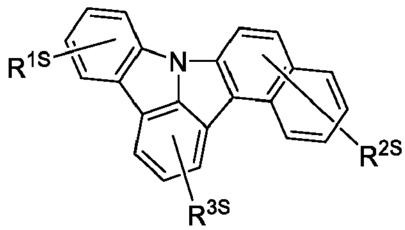,

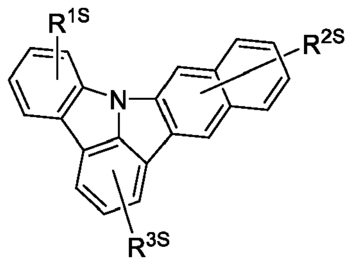,
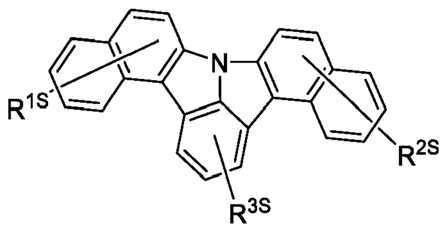,

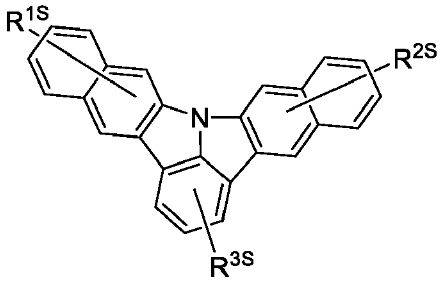,
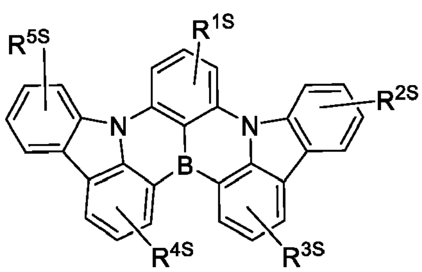,

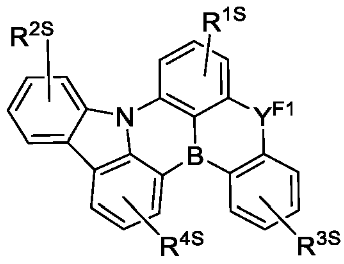
,
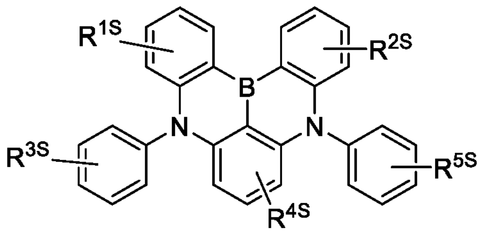
,

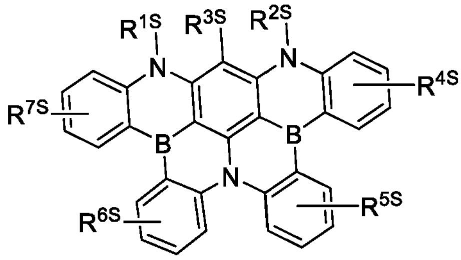
,
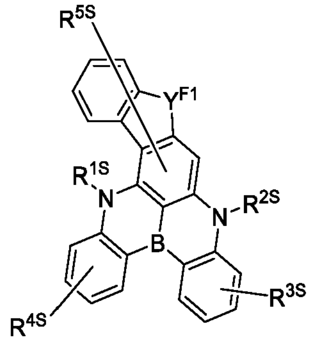
,

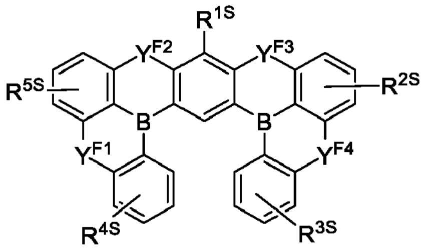
,
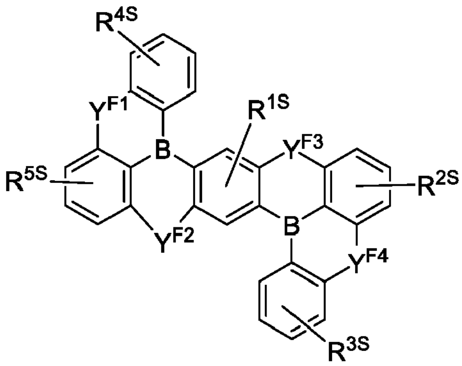
,

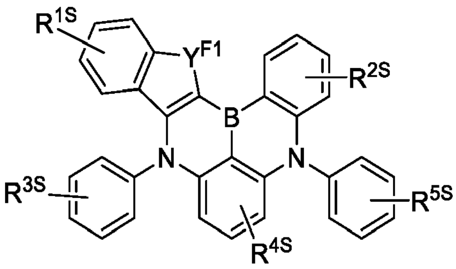
,
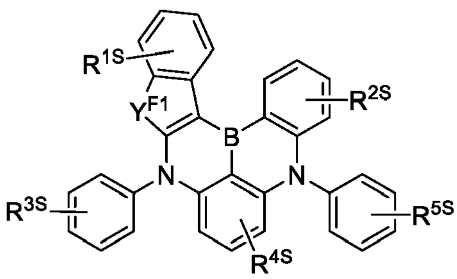
,

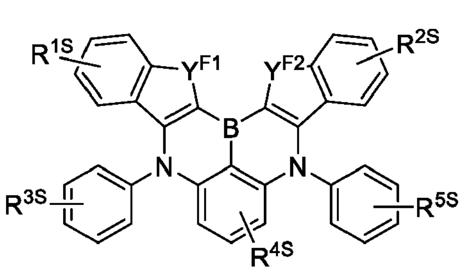
,
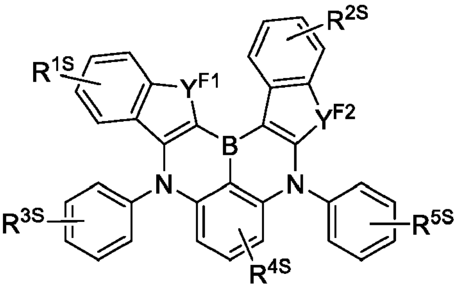
,

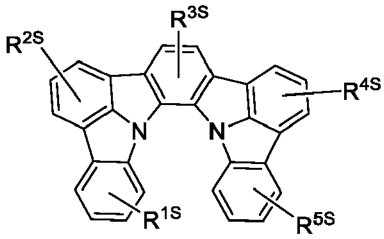,
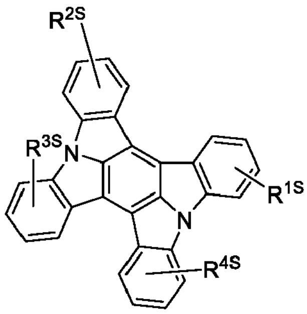,
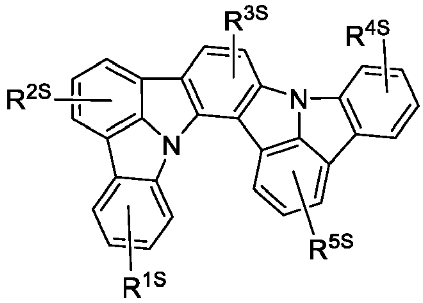,

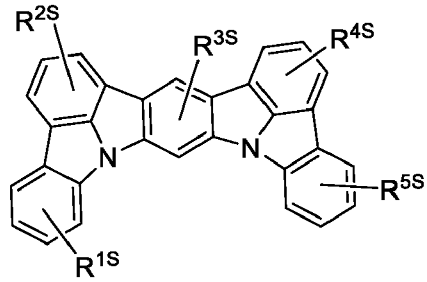,
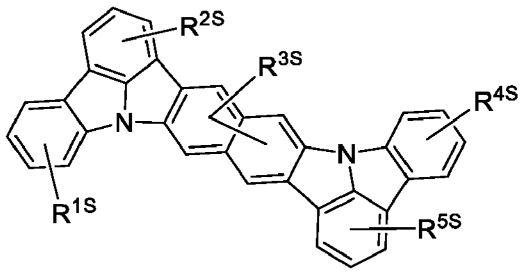,

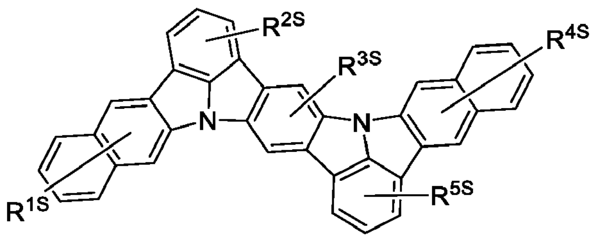, and
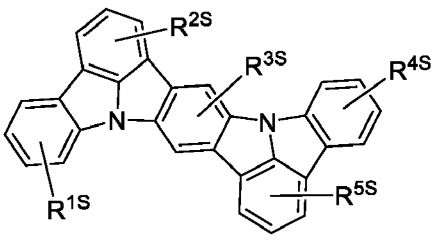;

wherein $Y^{F1}$ to $Y^{F4}$ are each independently selected from O, S, and $NR^{F1}$;

wherein $R^{F1}$ and $R^1$ to $R^9$ each independently represents from mono to maximum possible number of substitutions, or no substitution; and

wherein $R^{F1}$ and $R^1$ to $R^9$ are each independently a hydrogen or a substituent selected from the group consisting of the general substituents as defined herein, and any two substituents can be joined or fused to form a ring.

In some of the above embodiments, any carbon ring atoms up to maximum of a total number of three, together with their substituents, in each phenyl ring of any of above structures can be replaced with N.

In some embodiments, the acceptor compound comprises a fused ring system having at least five to ten 5-membered and/or 6-membered aromatic rings.

In some embodiments, the acceptor compound has a first group and a second group with the first group not overlapping with the second group; wherein at least 80% of the singlet excited state population of the lowest singlet excitation state are localized in the first group; and wherein at least 80%, 85%, 90%, or 95% of the triplet excited state population of the lowest triplet excitation state are localized in the second group.

In some embodiments, the acceptor compound is selected from the group consisting of the structures of the following ACCEPTOR LIST:

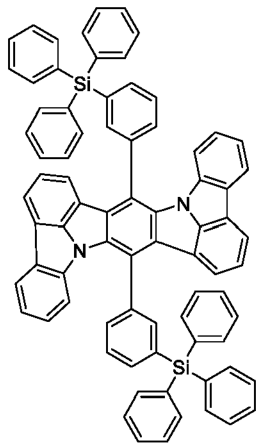 , 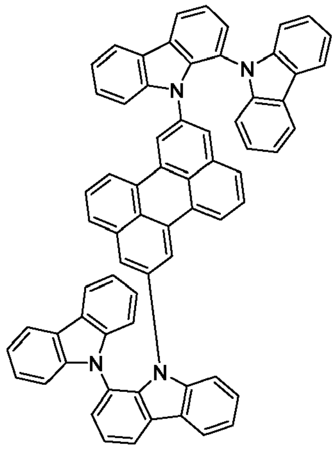 , 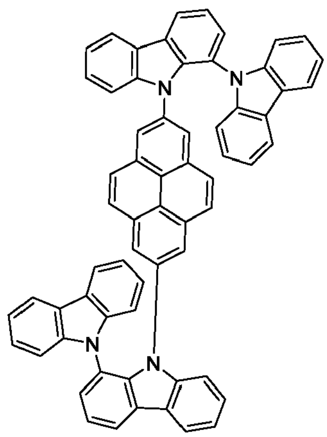 ,

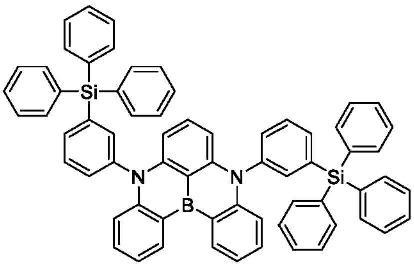 , 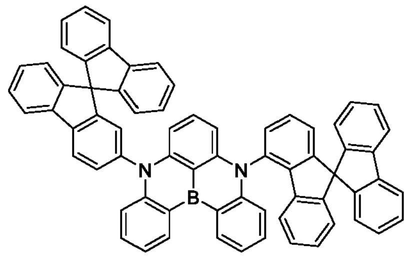 ,

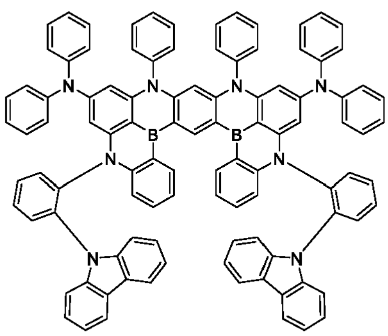 , 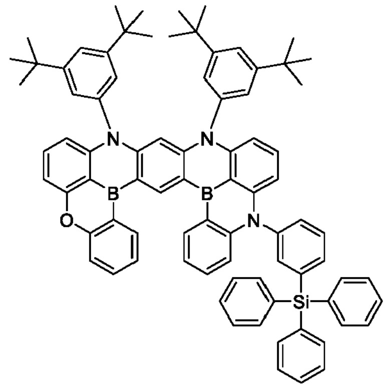 ,

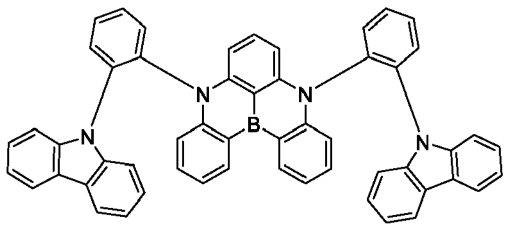 , 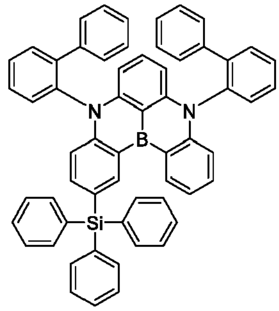 , 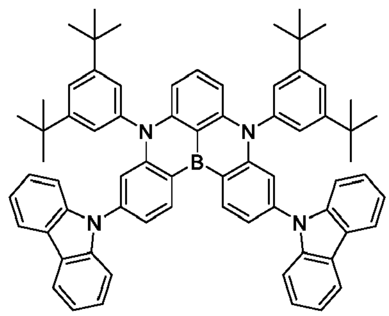 ,

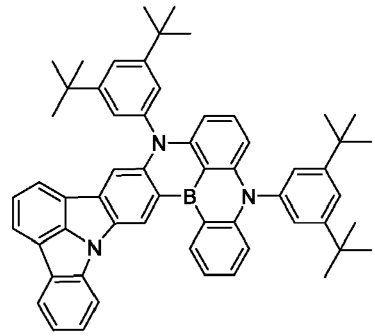,
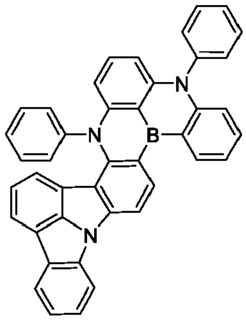,
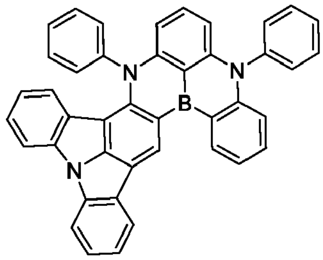,

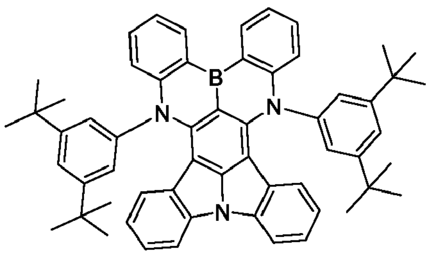,
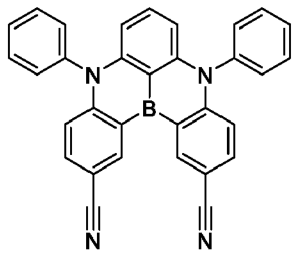,
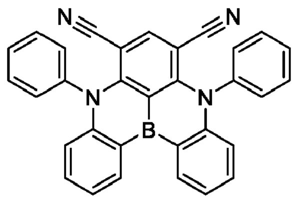,

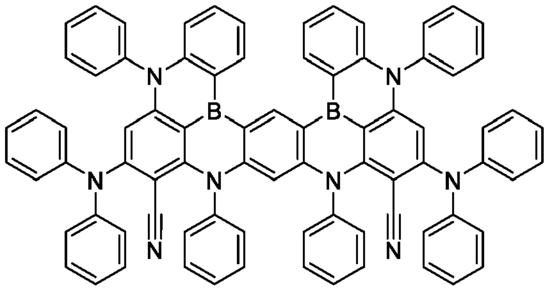,
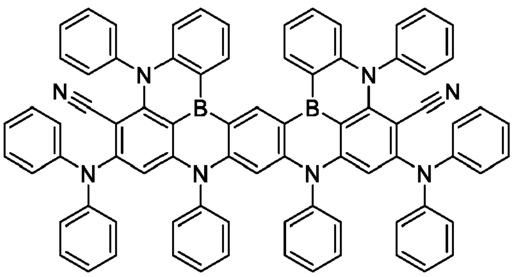,

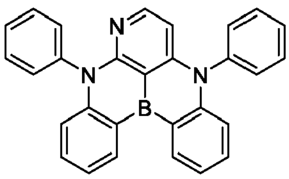,
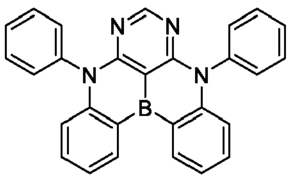,
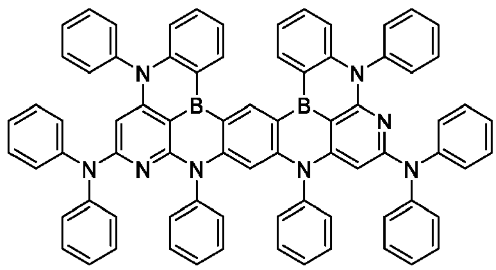,

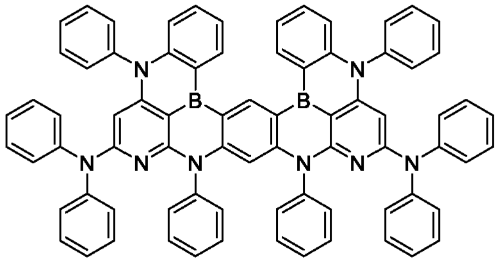,
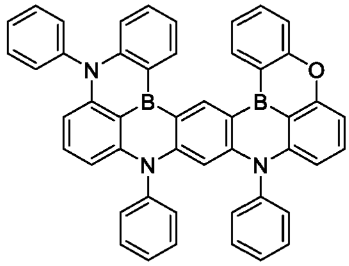,
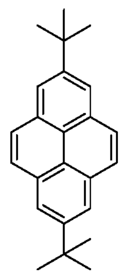,

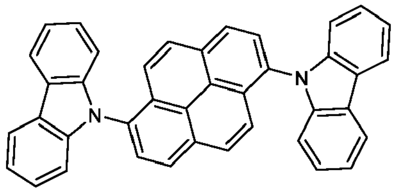, 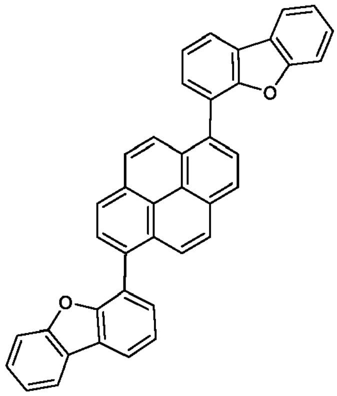, 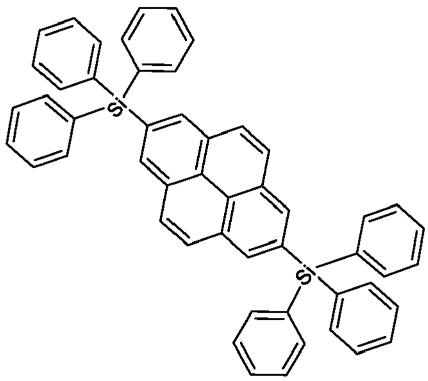,

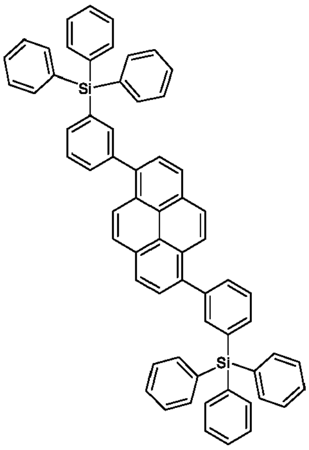, 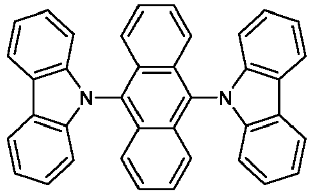, 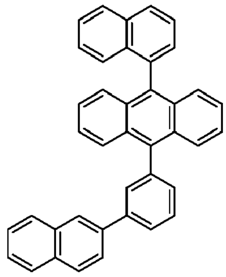, 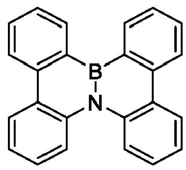,

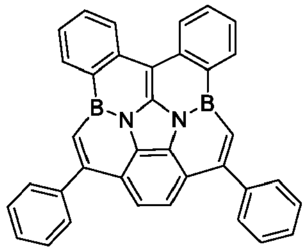, 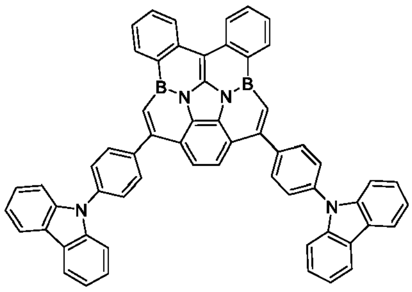, 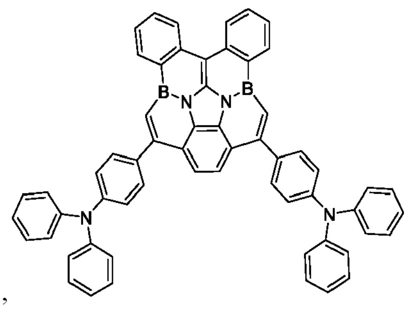,

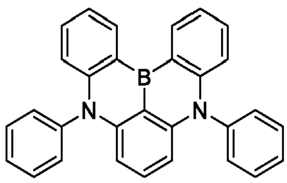, 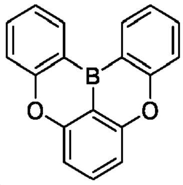, 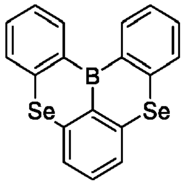, 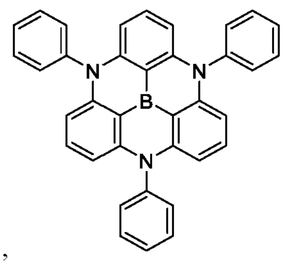,

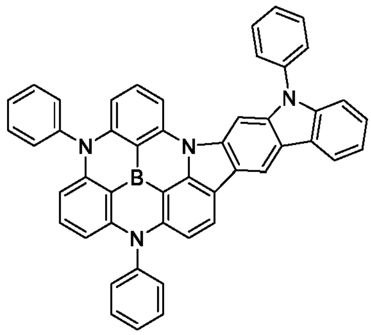,
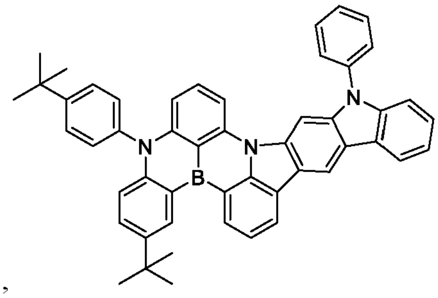,
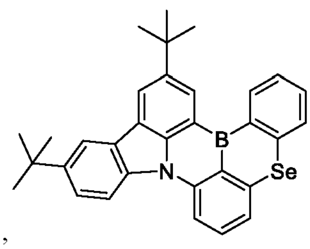,

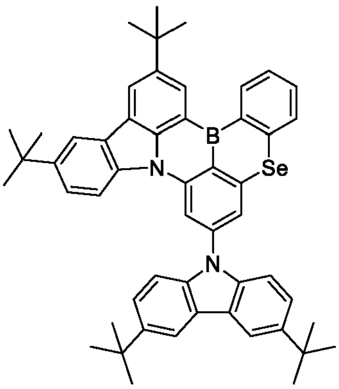,
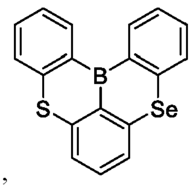,
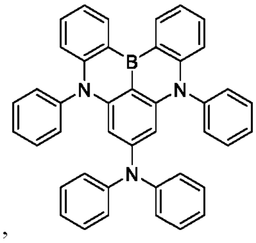,
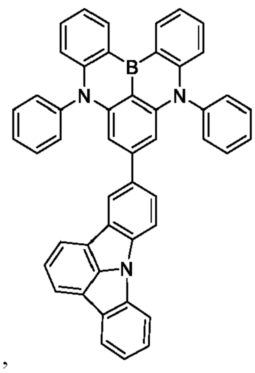,

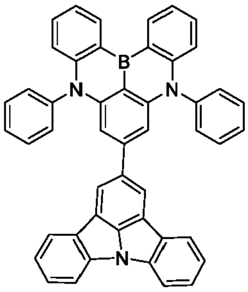,
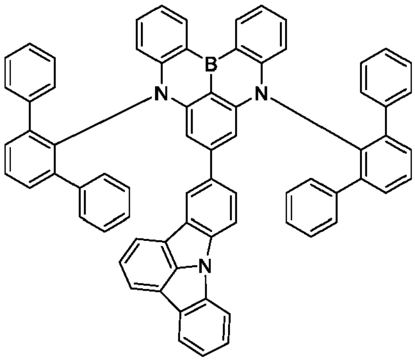,
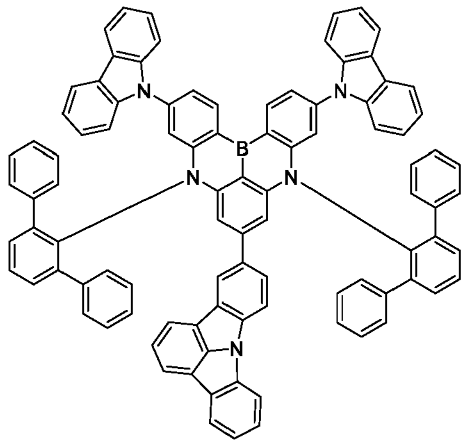,

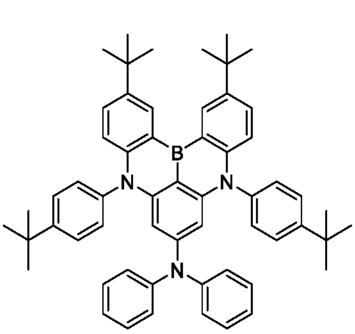,
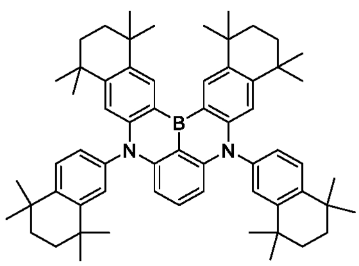,
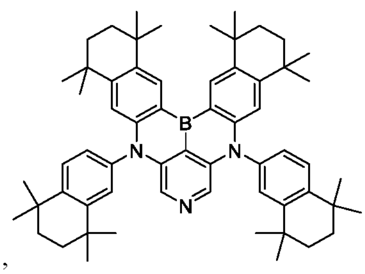,

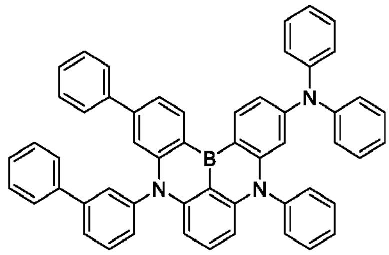,
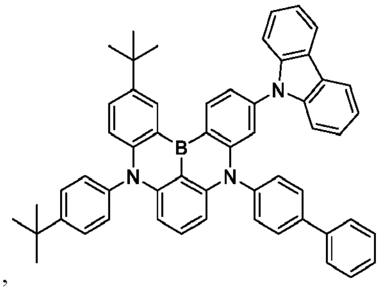,
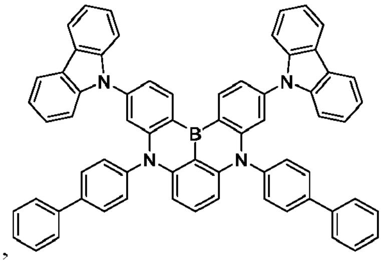,

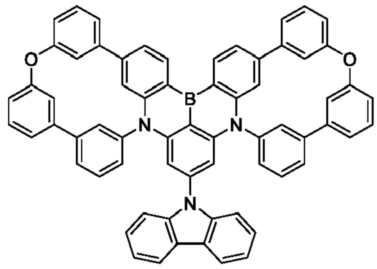,
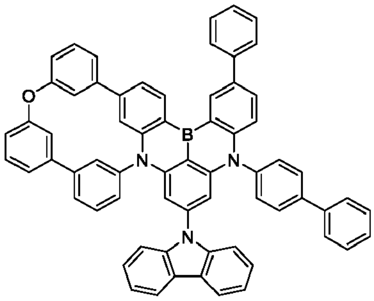,
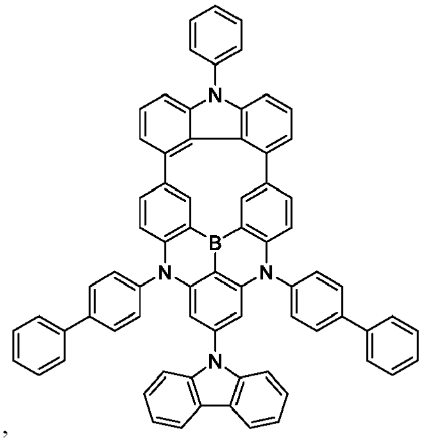,

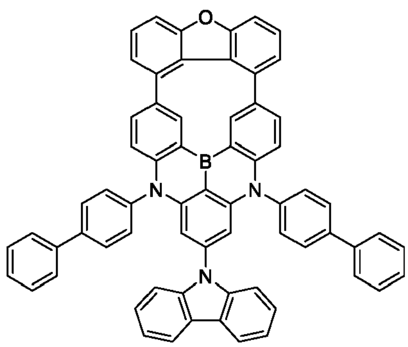,
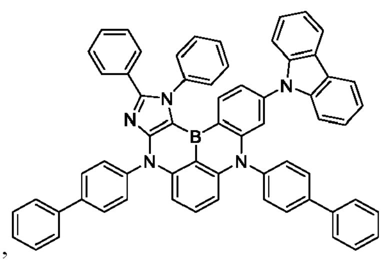,
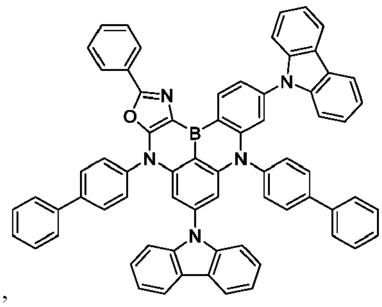,

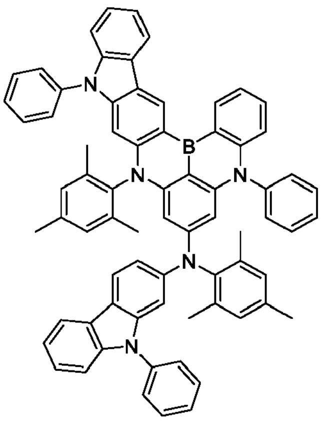,
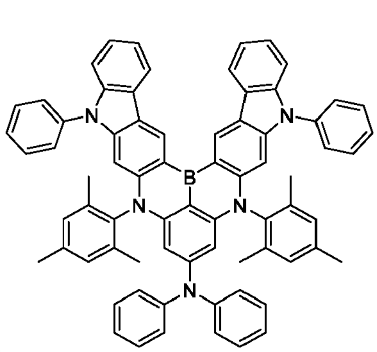,

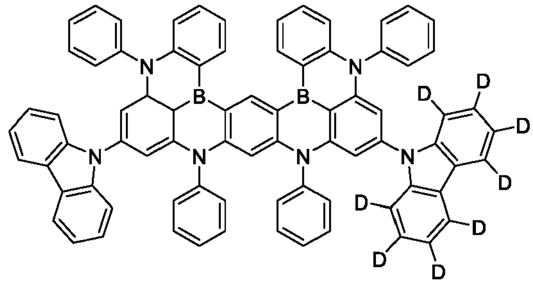
,
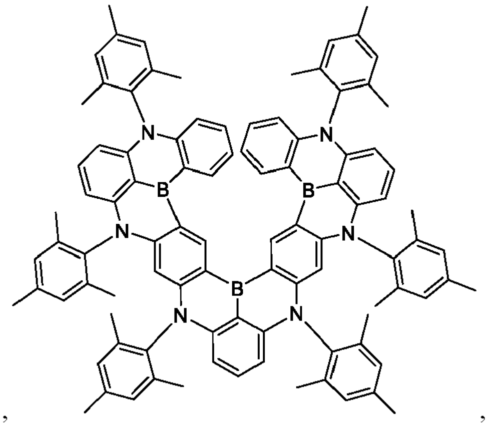
,

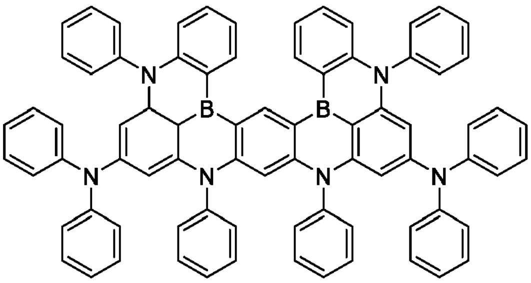
,
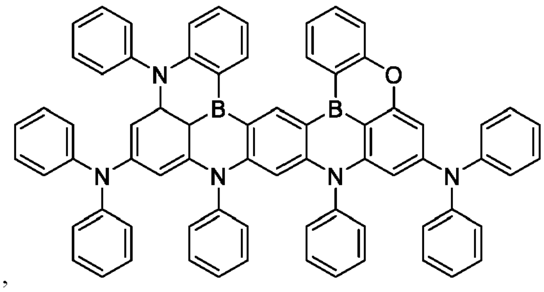
,

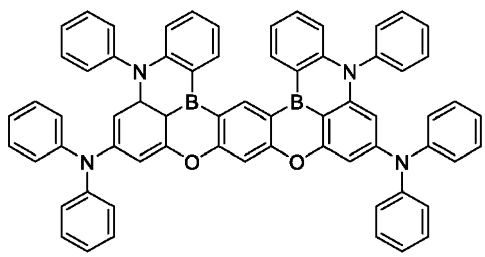
,
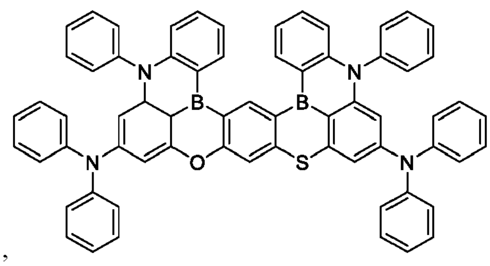
,

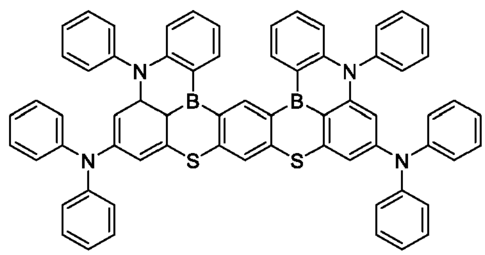
,
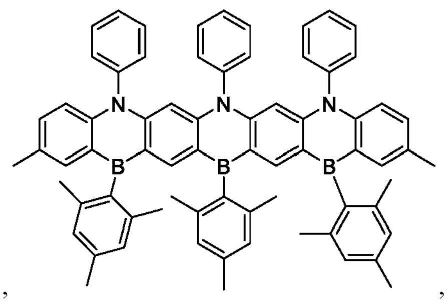
,

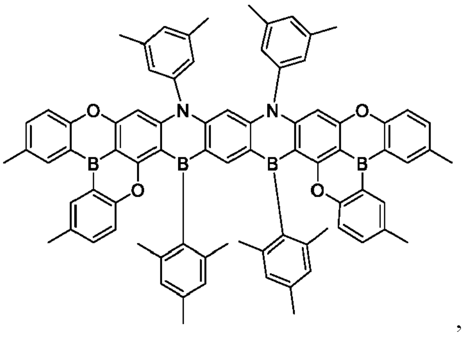
,
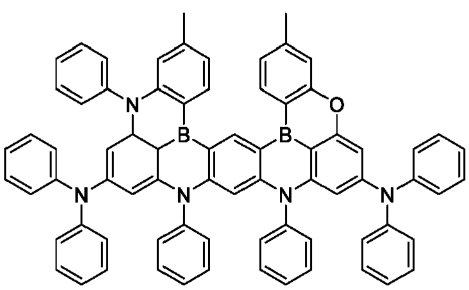
,

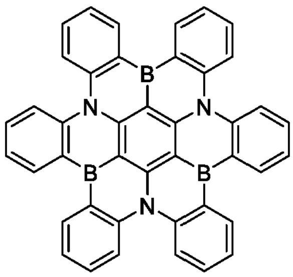,
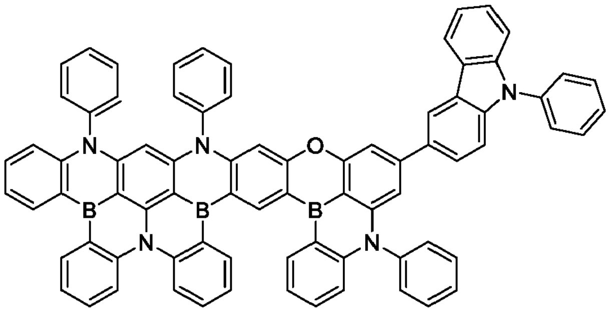,

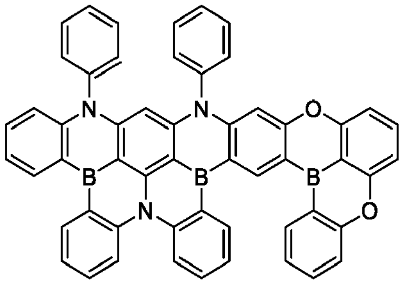,
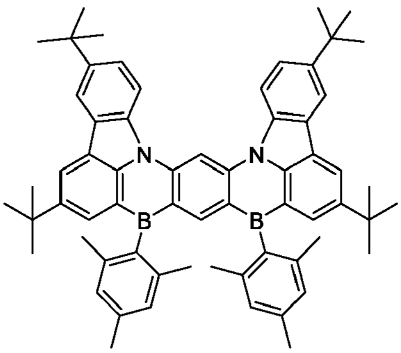,

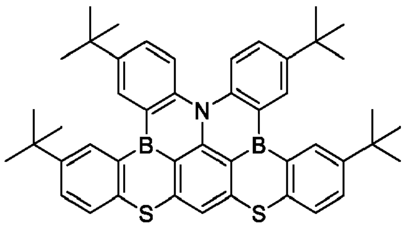,
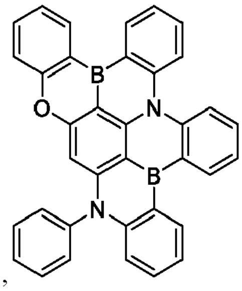,

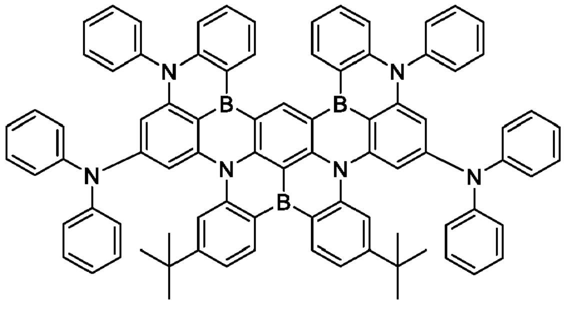,
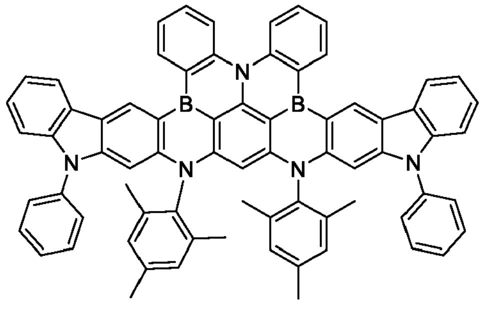,

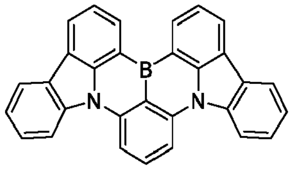,
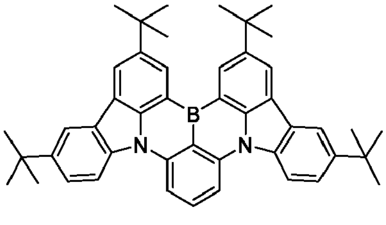,
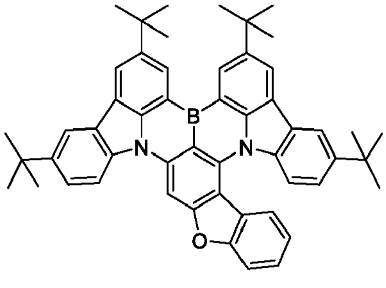,

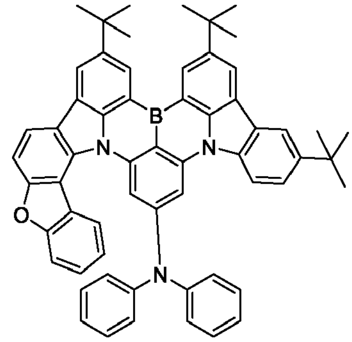,
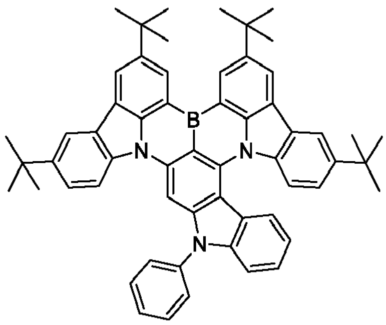,
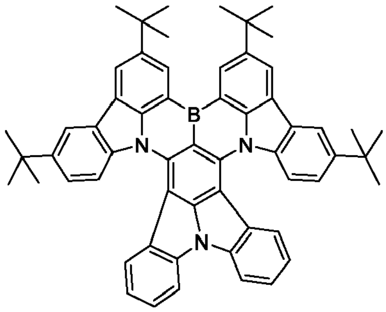,

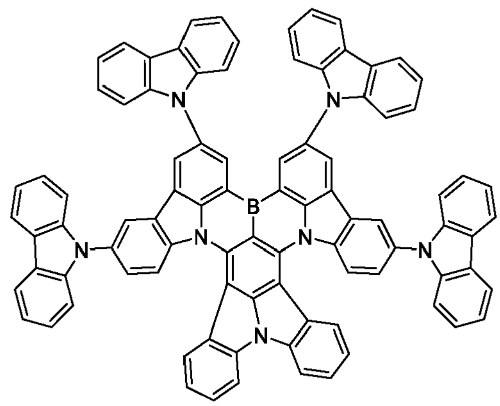,
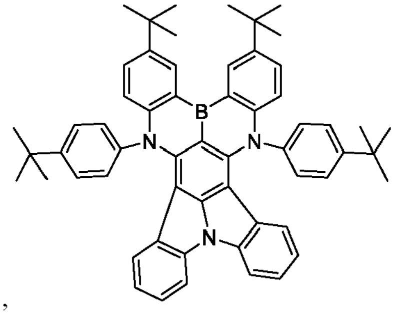,

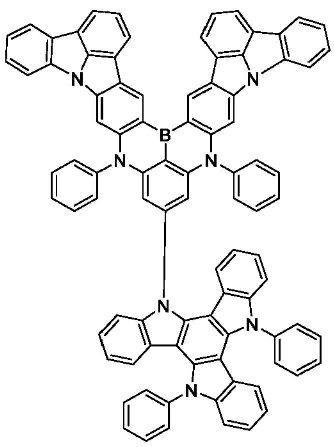,
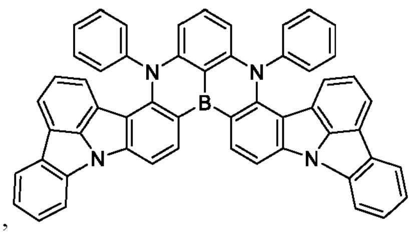,
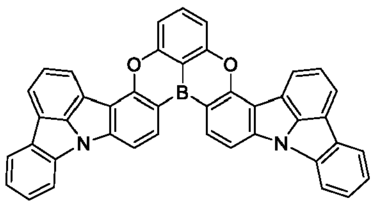,

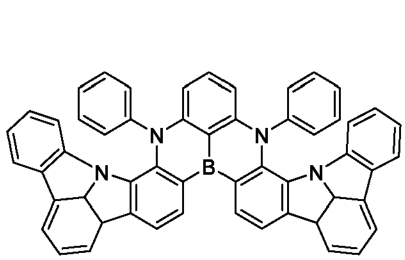,
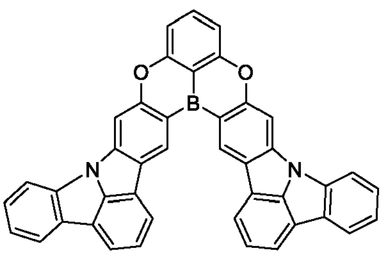,
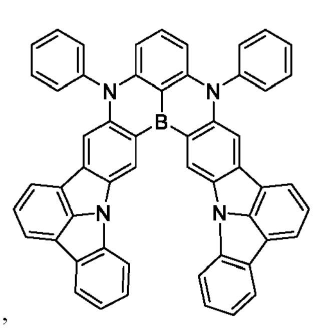,

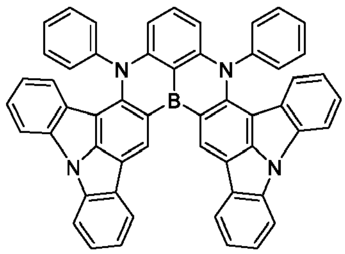 , 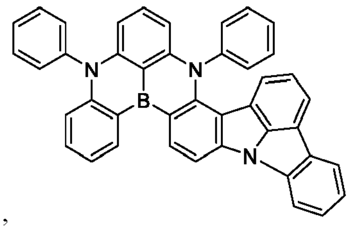 , 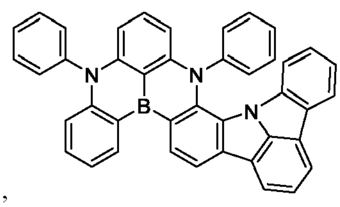 ,

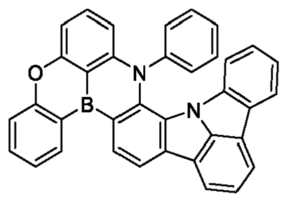 , 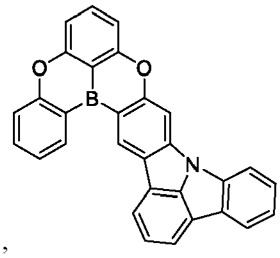 , 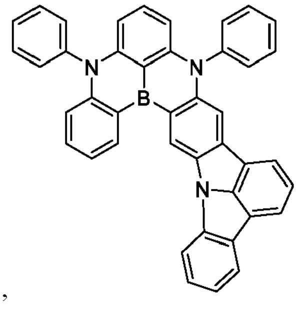 , 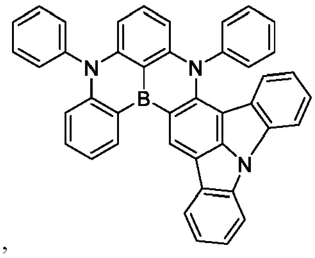 ,

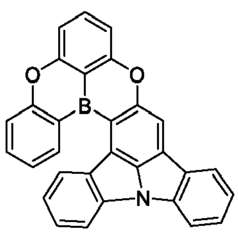 , 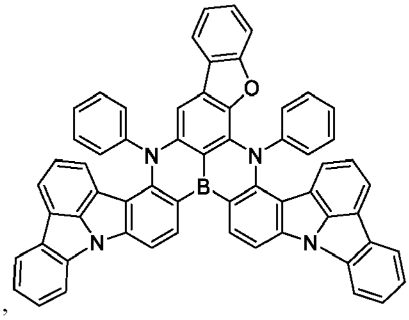 , 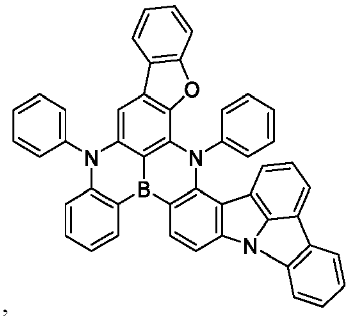 ,

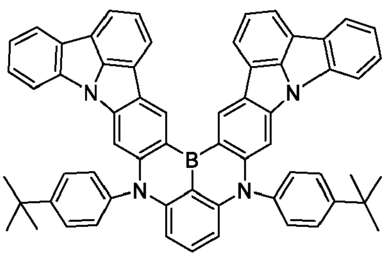 , 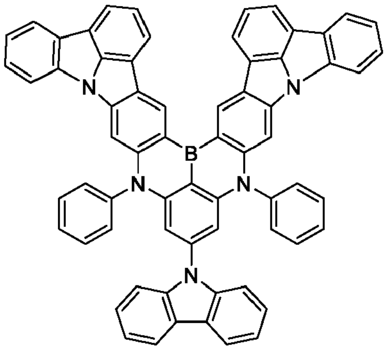 , 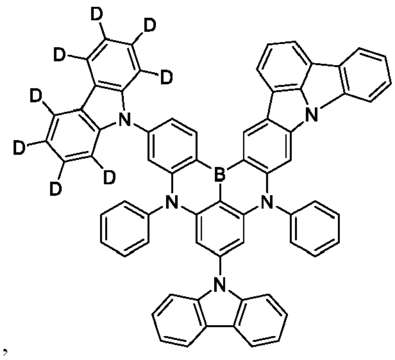 ,

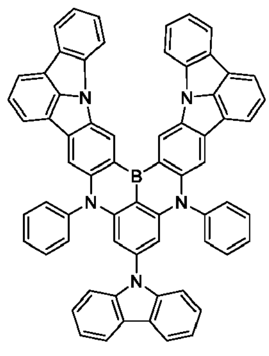 , 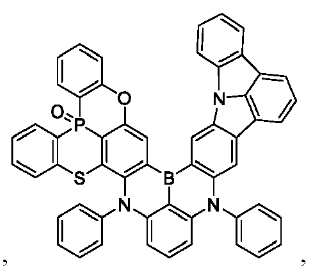 , 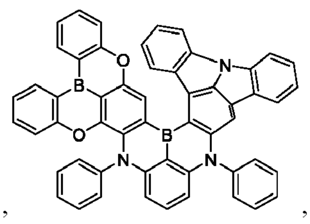 ,

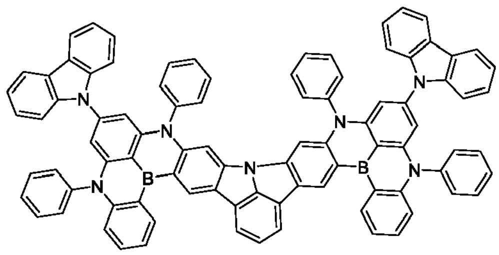,
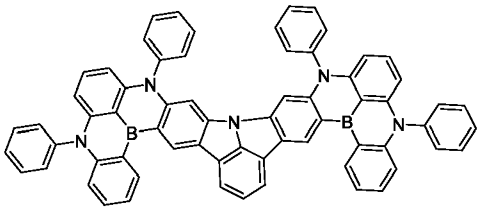,
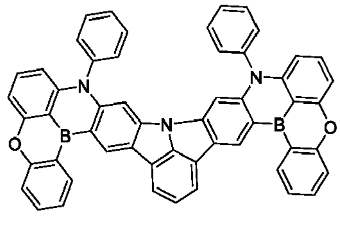,
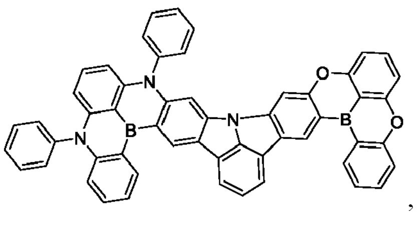,
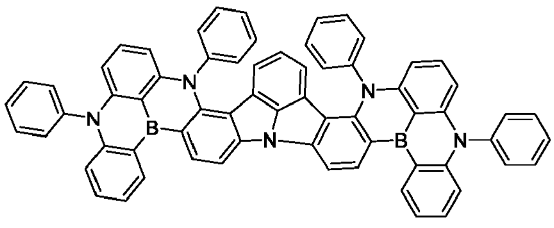,
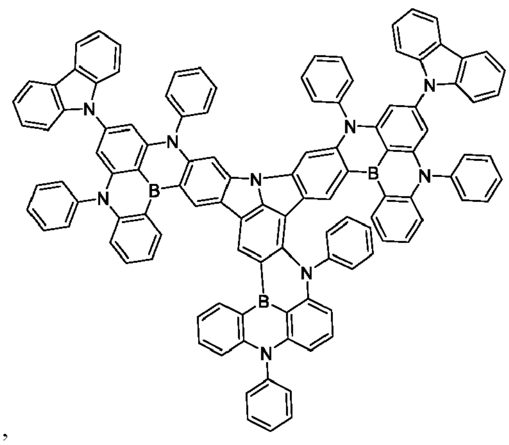,
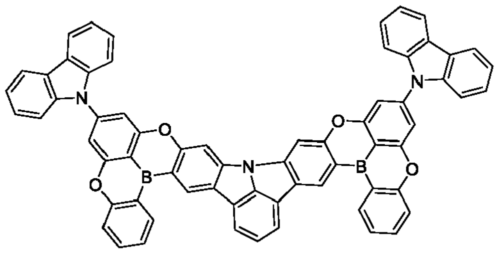,
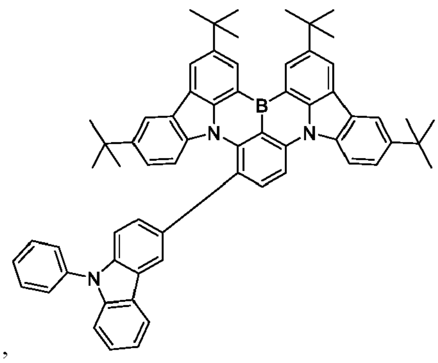,

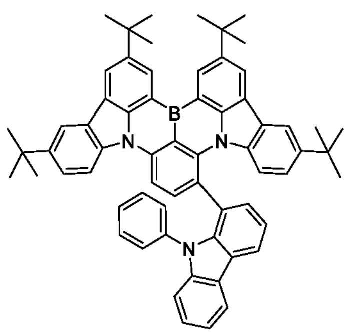,
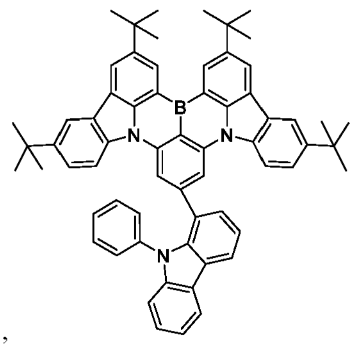,
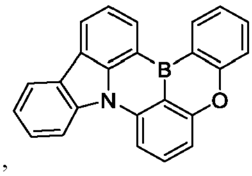,
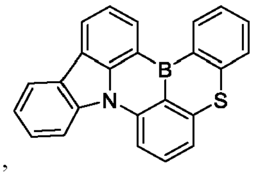,

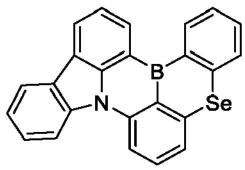,
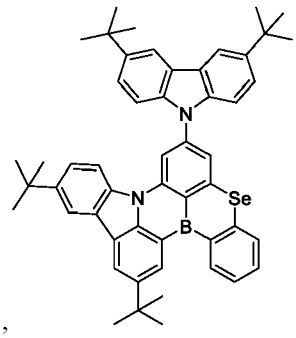,
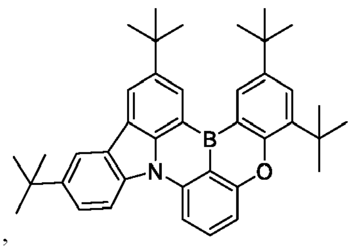,

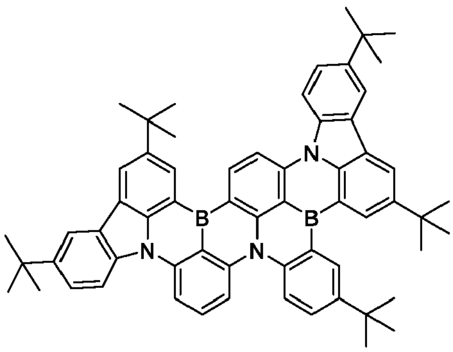,
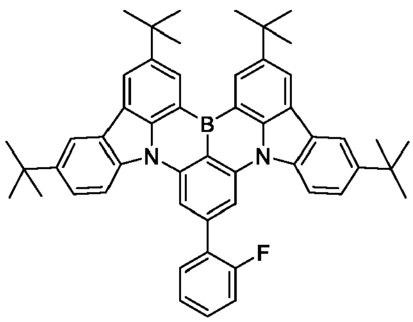,

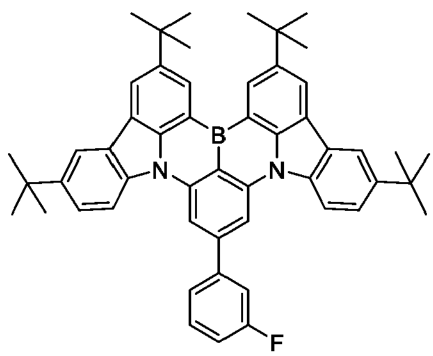,
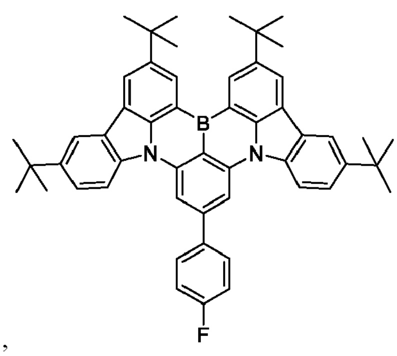,

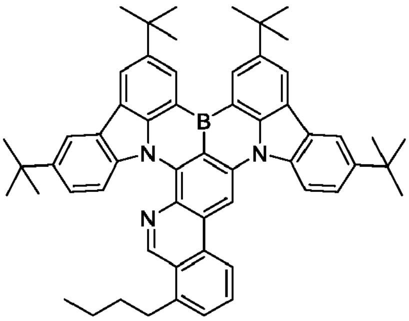

,

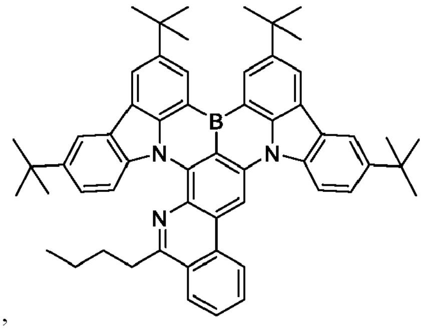

,

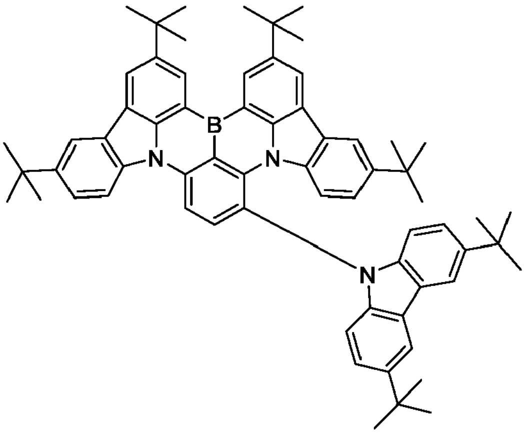

,

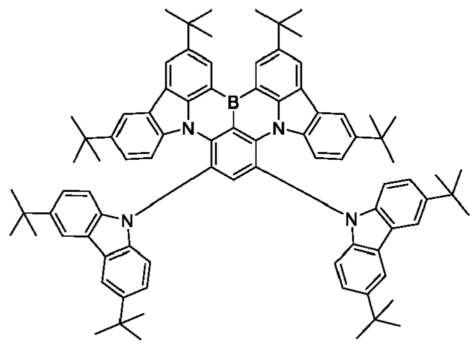

,

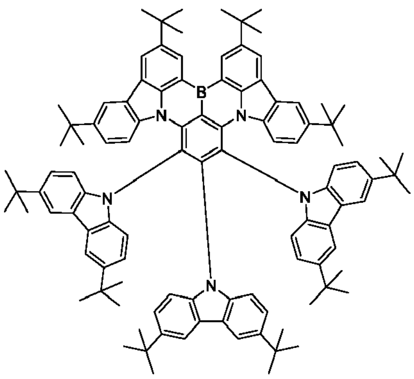

,

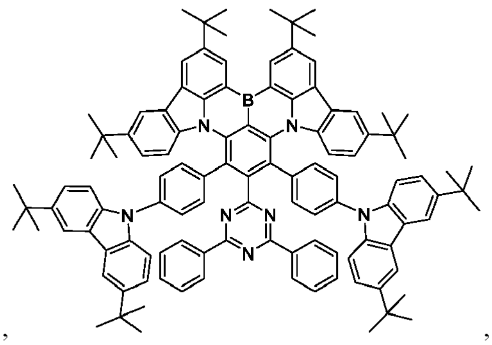

,

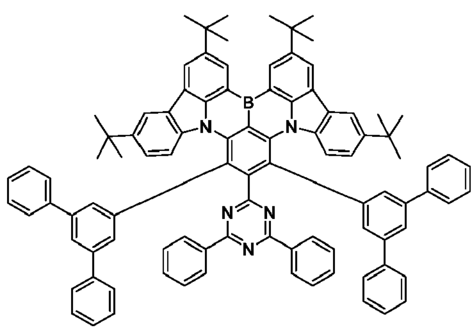

,

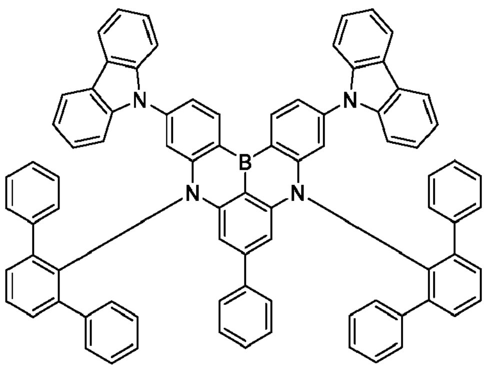

,

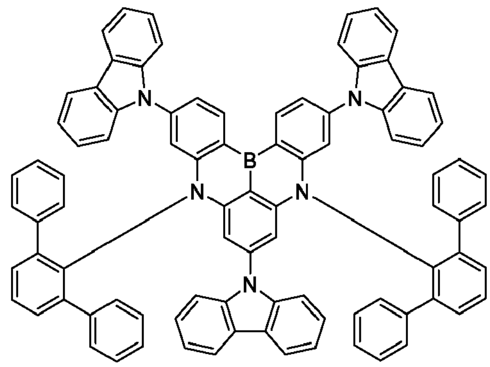 ,

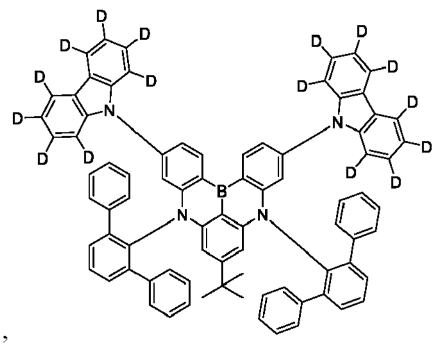 ,

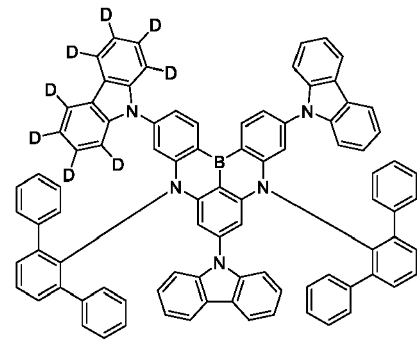 ,

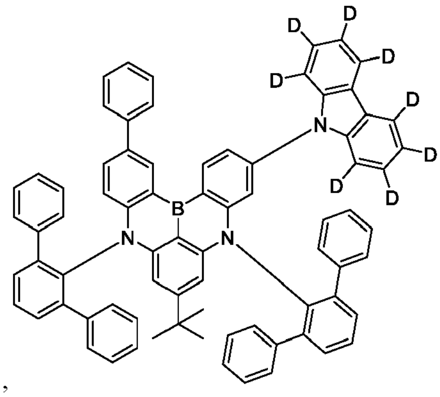 ,

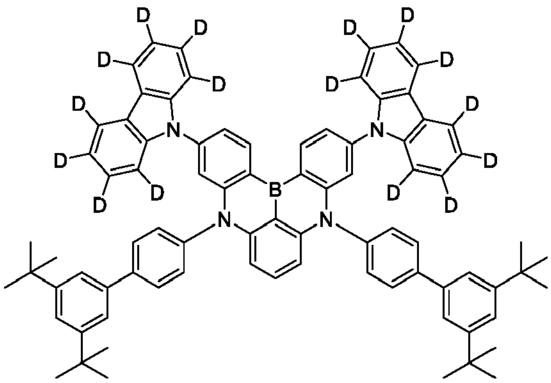 ,

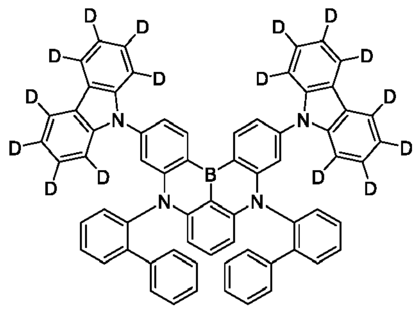 ,

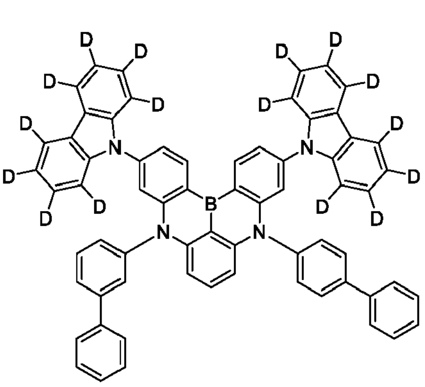 ,

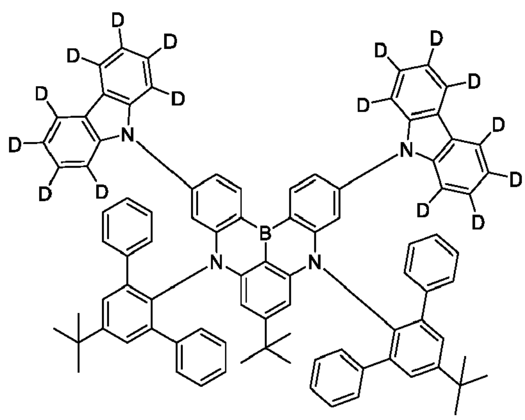 ,

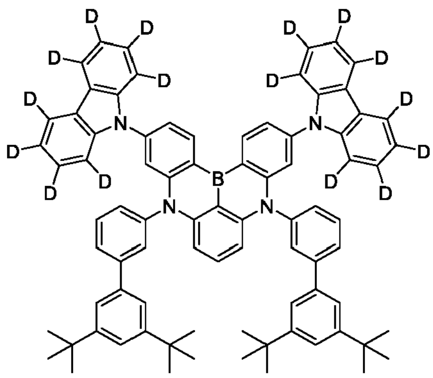

,

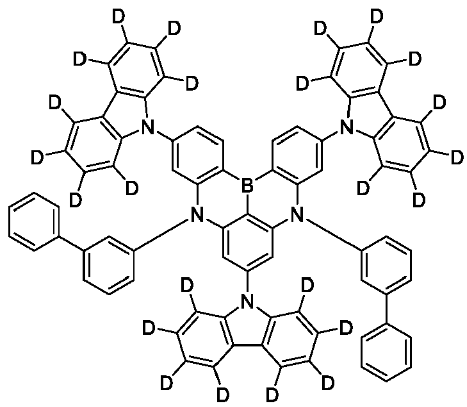

,

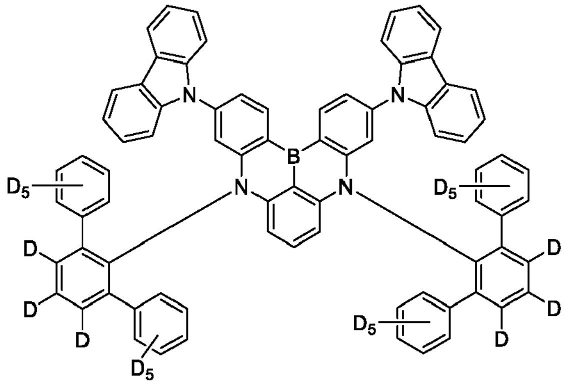

,

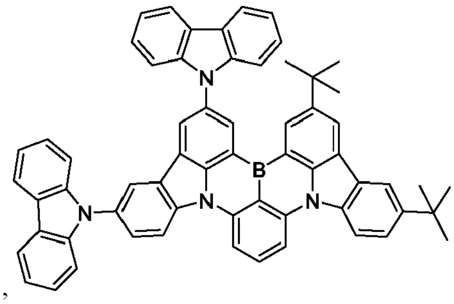

,

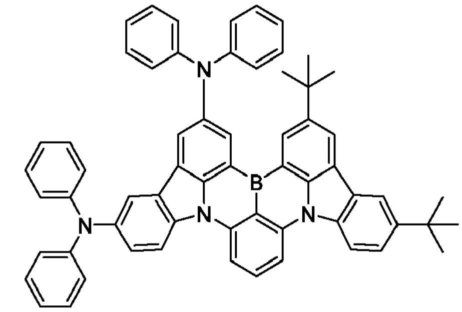

,

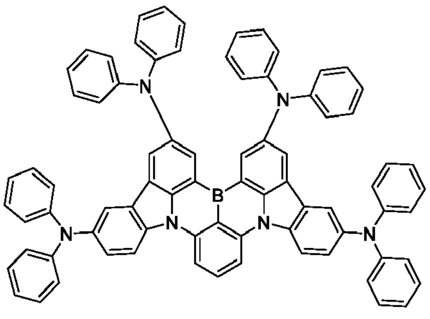

,

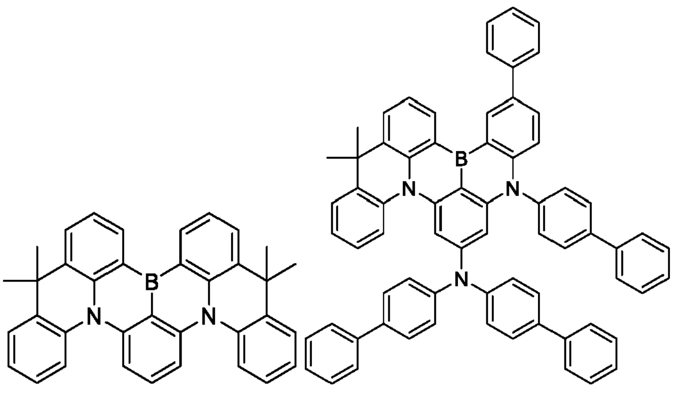

,

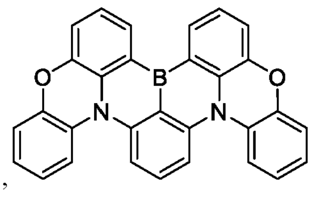

,

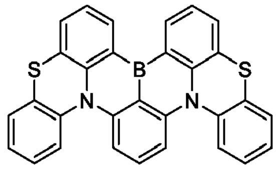, 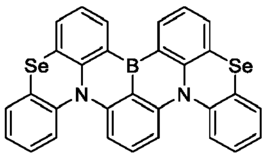, 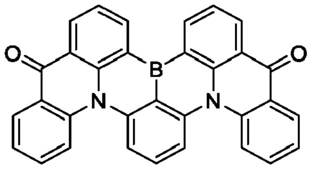,

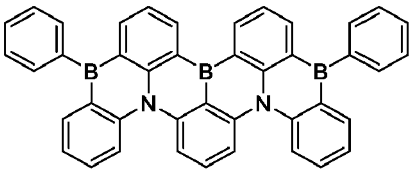, 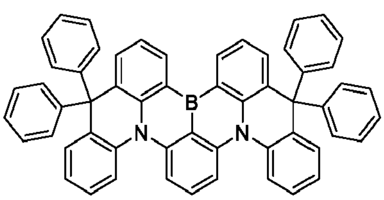, 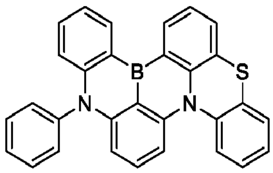,

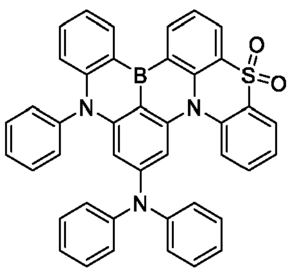, 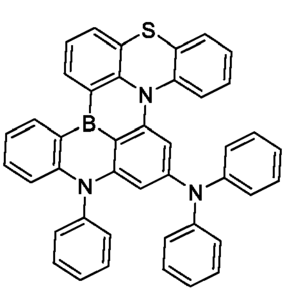, 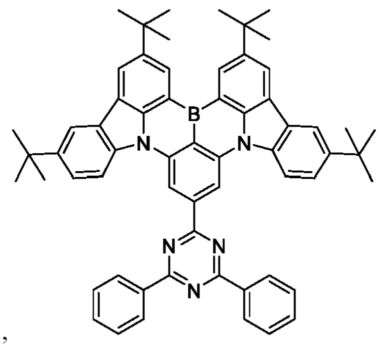,

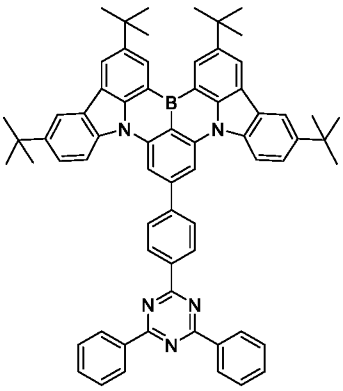, 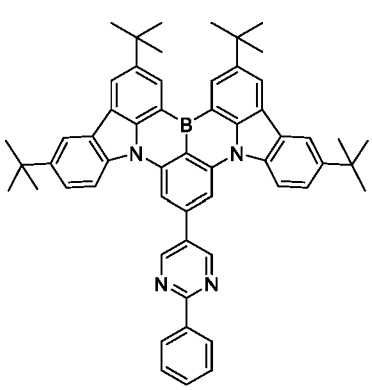, 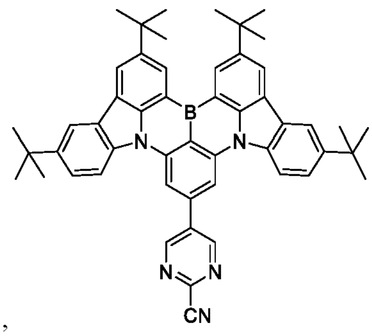,

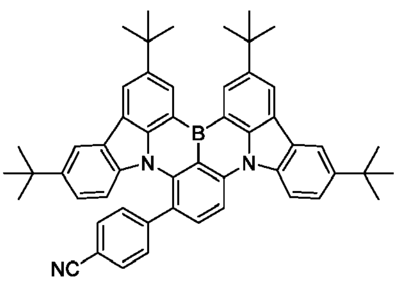, 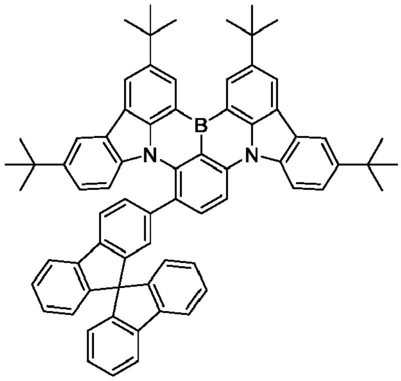, 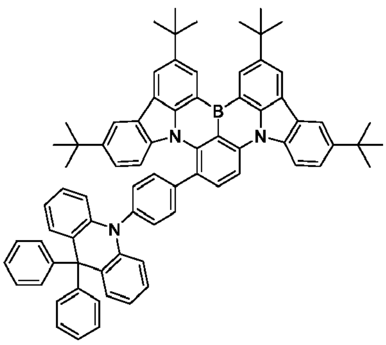,

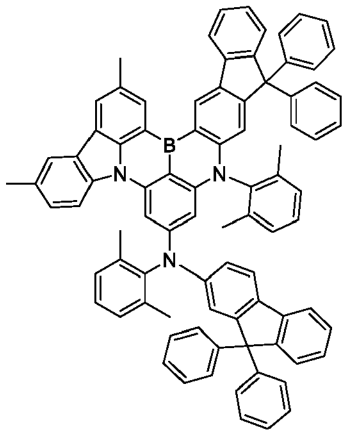

,

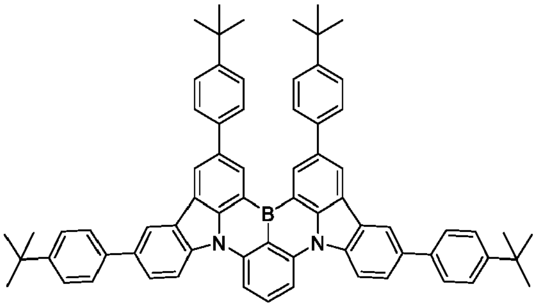

,

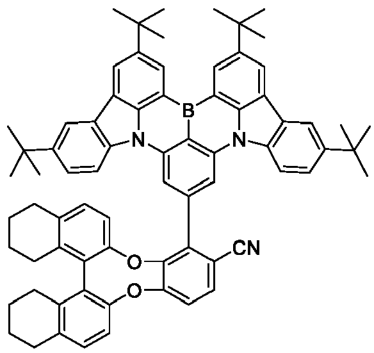

,

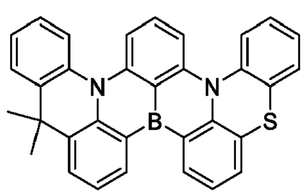

,

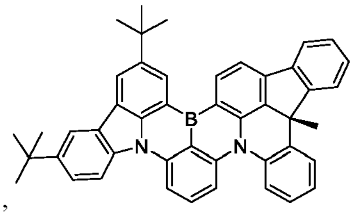

,

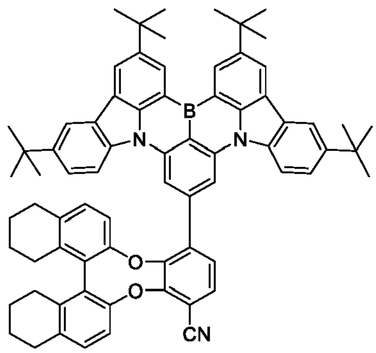

,

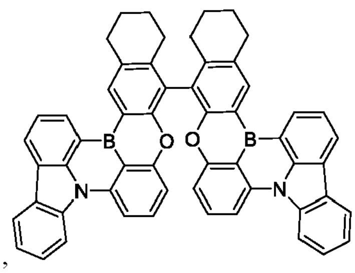

,

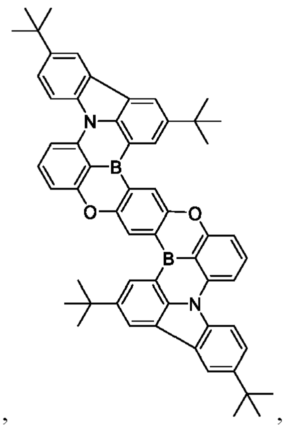

,

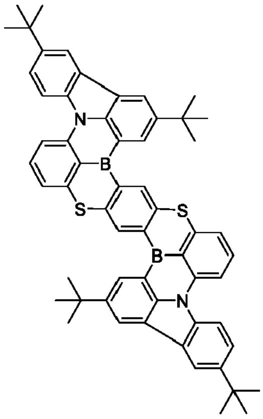

,

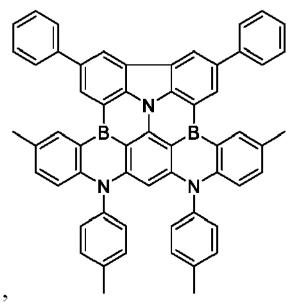

,

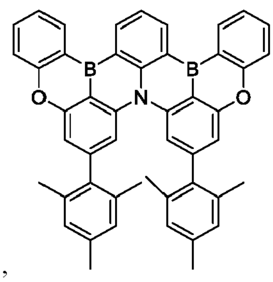

,

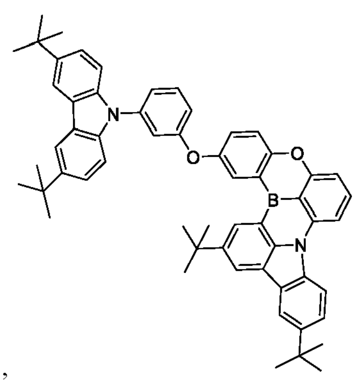

,

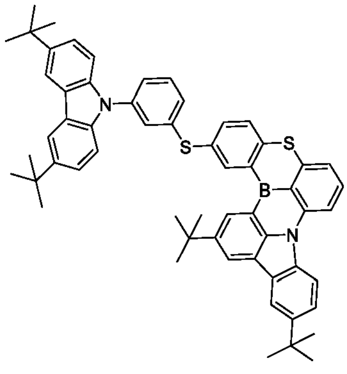,
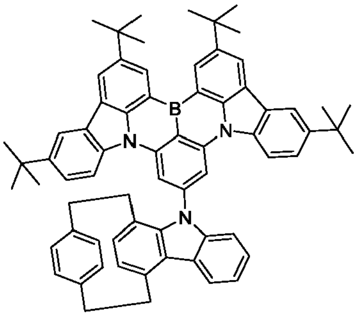,
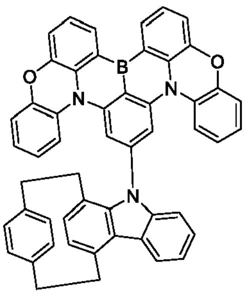,

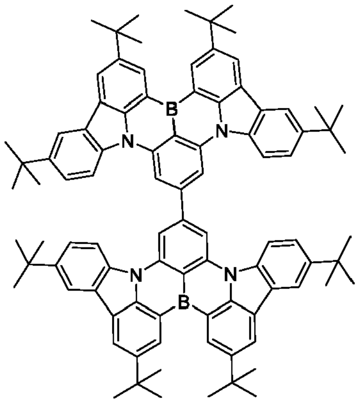,
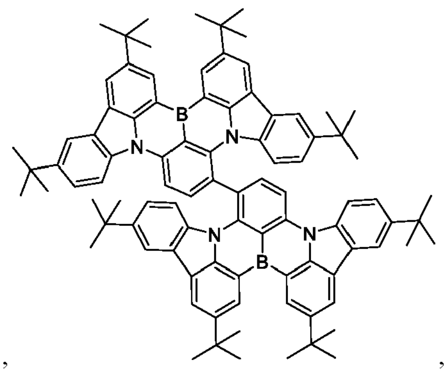,
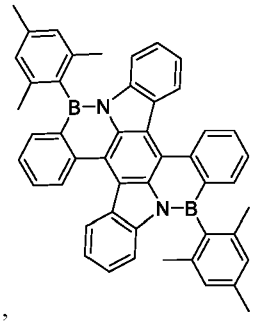,

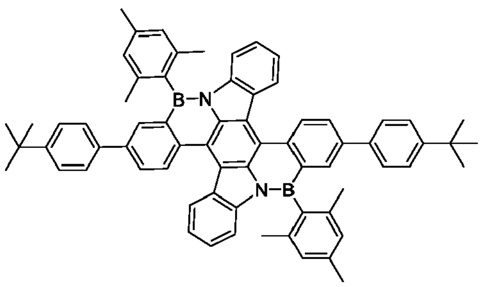,
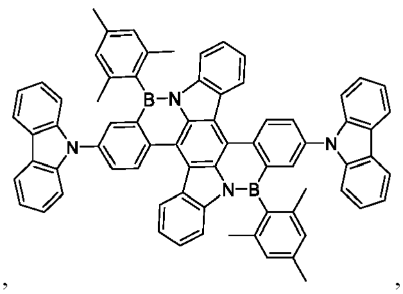,

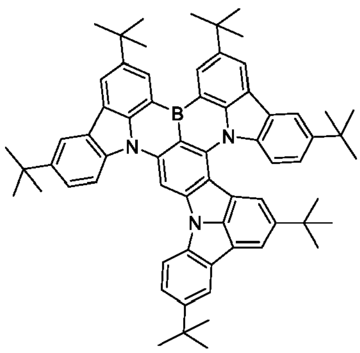,
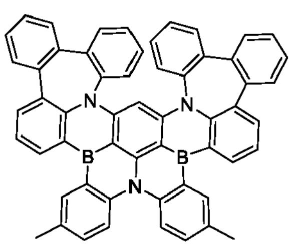,
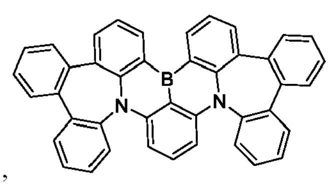,

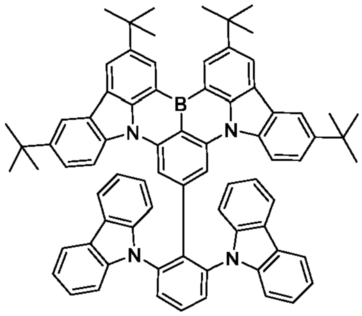,
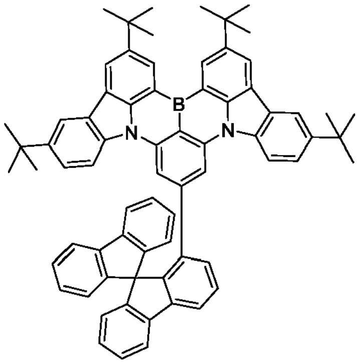,
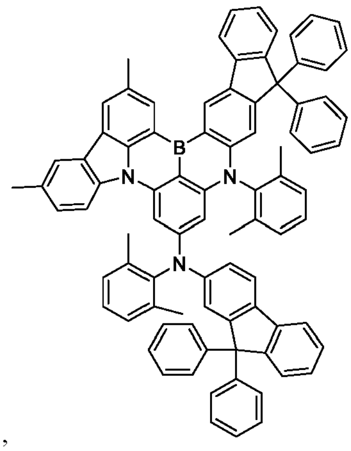,

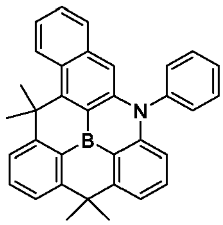,
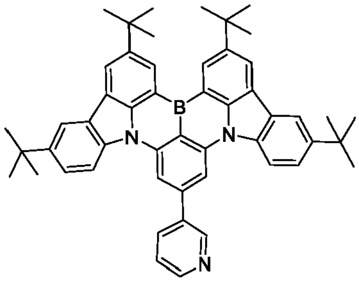,
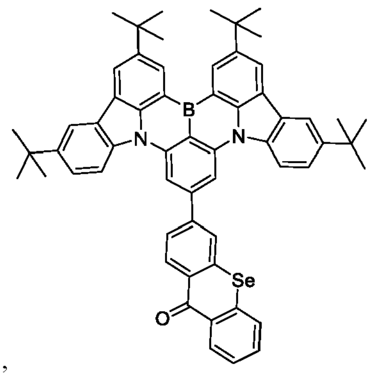,

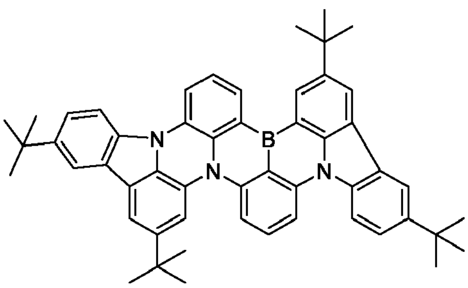,
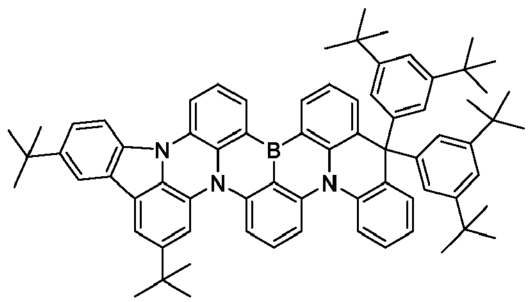,

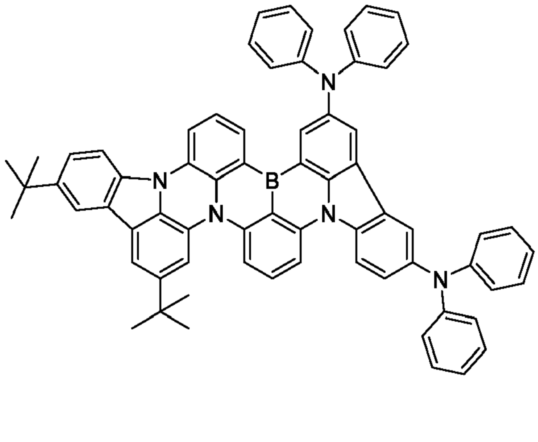,
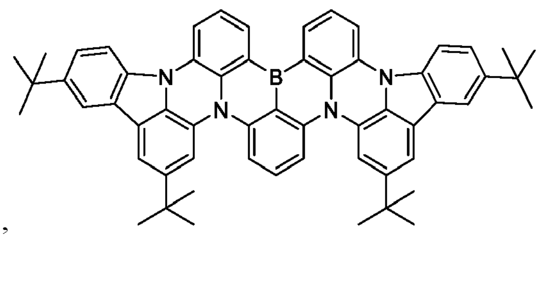,

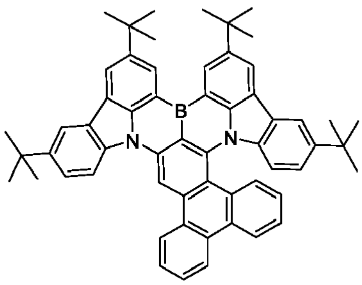 , 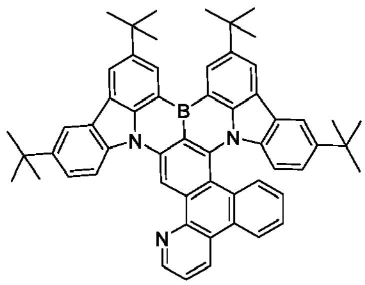 , 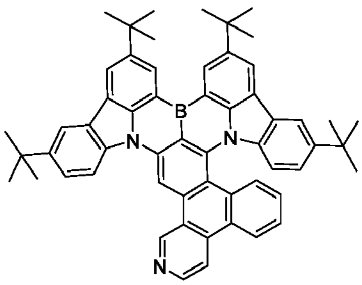 ,

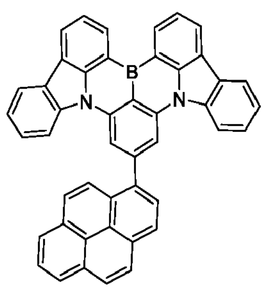 , 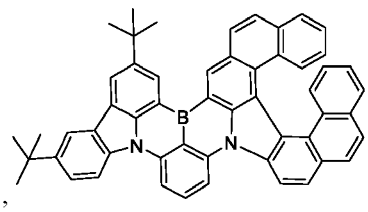 , 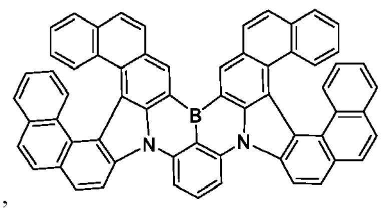 ,

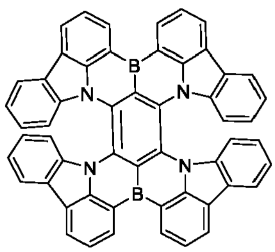 , 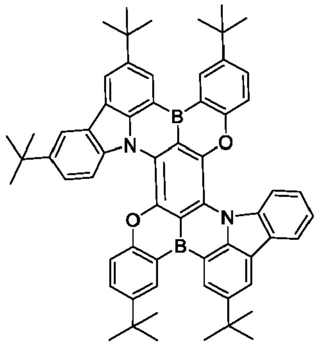 , 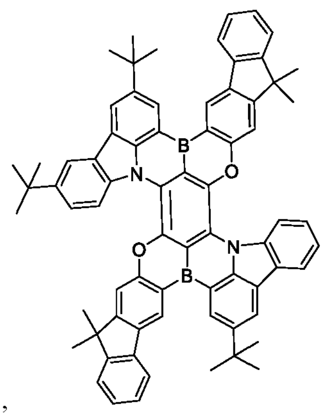 ,

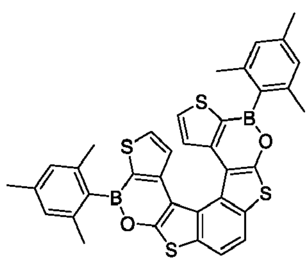 , 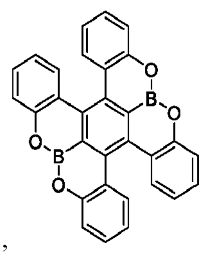 , 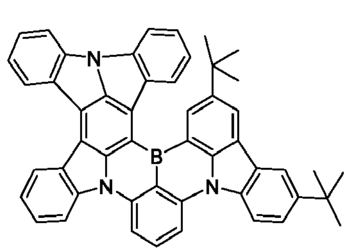 ,

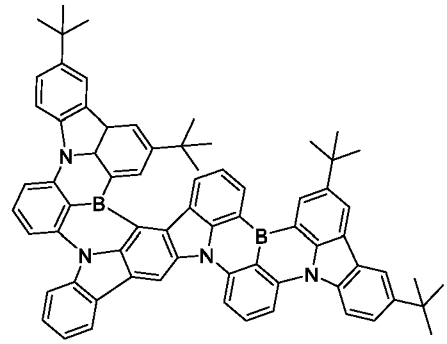,
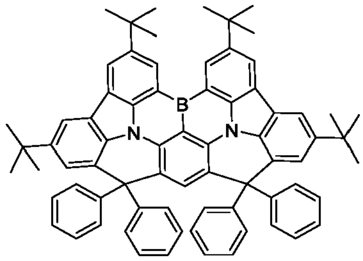,
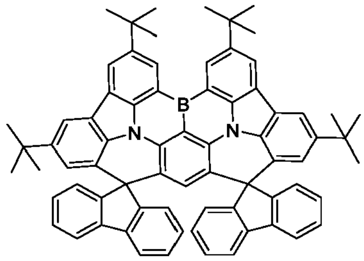,

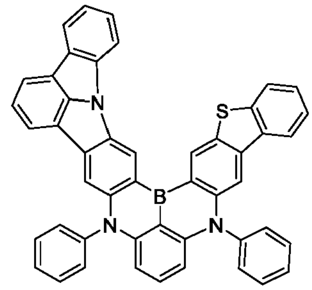,
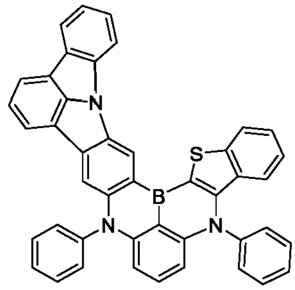,
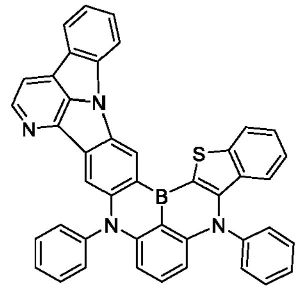,

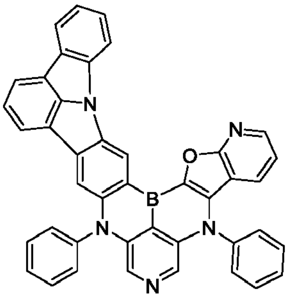,
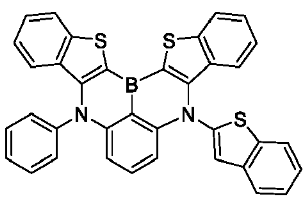,
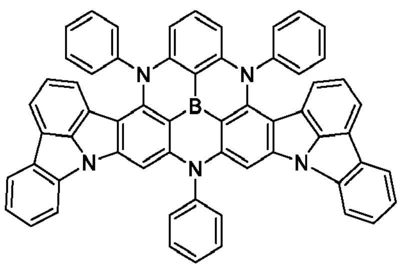,

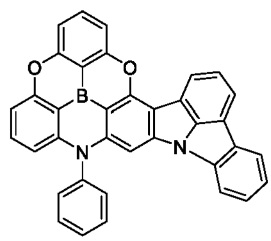,
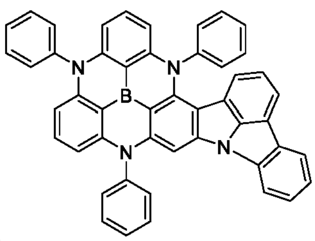,
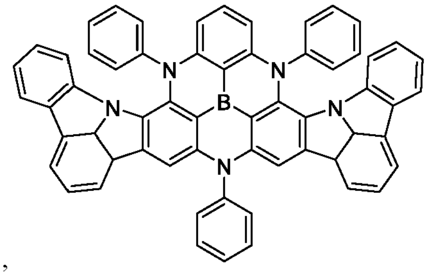,

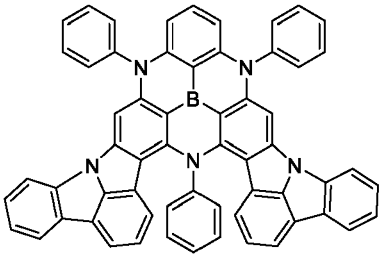,
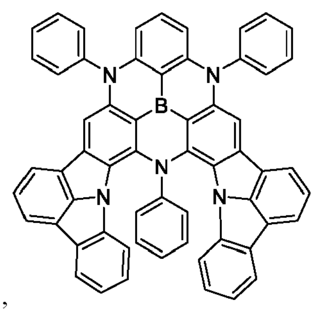,
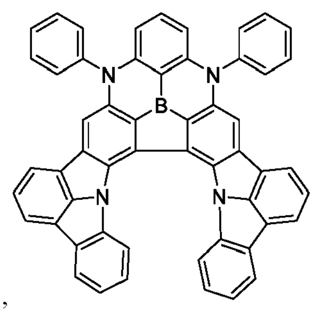,

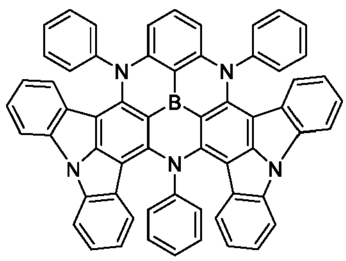 , 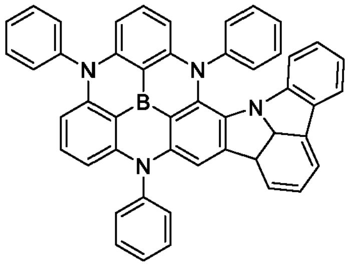 , 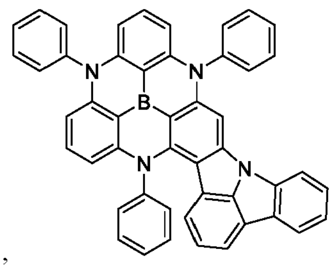 ,

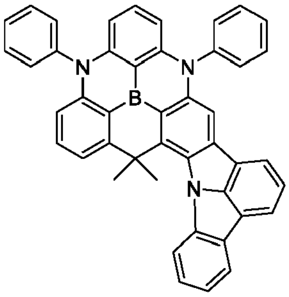 , 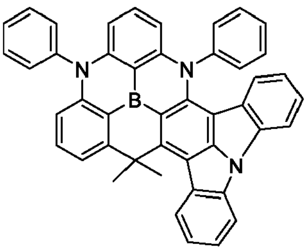 , 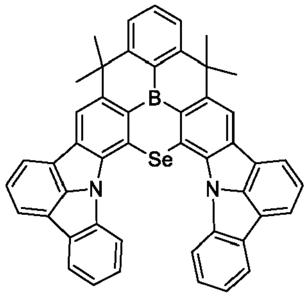 ,

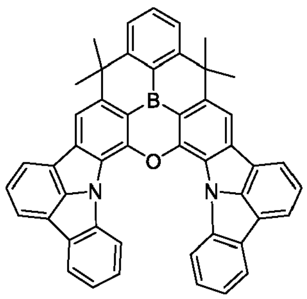 , 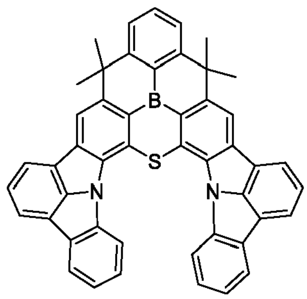 , 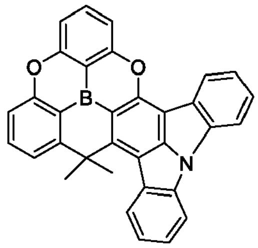 , 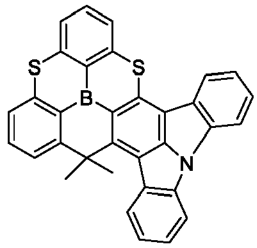 ,

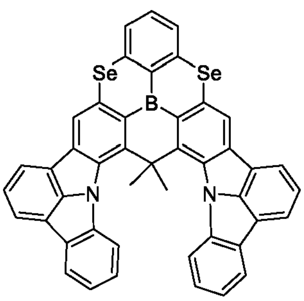 , 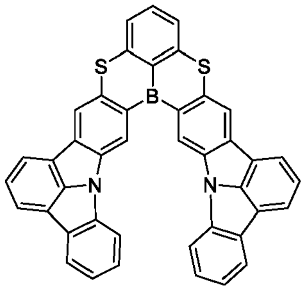 , 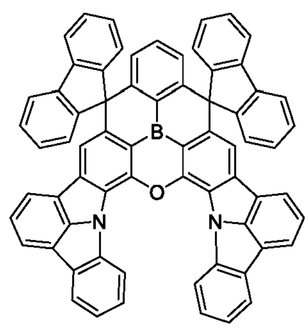 ,

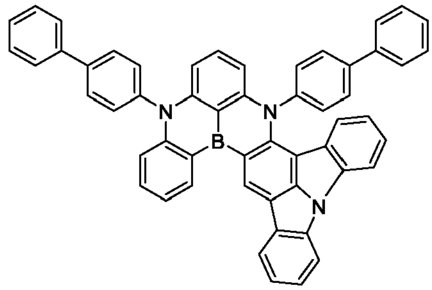 , 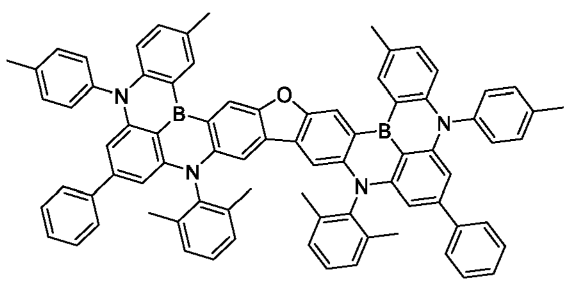 ,

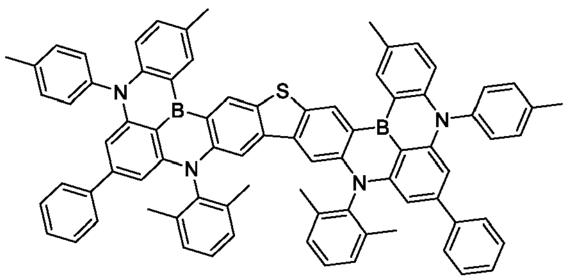, 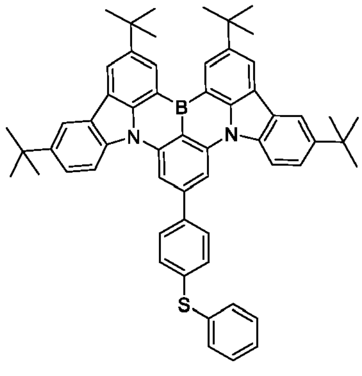,

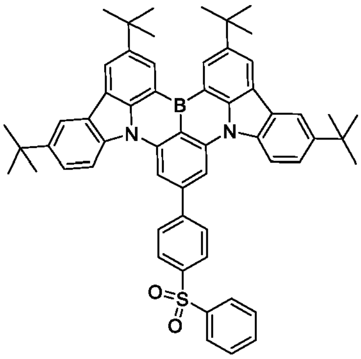, 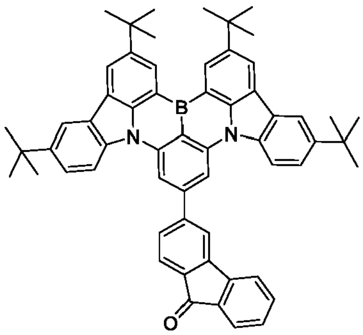, 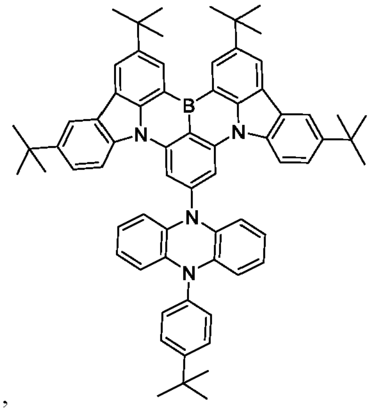,

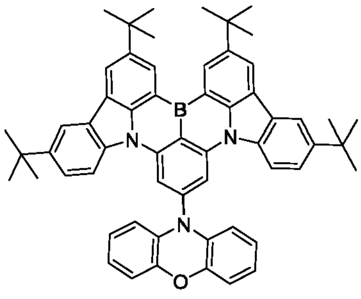, 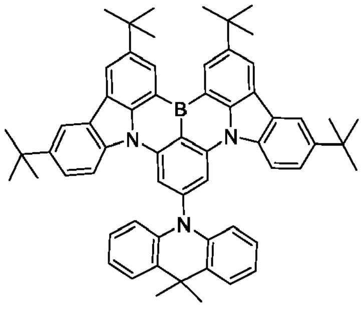, 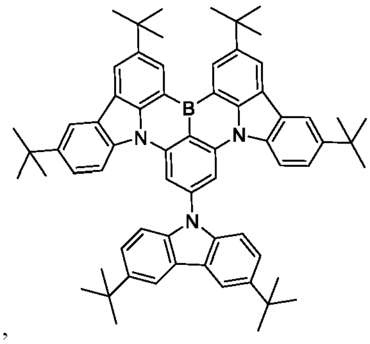,

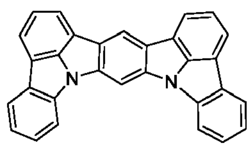, 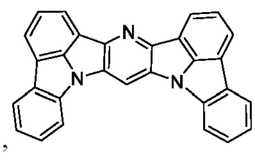, 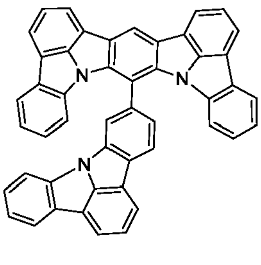, 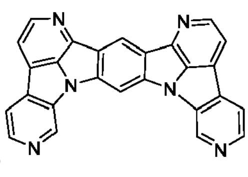,

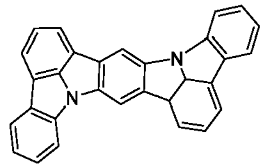,
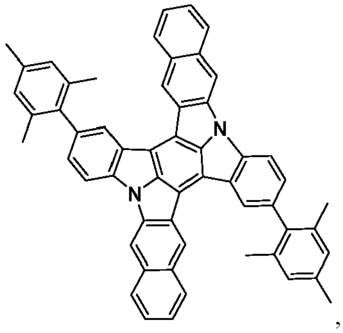,
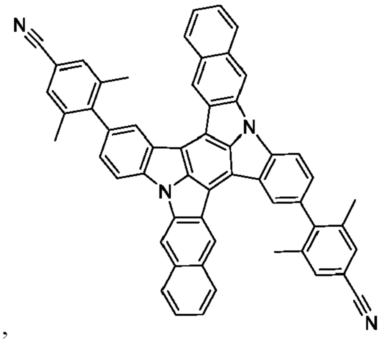,

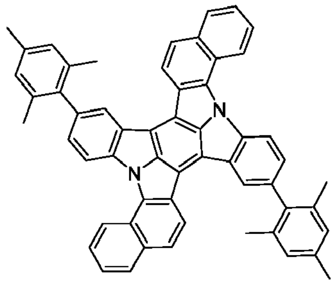,
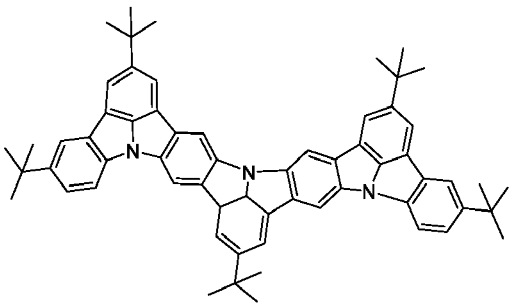,

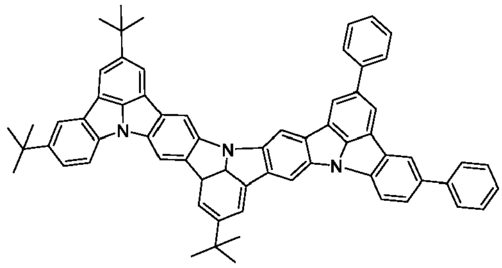,
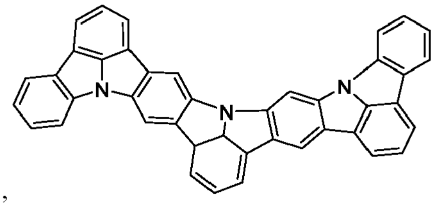,

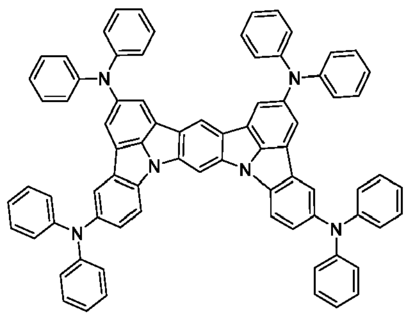,
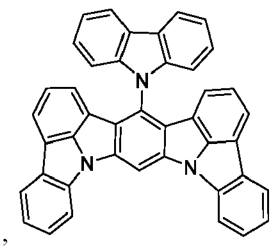,
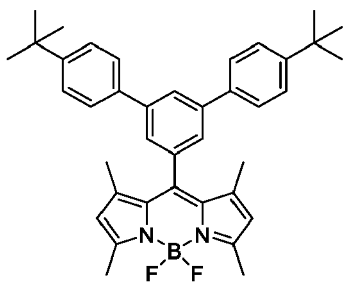,

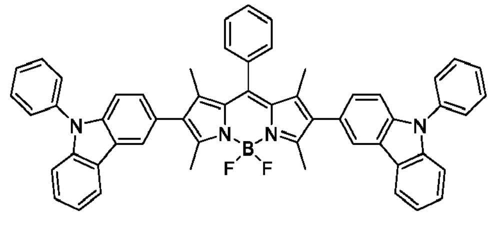,
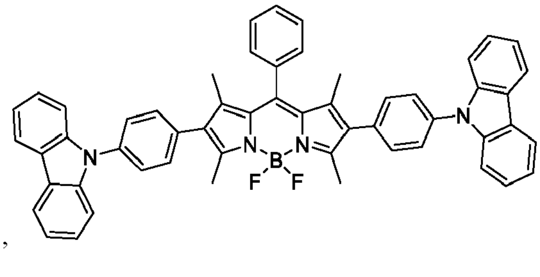,

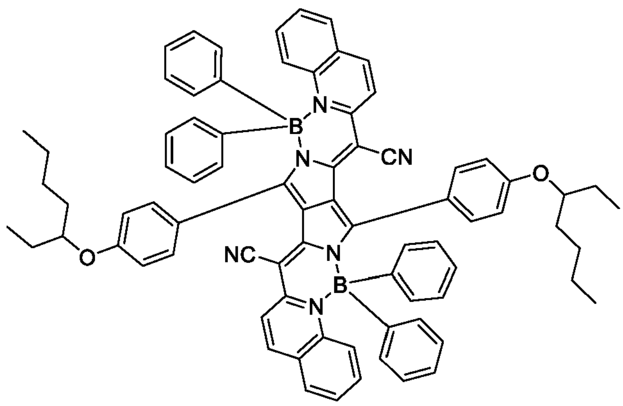 , 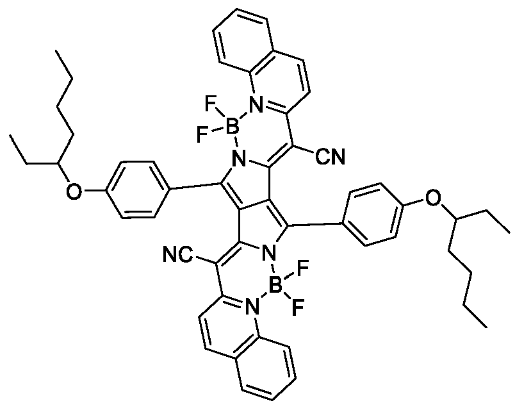 ,

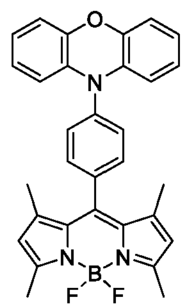 , 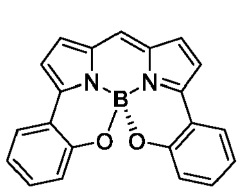 , 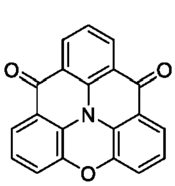 , 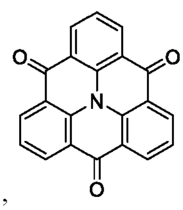 , 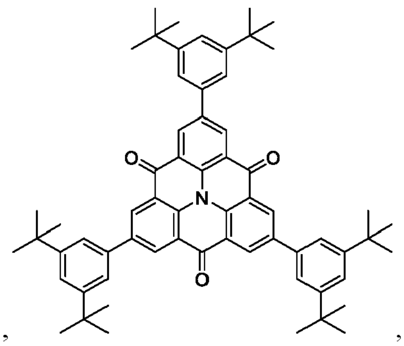 ,

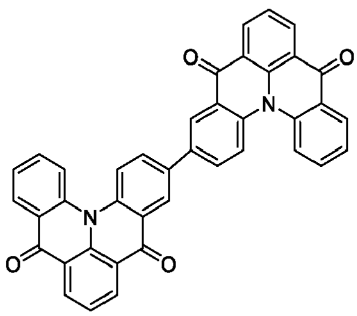 , 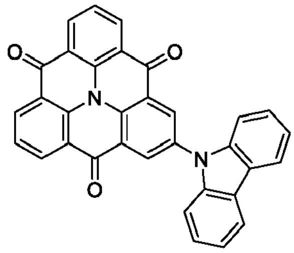 , 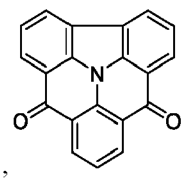 , 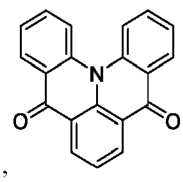 ,

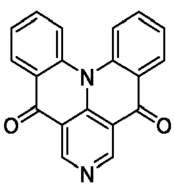 , 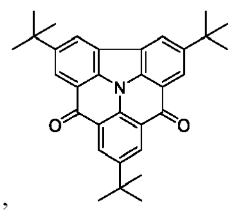 , 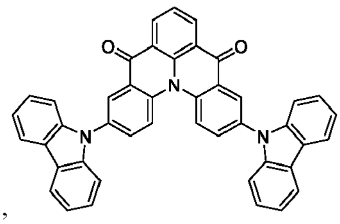 , 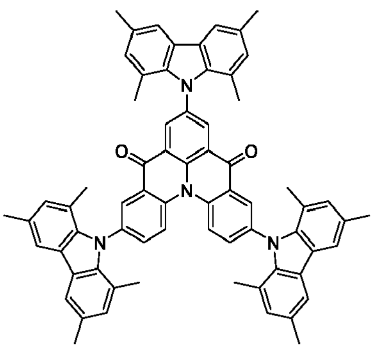 ,

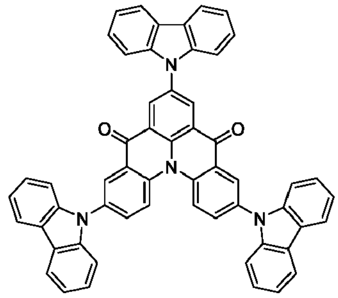 , 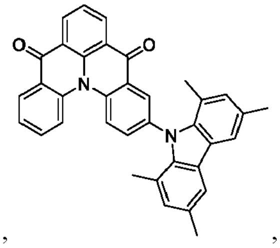 , 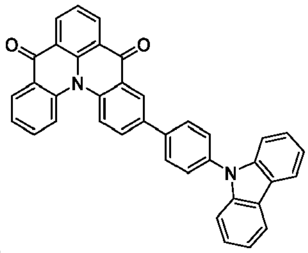 ,

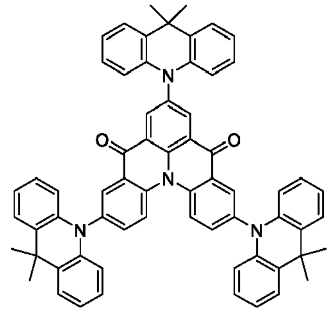 , 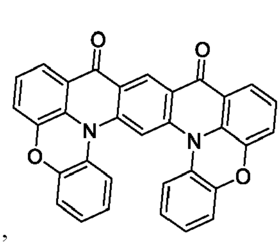 , 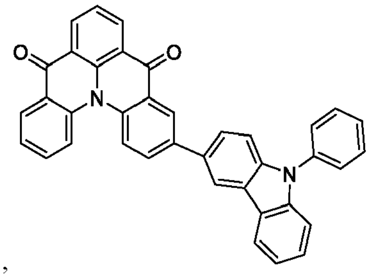 ,

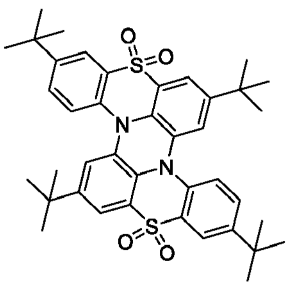 , 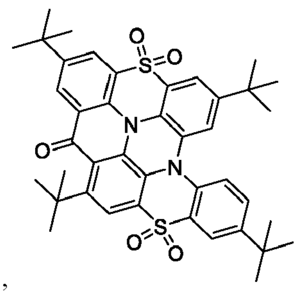 , 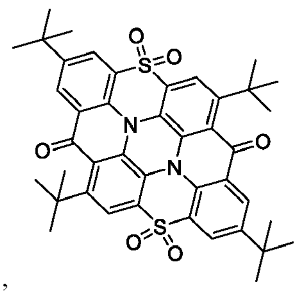 , 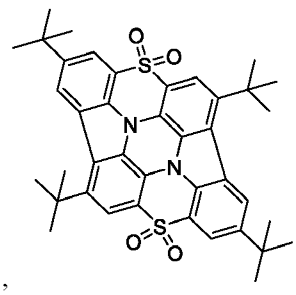 ,

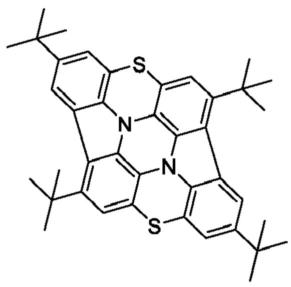 , 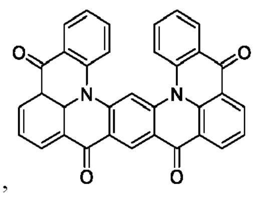 , 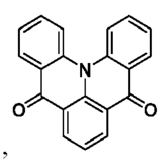 , 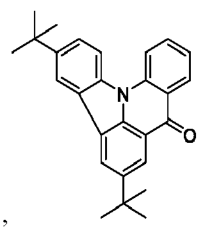 , 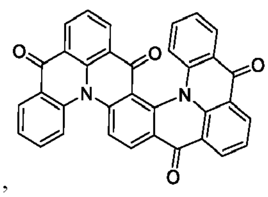 ,

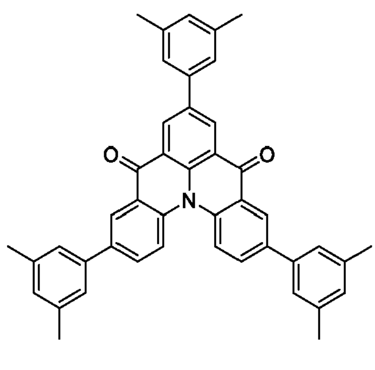 , 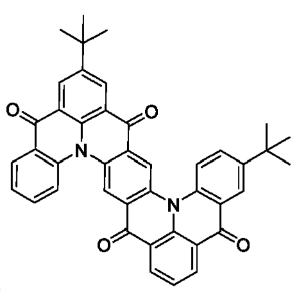 , 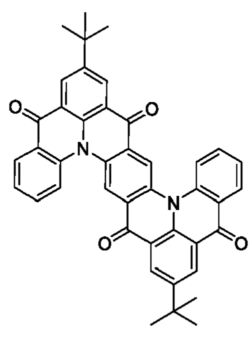 ,

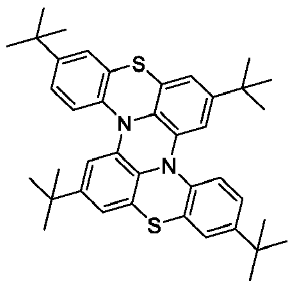, 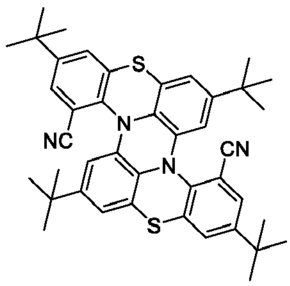, 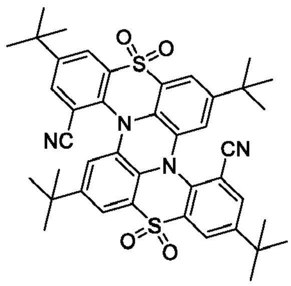,

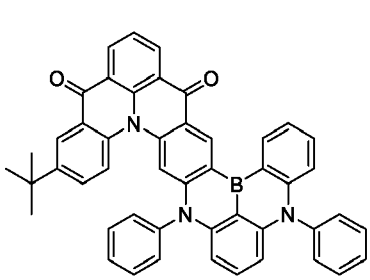, 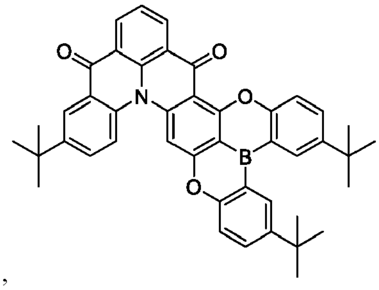, 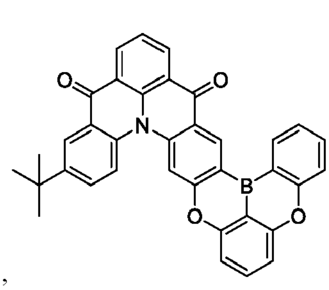,

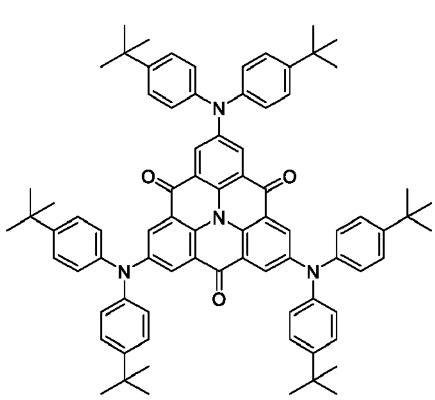, 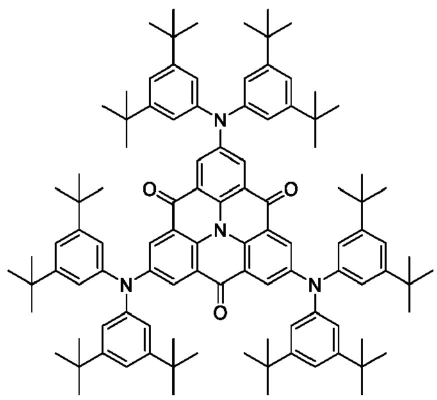,

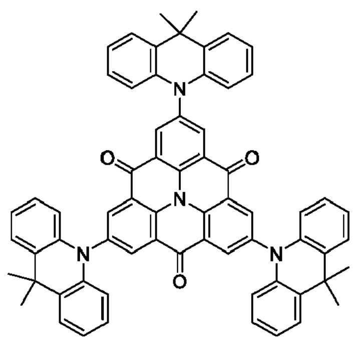, 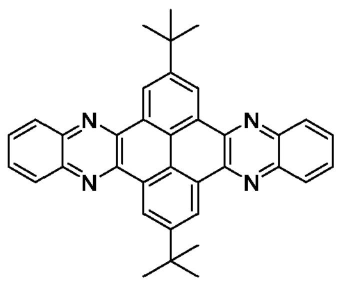,

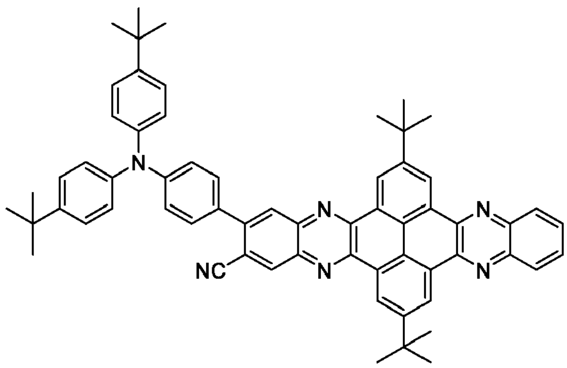
,
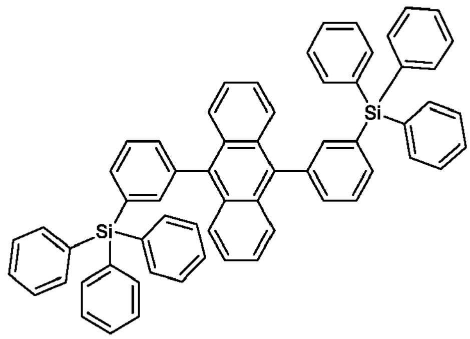
,

aza-substituted variants thereof, fully or partially deuterated variants thereof, and combinations thereof.

In some embodiments, the emissive region further comprises a first host. In some embodiments, the sensitizer compound forms an exciplex with the first host in said OLED at room temperature. In some embodiments, the first host has a LUMO energy that is lower than the LUMO energies of the sensitizer compound and the acceptor compound in the emissive region. In some embodiments, the first host has a HOMO energy that is lower than the HOMO energies of the sensitizer compound and the acceptor compound in the emissive region. In some embodiments, the first host has a HOMO energy that is higher than the HOMO energies of the sensitizer compound and the acceptor compound in the emissive region. In some embodiments, the first host has a HOMO energy that is higher than the HOMO energy of at least one of the sensitizer compound and the acceptor compound in the emissive region.

In some embodiments, the emissive region further comprises a second host. In some embodiments, the first host forms an exciplex with the second host in said OLED at room temperature. In some embodiments, the concentrations of the first and second hosts in the layer or layers containing the first and second host are greater than the concentrations of the sensitizer compound and the acceptor compound in the layer or layers containing the sensitizer compound and the acceptor compound. In some embodiments, the concentrations of the first and second hosts in the layer or layers containing the first and second host are greater than the concentrations of the acceptor compound in the layer or layers containing the sensitizer compound and the acceptor compound. In some embodiments, the S 1 energy of the first host is greater than that of the acceptor compound. In some embodiments, T1 energy of the first host is greater than that of the sensitizer compound. In some embodiments, the sensitizer compound has a HOMO energy that is greater than that of the acceptor compound. In some embodiments, the second host has a HOMO level that is shallower than that of the acceptor compound. In some embodiments, the HOMO level of the acceptor compound is deeper than at least one selected from the sensitizer compound and the first host.

In some embodiments, the first host comprises at least one chemical group selected from the group consisting of triphenylene, carbazole, indolocarbazole, dibenzothiophene, dibenzofuran, dibenzoselenophene, 5$\lambda^2$-benzo[d]benzo[4,5]imidazo[3,2-a]imidazole, 5,9-dioxa-13b-boranaphtho[3,2,1-de]anthracene, triazine, boryl, silyl, nitrile, aza-triphenylene, aza-carbazole, aza-indolocarbazole, aza-dibenzothiophene, aza-dibenzofuran, aza-dibenzoselenophene, aza-5$\lambda^2$-benzo[d]benzo[4,5]imidazo[3,2-a]imidazole, and aza-(5,9-dioxa-13b-boranaphtho

[3,2,1-de]anthracene). In some embodiments the first host and the second host are both organic compounds. In some embodiments, at least one of the first host and the second host is a metal complex.

In some embodiments, each of the first host and/or the second host is independently selected from the group consisting of:

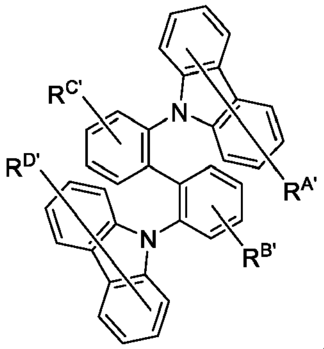
,
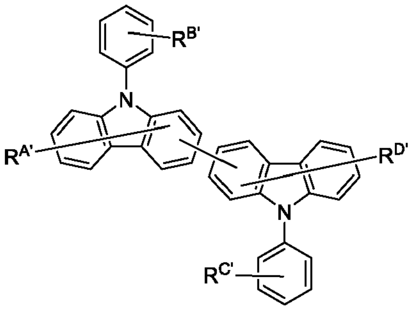
,
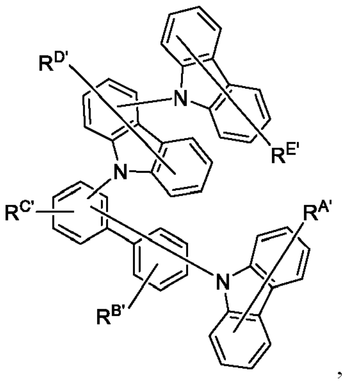
,

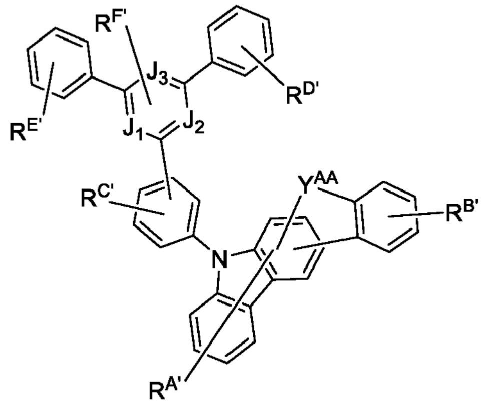

,

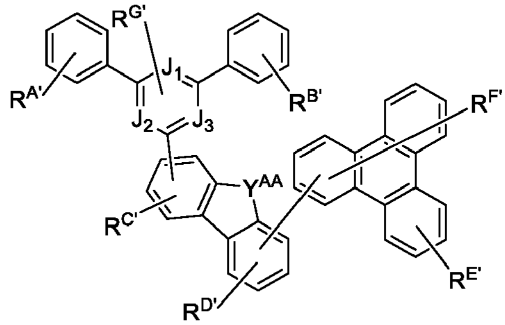

,

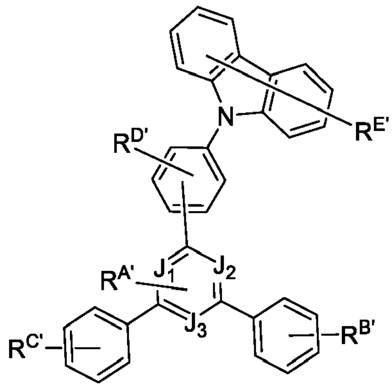

,

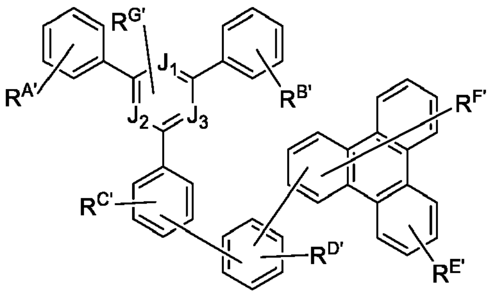

,

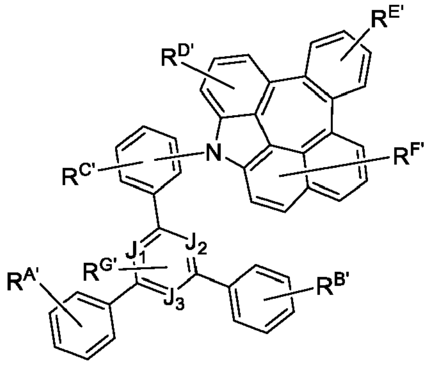

,

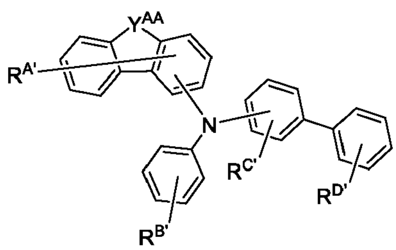

,

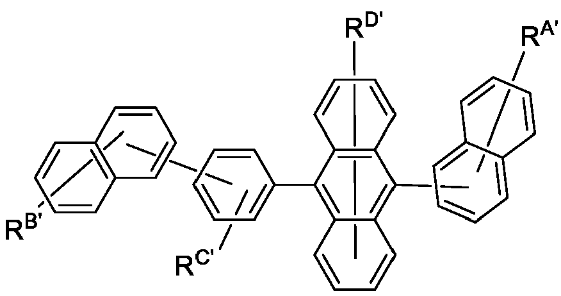

,

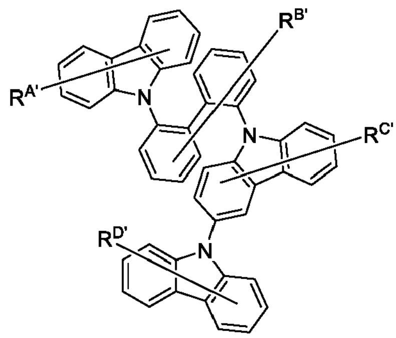

,

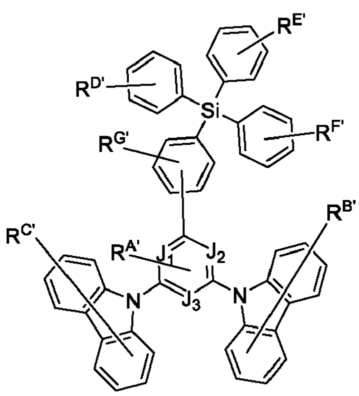,
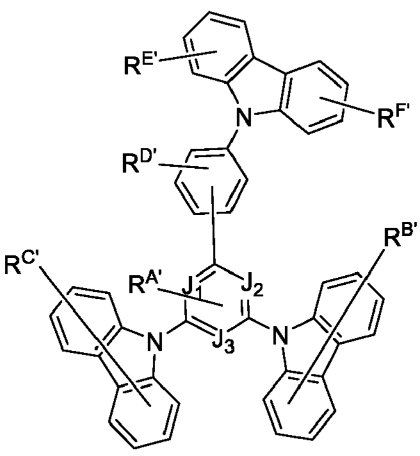,
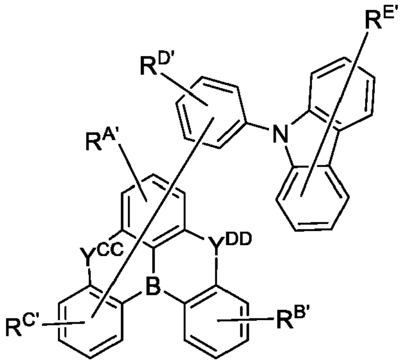,
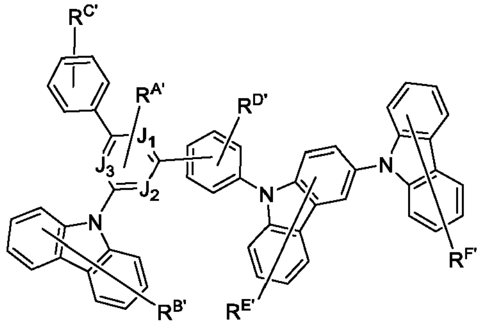,
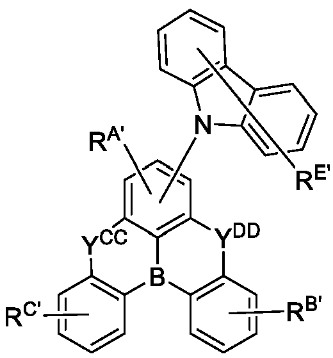,
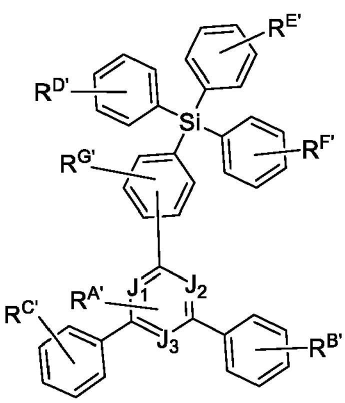,
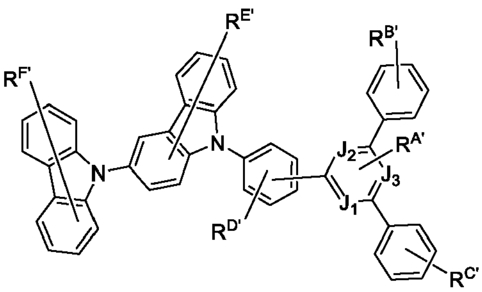,
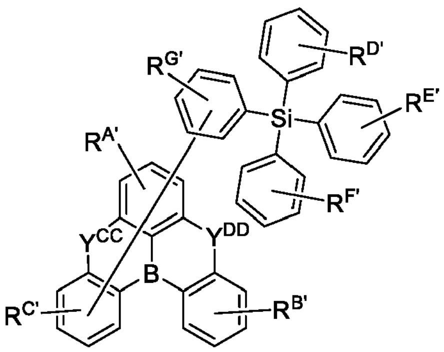,
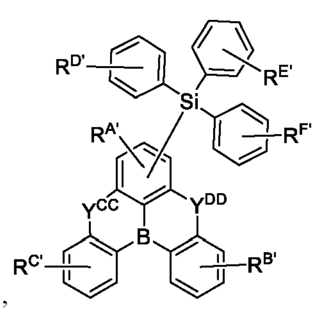,
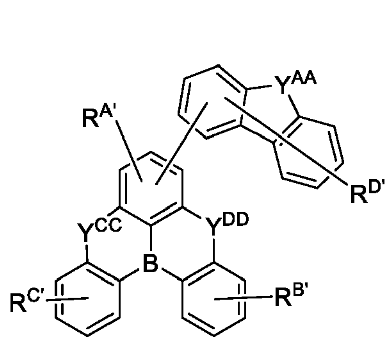,

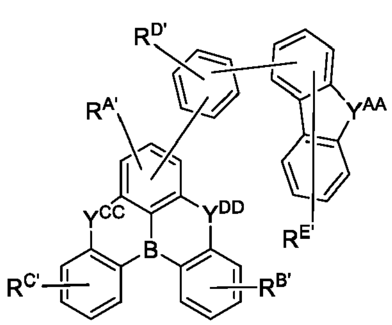

,

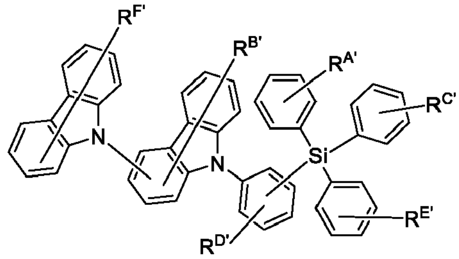

,

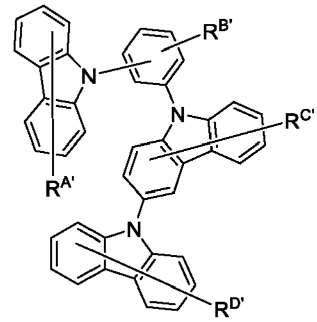

,

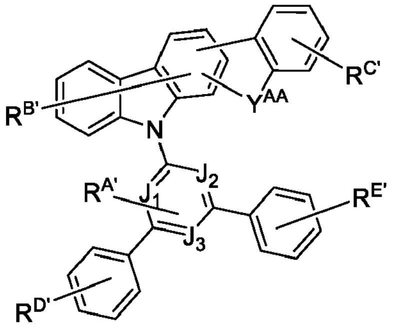

,

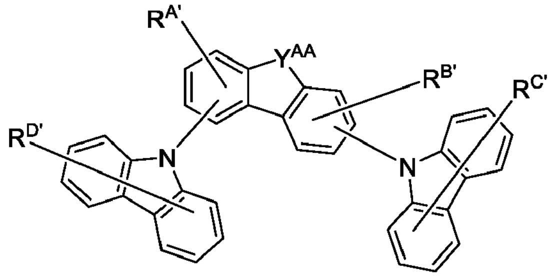

,

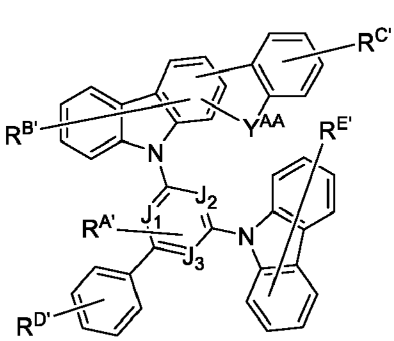

,

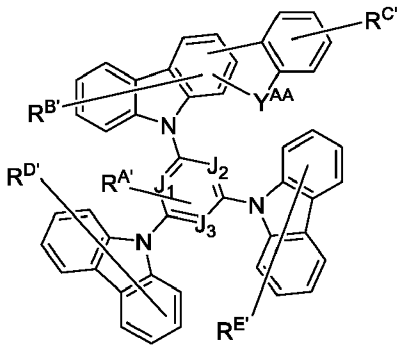

,

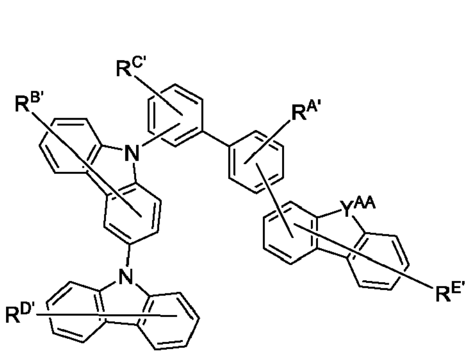

,

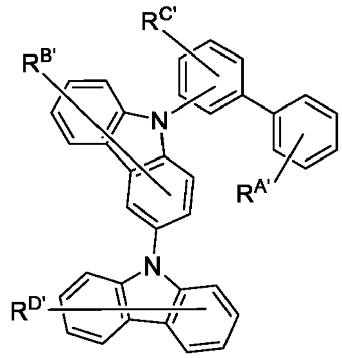

,

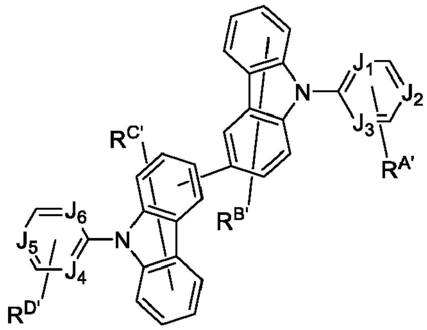

,

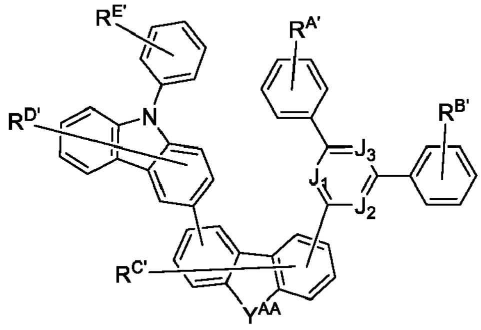

,

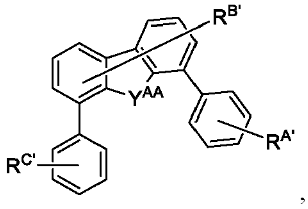

,

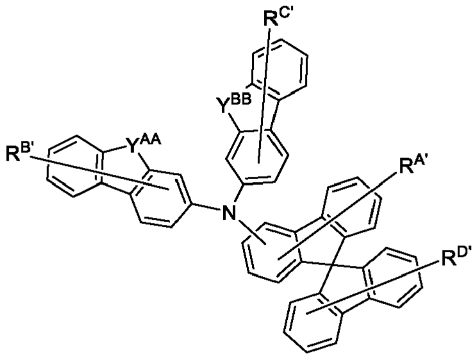

,

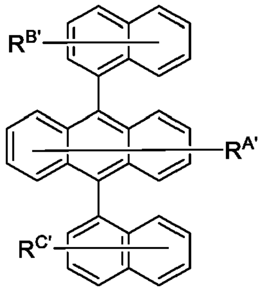

,

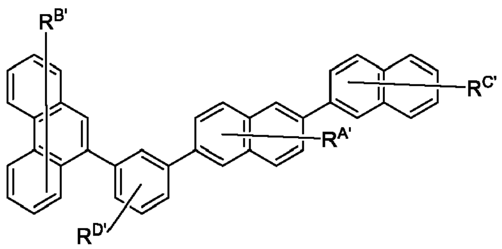

,

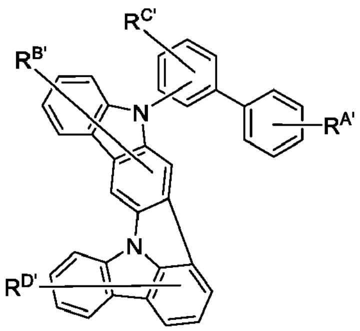

,

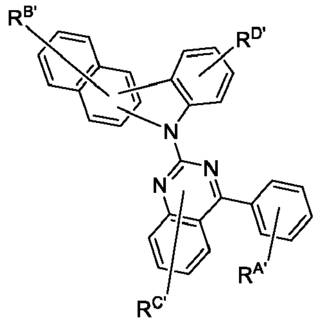

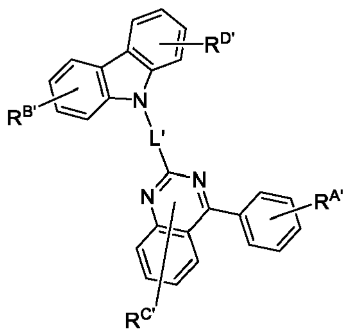

,

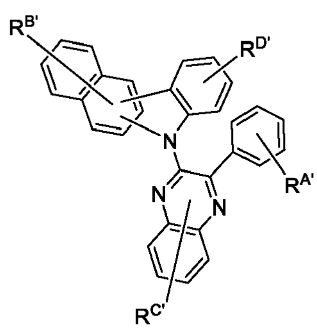

,

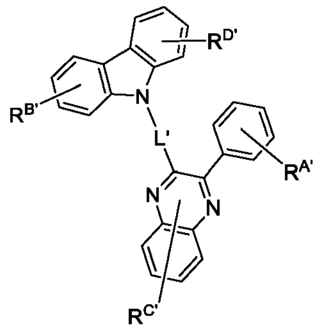

,

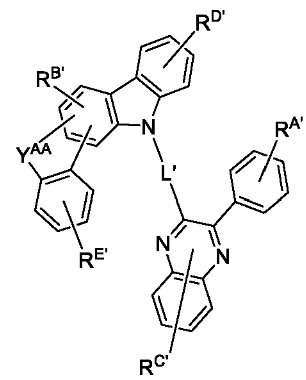
,
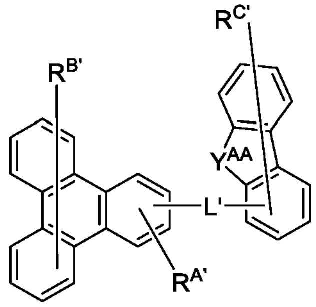
,
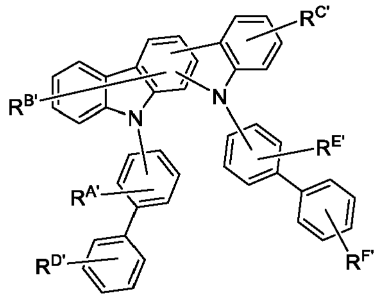
,

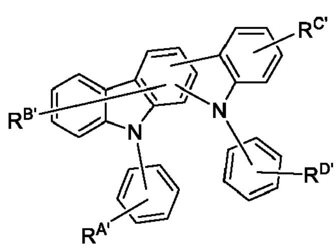
,
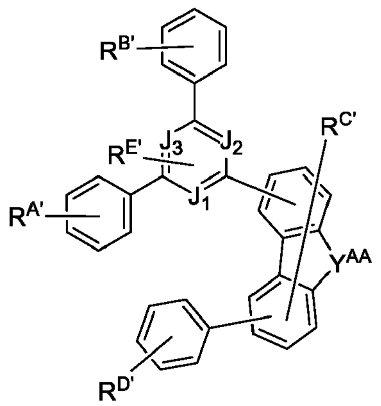
,
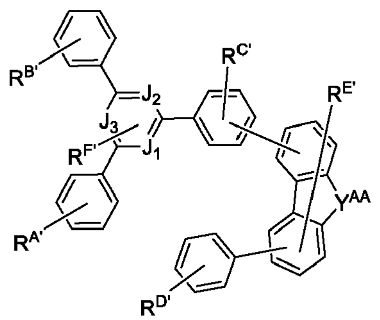
,

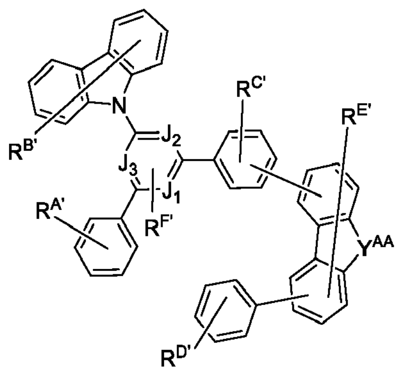
,
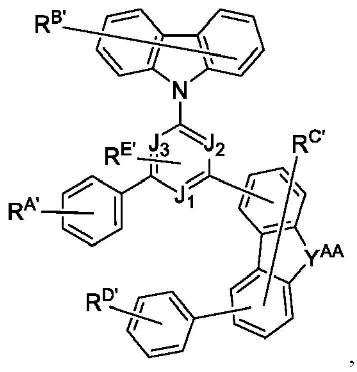
,
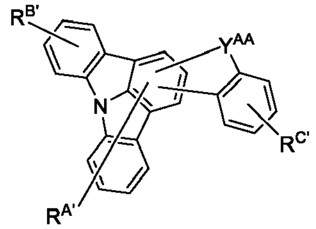
,

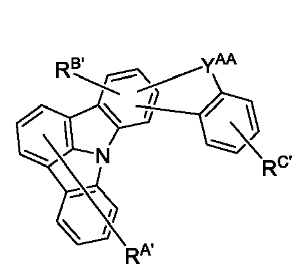
,
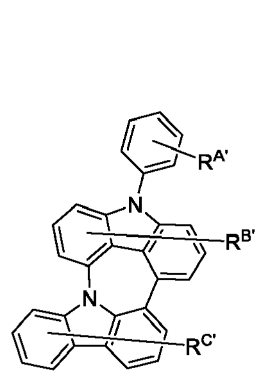
,
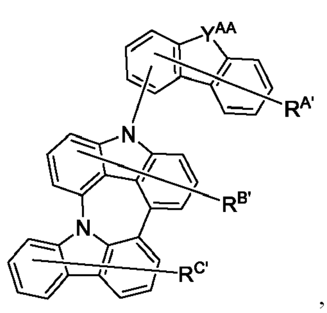
,
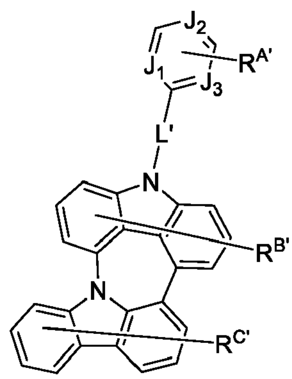
,

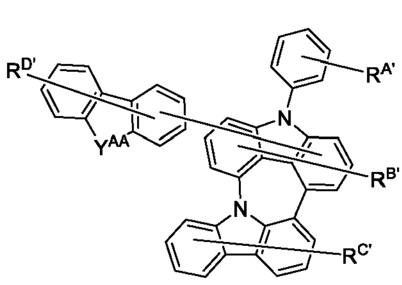 , 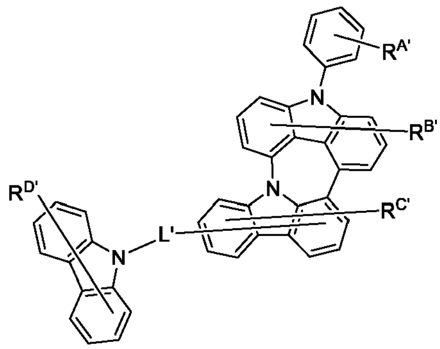 , 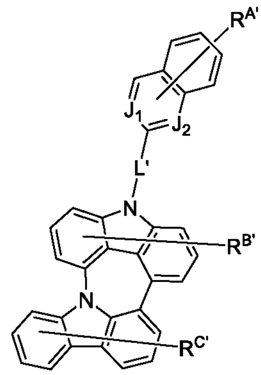 ,

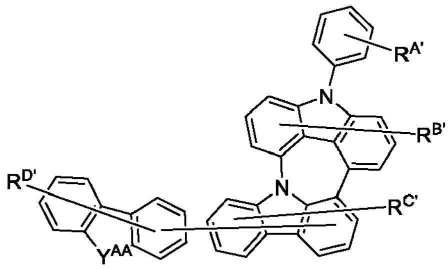 , 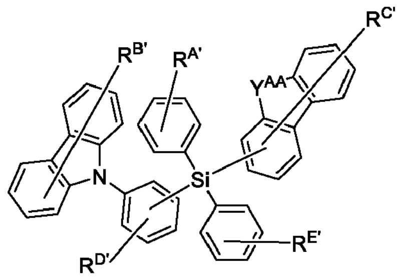 ,

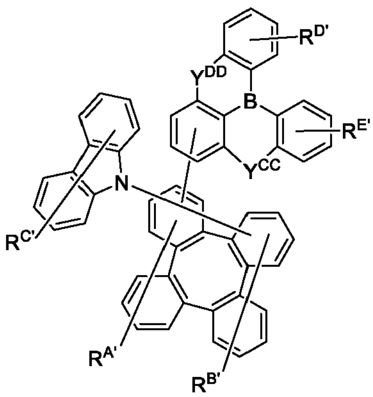 , 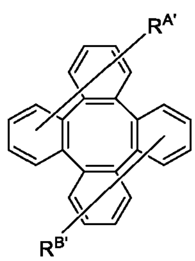 , 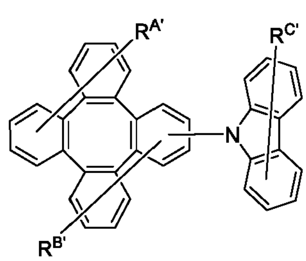 ,

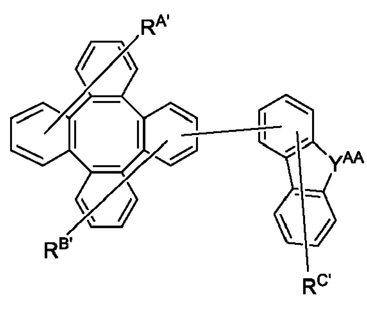 , 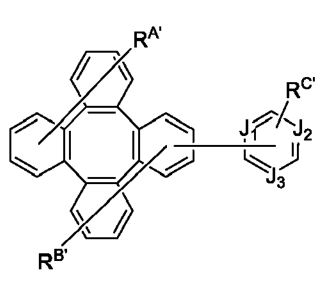 , 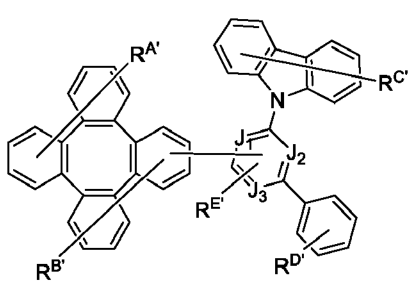 ,

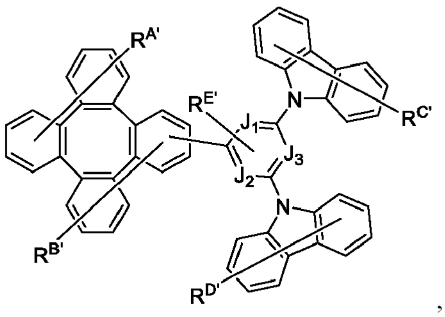
,
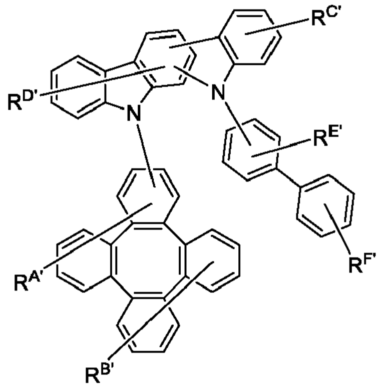
,

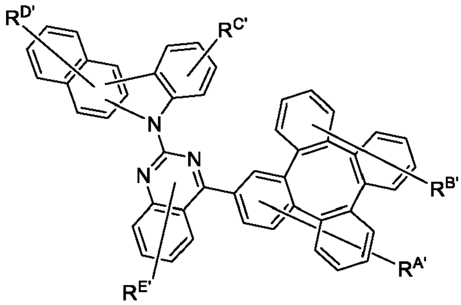
,
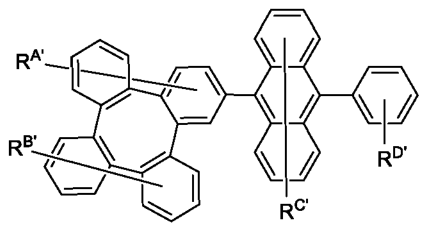
,

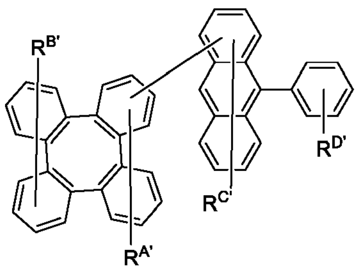
,
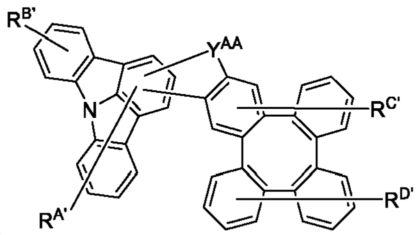
,

and

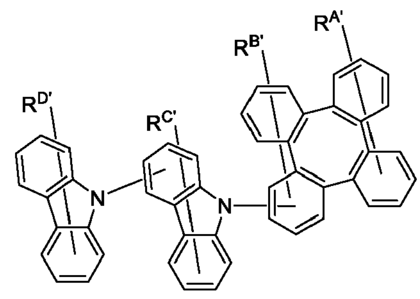
,

wherein:

each of $J_1$ to $J_6$ is independently C or N;
L' is a direct bond or an organic linker;
each $Y^{AA}$, $Y^{BB}$, $Y^{CC}$, and $Y^{DD}$ is independently selected from the group consisting of absent a bond, direct bond, O, S, Se, CRR', SiRR', GeRR', NR, BR, BRR';
each of $R^{A'}$, $R^{B'}$, $R^{C'}$, $R^{D'}$, $R^{E'}$, $R^{F'}$, and $R^{G'}$ independently represents mono, up to the maximum substitutions, or no substitutions;
each R, R', $R^{A'}$, $R^{B'}$, $R^{C'}$, $R^{D'}$, $R^{E'}$, $R^{F'}$, and $R^{G'}$ is independently a hydrogen or a substituent selected from the group

consisting of the general substituents as defined herein; any two substituents can be joined or fused to form a ring; and where possible, each unsubstituted aromatic carbon atom is optionally replaced with N to form an aza-substituted ring.

In some embodiments at least one of $J_1$ to $J_3$ are N. In some embodiments at least two of $J_1$ to $J_3$ are N. In some embodiments, all three of $J_1$ to $J_3$ are N. In some embodiments, each $Y^{CC}$ and $Y^{DD}$ are preferably O, S, and SiRR', more preferably O, or S. In some embodiments, at least one unsubstituted aromatic carbon atom is replaced with N to form an aza-ring.

In some embodiments, the distance between the center of mass of the acceptor compound and the sensitizer compound is at least 2, 1.5, 1.0, or 0.75 nm.

In some embodiments, each of the sensitizer compound and the acceptor compound independently has a VDR value equal or less than 0.33, 0.30, 0.25, 0.20, 0.15, 0.10, 0.08, or 0.05. In some embodiments, the acceptor compound has a VDR value equal or less than 0.33, 0.30, 0.25, 0.2, 0.15, 0.10, 0.08, or 0.05; and at least one of the sensitizer compound and the first host has a VDR value larger than 0.33, 0.4, 0.5, 0.6, or 0.7.

In some embodiments, the acceptor compound has a VDR value equal or greater than 0.33, 0.4, 0.5, 0.6, or 0.7; and at least one of the sensitizer compounds and the first host has a VDR value less than 0.33, 0.30, 0.25, 0.2, 0.15, 0.10, 0.08, or 0.05.

In some embodiments, the emissive region further comprises a second host. In some embodiments, the second host has a HOMO level that is shallower than that of the acceptor compound.

In some embodiments, the OLED emits a white light at room temperature when a voltage is applied across the device.

In some embodiments, the OLED emits a luminescent radiation at room temperature when a voltage is applied across the device; wherein the luminescent first radiation component contributed from the acceptor compound with an emission $\lambda_{max1}$ being independently selected from the group consisting of larger than 340 nm to equal or less than 500 nm, larger than 500 nm to equal or less than 600 nm, and larger than 600 nm to equal or less than 900 nm. In some embodiments, the first radiation component has FWHM of 50, 40, 35, 30, 25, 20, 15, 10, or 5 nm or less. In some embodiments, the first radiation component has a 10% onset of the emission peak is less than 465, 460, 455, or 450 nm.

In some embodiments, the sensitizer compound is partially or fully deuterated. In some embodiments, the acceptor compound is partially or fully deuterated. In some embodiments, the first host is partially or fully deuterated. In some embodiments, the second host is partially or fully deuterated.

In some embodiments, one of the first and second hosts is a hole transporting host, the other one of the first and second host is an electron transporting host. In some embodiments, the first host is a hole transporting host; and wherein the first host comprises at least one chemical group selected from the group consisting of amino, carbazole, indolocarbazole, dibenzothiophene, dibenzofuran, dibenzoselenophene, and 5$\lambda^2$-benzo[d]benzo[4,5]imidazo[3,2-a]imidazole. In some embodiments, the first host is an electron transporting host; and wherein the first host comprises at least one chemical group selected from the group consisting of pyridine, pyrimidine, pyrazine, pyridazine, triazine, imidazole, aza-triphenylene, aza-carbazole, aza-dibenzothiophene, aza-dibenzofuran, aza-dibenzoselenophene, 5,9-dioxa-13b-boranaphtho[3,2,1-de]anthracene, boryl, aza-5$\lambda^2$-benzo[d]benzo[4,5]imidazo [3,2-a]imidazole, and aza-(5,9-dioxa-13b-boranaphtho[3,2,1-de]anthracene).

To reduce the amount of Dexter energy transfer between the sensitizer compound and the acceptor compound, it would be preferable to have a large distance between the center of mass of the sensitizer compound and the center of mass of the closest neighboring acceptor compound in the emissive region. Therefore, in some embodiments, the distance between the center of mass of the acceptor compound and the center of mass of the sensitizer compound is at least 2, 1.5, 1.0, or 0.75 nm.

Preferred acceptor/sensitizer VDR combination (A): In some embodiments, it is preferable for the VDR of the acceptor to be less than 0.33 in order to reduce the coupling of the transition dipole moment of the emitting acceptor to the plasmon modes, compared to an isotropic emitter, in order to achieve a higher outcoupling efficiency. In some cases, when the VDR of the acceptor is less than 0.33, it would be preferable for the VDR of the sensitizer to be less than 0.33 in order to improve the coupling of the transition dipole moments of the sensitizer and acceptor to optimize the Forster energy transfer rate. Accordingly, in some embodiments of the inventive OLED, the acceptor compound in the inventive OLED exhibits a VDR value equal to or less than 0.33, 0.30, 0.25, 0.2, 0.15, 0.10, 0.08, or 0.05 when the VDR is measured with an emissive thin film test sample that has the acceptor compound as the only emitter; and the sensitizer compound in the inventive OLED exhibits a VDR value equal to or less than 0.33, 0.30, 0.25, 0.2, 0.15, 0.10, 0.08, or 0.05 when the VDR is measured with an emissive thin film test sample that has the sensitizer compound as the only emitter.

Preferred acceptor/sensitizer VDR combination (B): In some embodiments, it is preferable for the VDR of the acceptor to be less than 0.33 in order to reduce the coupling of the transition dipole moment of the emitting acceptor to the plasmon modes compared to an isotropic emitter in order to achieve a higher outcoupling efficiency. In some cases, when the VDR of the acceptor is less than 0.33, it would be preferable to minimize the intermolecular interactions between

the senstizer and acceptor to decrease the degree of Dexter quenching. By changing the molecular geometry of the sensitizer to reduce the intermolecular interactions, it may be preferable to have a sensitizer with a VDR greater than 0.33. Accordingly, in some embodiments of the inventive OLED, the acceptor compound in the inventive OLED exhibits a VDR value equal to or less than 0.33, 0.30, 0.25, 0.2, 0.15, 0.10, 0.08, or 0.05 when the VDR is measured with an emissive thin film test sample that has the acceptor compound as the only emitter; and the sensitizer compound in the inventive OLED exhibits a VDR value larger than 0.33, 0.4, 0.5, 0.6, or 0.7 when the VDR is measured with an emissive thin film test sample that has the sensitizer compound as the only emitter.

Preferred acceptor/sensitizer VDR combination (C): In some embodiments, it is preferable for the VDR of the acceptor to be greater than 0.33 in order to increase the coupling of the transition dipole moment of the acceptor to the plasmon modes compared to an isotropic emitter in order to decrease the transient lifetime of the excited states in the emissive layer. In some cases, the increased coupling to the plasmon modes can be paired with an enhancement layer in a plasmonic OLED device to improve efficiency and extend operational lifetime. In some cases, when the VDR of the acceptor is greater than 0.33, it would be preferable to minimize the intermolecular interactions between the senstizer and acceptor to decrease the degree of Dexter quenching. By changing the molecular geometry of the sensitizer to reduce the intermolecular interactions, it may be preferable to have a sensitizer with a VDR less than 0.33. Accordingly, in some embodiments of the inventive OLED, the acceptor compound in the inventive OLED exhibits a VDR value larger than 0.33, 0.4, 0.5, 0.6, or 0.7 when the VDR is measured with an emissive thin film test sample that has the acceptor compound as the only emitter; and the sensitizer compound in the inventive OLED exhibits a VDR value equal to or less than 0.33, 0.30, 0.25, 0.2, 0.15, 0.10, 0.08, or 0.05 when the VDR is measured with an emissive thin film test sample that has the sensitizer compound as the only emitter.

Preferred acceptor/sensitizer VDR combination (D): In some embodiments, it is preferable for the VDR of the acceptor to be greater than 0.33 in order to increase the coupling of the transition dipole moment of the acceptor to the plasmon modes compared to an isotropic emitter in order to decrease the transient lifetime of the excited states in the emissive layer. In some cases, the increased coupling to the plasmon modes can be paired with an enhancement layer in a plasmonic OLED device to improve efficiency and extend operational lifetime. In some cases, when the VDR of the acceptor is greater than 0.33, it would be preferable for the VDR of the sensitizer to be greater than 0.33 in order to improve the coupling of the transition dipole moments of the sensitizer and acceptor to optimize the Forster energy transfer rate. Accordingly, in some embodiments of the inventive OLED, the acceptor compound in the inventive OLED exhibits a VDR value larger than 0.33, 0.4, 0.5, 0.6, or 0.7 when the VDR is measured with an emissive thin film test sample that has the acceptor compound as the only emitter; and the sensitizer compound in the inventive OLED exhibits a VDR value larger than 0.33, 0.4, 0.5, 0.6, or 0.7 when the VDR is measured with an emissive thin film test sample that has the sensitizer compound as the only emitter.

VDR is the ensemble average fraction of vertically oriented molecular dipoles of the light-emitting compound in a thin film sample of an emissive layer, where the orientation "vertical" is relative to the plane of the surface of the substrate (i.e., normal to the surface of the substrate plane) on which the thin film sample is formed. A similar concept is horizontal dipole ratio (HDR) which is the ensemble average fraction of horizontally oriented molecular dipoles of the light-emitting compound in a thin film sample of an emissive layer, where the orientation "horizontal" is relative to the plane of the surface of the substrate (i.e. parallel to the surface of the substrate plane) on which the thin film sample is formed. By definition, VDR+HDR = 1. VDR can be measured by angle dependent, polarization dependent, photoluminescence measurements. By comparing the measured emission pattern of a photo-excited thin film test sample, as a function of polarization, to the computationally modeled pattern, one can determine VDR of the thin film test sample emission layer. For example, a modelled data of p-polarized emission is shown in FIG. 3. The modelled p-polarized angle photoluminescence (PL) is plotted for emitters with different VDRs. A peak in the modelled PL is observed in the p-polarized PL around the angle of 45 degrees with the peak PL being greater when the VDR of the emitter is higher.

To measure VDR values of the thin film test samples, a thin film test sample can be formed with the acceptor compound or the sensitizer compound (depending on whether the VDR of the acceptor compound or the sensitizer compound is being measured) as the only emitter in the thin film and a Reference Host Compound A as the host. Preferably, the Reference Host Compound A is

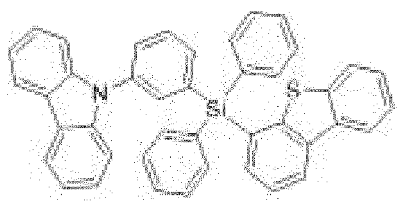.

The thin film test sample is formed by thermally evaporating the emitter compound and the host compound on a substrate.

For example, the emitter compound and the host compound can be co-evaporated. In some embodiments, the doping level of the emitter compounds in the host can be from 0.1 wt. % to 50 wt. %. In some embodiments, the doping level of the emitter compounds in the host can be from 3 wt. % to 20 wt. % for blue emitters. In some embodiments, the doping level of the emitter compounds in the host can be from 1 wt. % to 15 wt. % for red and green emitters. The thickness of the thermally evaporated thin film test sample can have a thickness of from 50 to 1000 Å.

In some embodiments, the OLED of the present disclosure can comprise a sensitizer, an acceptor, and one or more hosts in the emissive region, and the preferred acceptor/sensitizer VDR combinations (A) - (D) mentioned above are still applicable. In these embodiments, the VDR values for the acceptor compound can be measured with a thin film test sample formed of the one or more hosts and the acceptor, where the acceptor is the only emitter in the thin film test sample. Similarly, the VDR values for the sensitizer compound can be measured with a thin film test sample formed of the one or more hosts and the sensitizer, where the sensitizer is the only emitter in the thin film test sample.

In the example used to generate FIG. 3, a 30 nm thick film of material with a refractive index of 1.75 and the emission is monitored in a semi-infinite medium with a refractive index of 1.75. Each curve is normalized to a photoluminescence intensity of 1 at an angle of zero degrees, which is perpendicular to the surface of the film. As the VDR of the emitter is varied, the peak around 45 degrees increases greatly. When using a software to fit the VDR of experimental data, the modeled VDR would be varied until the difference between the modeled data and the experimental data is minimized.

Because the VDR represents the average dipole orientation of the light-emitting compound in the thin film sample, even if there are additional emission capable compounds in the emissive layer, if they are not contributing to the light emission, the VDR measurement does not reflect their VDR. Further, by inclusion of a host material that interacts with the light-emitting compound, the VDR of the light-emitting compound can be modified. Thus, a light-emitting compound in a thin film sample with host material A will exhibit one measured VDR value and that same light-emitting compound in a thin film sample with host material B will exhibit a different measured VDR value. Further, in some embodiments, exciplex or excimers are desirable which form emissive states between two neighboring molecules. These emissive states may have a VDR that is different than that if only one of the components of the exciplex or excimer were emitting or present in the sample.

In some embodiments, the OLED is a plasmonic OLED. In some embodiments, the OLED is a wave - guided OLED.

In some embodiments, the emissive region can further include a second host. In some embodiments, the second host comprises a moiety selected from the group consisting of bicarbazole, indolocarbazole, triazine, pyrimidine, pyridine, and boryl. In some embodiments, the second host has a HOMO level that is shallower than that of the acceptor compound.

In some embodiments, the OLED emits a white light at room temperature when a voltage is applied across the device.

In some embodiments, the OLED emits a luminescent radiation at room temperature when a voltage is applied across the device; wherein the luminescent first radiation component contributed from the acceptor compound with an emission $\lambda_{max1}$ being independently selected from the group consisting of larger than 340 nm to equal or less than 500 nm, larger than 500 nm to equal or less than 600 nm, and larger than 600 nm to equal or less than 900 nm. In some embodiments, the first radiation component has FWHM of 50, 40, 35, 30, 25, 20, 15, 10, or 5 nm or less. In some embodiments, the first radiation component has a 10% onset of the emission peak is less than 465, 460, 455, or 450 nm.

In some embodiments, the sensitizer compound is partially or fully deuterated. In some embodiments, the acceptor compound is partially or fully deuterated. In some embodiments, the first host is partially or fully deuterated. In some embodiments, the second host is partially or fully deuterated.

In some embodiments, the sensitizer and/or the acceptor each independently comprises at least one substituent having a spherocity greater than or equal to 0.45, 0.55, 0.65, 0.75, or 0.80. The spherocity is a measurement of the three-dimensionality of bulky groups. Spherocity is defined as the ratio between the principal moments of inertia (PMI). Specifically, spherocity is the ratio of three times PMI1 over the sum of PMI1, PMI2, and PMI3, where PMI1 is the smallest principal moment of inertia, PMI2 is the second smallest principal moment of inertia, and PMI3 is the largest principal moment of inertia. The spherocity of the lowest energy conformer of a structure after optimization of the ground state with density functional theory may be calculated. More detailed information can be found in paragraphs [0054] to [0059] of US application No. 18/062,110 filed December 6, 2022, the contents of which are incorporated herein by reference. In some embodiments, compound S1 and/or compound A1 each independently comprises at least one substituent having a Van der Waals volume greater than 153, 206, 259, 290, or 329 $Å^3$. In some embodiments, compound S1 and/or compound A1 each independently comprises at least one substituent having a molecular weight greater than 167, 187, 259, 303, or 305 amu.

In some embodiments, one of the first and second hosts is a hole transporting host, the other one of the first and second host is an electron transporting host. In some embodiments, the first host is a hole transporting host; and wherein the first host comprises at least one chemical group selected from the group consisting of amino, carbazole,

indolocarbazole, dibenzothiophene, dibenzofuran, dibenzoselenophene, and 5$\lambda^2$-benzo[d]benzo[4,5]imidazo[3,2-a]imidazole. In some embodiments, the first host is an electron transporting host; and wherein the first host comprises at least one chemical group selected from the group consisting of pyridine, pyrimidine, pyrazine, pyridazine, triazine, imidazole, aza-triphenylene, aza-carbazole, aza-dibenzothiophene, aza-dibenzofuran, aza-dibenzoselenophene, 5,9-dioxa-13b-boranaphtho[3,2,1-de]anthracene, boryl, nitrile, aza-5$\lambda^2$-benzo[d]benzo[4,5]imidazo[3,2-a]imidazole, and aza-(5,9-dioxa-13b-boranaphtho[3,2,1-de]anthracene). In some embodiments, one of the first and second hosts is a bipolar host comprising both hole transporting and electron transporting moieties.

In yet another aspect, the present disclosure also provides an organic light emitting device (OLED) comprising:

an anode;
a cathode; and
an emissive region disposed between the anode and the cathode;
wherein the emissive region comprises:

a compound S1;
a compound A1;
a compound H1;

wherein the compound S1 is a sensitizer that transfers energy to the compound A1;
wherein the compound A1 is an acceptor that is an emitter;
wherein the compound H1 is a host, and at least one of the compounds S1 and A1 is doped with the compound H1;
wherein at least one of the following conditions is true:

(1) the emissive region consists of one or more organic layers, wherein at least one of the one or more organic layers has a minimum thickness selected from the group consisting of 350, 400, 450, 500, 550, 600, 650 and 700 Å;
(2) the OLED further comprises a layer comprising quantum dot;
(3) the compound S1 is capable of functioning as a doublet emitter in an OLED at room temperature, or the compound S1 has a first excited state energy that is less than its energy of the lowest excited triplet state $T_1$;
(4) the compound A1 is a doublet emitter; or the compound A1 has a first excited state energy that is less than its energy of the lowest excited triplet state $T_1$;
(5) at least one of the compounds S1 and A1 is a triplet-triplet annihilation upconversion (TTA-UC) material;
(6) at least one of the compounds S1 and A1 is chiral;
(7) the compound S1 is a metal coordination complex having at least one feature selected from the group consisting of at least two metals, three different bidentate ligands, three same bidentate ligands, a tetradentate or hexadentate ligand coordinating to Ir or Os, a Ir-carbene bond, Os-carbene bond, M-K bond wherein K is a non-ring atom and M is the metal, a ligand comprising a five-membered heteroaryl ring coordinating to the metal through M-N bond, a ligand comprising a six-membered heteroaryl ring having at least two heteroatoms with one of them coordinating to the metal, a ligand comprising a fused ring system having at least four rings, at least 25% deuterated of the metal complex, and combinations thereof;
(8) the compound S1 is a Au(III) coordination complex having a bidentate, tridentate, or tetradentate ligand and capable of functioning as a phosphorescent or delayed fluorescent emitter in an OLED at room templerature;
(9) the compound S1 is a Zn(II) coordination complex having a bidentate ligand and capable of functioning as a phosphorescent or delayed fluorescence emitter in an OLED at room temperature;
(10) the compound S1 comprises at least one electron-withdrawing group (EWG);
(11) the compound A1 comprises at least one electron-withdrawing group;
(12) any combination of two or more conditions of (1) through (11) listed above.

In some embodiments, condition (1) is true. In some embodiments, the at least one of the one or more organic layers comprising the compound A1 has a minimum thickness selected from the group consisting of 250, 300, 350, 400, 450, 500, 550, 600, 650 and 700 Å. In some embodiments, the at least one of the one or more organic layers comprising the compound A1 is formed from an Emissive System that has a FOM value equal to or larger than the number selected from the group consisting of 2.50, 2.55, 2.60, 2.65, 2.70, 2.75, 2.80, 2.85, 2.90, 2.95, 3.00, 5.00, 10.0, 15.0, and 20.0. The definition of FOM is available in US application 18/177,174, and its entire contents are incorporated herein by reference.

Determining FOM Value

In this disclosure FOM value is used as a metric to define the desired composition of an EML in an OLED. For the purposes of this disclosure, the materials that make up a given EML, i.e., the emitter material and its associated host material(s), if any, will be collectively referred to as the "Emissive System" To determine the FOM value of a given EML that comprises a given Emissive System, two test OLEDs are fabricated (in a thin film form factor) whose EMLs have the same Emissive System but have two different thicknesses. The two test OLEDs will be referred to as "a first test OLED" and "a second test OLED."

FOM value is defined as FOM = **(t2/t1)/(V2-V1);** where **t1** is the LT90 device lifetime measured at 20 mA/cm$^2$ for the first test OLED whose EML is formed of the given Emissive System and its EML has a thickness of 350 Å; where **t2** is the LT90 device lifetime measured at 20 mA/cm$^2$ for the second test OLED whose EML is formed of the same given Emissive System but its EML has a thickness of 450 Å; where **V1** is the device operating voltage value of the first test OLED measured at a current density of 10 mA/cm$^2$; and where **V2** is the device operating voltage value of the second test OLED measured at a current density of 10 mA/cm$^2$. The device operating voltage (a.k.a. driving voltage) value for a given OLED is measured across the OLED's anode and cathode while the OLED is activated with a current and is emitting light.

Thus, FOM value represents a property of a given EML (having a particular Emissive System) that is measured by fabricating two test OLEDs using the given Emissive System. It should be understood that the **t1** and **t2** measurements are performed under exactly the same conditions for the two test OLEDs with the only difference being the thickness of the EMLs. Likewise, **V1** and **V2** measurements are performed under exactly the same conditions for the two test OLEDs with the only difference being the thickness of the EMLs. In other words, the first and the second test OLEDs have the same configuration except for the thickness of their EMLs. It should also be understood that all the components and their ratios are the same in the EMLs of the two test OLEDs.

Using the novel material combinations, the amount of enhancement achieved in the OLED device lifetime per volt incremental increase in the operating voltage resulting from the incremental increase in the thickness of the EML is substantially more than what was conventionally observed. This corresponds to a large FOM. Having a large FOM can provide OLED designers an attractive option to choose enhanced device lifetime while minimizing the increase in the power consumption.

In some embodiments, condition (2) is true. Similarly, a color altering layer refers to a layer that converts or modifies another color of light to light having a wavelength as specified for that color. For example, a "red" color filter refers to a filter that results in light having a wavelength in the range of about 580-700nm. In general, there are two classes of color altering layers: color filters that modify a spectrum by removing unwanted wavelengths of light, and color changing layers that convert photons to a different energy, examples being downconversion and upconversion. An unfiltered sub-pixel is one that excludes a color modifying component such as a color altering layer, but may include one or more emissive regions, layers, or devices.

A color altering layer, color filter, upconversion, or downconversion layer or structure may include a material containing quantum dots, though such layer may not be considered an "emissive layer" as disclosed herein. In general, an "emissive layer" or material is one that emits an initial light, which may be altered by another layer such as a color filter or other color altering layer that does not itself emit an initial light within the device, but may re-emit altered light of a different spectra content based upon initial light emitted by the emissive layer. Often the color altering layers are not within the two electrodes of the OLED.

Current OLED TVs rely on either the use of a white unpatterned OLED stack, with color filters used to produce blue, green, and red sub-pixels or has an unpatterned OLED stack that contains at least one deep blue emissive region, with quantum dot down-conversion to provide red and green sub-pixels. Both of these approaches benefit from not having any deposition of the organic material through a fine metal mask (FMM) to render the sub-pixel patterning, both of these approaches currently utilize low efficiency deep fluorescent blue emissive layers. Utilization of sensitization to provide high efficiency and increased stability will enable large area unpatterned OLEDs with increase display performance.

Embodiments of the disclosed subject matter provide a full color OLED display architecture using a sensitized emissive layer to enable a highly efficient OLED to be deposited unpatterned over a large area substrate. In some embodiments, deep blue sub-pixels may be formed by filtering or with a microcavity, and red, green, and/or yellow sub-pixels may be provided by patterning quantum dots to downconvert the blue OLED with optional additional filtering. That is, embodiments of the disclosed subject matter provide an OLED display architecture that includes a highly efficient blue as the unpatterned OLED emissive layer. In the presence of light blue sub-pixels, deep blue sub-pixels may be used for a small fraction of the time, i.e., when a color may not be rendered from the light blue sub-pixel emission. This arrangement reduces the lifetime requirement for the deep blue sub-pixel. Moreover, the unpatterned light blue sub-pixel can take advantage of a high fill-factor, as pixel layout in this arrangement may not have large OLED deposition alignment tolerances between sub-pixels (i.e., preventing one color emitter being placed in an adjacent color sub-pixel).

In other embodiments, the green emissive region is downcoverted to red using one or more color altering layers. In embodiments of the disclosed subject matter, sub-pixels may be defined by lithography and/or color filter or down conversion medium patterning.

In some embodiments, condition (3) is true. In some embodiments, the compound S1 is capable of functioning as a doublet emitter in an OLED at room temperature. In some embodiments, the compound S1 has a first excited state energy that is less than its energy of the lowest excited triplet state $T_1$. In some embodiments, the lowest energy excited state of S1 is not a triplet excited state. It may be either a doublet or a singlet excited state. In this case, the sensitizer can convert electrically injected charges to the lowest excited state doublet or singlet. If the material is fluorescent with a first singlet energy lower in energy than the lowest energy triplet energy then any electrically injected charges that initially make a lowest triplet energy are converted through rapid inter-system to the lowest energy singlet. The sensitizer then transfers those singlet excitons to a material serving as an acceptor, via FRET or Dexter energy transfer, while avoiding the deleterious process of transferring triplet excitons to A1. Transfer of singlet excitons via FRET can be significantly faster than Dexter-mediated transfer - a feature which reflects in overall faster sensitization events. These two features combined - the lack of T1 exciton transfer and the improved FRET transfer - result in faster and more efficient sensitization than is experienced in other systems employing a sensitizer with triplet as the lowest energy excited state.

In other embodiments, the material with the lowest energy excited state which is not a triplet exciton but rather is a doublet is utilized as the sensitizer. In this case, the doublet emitter traps electrically injected charge carriers converting them to excited state doublets. The doublet energy then can be transferred to the acceptor via FRET or Dexter energy transfer.

In some embodiments, the lowest excited state energy of compound S1 is a doublet excited state. In some embodiments, the lowest excited state energy of compound S1 is a singlet excited state.

In some embodiments, condition (4) is true. In some embodiments, the compound A1 is a doublet emitter. In some embodiments, the compound A1 has a first excited state energy that is less than its energy of the lowest excited triplet state $T_1$.

Sensitization is advantageous in some cases to modify the efficiency, color, and stability of OLEDs containing phosphorescent, thermally activated delayed fluorescent (TADF), or fluorescent materials. Sensitization is a process of energy transferring from an excited state of higher energy to that of one lower in energy, often on a different emitting moiety. Typically one refers to the high energy excited state which is the source of the energy as the 'donor' or 'sensitizer' and the final energy emitting moiety as the 'acceptor'. Often in the sensitization process, the donor is a material that can harvest electrically-formed triplets such as phosphors or delayed fluorescent emitters which then energy transfer to a fluorescent acceptor. However, Dexter quenching of the triplet exciton of the donor to the acceptor leads to loss in efficiency as triplet excitons on a fluorescent acceptor can only decay non-radiatively. Recently, there are some cases where a thermally activated delay fluorescent molecule is used as the acceptor, which allows for harnessing of the Dexter energy transferred triplets. However, TADF molecules are often broadband emitters and the triplet will reside on the molecule for a long time period leading to stability issues. Here, we utilize two systems to eliminate the Dexter loss: (1) fluorescent materials when the lowest energy excited state is a singlet excited state instead of a triplet excited state and (2) the stable radicals in which the lowest energy excited state is a doublet. In these systems, when utilizing the materials as acceptors, even if triplet excitons are transferred to the materials, they can still emit the energy as light, thus avoiding a well-known loss pathway in sensitization.

In some embodiments, the fluorescent material with lowest excited state that is a singlet exciton or the stable radical with a lowest excited state of a doublet are used as acceptors in a sensitized OLED device. When using these novel chemicals as acceptors, the process of transferring energy from the donor to the acceptor is quantum mechanically allowed. For example, if a phosphor is the donor, then the emissive state is a triplet exciton which can energy transfer to the acceptors through Forester energy transfer (FRET) and/or through Dexter energy transfer. Similarly, if the donor is a TADF material or a fluorescent material, then the emissive state is a singlet exciton which can FRET or Dexter to the acceptor. In other embodiments where the doublet emitter is the acceptor, FRET and Dexter from a phosphor, TADF emitter, or fluorescent emitter are quantum mechanically allowed to energy transfer to a ground state doublet emitter, indicating sensitized devices will work efficiently. Importantly, since the lowest energy state for both these acceptors is emissive, the internal quantum efficiency of these sensitized devices can approach 100%. This can happen even with slow radiative rates for the acceptor.

In some embodiments, the lowest excited state energy of compound A1 is a doublet excited state. In some embodiments, the lowest excited state energy of compound A1 is a singlet excited state.

In some embodiments, condition (5) is true. In some embodiments, the compound S1 is a TTA upconversion material. In some embodiments, the compound A1 is a TTA upconversion material. In some embodiments, the lowest triplet energy of the compound S 1 is lower than the lowset triplet energy of A1 and the lowest singlet energy of the compound S1 is higher than the lowest singlet energy of A1. In some embodiments, the lowest triplet energy of the compound A1 is lower than the lowset triplet energy of S 1 and the lowest singlet energy of the compound S1 is higher

than the lowest singlet energy of A1. In some embodiments, the difference between the lowest triplet energy of the compound A1 and the lowest triplet energy of the compound S1 is greater than 0.5eV, 0.75eV, 1eV, 1.25eV, and 1.5eV. In some embodiments, the difference between the lowest singlet energy of the compound A1 and the lowest singet energy of the compound S1 is less than 0.5eV, 0.4eV, 0.3eV, 0.2eV, 0.1eV, and 0.05eV. In some embodiments, the compound S1 comprises an anthracene moiety. In some embodiments, the compound A1 comprises an anthracene moiety.

In some embodiments, condition (6) is true. In some embodiments, the compound S1 is chiral. In some embodiments, the compound A1 is chiral. In some embodiments, both compound S1 and A1 are chiral. In some embodiments, the chiral material includes an optically active compound with one enantiomer present in an enantiomeric excess (ee) of at least 75%. In some embodiments, the chiral material includes an optically active host compound with one enantiomer present in an enantiomeric excess (ee) of at least 85%, and in still other embodiments, the optically active compound will have one enantiomer present in an enantiomeric excess (ee) of at least 95%.

Current OLED display panels and similar devices as described above often use both a polarizer and a quarter wave plate to eliminate ambient light reflection from the display. However, this combination also decreases the brightness of the emitted light, typically by about 50%. Embodiments disclosed herein leverage circularily polarized emission from the emissive region to increase the fraction of light emitted by the pixel that passes through the polarizer. This allows for devices having display panels that utilize these device requiring fewer or no additional polarization control elements. More specifically, embodiments disclosed herein provide high-efficiency sensitized OLED-based displays by using sensitization and chiral compounds overcome some of the shortcomings that exist in a conventional display panel. Various embodiments include arrangements to provide control of the Stokes parameters of the emitted light to maximize the amount of light that a user can see from the OLED display.

However, the total emission measured will have a net circular polarization due to the outcoupling of some circularly polarized light along with some non-circularly polarized light. As described in further detail herein, it may be circularly polarized with a Stokes parameter $S_3$ having an absolute value of 0.1 or greater, more preferably between 0.1 and 0.5, more preferably between 0.5 and 0.75, or more preferably between 0.75 and 1, where a larger portion of circular polarized light is desired.

In some embodiments, the orientation of a quarter waveplate and a polarizer in the display panel can be adjusted to increase or maximize the EL light output from the panel, while maintaining a 45° relative orientation between the fast axis of the quarter waveplate and the polarizer to ensure minimal ambient light reflection from the device.

The polarization of light can be quantified using Stokes parameters. For a plasmonic device as disclosed herein, the Stokes parameters values may be estimated from a polarimetry analysis of emitted light from the OLED device. FIG. 7 shows examples of an experimental setup for measuring the Stokes parameters of an OLED device as disclosed herein. The arrangement utilizes a quarter waveplate, a polarizer, and a photodiode to analyze the light intensity. The orientation of the quarter waveplate is fixed with the fast axis aligned parallel to the x axis and linear polarizer is rotated through an angle $\theta$. The light intensity variation for a beam of light passing through a waveplate and a polarizer can be expressed in terms of Stoke's parameters as follows:

$$I(\theta,\varphi) = \frac{1}{2}(S_0 + S_1 cos2\theta + S_2\ sin2\theta\ cos\varphi + S_3\ sin2\theta\ sin\varphi)$$

where $I(\theta,\varphi)$ is the light intensity for polarizer orientation $\theta$ and phase retardation $\varphi$ introduced by the waveplate, and $S_0$, $S_1$, $S_2$ and $S_3$ are the conventional Stoke's parameters for polarized light. The quarter waveplate introduces a phase shift $\varphi = \pi/2$ between the orthogonal polarized component of the light.

To measure the Stoke's parameters, the electroluminescent (EL) intensity is measured for polarizer orientations of $\theta$ =45° and 90° with and without the quarter waveplate in the beam path. The intensity variation can be expressed as

$$I(0°, 0°) = \frac{1}{2}\ (S_0 + S_1)$$

$$I(45°, 0°) = \frac{1}{2}\ (S_0 + S_2)$$

$$I(90°, 0°) = \frac{1}{2}\,(S_0 - S_1)$$

$$I(45°, 90°) = \frac{1}{2}\,(S_0 + S_3)$$

Solving these equations yields the Stoke's parameters:

$$S_0 = I(0°, 0°) + I(90°, 0°)$$

$$S_1 = I(0°, 0°) - I(90°, 0°)$$

$$S_2 = 2I(45°, 0°) - S_0$$

$$S_3 = 2I(45°, 90°) - S_0$$

where $S_0$ signifies the total EL intensity, $S_1$, and $S_2$ represent the linear polarized components, and $S_3$ represents the circular polarized components of the EL emission. When normalized with the total light intensity, the values of $S_1$,$S_2$ and $S_3$ vary between -1 and 1, such that $S_1^2 + S_2^2 + S_3^2 = 1$, where $S_1$,$S_2$ and $S_3$ signifies the light intensity fraction of linearly polarized vertical components, linearly polarized components having a 45° alignment, and circular polarized components of the EL emission from the OLED device. Accordingly, the absolute value of $S_3$ indicates the degree of circular polarization of the emitted light, which in turn results in differences in the brightness of light emitted by the device as shown in Table 1.

Table 1. Expected improvements in OLED panel brightness for different ranges of $S_3$ values assuming the OLED EL emission passes through a quarter wave plate and a linear polarizer.

| Absolute value of $S_3$ | Effect on OLED brightness with a quarter wave plate and linear polarizer |
|---|---|
| $0.1 < S_3 < 0.5$ | The EL emission will contain either elliptically polarized or circularly polarized light with predominantly unpolarized or linear polarized components. Almost 100 % of the circularly polarized and a large fraction of elliptically polarized components will be transmitted through a circular polarizer, resulting in an enhancement of the brightness of the OLED panel. |
| $0.5 < S_3 < 0.75$ | The EL mission will be predominantly circularly or elliptically polarized leading to significant enhancement in the device brightness with the possibility of a brightness increase up to 1.75 times. |
| $0.75 < S_3 < 1$ | The EL emission is significantly circularly polarized. This is the most preferred embodiment for the polarization control layers in the panel.. The enhancement in the brightness value can range from 1.75 to a maximum of 2 for when absolute value of $S_3$ = 1. |

For a perfectly circular polarized emission, $S_3 = \pm 1$, where +1 indicates a right circular and -1 a left circular polarized light. Although, $S_3 = \pm 1$ is ideal for the device performance where the EL passes through quarter wave plate and linear polarizer. As shown in Table 1, embodiments disclosed herein may achieve emission having a Stokes parameter $S_3$ with an absolute value of 0.1 or greater, leading to increased brightness of the device, even where the device includes a quarter wave plate and/or a linear polarizer. Importantly, $S_3 = \pm 1$ is ideal for OLED panels with a quarter waveplate and linear polarizer, it may not be ideal for other OLED panels where the polarization control optics are different. In that case, the outcoupling structure of the OLED device may be designed to generate light with a different

Stokes parameter.

In some embodiments, condition (7) is true. In some embodiments, the compound S1 is a metal coordination complex having at least two features selected from the group consisting of at least two metals, three different bidentate ligands, three same bidentate ligands, a tetradentate or hexadentate ligand coordinating to Ir or Os, a Ir-carbene bond, Os-carbene bond, M-K bond wherein K is a non-ring atom and M is the metal, a ligand comprising a five-membered heteroaryl ring coordinating to the metal through M-N bond, a ligand comprising a six-membered heteroaryl ring having at least two heteroatoms with one of them coordinating to the metal, a ligand comprising a fused ring system having at least four rings, at least 25% deuterated of the metal complex, and combinations thereof.

In some embodiments, the compound S1 is a metal coordination complex comprising at least two different metals. In some embodiments, the compound S1 is a metal coordination complex comprising at least two atoms of the same metal. In some embodiments, the compound S1 is a metal coordination complex comprising at least two metals of different oxidation states. In some embodiments, the compound S 1 is a metal coordination complex comprising at least two metals with the same oxidation states. In some embodiments, the compound S1 is a metal coordination complex comprising at least two metals coordinated to the same ligand. In some embodiments, the compound S1 is a metal coordination complex comprising a single polydentate ligand and at least two metals.

In some embodiments, the compound S1 is a metal coordination complex comprising three different bidentate ligands three same bidentate ligands. In some embodiments, the compound S1 is a metal coordination complex comprising three different bidentate ligands, wherein at least two of the ligands have different chelation ring size.

In some embodiments, the compound S1 is a metal coordination complex comprising three bidentate ligands, wherein at least one of the ligands have a chelation ring size of 6 atoms or larger. In some embodiments, the compound S1 is a metal coordination complex comprising three bidentate ligands, wherein at least two of the ligands have a chelation ring size of 6 atoms or larger.

In some embodiments, the compound S 1 is a metal coordination complex comprising three of the same bidentate ligands. In some embodiments, the compound S1 is a metal coordination complex comprising three of the same bidentate ligands, wherein the bidentate ligands comprise a group selected from benzimidazole and imidazole.

In some embodiments, the compound S1 is a metal coordination complex comprising a tetradentate or hexadentate ligand coordinating to Ir or Os.

In some embodiments, the compound S1 is a metal coordination complex comprising a Ir-carbene bond or an Os-carbene bond. In some embodiments, the compound S1 is a metal coordination complex comprising exactly one Ir-carbene bond or exactly one Os-carbene bond. In some embodiments, the compound S1 is a metal coordination complex comprising at least two Ir-carbene bond or at least two Os-carbene bond. In some embodiments, the compound S1 is a metal coordination complex comprising exactly two Ir-carbene bond or exactly two Os-carbene bond. In some embodiments, the compound S1 is a metal coordination complex comprising three Ir-carbene bond or three Os-carbene bond.

In some embodiments, the compound S1 is a metal coordination complex comprising a M-K bond wherein K is a non-ring atom and M is the metal. In some embodiments, K is an oxygen atom. In some embodiments, M is an Pt or Pd. In some embodiments, the compound S1 is a metal coordination complex comprising a M-K bond wherein the M-K bond is part of a chelation ring comprising 6, 7, or 8 atoms.

In some embodiments, the compound S1 is a metal coordination complex comprising a ligand comprising a five-membered heteroaryl ring coordinating to the metal through M-N bond. In some embodiments, the compound S1 is a metal coordination complex comprising a ligand comprising a six-membered heteroaryl ring having at least two heteroatoms with one of them coordinating to the metal. In some embodiments, the compound S1 is a metal coordination complex comprising a fused polycyclic ring system comprising at least one a six-membered heteroaryl ring having at least two heteroatoms. In some embodiments, the compound S1 is a metal coordination complex comprising a fused ring system having at least four rings,

In some embodiments, the compound S1 is at least 25% deuterated. In some embodiments, the compound S1 is at least 30, 50, 75, 90, 95, 99, or 100% deuterated.

In some embodiments, the metal coordination complex has at least two metals. In some embodiments, such two metals can be same or different, and selected from the group consisting of Re, Os, Ru, Ir, Rh, Pt, Pd, Au, Ag, and Cu. In some embodiments, such two metals are selected from the pair consisting of: (Ir, Ir), (Ir, Pt), (Pt, Pt), (Ir-Au), (Ir-Cu), (Pt-Au), (Pt-Cu), and (Au-Cu). In some embodiments, the metal coordination complex has at least three metals. In some embodiments, the metal coordination complex has at least four metals.

In some embodiments, the metal coordination complex has three different bidentate ligands or three identical bidentate ligands. In some embodiments, the metal is Ir or Os. In some embodiments, each bidentate ligand has two coordinating atoms selected from the pair consisting of: (C, N), (C, C), (C, O), (N, N), (N, O), and (O, O). In some embodiments, each bidentate ligand is a mono-anionic bidentate ligand. In some embodiments, each coordinating atom can be a neutral or anionic N atom, a carbene C or a anionic C, a neutral or anionic O atom. In some embodiments, each bidentate ligand can be linked to another bidentate ligand to form a tetradentate or hexadentate ligand.

In some embodiments, the metal coordination complex has a tetradentate ligand or hexadentate ligand coordinating to Ir or Os.

In some embodiments, the metal coordination complex has a Ir-carbene or Os-carbene bond. In some embodiments, the metal coordination complex has exact one Ir-carbene or Os-carbene bond. In some embodiments, the metal coordination complex comprises another metal-carbene bond. In some embodiments, the metal coordination complex is heteraleptic or homoleptic. In some embodiments, the carbene ligand is N-heterocyclic carbene. In some embodiments, the carbene ligand is an imidazole-derived or benzimidazole-derived carbene.

In some embodiments, the metal coordination complex has a M-K bond wherein K is a non-ring atom and M is the metal. In some embodiments, K is selected from the group consisting of a direct bond, O, S, N($R^{\alpha}$), P($R^{\alpha}$), B($R^{\alpha}$), C($R^{\alpha}$)($R^{\beta}$), and Si($R^{\alpha}$)($R^{\beta}$), wherein each of $R^{\alpha}$ and $R^{\beta}$ is independently hydrogen or a substituent selected from the group consisting of the general substituents as defined herein. In some embodiments, K is O, S or $NR^{\alpha}$. In some embodiments, K is mono-anionic. In some embodiments, K is neutral. In some embodiments, M is selected from the group consisting of Re, Os, Ru, Ir, Rh, Pt, Pd, Au, Ag, and Cu. In some embodiments, M is selected from the group consisting of Ir, Pt, and Cu.

In some embodiments, the metal coordination complex has a ligand comprising a five-member heteroaryl ring coordinating to the metal through M-N bond. In some embodiments, the five-member heteroaryl ring is selected from the group consisting of imidazole, oxazole, thiazole, pyrazole, isoxazole, isothiazole, oxadiazole, triazole, and thiadiazole.

In some embodiments, the metal coordination complex has a ligand comprising a six-membered heteroaryl ring having at least two heteroatoms with one of them coordinating to the metal. In some embodiments, the six-membered heteroaryl ring is selected from the group consisting of pyrimidine, pyridazine, pyrazine, and triazine.

In some embodiments, the metal coordination complex has a ligand comprising a fused ring system having at least four rings. In some embodiments, each of the at least four rings only share one or two edges with the neighboring rings. In some embodiments, each of the at least four rings share exact two edges with the neighboring rings. In some embodiments, each of the at least four rings share at least two edges with the neighboring rings. In some embodiments, at least one of the at least four rings share three edges with the neighboring rings. In some embodiments, at least two of the at least four rings share three edges with the neighboring rings. In some embodiments, at least three of the at least four rings share three edges with the neighboring rings.

In some embodiments, the metal coordination complex is at least 25% deuterated. In some embodiments, at least 30, 50, 75, 90, 95, 99, or 100% of the saturated carbons in the metal coordination complex are deuterated. In some embodiments, all the saturated carbons in the metal coordination complex are deuterated. In some embodiments, at least 30, 50, 75, 90, 95, 99, or 100% of the unsaturated carbons in the metal coordination complex are deuterated. In some embodiments, all the unsaturated carbons in the metal coordination complex are deuterated.

In some embodiments, condition (8) is true. In some embodiments, the compound S 1 is a bidentate Au(III) coordination complex. In some embodiments,the compound S1 is a tridentate Au(III) coordination complex. In some embodiments,the compound S1 is a tetradentate Au(III) coordination complex. In some of these embodiments, the compound S1 is capable of functioning as a phosphorescent or delayed fluorescence emitter in an OLED at room temperature.

In some of these embodiments, the Au(III) coordination complex may be one of the following:

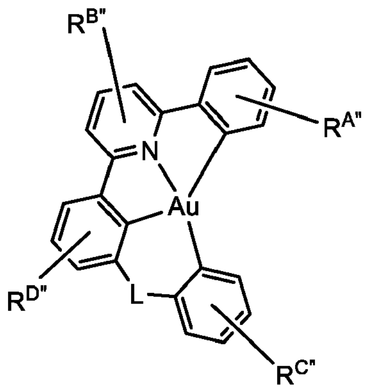
,
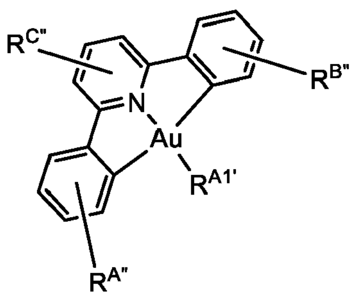
,

and

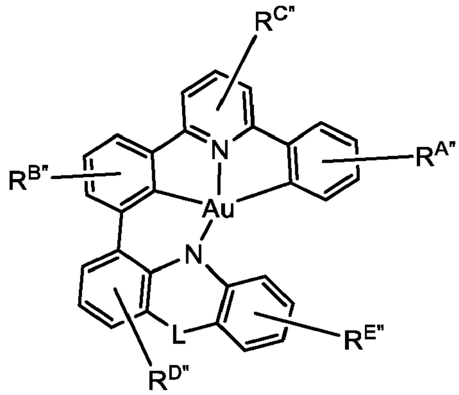

,

wherein each $R^{A''}$, $R^{B''}$, $R^{C''}$, $R^{D''}$, and $R^{E''}$ can independently represent from mono to the maximum possible number of substitutions, or no substitution;
each $R^{A1}$, $R^{A''}$, $R^{B''}$, $R^{C''}$, $R^{D''}$, and $R^{E''}$ is independently a hydrogen or a substituent selected from the group consisting of the general substituents as defined herein; wherein any two substituents can be fused or joined to form into a ring.
wherein L is independently selected from the group consisting of a direct bond, BR", BR"R‴, NR", PR", O, S, Se, C=O, C=S, C=Se, C=NR", C=CR"R‴, S=O, $SO_2$, CR", CR"R‴, SiR"R‴, GeR"R‴, alkyl, cycloalkyl, aryl, heteroaryl, and combinations thereof; and
wherein any two substituents can be fused or joined to form a ring.

In some of these embodiments, the Au coordination complex may be one of the following:

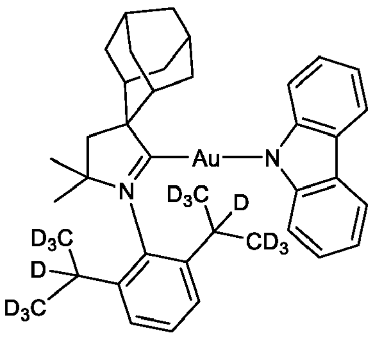

,

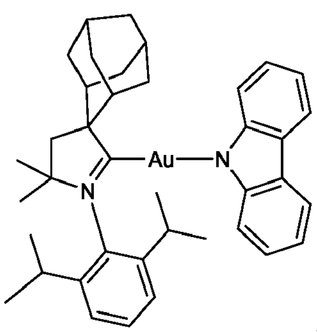

,

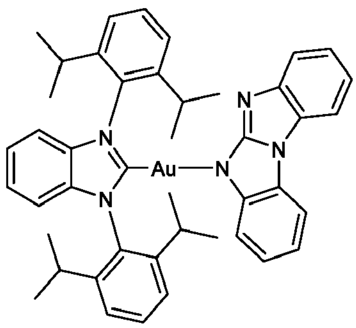

,

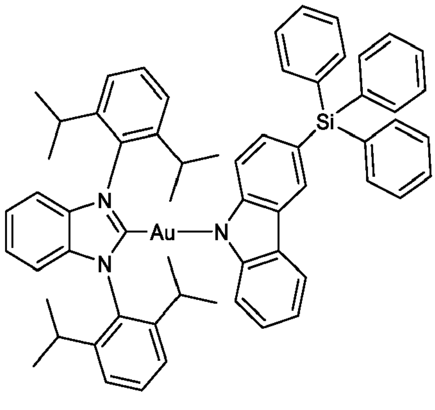

,

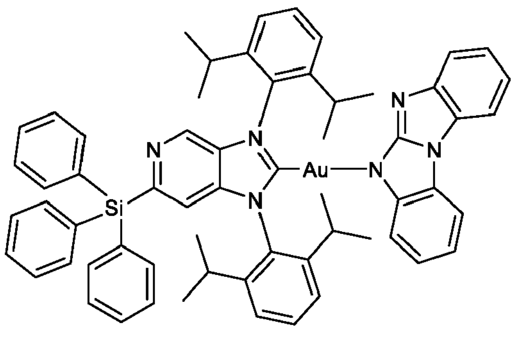

,

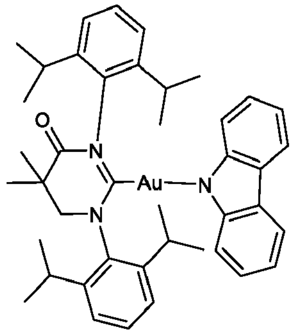
,
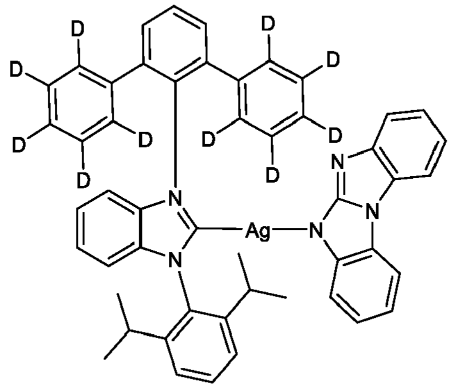
,
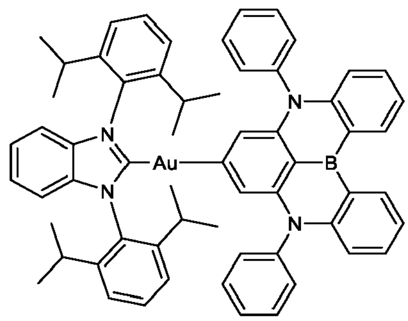
,

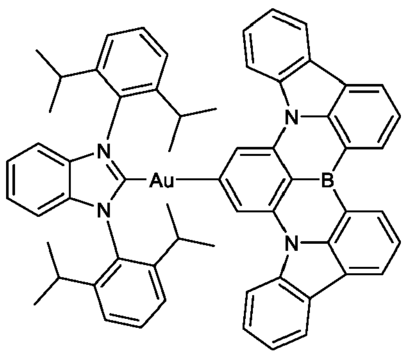
,
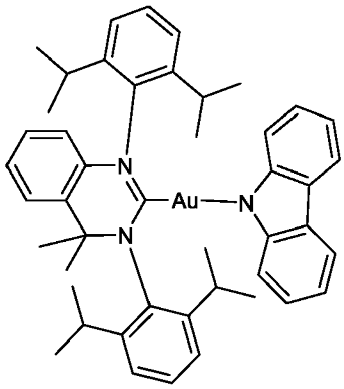
,
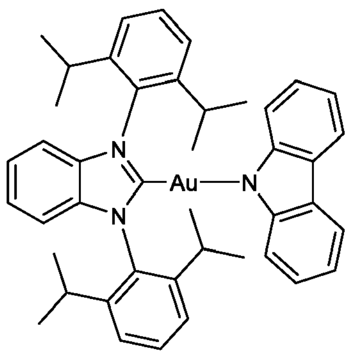
,

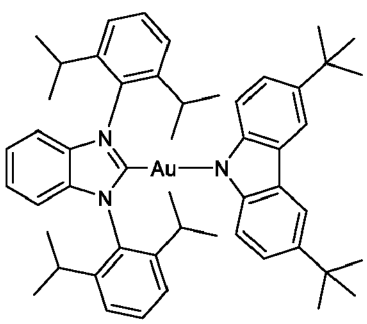
,
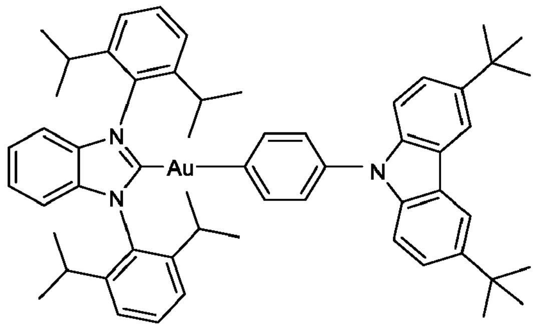
,

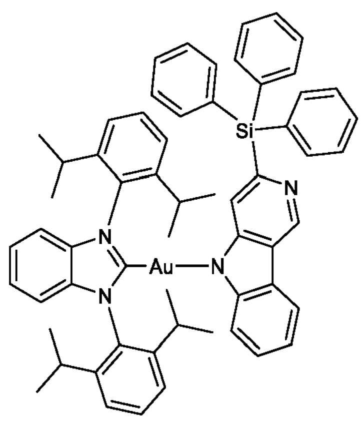
,
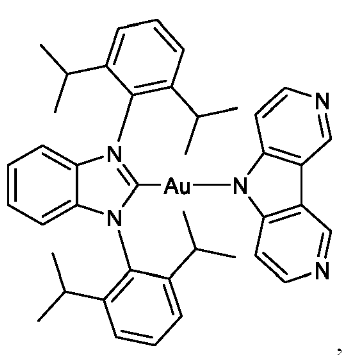
,

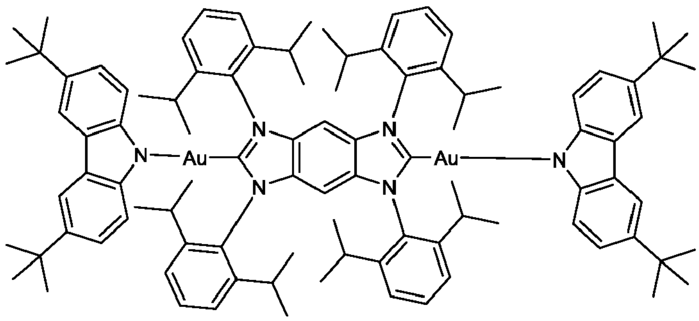

,

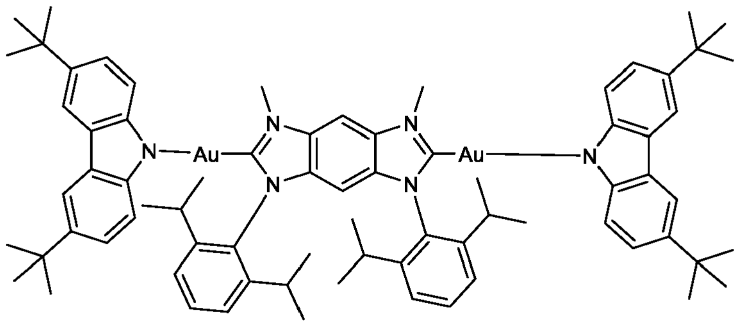

,

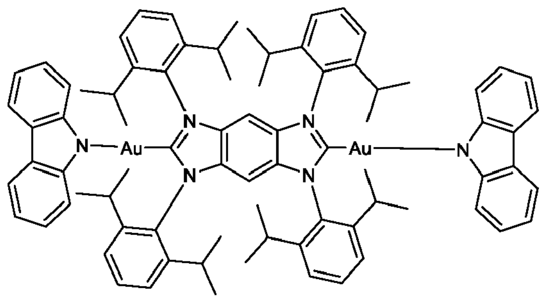

,

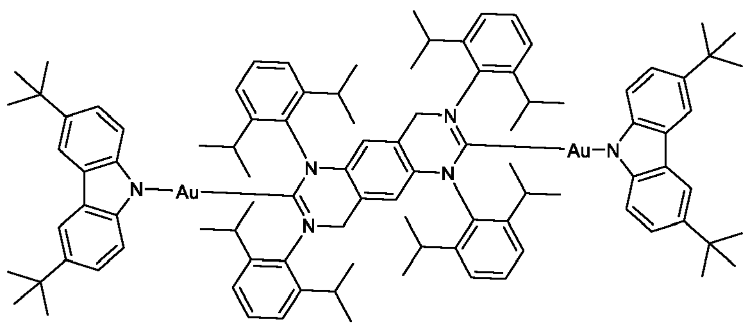

,

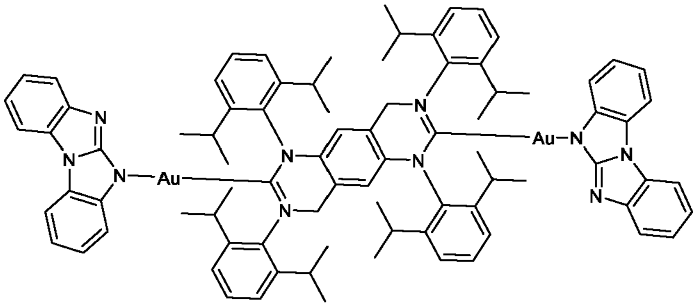

,

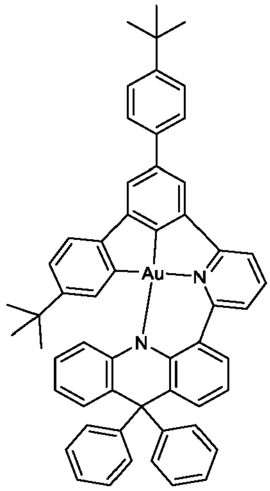

,

and

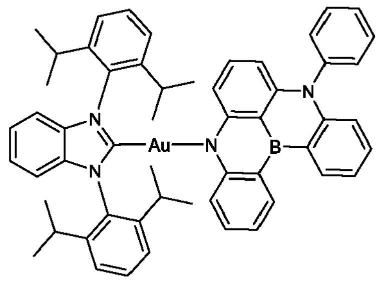

.

In some embodiments, condition (9) is true. In some of these embodiments, the compound S1 is a Zn(II) coordination complex having a bidentate ligand. In some of these embodiments, the compound S 1 is capable of functioning as a phosphorescenr or delayed fluorescence emitter in an OLED at room temperature. In some of these embodiments, the compound S1 may be one of the following:

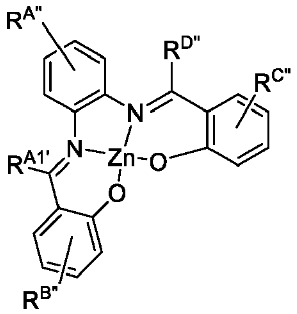

,

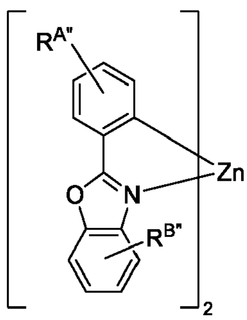

,

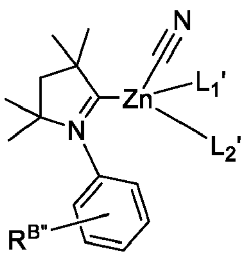

,

and

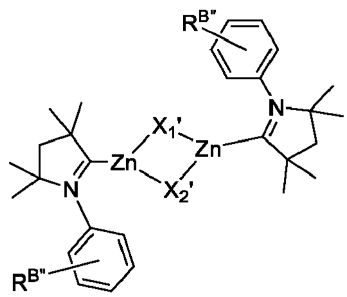

,

wherein each $R^{A''}$, $R^{B''}$, $R^{C''}$, and $R^{D''}$ can independently represent from mono to the maximum possible number of substitutions, or no substitution;

each R", R‴, $R^{A1}$, $R^{A''}$, $R^{B''}$, $R^{C''}$, $R^{D''}$, $R^{E''}$, and $R^{F''}$ is independently a hydrogen or a substituent selected from the group consisting of the general substituents as defined herein; wherein any two substituents can be fused or joined to form into a ring.

wherein each of $L_1$ and $L_2$ is a monodentate anionic ligand,

wherein each of $X_1$' and $X_2$' is a halide; and

wherein any two substituents can be fused or joined to form a ring.

In some embodiments, condtion (10) is true. In some embodiments, the compound S1 comprises at least one electron-withdrawing group (EWG). In some embodiments, the compound S1 comprises at least two EWGs. In some embodiments, the EWG attaches to the ring that coordinates to the metal. In some embodiments, the EWG attaches to the ring that does not coordinate to the metal. In some embodiments, the EWG attaches to the fused ring system with one of the rings in the fused ring system that coordinates to the metal. In some embodiments, the EWG attaches to the ring that does not coordinate to the metal and does not belong to a fused ring system. In some embodiments,

In some embodiments, the electron-withdrawing groups commonly comprise one or more highly electronegative elements including but not limited to fluorine, oxygen, sulfur, nitrogen, chlorine, and bromine.

In some embodiments of the compound, the electron-withdrawing group has a Hammett constant larger than 0. In some embodiments, the electron-withdrawing group has a Hammett constant equal or larger than 0.1, 0.2, 0.3, 0.4, 0.5, 0.6, 0.7, 0.8, 0.9, 1.0, or 1.1.

In some embodiments, the electron-withdrawn group is selected from the group consisting of the following structures (LIST EWG 1): F, $CF_3$, CN, $COCH_3$, CHO, $COCF_3$, COOMe, $COOCF_3$, $NO_2$, $SF_3$, $SiF_3$, $PF_4$, $SF_5$, $OCF_3$, $SCF_3$, $SeCF_3$, $SOCF_3$, $SeOCF_3$, $SO_2F$, $SO_2CF_3$, $SeO_2CF_3$, $OSeO_2CF_3$, OCN, SCN, SeCN, NC, $^+N(R^{k2})_3$, $(R^{k2})_2CCN$, $(R^{k2})_2CCF_3$, $CNC(CF_3)_2$, $BR^{k3}R^{k2}$, substituted or unsubstituted dibenzoborole, 1-substituted carbazole, 1,9-substituted carbazole, substituted or unsubstituted carbazole, substituted or unsubstituted pyridine, substituted or unsubstituted pyrimidine, substituted or unsubstituted pyrazine, substituted or unsubstituted pyridoxine, substituted or unsubstituted triazine, substituted or unsubstituted oxazole, substituted or unsubstituted benzoxazole, substituted or unsubstituted thiazole, substituted or unsubstituted benzothiazole, substituted or unsubstituted imidazole, substituted or unsubstituted benzimidazole, ketone, carboxylic acid, ester, nitrile, isonitrile, sulfinyl, sulfonyl, partially and fully fluorinated alkyl, partially and fully fluorinated aryl, partially and fully fluorinated heteroaryl, cyano-containing alkyl, cyano-containing aryl, cyano-containing heteroaryl, isocyanate,

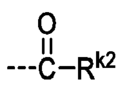, 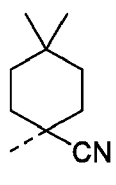, 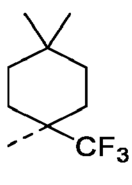, 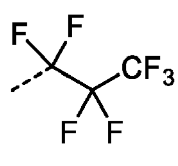, 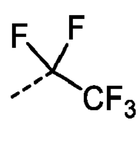,

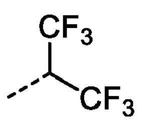, 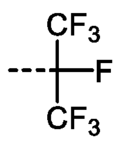, 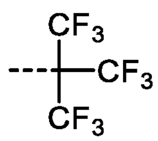, 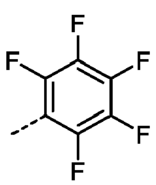, 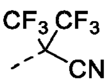, 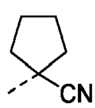, 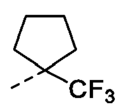, 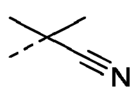,

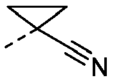, 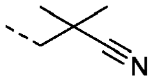, 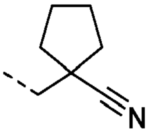, 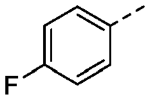, 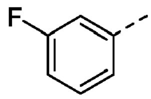, 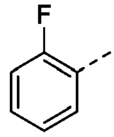, 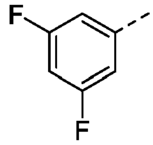,

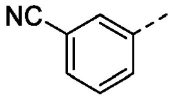, 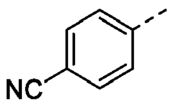, 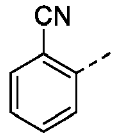, 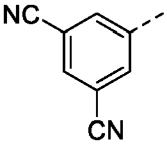, 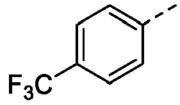, 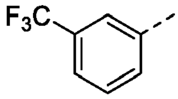, 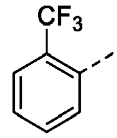,

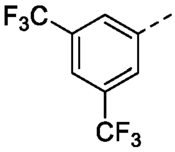, 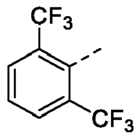, 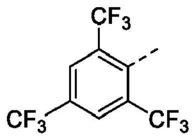, 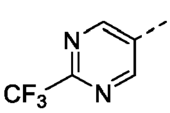, 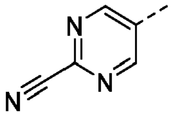, 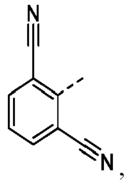, 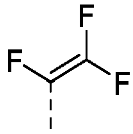,

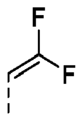, 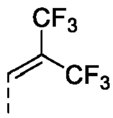, 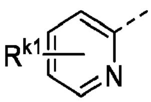, 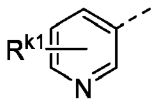, 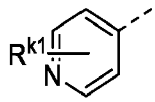, 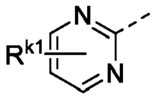, 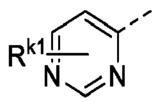,

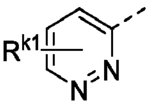, 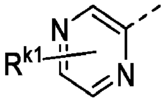, 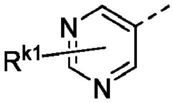, 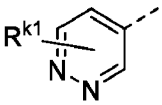, 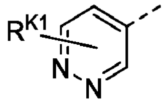, 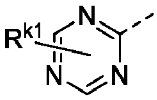, 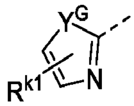

, 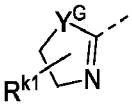, 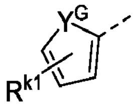, and 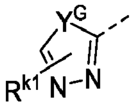;

wherein $Y^G$ is selected from the group consisting of $BR_e$, $NR_e$, $PR_e$, O, S, Se, C=O, S=O, $SO_2$, $CR_eR_f$, $SiR_eR_f$, and $GeR_eR_f$; and
$R^{k1}$ each independently represents mono to the maximum allowable substitutions, or no substitution;
wherein each of $R^{k1}$, $R^{k2}$, $R^{k3}$, $R_e$, and $R_f$ is independently a hydrogen or a substituent selected from the group consisting of the General Substituents defined herein.

In some embodiments, the electron-withdrawing group is selected from the group consisting of the following structures (LIST EWG 2):

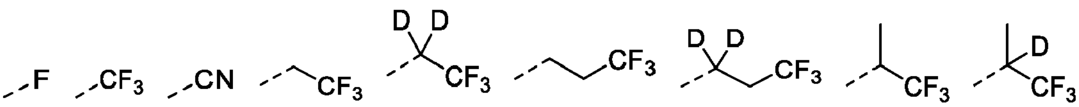
E1, E2, E3, E4, E5, E6, E7, E8, E9,

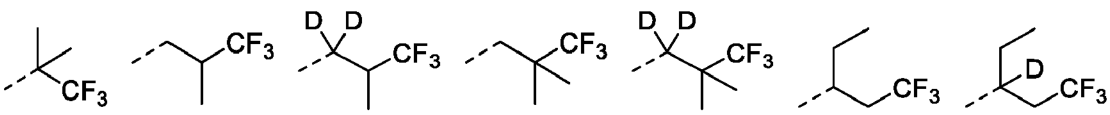
E10, E11, E12, E13, E14, E15, E16,

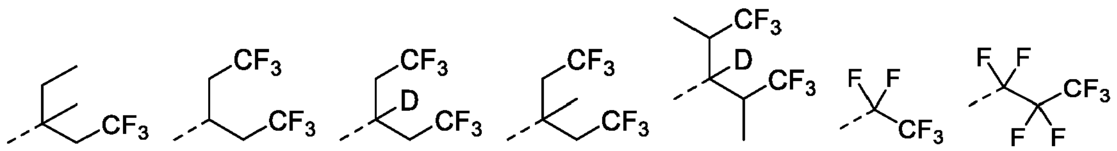

E17 , E18 , E19 , E20 , E21 , E22 , E23 ,

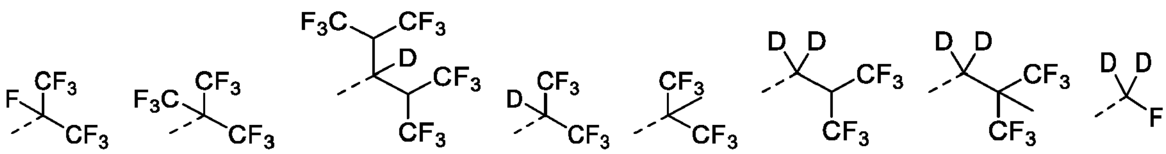

E24 , E25 , E26 , E27 , E28 , E29 , E30 , E31 ,

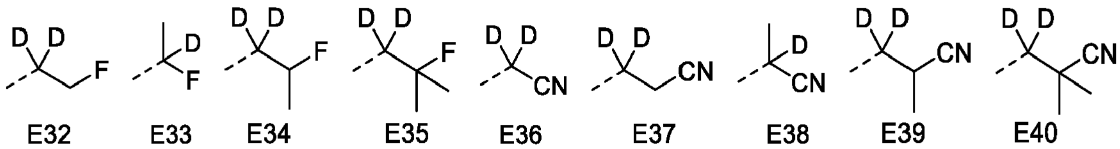

E32 , E33 , E34 , E35 , E36 , E37 , E38 , E39 , E40 ,

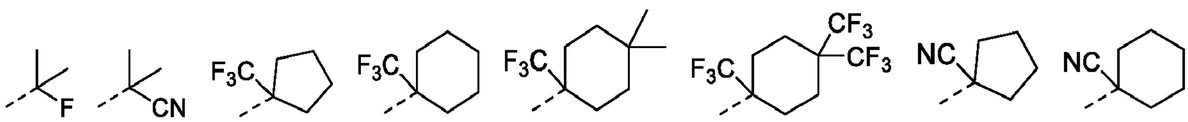

E41 , E42 , E43 , E44 , E45 , E46 , E47 , E48 ,

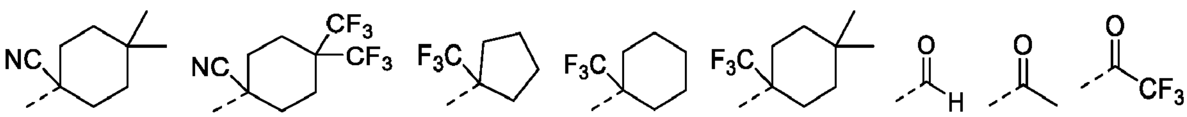

E49 , E50 , E51 , E52 , E53 , E54 , E55 , E56 ,

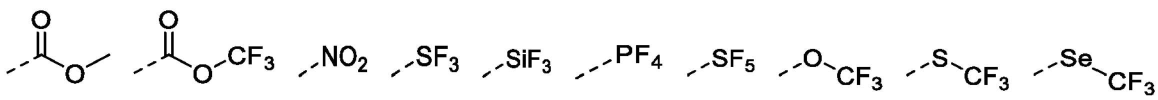

E57 , E58 , E59 , E60 , E61 , E62 , E63 , E64 , E65 , E66 ,

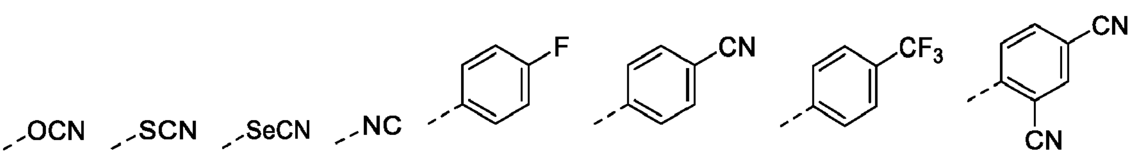

E67 , E68 , E69 , E70 , E71 , E72 , E73 , E74 ,

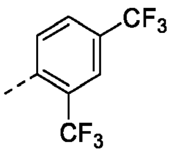 E75 , 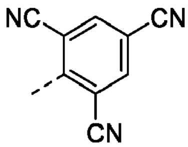 E76 , 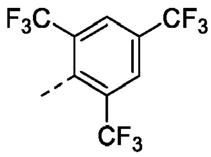 E77 , 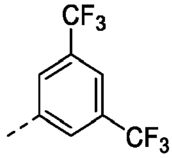 E78 , 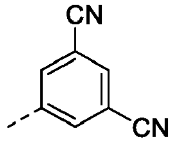 E79 , 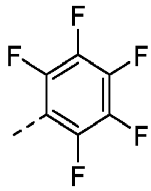 E80 ,

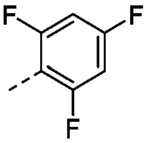 E81 , 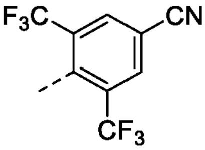 E82 , 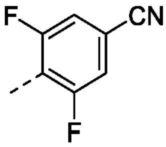 E83 , 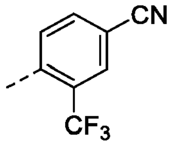 E84 , 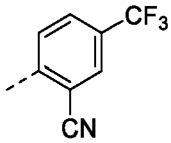 E85 , 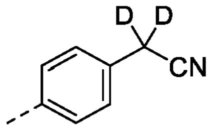 E86 ,

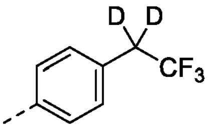 E87 , 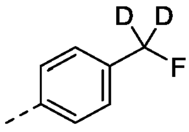 E88 , 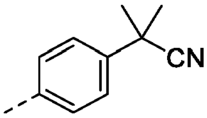 E89 , 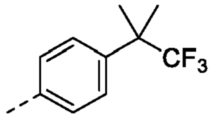 E90 , 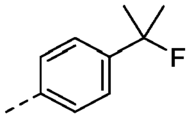 E91 ,

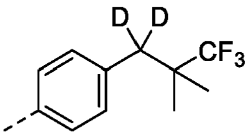 E92 , 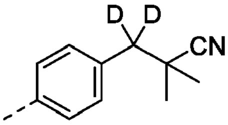 E93 , 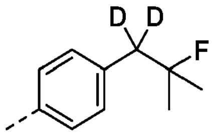 E94 , 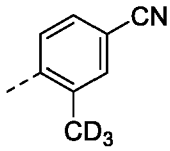 E95 , 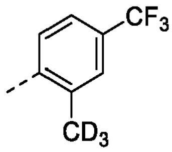 E96 ,

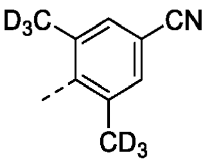 E97 , 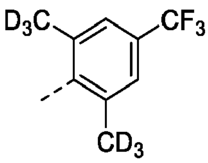 E98 , 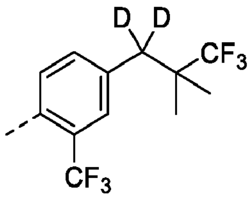 E99 , 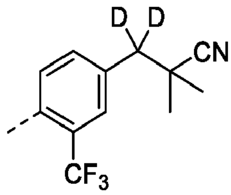 E100 , 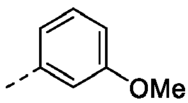 E101 ,

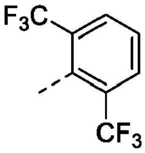 E102 , 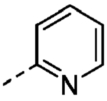 E103 , 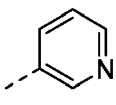 E104 , 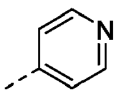 E105 , 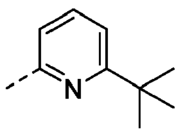 E106 , 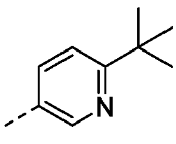 E107 , 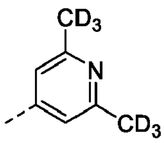 E108 ,

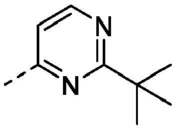 E109, 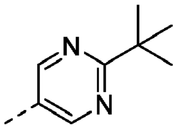 E110, 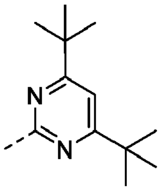 E111, 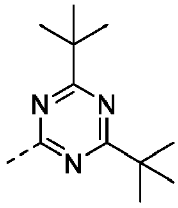 E112, 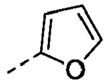 E113, 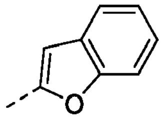 E114, 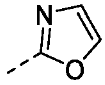 E115,

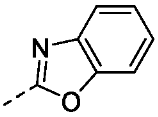 E116, 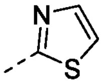 E117, 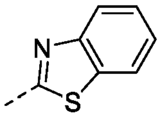 E118, 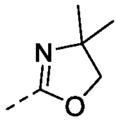 E119, 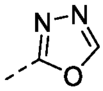 E120, 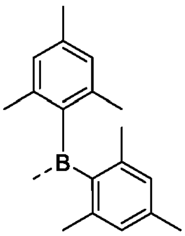 E121, 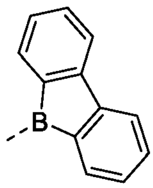 E122,

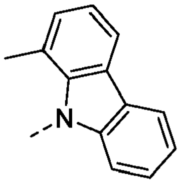 E123, 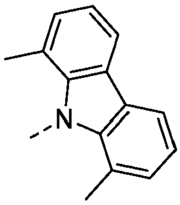 E124, and 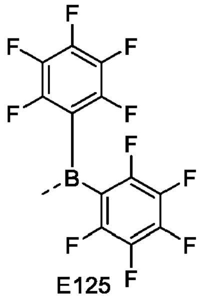 E125.

In some embodiments, the electron-withdrawing group is selected from the group consisting of the following structures (LIST EWG 3):

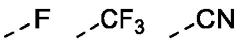 E1, E2, E3, 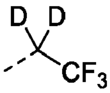 E5, 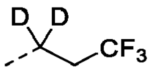 E7, 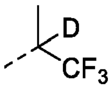 E9, 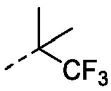 E10, 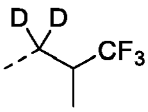 E12, 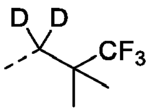 E14,

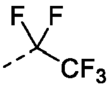 E22, 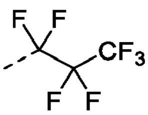 E23, 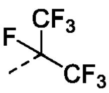 E24, 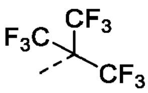 E25, 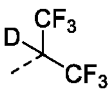 E27, 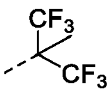 E28, 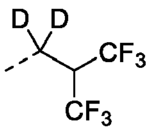 E29, 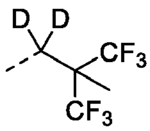 E30,

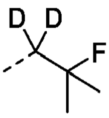 E35, 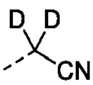 E36, 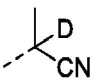 E38, 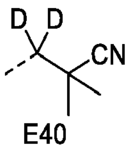 E40, 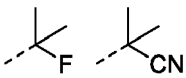 E41, E42, 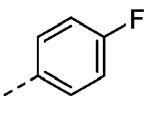 E71, 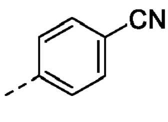 E72,

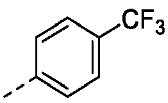
E73 ,
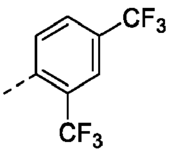
E75 ,
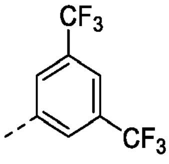
E78 ,
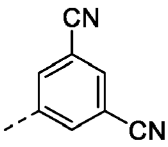
E79 ,
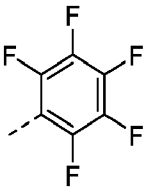
E80 ,
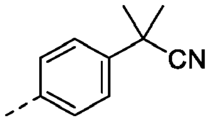
E89 ,

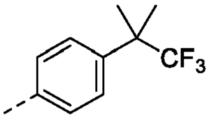
E90 ,
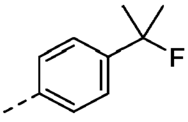
E91 ,
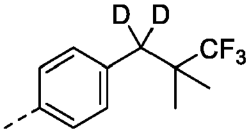
E92 ,
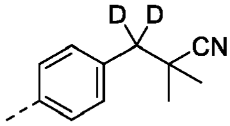
E93 ,
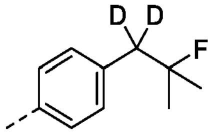
E94 ,

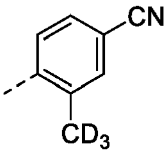
E95 ,
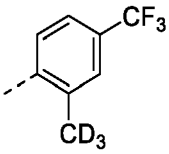
E96 ,
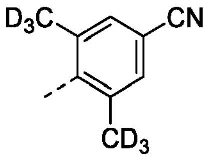
E97 ,
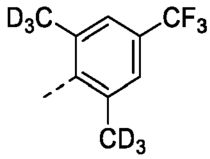
E98 ,
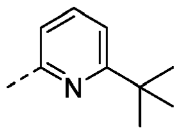
E106 ,
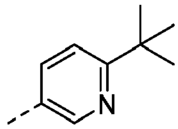
E107 ,

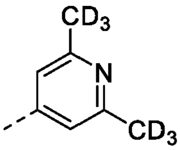
E108 ,
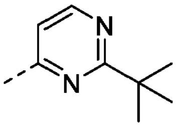
E109 ,
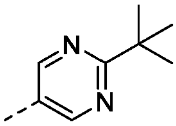
E110 ,
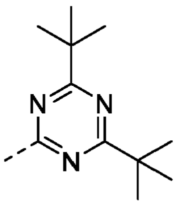
E112 ,
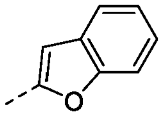
E114 ,
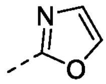
E115 ,

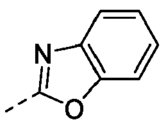
E116 , and
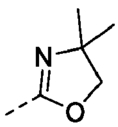
E119 .

In some embodiments, the electron-withdrawing group is selected from the group consisting of the following structures (LIST EWG 4):

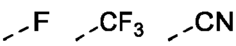
E1 , E2 , E3 ,
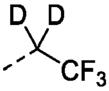
E5 ,
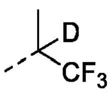
E9 ,
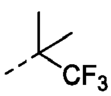
E10 ,
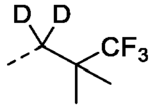
E14 ,
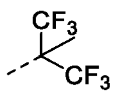
E28 ,
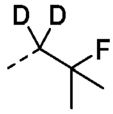
E35 ,
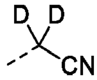
E36 ,

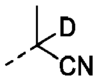
E38 ,
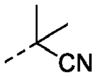
E42 ,
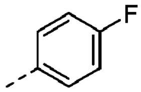
E71 ,
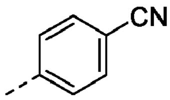
E72 ,
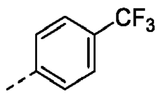
E73 ,
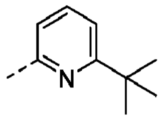
E106 ,
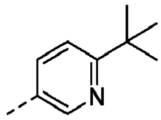
E107 ,

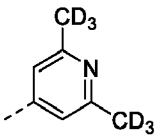
E108 ,
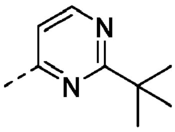
E109 ,
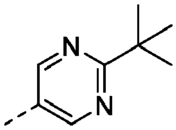
E110 ,
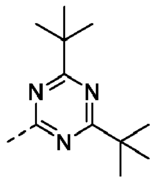
E112 ,
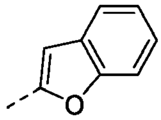
E114 ,
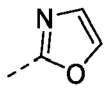
E115 ,
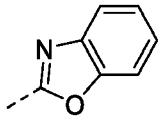
E116 ,

and

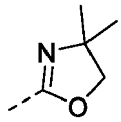
E119 .

In some embodiments, the electron-withdrawing group is a π-electron deficient electron-withdrawing group. In some embodiments, the π-electron deficient electron-withdrawing group is selected from the group consisting of the following structures (LIST Pi-EWG): CN, $COCH_3$, CHO, $COCF_3$, COOMe, $COOCF_3$, $NO_2$, $SF_3$, $SiF_3$, $PF_4$, $SF_5$, $OCF_3$, $SCF_3$, $SeCF_3$, $SOCF_3$, $SeOCF_3$, $SO_2F$, $SO_2CF_3$, $SeO_2CF_3$, $OSeO_2CF_3$, OCN, SCN, SeCN, NC, $^{+}N(R^{k1})_3$, $BR^{k1}R^{k2}$. substituted or unsubstituted dibenzoborole, 1-substituted carbazole, 1,9-substituted carbazole, substituted or unsubstituted carbazole, substituted or unsubstituted pyridine, substituted or unsubstituted pyrimidine, substituted or unsubstituted pyrazine, substituted or unsubstituted pyridazine, substituted or unsubstituted triazine, substituted or unsubstituted oxazole, substituted or unsubstituted benzoxazole, substituted or unsubstituted thiazole, substituted or unsubstituted benzothiazole, substituted or unsubstituted imidazole, substituted or unsubstituted benzimidazole, ketone, carboxylic acid, ester, nitrile, isonitrile, sulfinyl, sulfonyl, partially and fully fluorinated aryl, partially and fully fluorinated heteroaryl, cyano - containing aryl, cyano-containing heteroaryl, isocyanate,

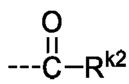
,
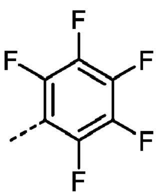
,
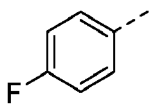
,

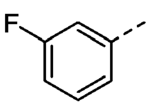
,
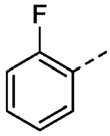
,
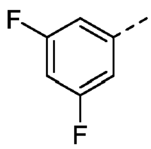
,
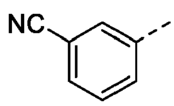
,
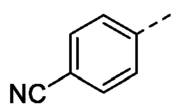
,
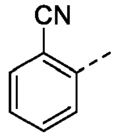
,
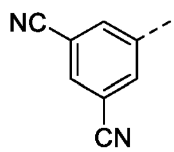
,

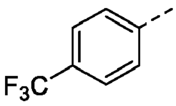, 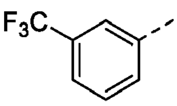, 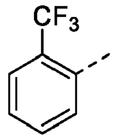, 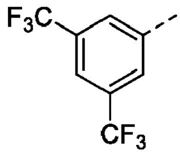, 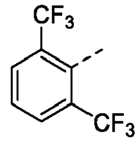, 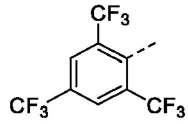,

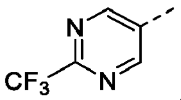, 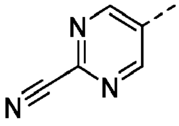, 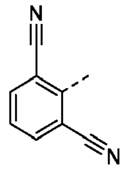, 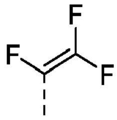, 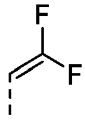, 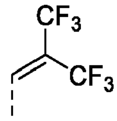, 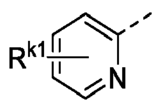,

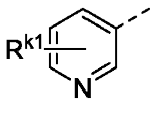, 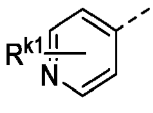, 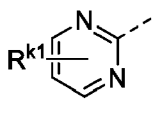, 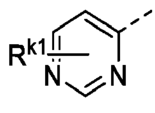, 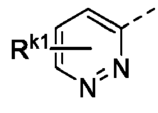, 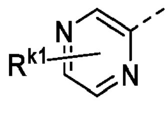, 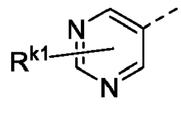,

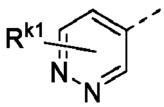, 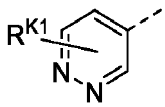, 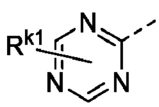, 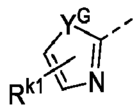, 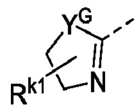, 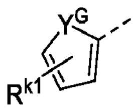, and 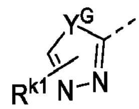,

wherein the variables are the same as previously defined.

In some embodiments, condtion (11) is true. In some embodiments, the compound A1 comprises at least one electron-withdrawing group (EWG). In some embodiments, the compound A1 comprises at least two EWGs. In some embodiments, the EWG attaches to the ring that coordinates to the metal. In some embodiments, the EWG attaches to the ring that does not coordinate to the metal. In some embodiments, the EWG attaches to the fused ring system with one of the rings in the fused ring system that coordinates to the metal. In some embodiments, the EWG attaches to the ring that does not coordinate to the metal and does not belong to a fused ring system. In some embodiments, the electron-withdrawing group is seleted from LIST EWG 1 as defined for condition (10). In some embodiments, the electron-withdrawing group is seleted from LIST EWG 2 as defined for condition (10). In some embodiments, the electron-withdrawing group is seleted from LIST EWG 3 as defined for condition (10). In some embodiments, the electron-withdrawing group is seleted from LIST EWG 4 as defined for condition (10). In some embodiments, the electron-withdrawing group is seleted from LIST Pi-EWG as defined for condition (10). It should be understood that all the EWG related embodiments for condition (10) can be equally applied to all the embodiments of the condition (11) and throughout the disclosure where/if an EWG group is applicable.

In some embodiments, condition (12) is true. In some embodiments, at least two of conditions (1) through (11) are true, or at least three of conditions (1) through (11) are true, or at least four of conditions (1) through (11) are true, or five to seven of conditions (1) through (11) are true (so long as they are internally consistent).

In some embodiments, the OLED further comprises a color conversion layer or a color filter.

In some embodiments, a formulation can comprise at least two different compounds of the following compounds: a sensitizer compound, an acceptor compound and a host.

In some embodiments, a chemical structure/assembly selected from the group consisting of a mo nomer, a polymer, a macromolecule, and a supramolecule, wherein the chemical structure/assembly comprises at least two of the following components: a sensitizer compound, an acceptor compound and a host.

In some embodiments, a premixed co-evaporation source that is a mixture of a first compound and a second compound; wherein the co-evaporation source is a co-evaporation source for vacuum deposition process or OVJP process; wherein the first compound and the second compound are differently selected from the group 1 consisting of: a sensitizer compound, an acceptor compound, a first host compound; and a second host compound; wherein the first compound has an evaporation temperature T1 of 150 to 350 °C; wherein the second compound has an evaporation temperature T2 of 150 to 350 °C; wherein absolute value of T1-T2 is less than 20 °C; wherein the first compound has a concentration C1 in said mixture and a concentration C2 in a film formed by evaporating the mixture in a vacuum deposition tool at a constant pressure between $1\times10^{-6}$ Torr to $1\times10^{-9}$ Torr, at a 2Å/sec deposition rate on a surface positioned at a predefined distance away from the mixture being evaporated; and wherein absolute value of (C1-C2)/C1 is less than 5%. In some embodiments, the mixture further comprises a third compound; wherein the third compound is different from the first and the second compound and is selected from the same group 1; wherein the third compound

has an evaporation temperature T3 of 150 to 350 °C, and wherein absolute value of T1-T3 is less than 20 °C.

In some embodiments, the first compound has evaporation temperature T1 of 200 to 350 °C and the second compound has evaporation temperature T2 of 200 to 350 °C. In some embodiments, the absolute value of $(C_1-C_2)/C_1$ is less than 3%. In some embodiments, the first compound has a vapor pressure of $P_1$ at T1 at 1 atm, and the second compound has a vapor pressure of $P_2$ at T2 at 1 atm; and wherein the ratio of $P_1/P_2$ is within the range of 0.90:1 to 1.10:1. In some embodiments, the first compound has a first mass loss rate and the second compound has a second mass loss rate, wherein the ratio between the first mass loss rate and the second mass loss rate is within the range of 0.90:1 to 1.10:1, 0.95:1 to 1.05:1, or 0.97:1 to 1.03:1. In some embodiments, the first compound and the second compound each has a purity in excess of 99 % as determined by high pressure liquid chromatography. In some embodiments, the composition is in liquid form at a temperature less than the lesser of T1 and T2.

In some embodiments, a method for fabricating an organic light emitting device can comprises: providing a substrate having a first electrode disposed thereon; depositing a first organic layer over the first electrode by evaporating a pre-mixed co-evaporation source that is a mixture of a first compound and a second compound described above in a high vacuum deposition tool with a chamber base pressure between $1\times10^{-6}$ Torr to $1\times10^{-9}$ Torr; and depositing a second electrode over the first organic layer.

In yet another aspect, the present disclosure provides a method for fabricating an organic light emitting device (OLED), the method comprising: providing a substrate having a first electrode disposed thereon; depositing a first organic region over the first electrode by printing at least one of a compound SI and a compound A1 through an organic vapor jet printing (OVJP) head; and depositing a second electrode over a first organic layer; wherein the compound S1 is a sensitizer that transfers energy to the compound A1; and the compound A1 is an acceptor that is an emitter in the OLED. In some embodiments, both compounds S1 and A1 are printed through the OVJP heads. In some embodiments, compounds S1 and A1 are mixed together and printed through the same OVJP head. In some embodiments, compounds S1 and A1 are printed through separated OVJP heads. In some embodiments, compounds S1 and/or A1 can be mixed with another compound, such as host, and are printed through the same or different OVJP heads. In some embodiments, each component in the first organic region is printed through separated OVJP heads either simultaneously or asynchronously.

In some embodiments, each of the compound S1, the compound A1, the compound H1, the compound A2; and the compound H2 described herein can be at least 10% deuterated, at least 20% deuterated, at least 30% deuterated, at least 40% deuterated, at least 50% deuterated, at least 60% deuterated, at least 70% deuterated, at least 80% deuterated, at least 90% deuterated, at least 95% deuterated, at least 99% deuterated, or 100% deuterated. As used herein, percent deuteration has its ordinary meaning and includes the percent of possible hydrogen atoms (e.g., positions that are hydrogen or deuterium) that are replaced by deuterium atoms.

C. Other Aspects of the OLEDs of the Present Disclosure

In some embodiments, the OLED may further comprise an additional host, wherein the additional host comprises a triphenylene containing benzo-fused thiophene or benzo-fused furan, wherein any substituent in the host is an unfused substituent independently selected from the group consisting of $C_nH_{2n+1}$, $OC_nH_{2n+1}$, $OAr_1$, $N(C_nH_{2n+1})_2$, $N(Ar_1)(Ar_2)$, $CH=CH-C_nH_{2n+1}$, $C\equiv CC_nH_{2n+1}$, $Ar_1$, $Ar_1-Ar_2$, $C_nH_{2n}-Ar_1$, or no substitution, wherein n is an integer from 1 to 10; and wherein $Ar_1$ and $Ar_2$ are independently selected from the group consisting of benzene, biphenyl, naphthalene, triphenylene, carbazole, and heteroaromatic analogs thereof.

In some embodiments, the additional host comprises at least one chemical group selected from the group consisting of triphenylene, carbazole, indolocarbazole, dibenzothiophene, dibenzofuran, dibenzoselenophene, 5λ2-benzo[d]benzo[4,5]imidazo[3,2-a]imidazole, 5,9-dioxa-13b-boranaphtho[3,2,1-de]anthracene, triazine, boryl, silyl, aza-triphenylene, aza-carbazole, aza-indolocarbazole, aza-dibenzothiophene, aza-dibenzofuran, aza-dibenzoselenophene, aza-5λ2-benzo[d]benzo[4,5]imidazo[3,2-a]imidazole, and aza-(5,9-dioxa-13b-boranaphtho[3,2,1-de]anthracene).

In some embodiments, the additional host may be selected from the Host goup 1 consisting of:

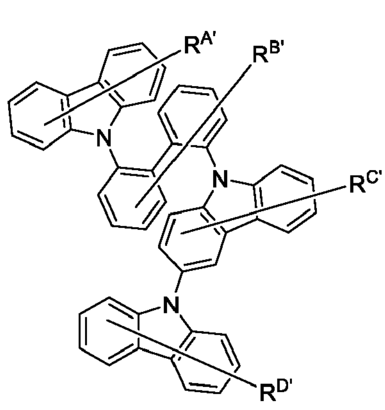,
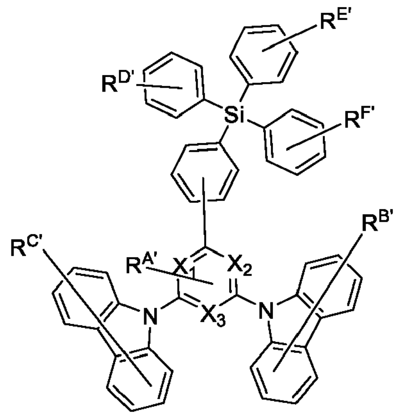,
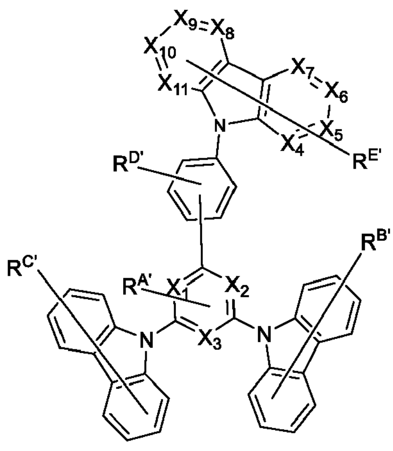,

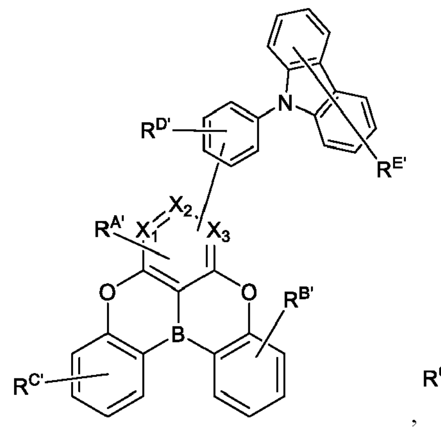,
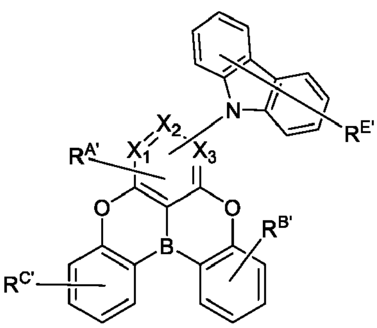,
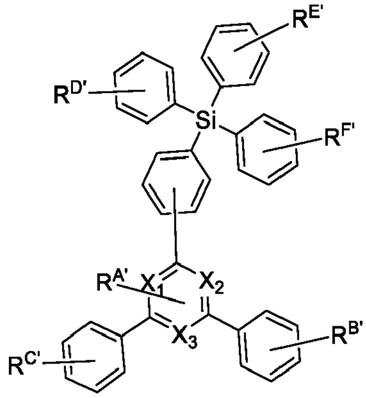,

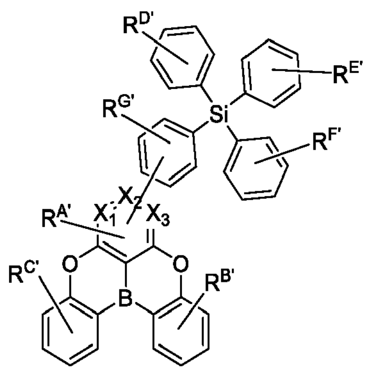,
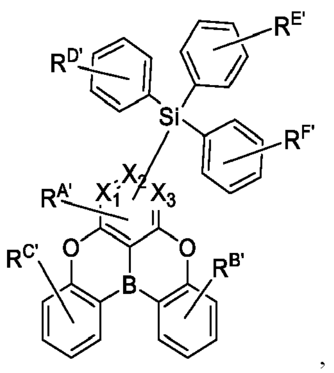,
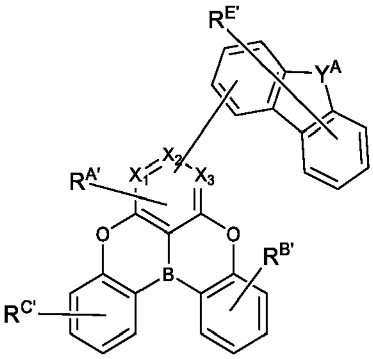,

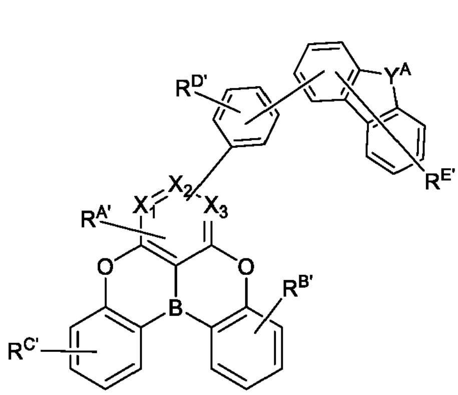,
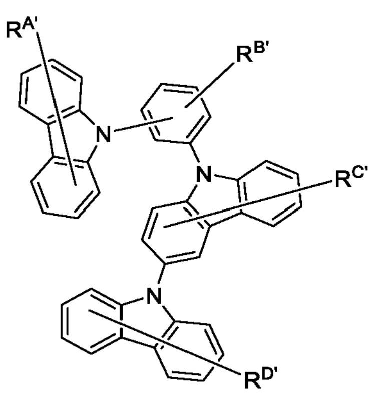,

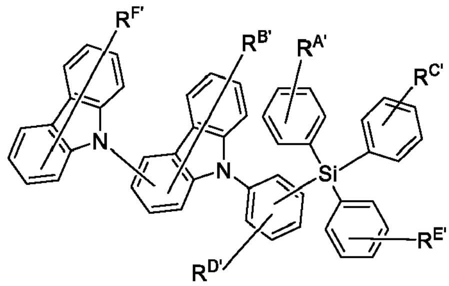

,

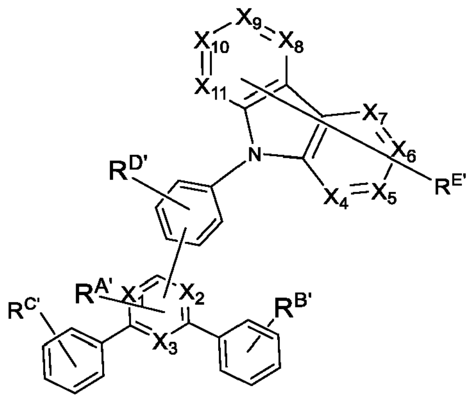

,

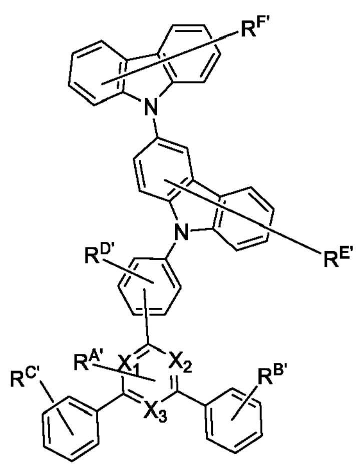

,

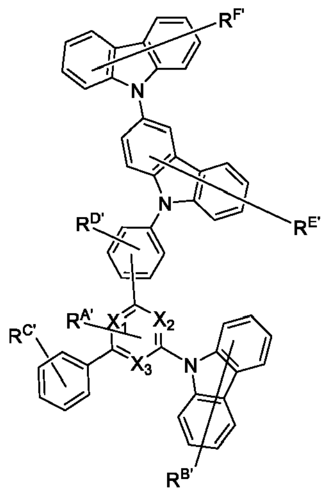

,

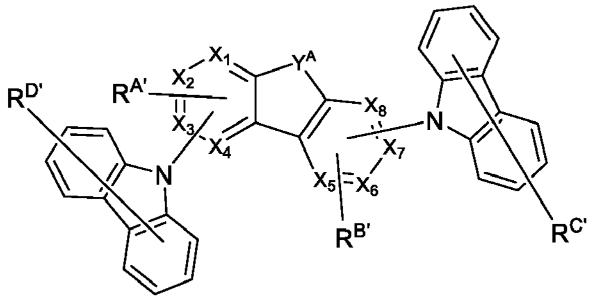

,

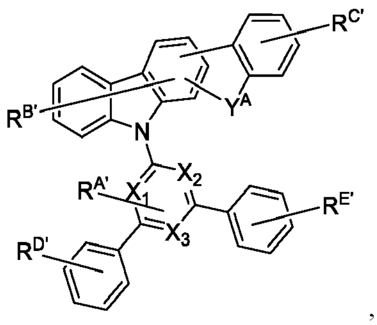

,

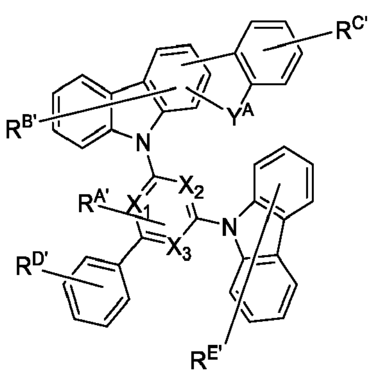

,

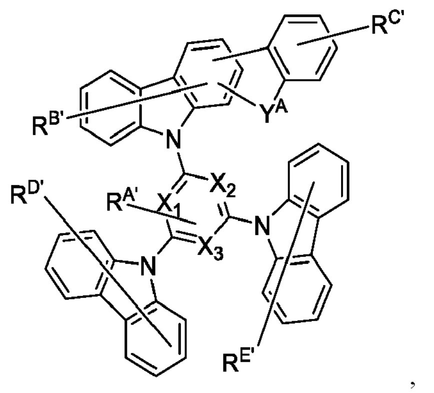

,

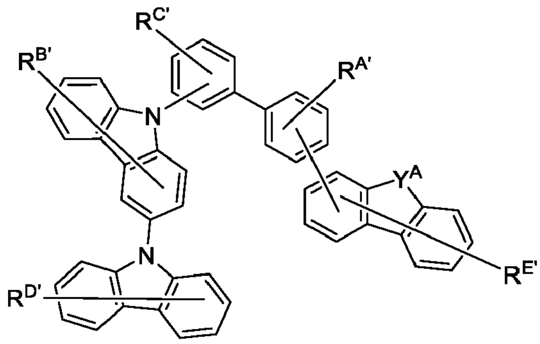,
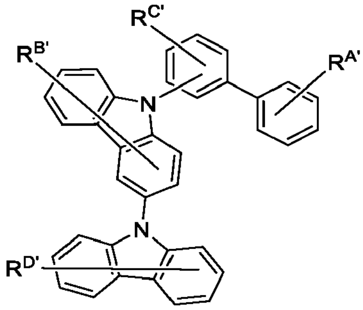,

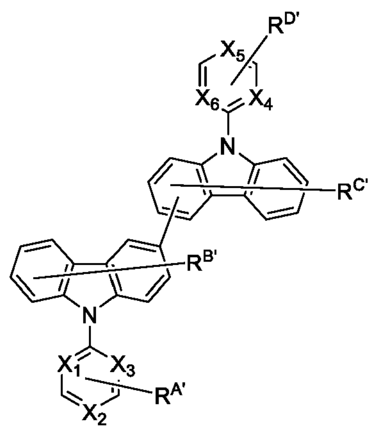,
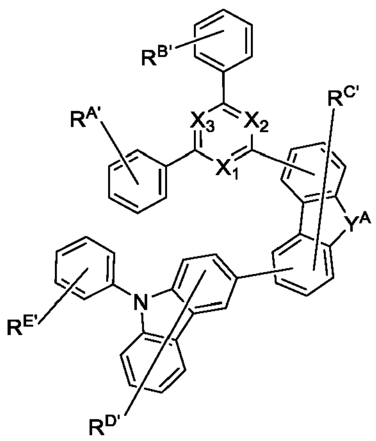,
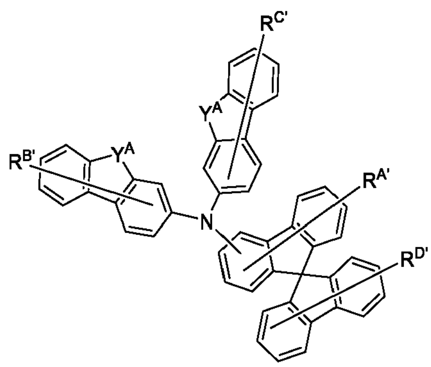,

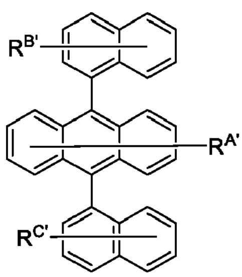,
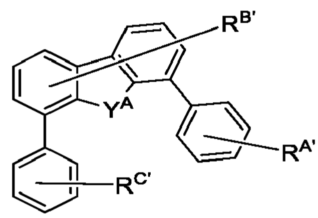,
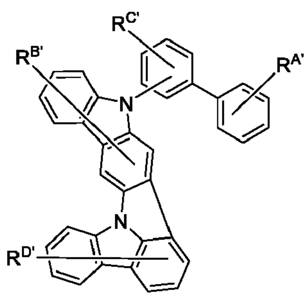,

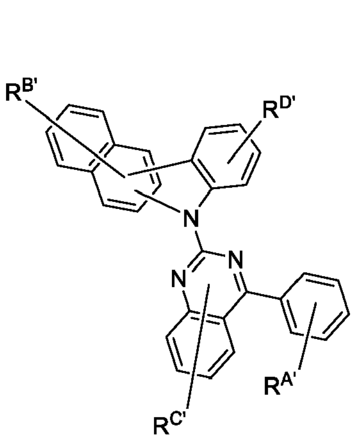,
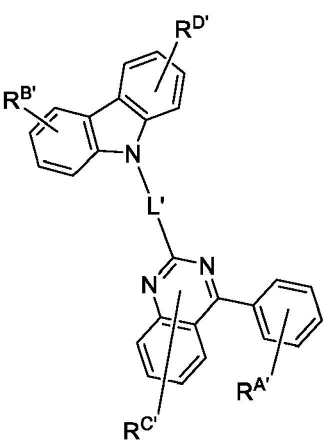,
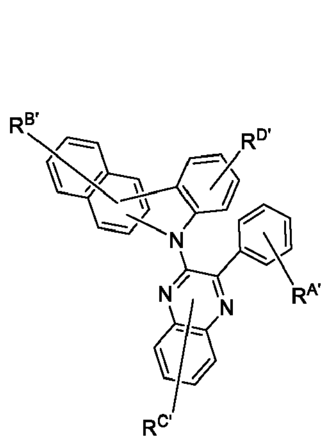,

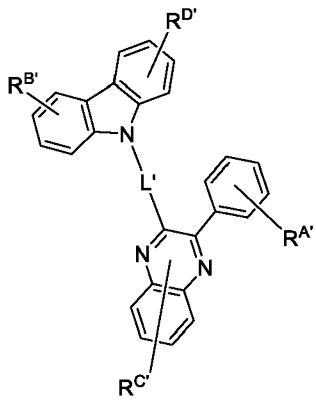 , 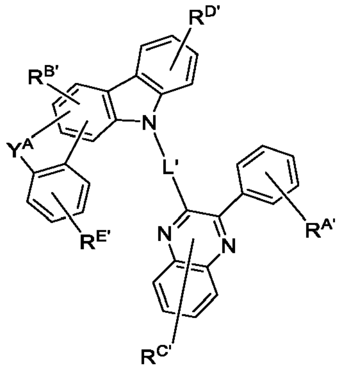 , 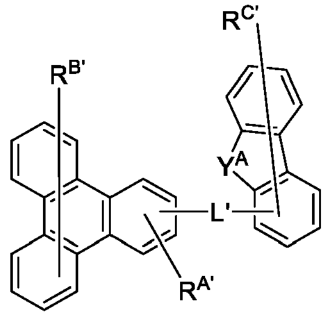 ,

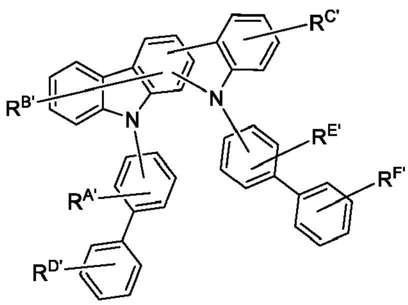 , 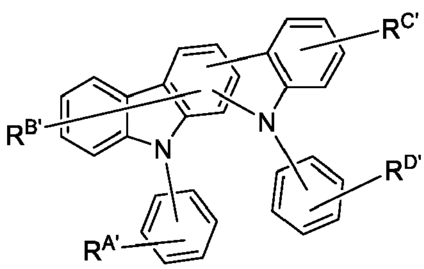 , 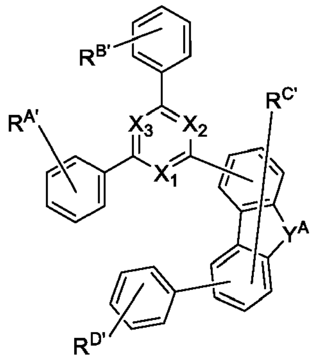 ,

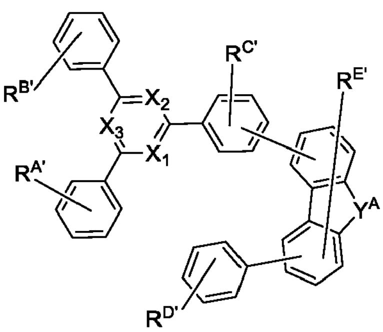 , 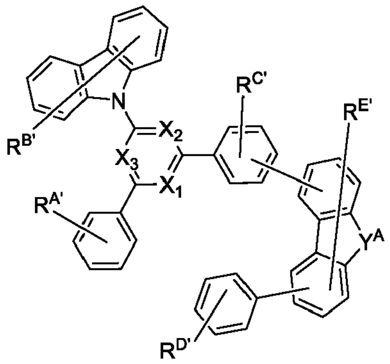 , 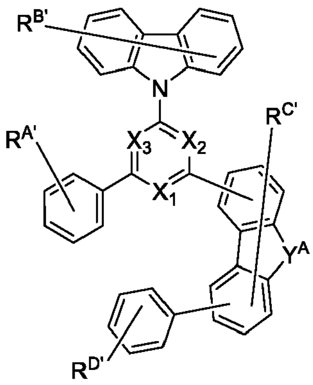 ,

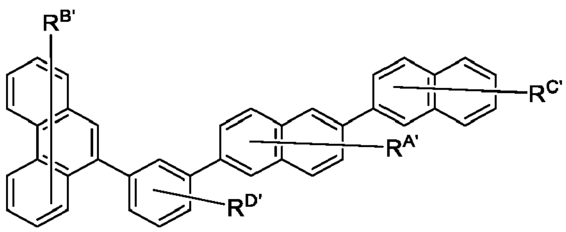 , 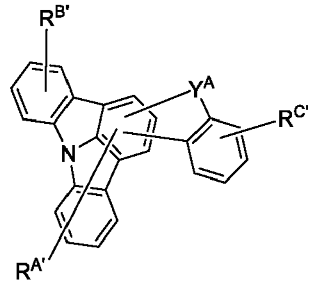 ,

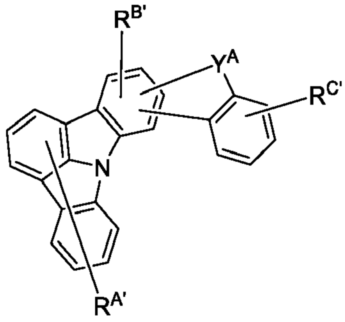

,

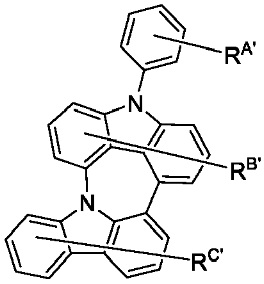

,

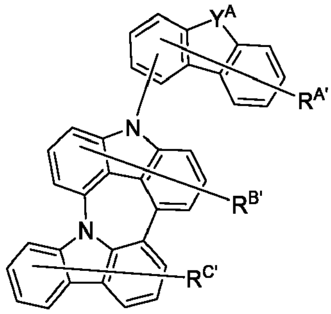

,

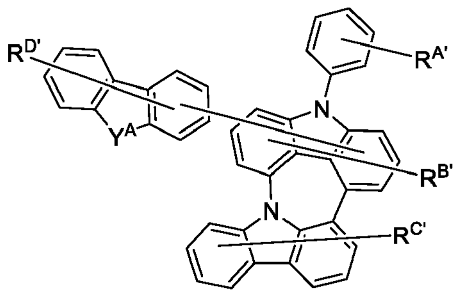

,

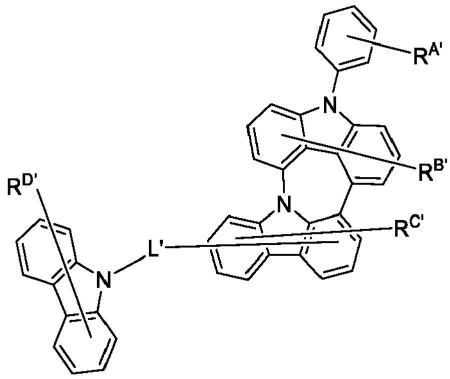

,

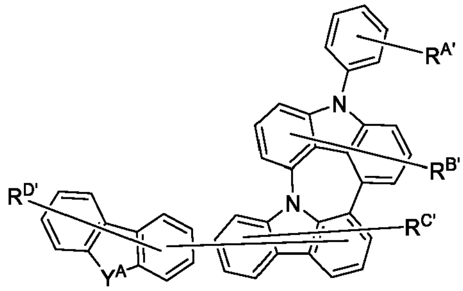

,

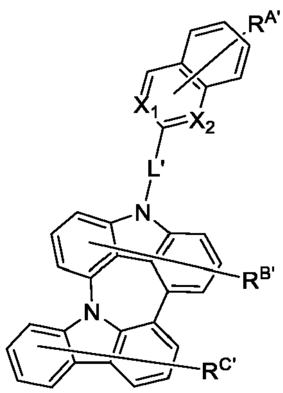

,

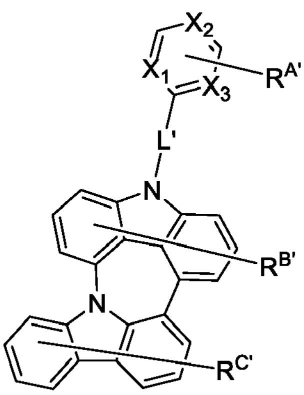

,

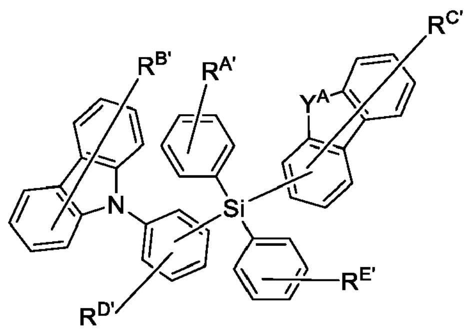

,

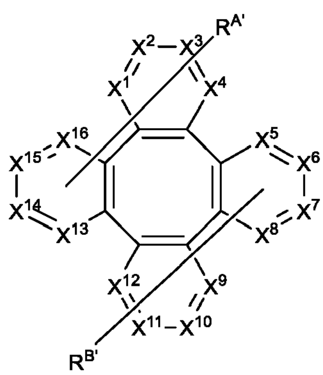

,

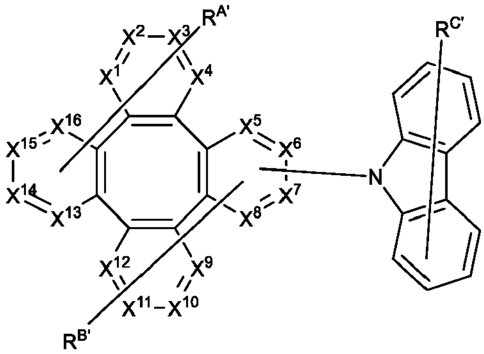,

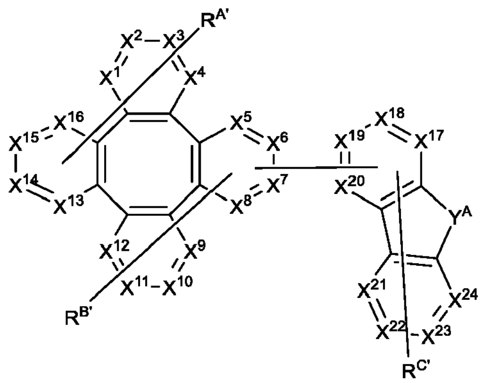,

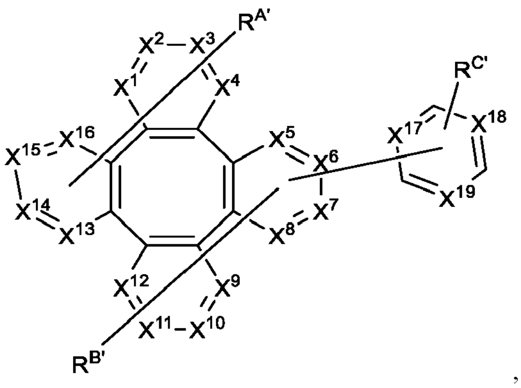,

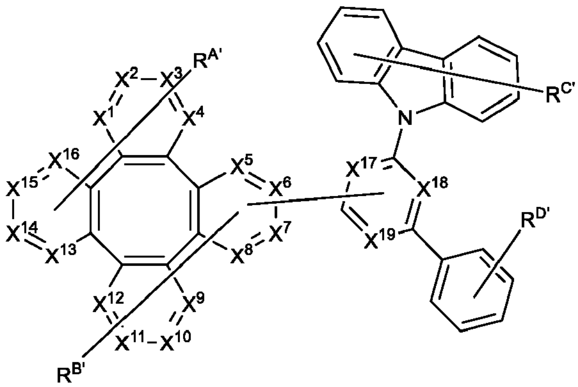,

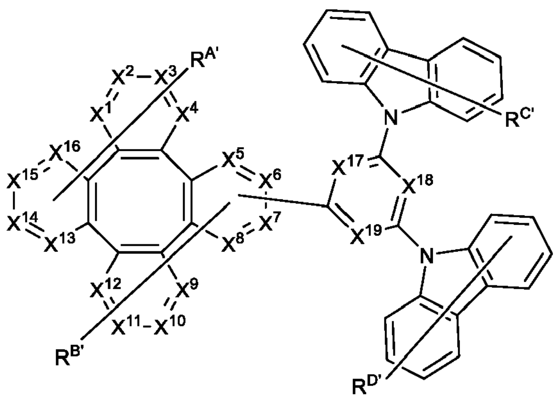,

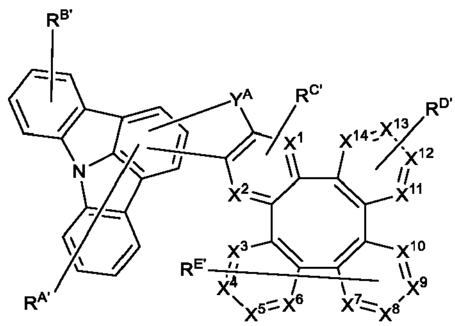,

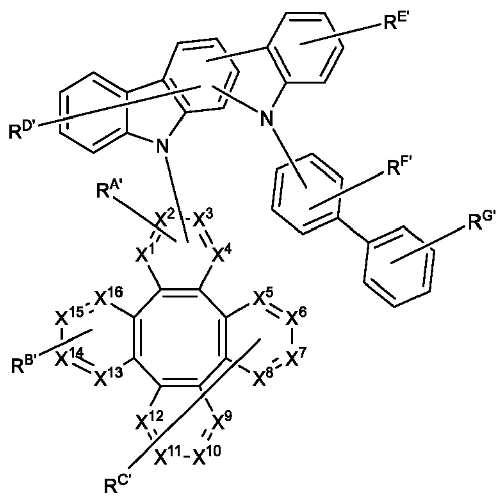

,

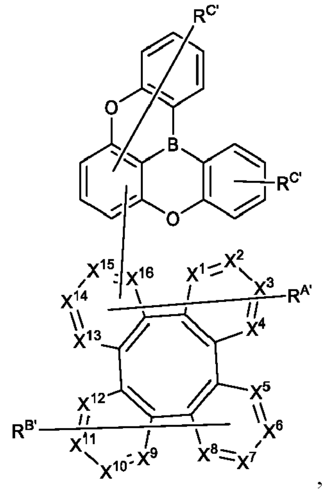

,

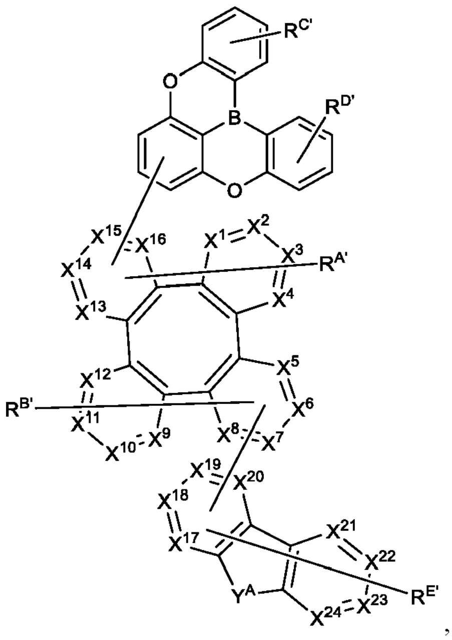

,

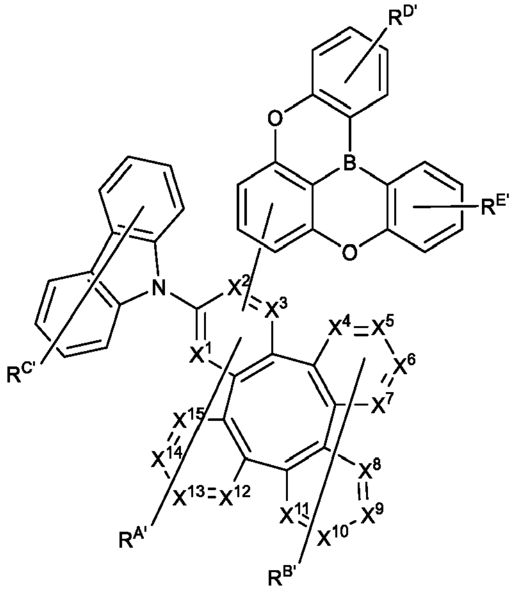

,

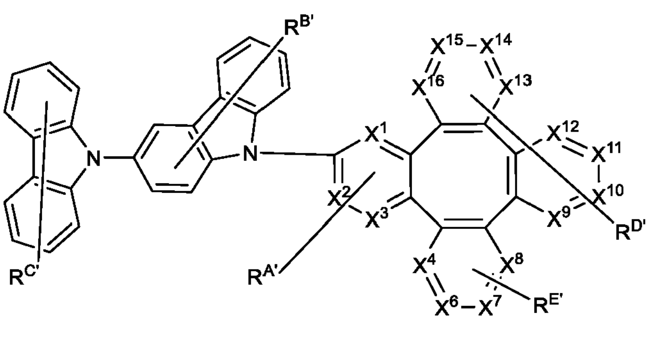

,

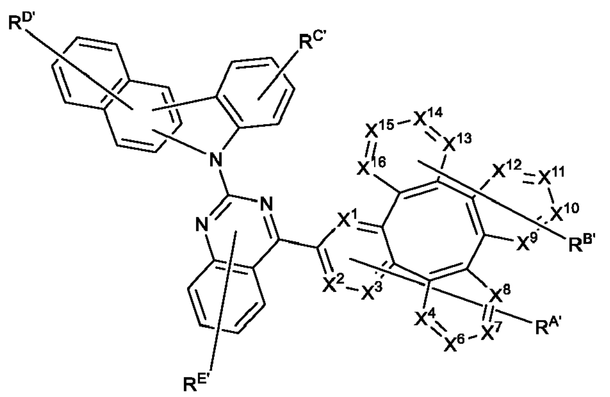

,

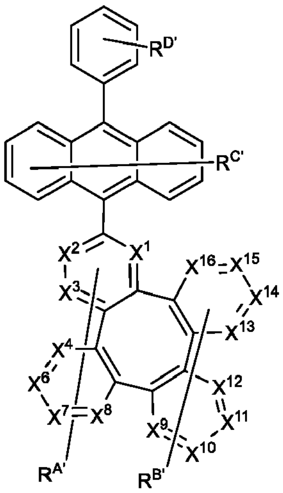

,

and

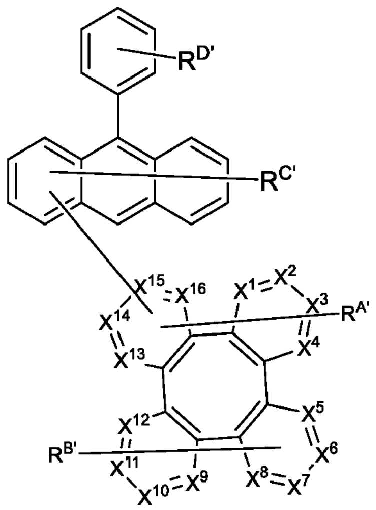

;

wherein:

each of $X^1$ to $X^{24}$ is independently C or N;

L' is a direct bond or an organic linker;

each $Y^A$ is independently selected from the group consisting of absent a bond, O, S, Se, CRR', SiRR', GeRR', NR, BR, BRR';

each of $R^{A'}$, $R^{B'}$, $R^{C'}$, $R^{D'}$, $R^{E'}$, $R^{F'}$, and $R^{G'}$ independently represents mono, up to the maximum substitutions, or no substitutions;

each R, R', $R^{A'}$, $R^{B'}$, $R^{C'}$, $R^{D'}$, $R^{E'}$, $R^{F'}$, and $R^{G'}$ is independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, selenyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, boryl, and combinations thereof; wherein the organic layer further comprises a host,

two adjacent of $R^{A'}$, $R^{B'}$, $R^{C'}$, $R^{D'}$, $R^{E'}$, $R^{F'}$, and $R^{G'}$ are optionally joined or fused to form a ring.

In some embodiments, the additional host may be selected from the Host goup 2 consisting of:

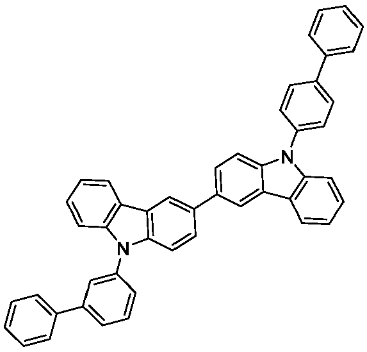,
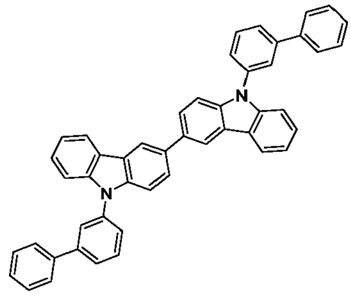,
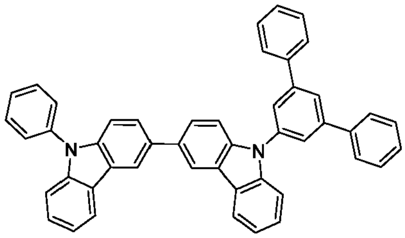,

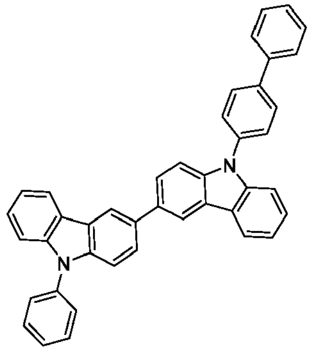,
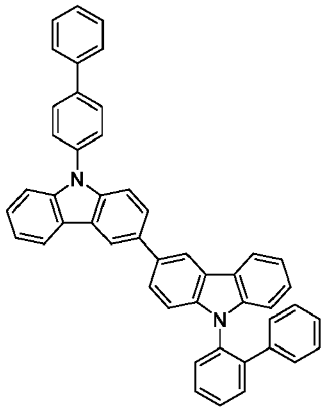,
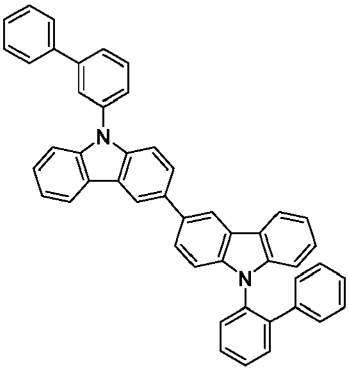,

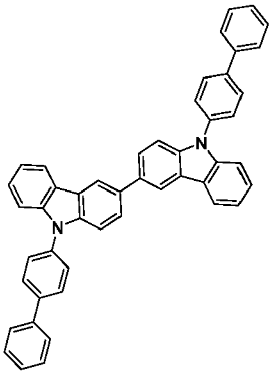,
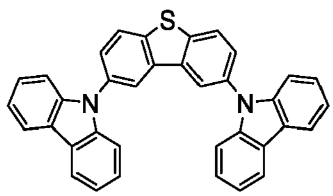,
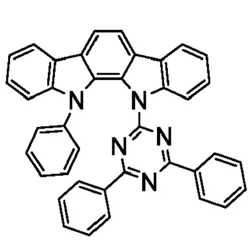,
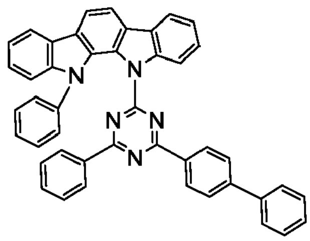,

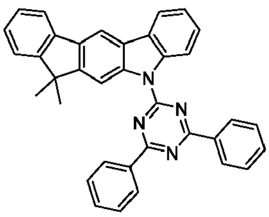,
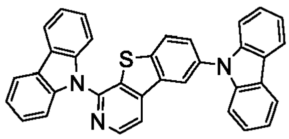,
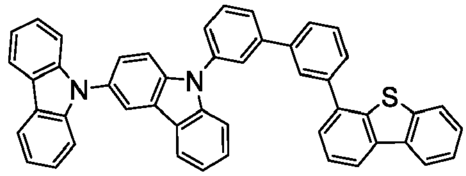,

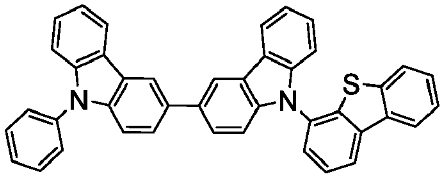, 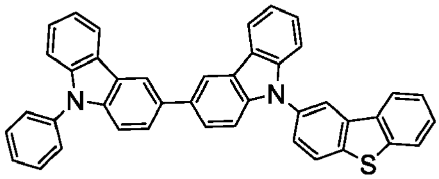, 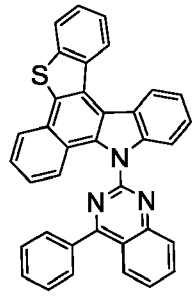,

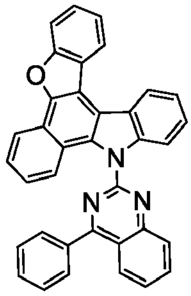, 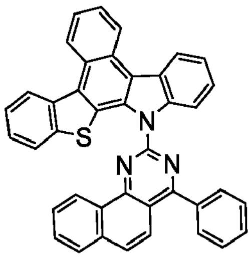, 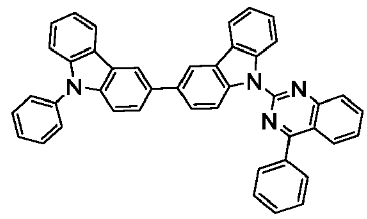, 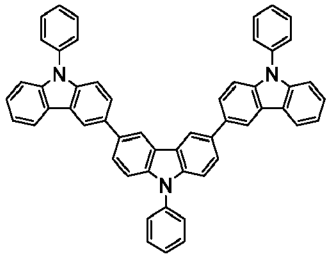,

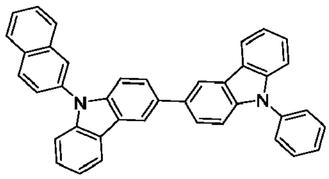, 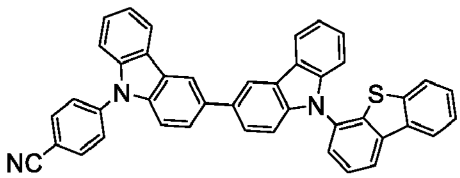, 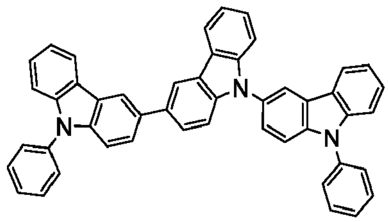,

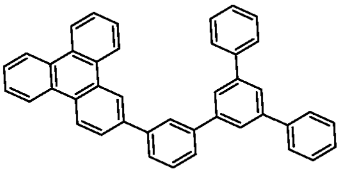, 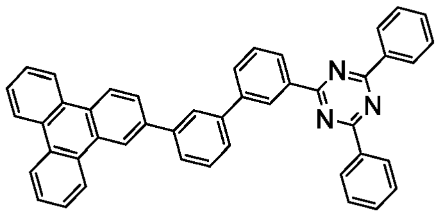, 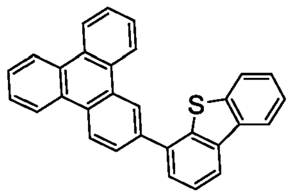,

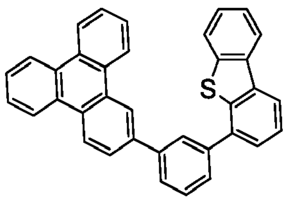, 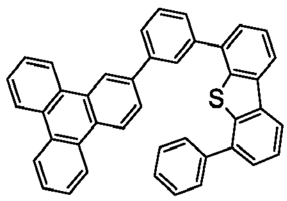, 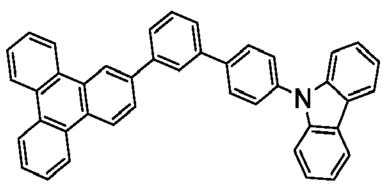,

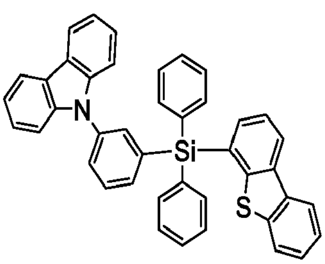, 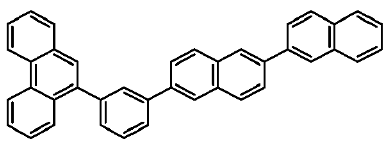, 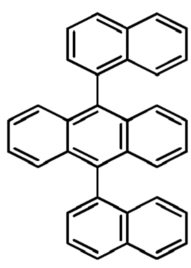,

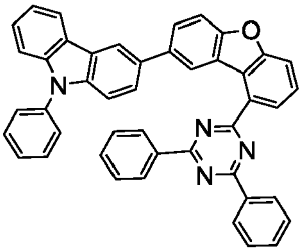, 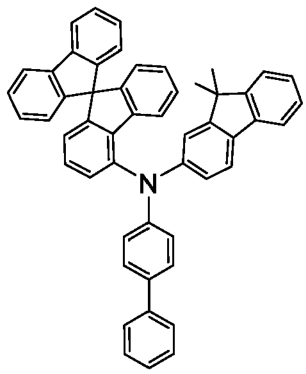, 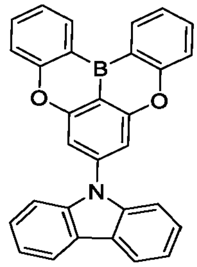, 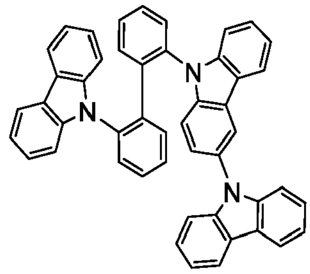,

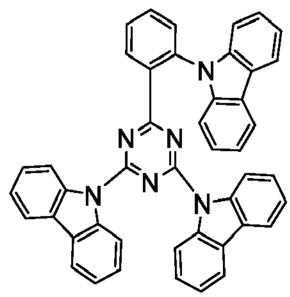, 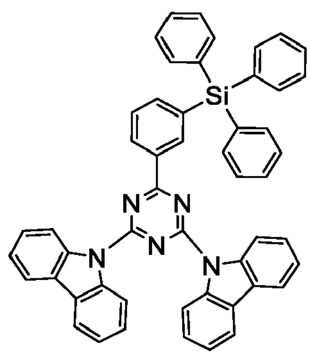, 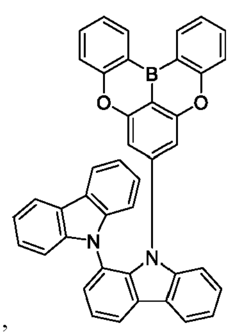, 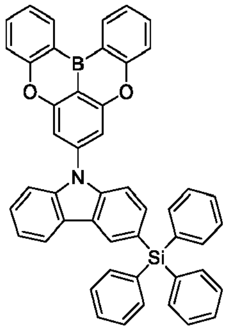,

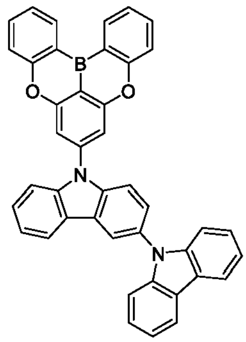, 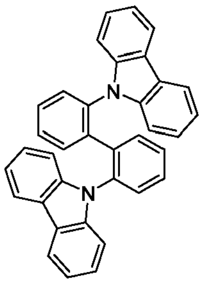, 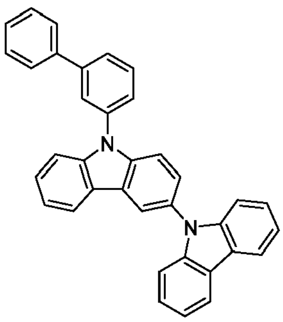, 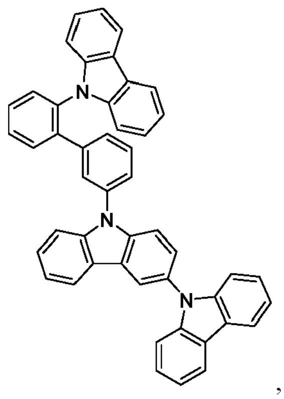,

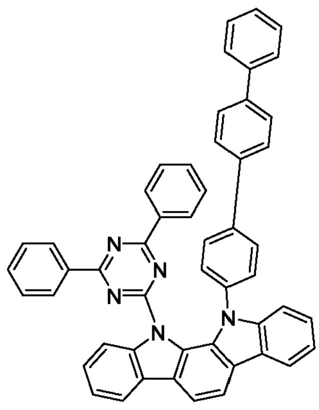, 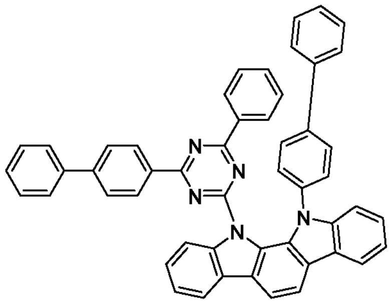 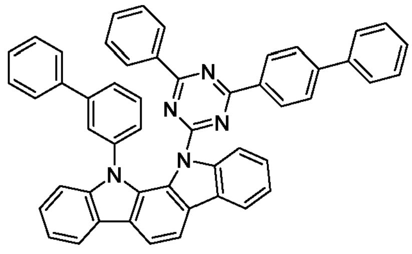,

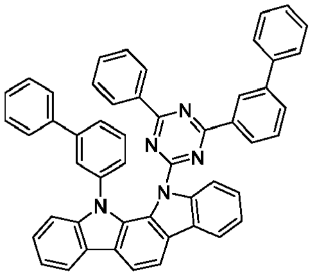 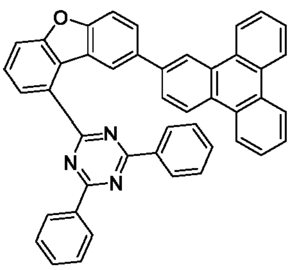, 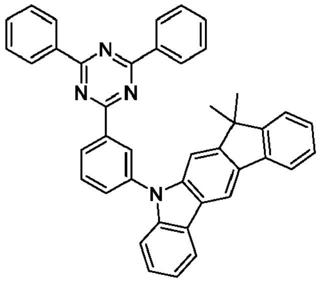, 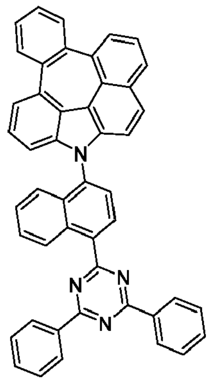,

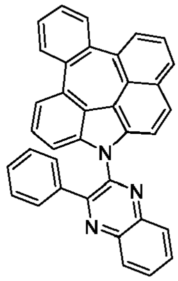 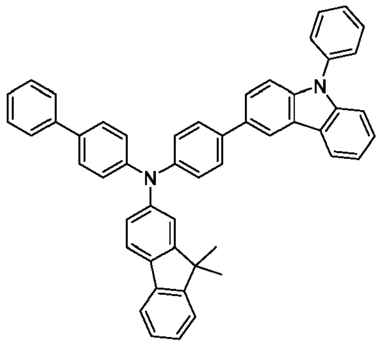 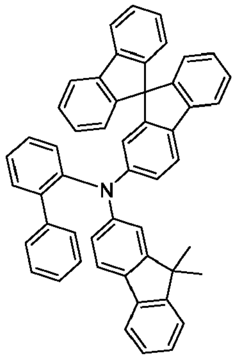,

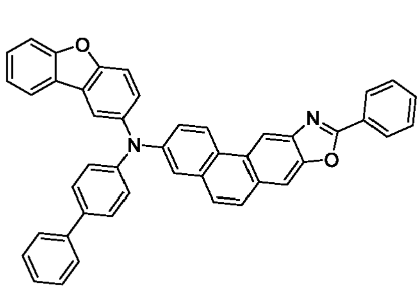, 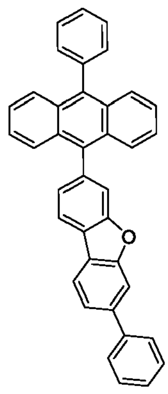, 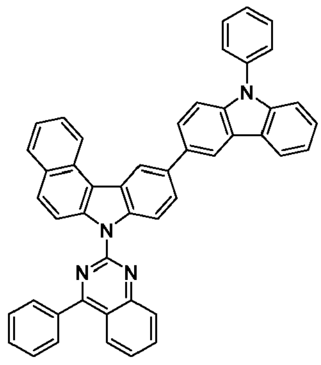, 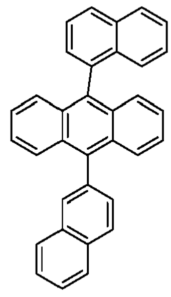,

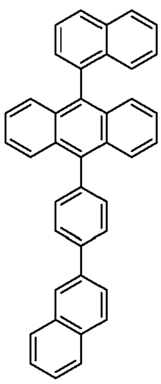, 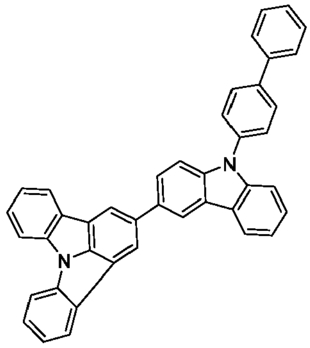, 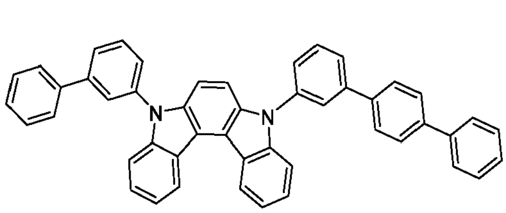,

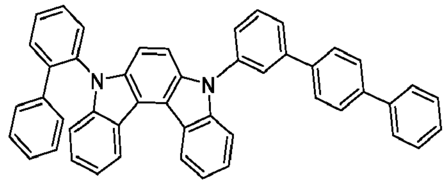,
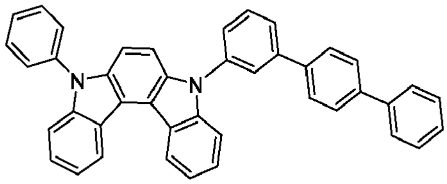,

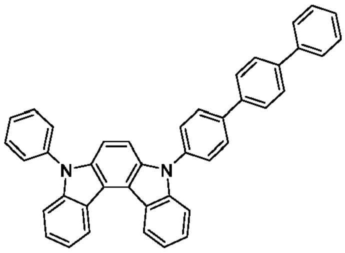,
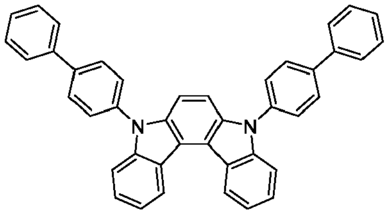,
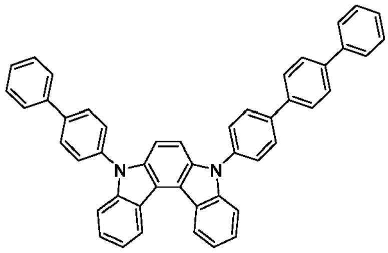,

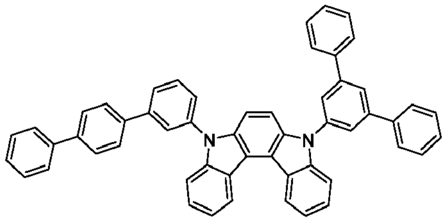,
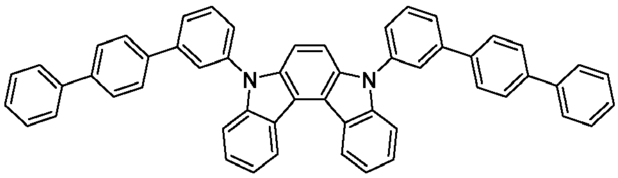,

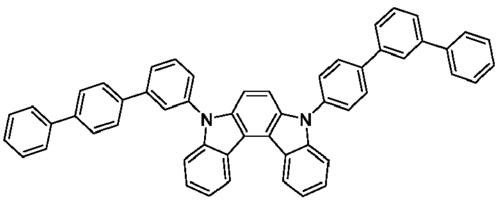,
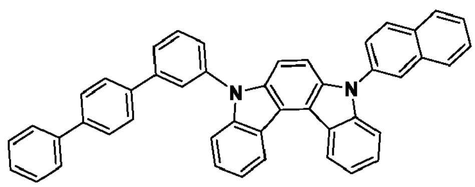,

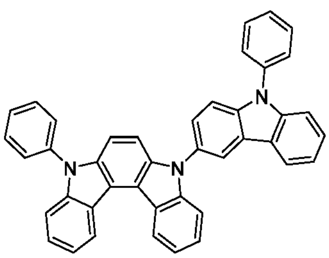,
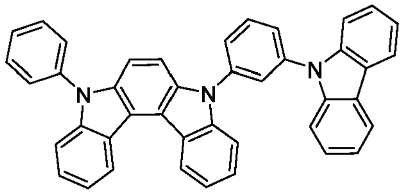,
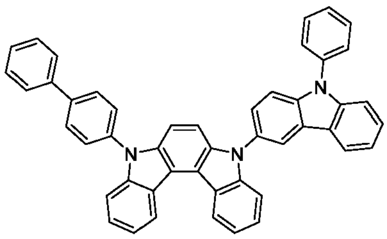,

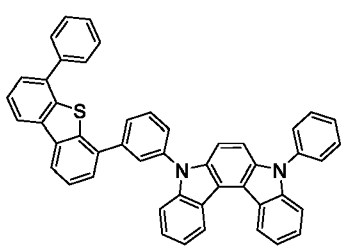,
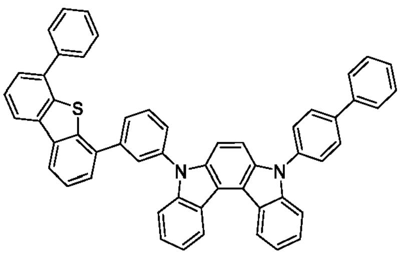,
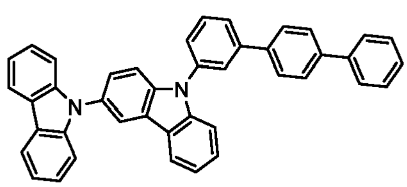,

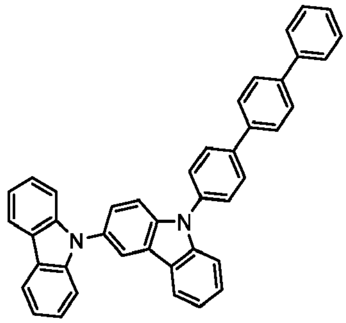,
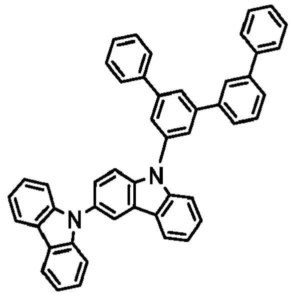,
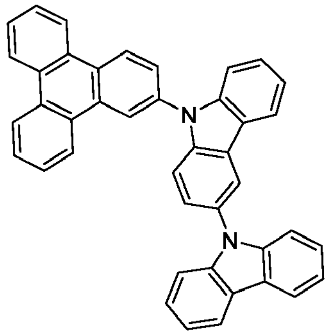,

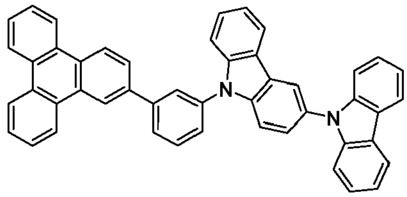,
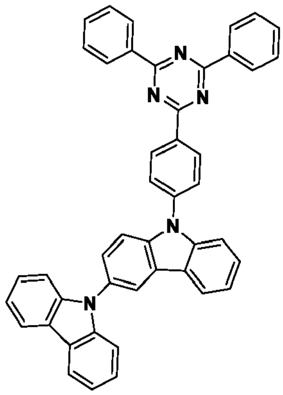,
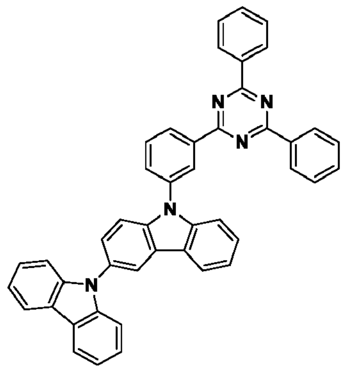,

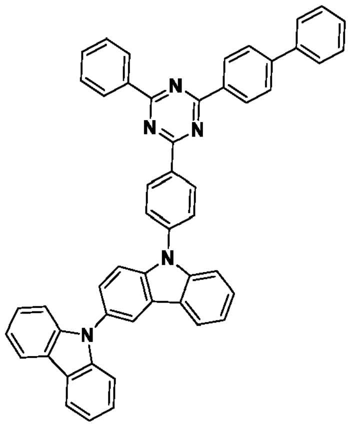,
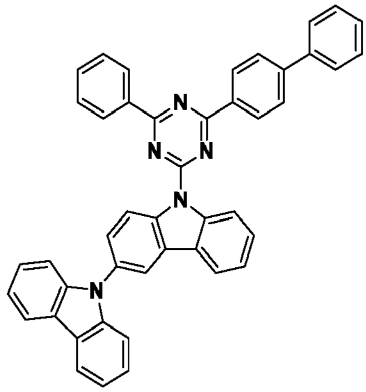,
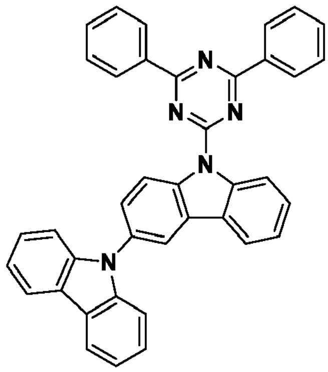,

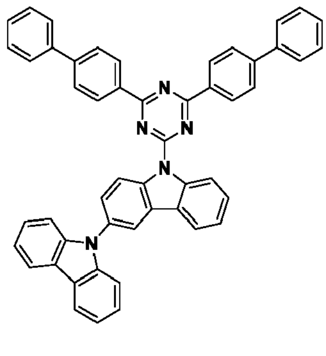,
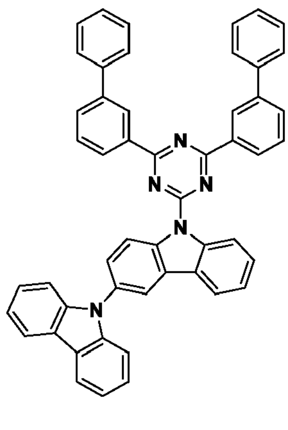,
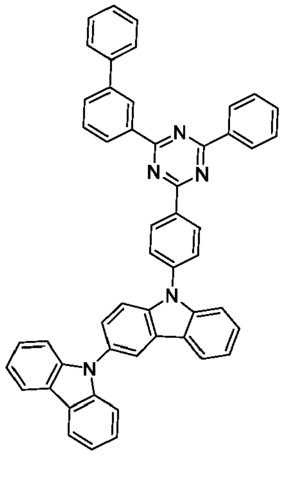,

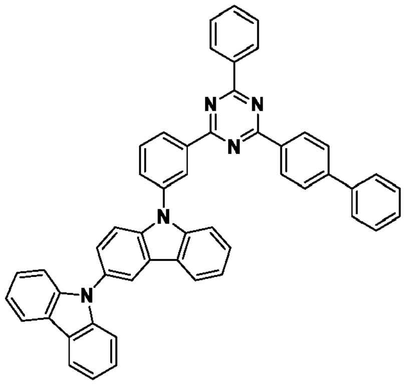 , 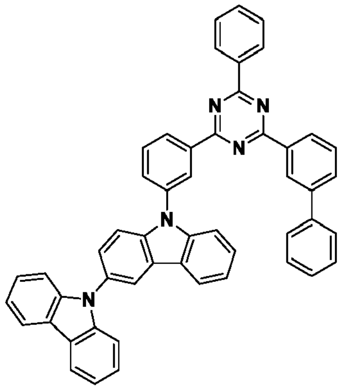 , 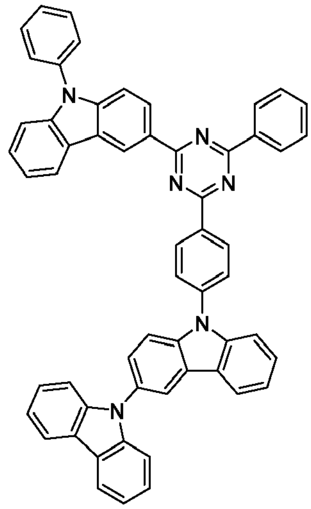 ,

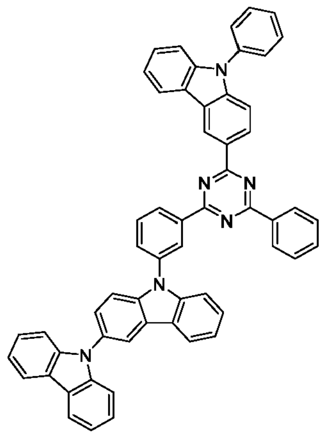 , 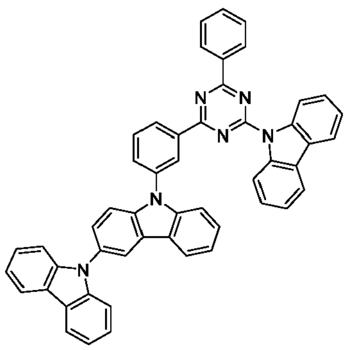 , 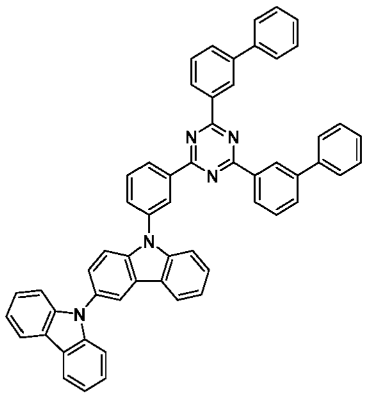 ,

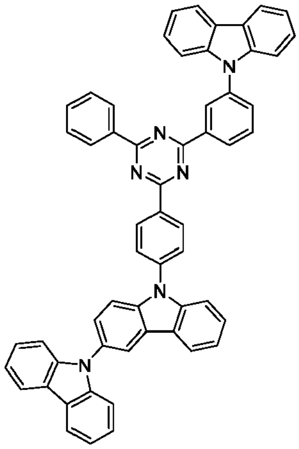 , 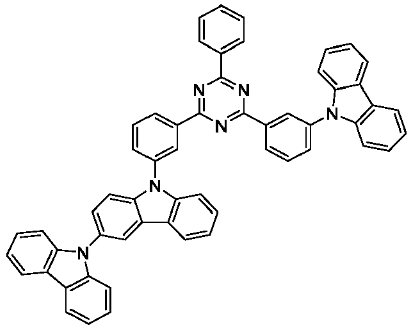 , 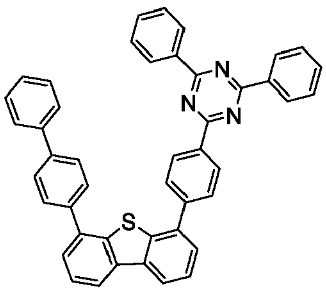 ,

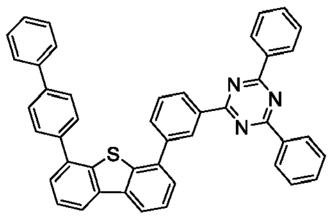,
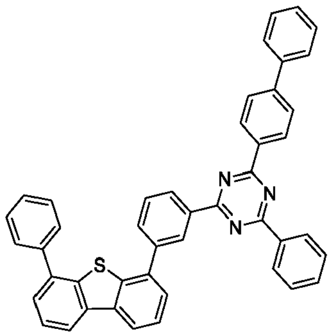,
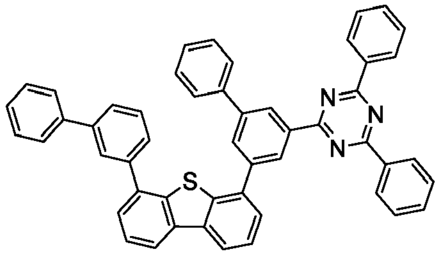,

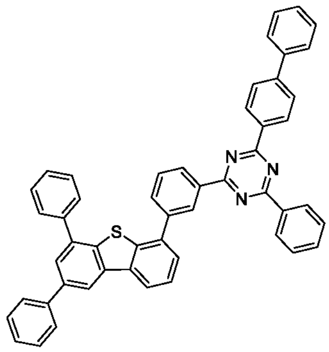,
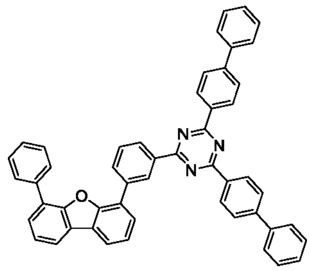,
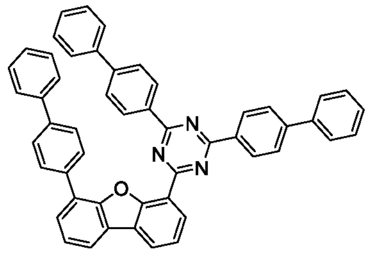,

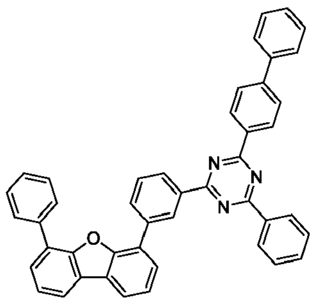,
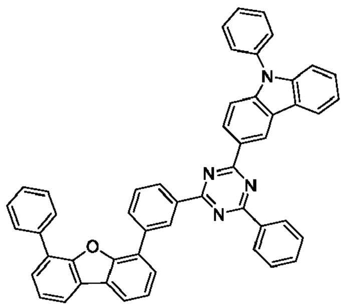,
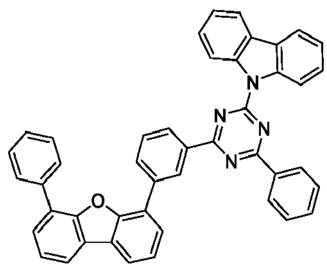,

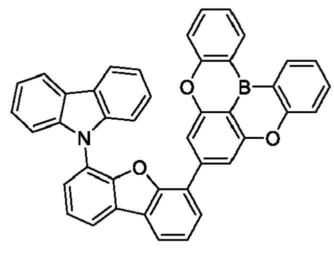,
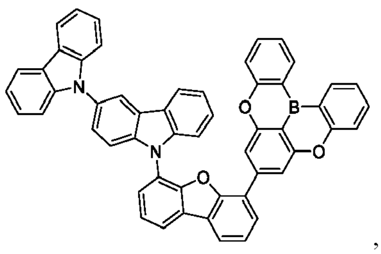,
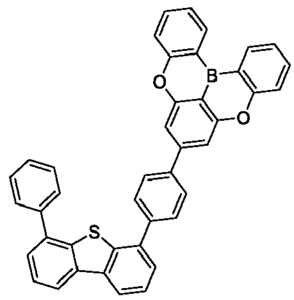,

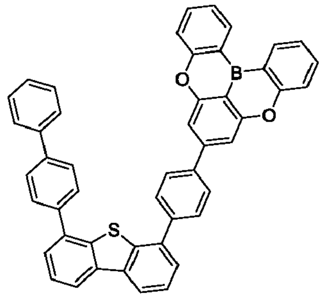

, and

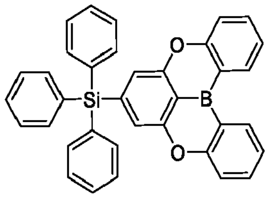

,

aza-substituted variants thereof, fully or partially deuterated variants thereof, and combinations thereof.

In some embodiments, the additional host comprises a metal complex.

In yet another aspect, the OLED of the present disclosure may also comprise an emissive region containing a formulation as disclosed in the above compounds section of the present disclosure.

In some embodiments, at least one of the anode, the cathode, or a new layer disposed over the organic emissive layer functions as an enhancement layer. The enhancement layer comprises a plasmonic material exhibiting surface plasmon resonance that non-radiatively couples to the emitter material and transfers excited state energy from the emitter material to non-radiative mode of surface plasmon polariton. The enhancement layer is provided no more than a threshold distance away from the organic emissive layer, wherein the emitter material has a total non-radiative decay rate constant and a total radiative decay rate constant due to the presence of the enhancement layer and the threshold distance is where the total non-radiative decay rate constant is equal to the total radiative decay rate constant. In some embodiments, the OLED further comprises an outcoupling layer. In some embodiments, the outcoupling layer is disposed over the enhancement layer on the opposite side of the organic emissive layer. In some embodiments, the outcoupling layer is disposed on opposite side of the emissive layer from the enhancement layer but still outcouples energy from the surface plasmon mode of the enhancement layer. The outcoupling layer scatters the energy from the surface plasmon polaritons. In some embodiments this energy is scattered as photons to free space. In other embodiments, the energy is scattered from the surface plasmon mode into other modes of the device such as but not limited to the organic waveguide mode, the substrate mode, or another waveguiding mode. If energy is scattered to the non-free space mode of the OLED other outcoupling schemes could be incorporated to extract that energy to free space. In some embodiments, one or more intervening layer can be disposed between the enhancement layer and the outcoupling layer. The examples for interventing layer(s) can be dielectric materials, including organic, inorganic, perovskites, oxides, and may include stacks and/or mixtures of these materials.

The enhancement layer modifies the effective properties of the medium in which the emitter material resides resulting in any or all of the following: a decreased rate of emission, a modification of emission line - shape, a change in emission intensity with angle, a change in the stability of the emitter material, a change in the efficiency of the OLED, and reduced efficiency roll-off of the OLED device. Placement of the enhancement layer on the cathode side, anode side, or on both sides results in OLED devices which take advantage of any of the above-mentioned effects. In addition to the specific functional layers mentioned herein and illustrated in the various OLED examples shown in the figures, the OLEDs according to the present disclosure may include any of the other functional layers often found in OLEDs.

The enhancement layer can be comprised of plasmonic materials, optically active metamaterials, or hyperbolic metamaterials. As used herein, a plasmonic material is a material in which the real part of the dielectric constant crosses zero in the visible or ultraviolet region of the electromagnetic spectrum. In some embodiments, the plasmonic material includes at least one metal. In such embodiments the metal may include at least one of Ag, Al, Au, Ir, Pt, Ni, Cu, W, Ta, Fe, Cr, Mg, Ga, Rh, Ti, Ru, Pd, In, Bi, Ca alloys or mixtures of these materials, and stacks of these materials. In general, a metamaterial is a medium composed of different materials where the medium as a whole acts differently than the sum of its material parts. In particular, we define optically active metamaterials as materials which have both negative permittivity and negative permeability. Hyperbolic metamaterials, on the other hand, are anisotropic media in which the permittivity or permeability are of different sign for different spatial directions. Optically active metamaterials and hyperbolic metamaterials are strictly distinguished from many other photonic structures such as Distributed Bragg Reflectors ("DBRs") in that the medium should appear uniform in the direction of propagation on the length scale of the wavelength of light. Using terminology that one skilled in the art can understand: the dielectric constant of the metamaterials in the direction of propagation can be described with the effective medium approximation. Plasmonic materials and metamaterials provide methods for controlling the propagation of light that can enhance OLED performance in a number of ways.

In some embodiments, the enhancement layer is provided as a planar layer. In other embodiments, the enhancement layer has wavelength-sized features that are arranged periodically, quasi-periodically, or randomly, or sub-wavelength-sized features that are arranged periodically, quasi-periodically, or randomly. In some embodiments, the wavelength-sized features and the sub-wavelength-sized features have sharp edges.

In some embodiments, the outcoupling layer has wavelength-sized features that are arranged periodically, quasi-periodically, or randomly, or sub-wavelength-sized features that are arranged periodically, quasi-periodically, or randomly. In some embodiments, the outcoupling layer may be composed of a plurality of nanoparticles and in other embodiments the outcoupling layer is composed of a pluraility of nanoparticles disposed over a material. In these embodiments the outcoupling may be tunable by at least one of varying a size of the plurality of nanoparticles, varying a shape of the plurality of nanoparticles, changing a material of the plurality of nanoparticles, adjusting a thickness of the material, changing the refractive index of the material or an additional layer disposed on the plurality of nanoparticles, varying a thickness of the enhancement layer, and/or varying the material of the enhancement layer. The plurality of nanoparticles of the device may be formed from at least one of metal, dielectric material, semiconductor materials, an alloy of metal, a mixture of dielectric materials, a stack or layering of one or more materials, and/or a core of one type of material and that is coated with a shell of a different type of material. In some embodiments, the outcoupling layer is composed of at least metal nanoparticles wherein the metal is selected from the group consisting of Ag, Al, Au, Ir, Pt, Ni, Cu, W, Ta, Fe, Cr, Mg, Ga, Rh, Ti, Ru, Pd, In, Bi, Ca, alloys or mixtures of these materials, and stacks of these materials. The plurality of nanoparticles may have additional layer disposed over them. In some embodiments, the polarization of the emission can be tuned using the outcoupling layer. Varying the dimensionality and periodicity of the outcoupling layer can select a type of polarization that is preferentially outcoupled to air. In some embodiments the outcoupling layer also acts as an electrode of the device.

In yet another aspect, the present disclosure also provides a consumer product comprising an organic light-emitting device (OLED) having an anode; a cathode; and an organic layer disposed between the anode and the cathode, wherein the organic layer may comprise a compound as disclosed in the above compounds section of the present disclosure.

In some embodiments, the consumer product comprises an OLED having an anode; a cathode; and an organic layer disposed between the anode and the cathode, wherein the organic layer may comprise a formulation as described herein.

In some embodiments, the consumer product can be one of a flat panel display, a computer monitor, a medical monitor, a television, a billboard, a light for interior or exterior illumination and/or signaling, a heads-up display, a fully or partially transparent display, a flexible display, a laser printer, a telephone, a cell phone, tablet, a phablet, a personal digital assistant (PDA), a wearable device, a laptop computer, a digital camera, a camcorder, a viewfinder, a micro-display that is less than 2 inches diagonal, a 3 -D display, a virtual reality or augmented reality display, a vehicle, a video wall comprising multiple displays tiled together, a theater or stadium screen, a light therapy device, and a sign.

Generally, an OLED comprises at least one organic layer disposed between and electrically connected to an anode and a cathode. When a current is applied, the anode injects holes and the cathode injects electrons into the organic layer(s). The injected holes and electrons each migrate toward the oppositely charged electrode. When an electron and hole localize on the same molecule, an "exciton," which is a localized electron-hole pair having an excited energy state, is formed. Light is emitted when the exciton relaxes via a photoemissive mechanism. In some cases, the exciton may be localized on an excimer or an exciplex. Non-radiative mechanisms, such as thermal relaxation, may also occur, but are generally considered undesirable.

Several OLED materials and configurations are described in U.S. Pat. Nos. 5,844,363, 6,303,238, and 5,707,745, which are incorporated herein by reference in their entirety.

The initial OLEDs used emissive molecules that emitted light from their singlet states ("fluorescence") as disclosed, for example, in U.S. Pat. No. 4,769,292, which is incorporated by reference in its entirety. Fluorescent emission generally occurs in a time frame of less than 10 nanoseconds.

More recently, OLEDs having emissive materials that emit light from triplet states ("phosphorescence") have been demonstrated. Baldo et al., "Highly Efficient Phosphorescent Emission from Organic Electroluminescent Devices," Nature, vol. 395, 151-154, 1998; ("Baldo-I") and Baldo et al., "Very high-efficiency green organic light-emitting devices based on electrophosphorescence," Appl. Phys. Lett., vol. 75, No. 3, 4-6 (1999) ("Baldo-II"), are incorporated by reference in their entireties. Phosphorescence is described in more detail in U.S. Pat. No. 7,279,704 at cols. 5-6, which are incorporated by reference.

FIG. 1 shows an organic light emitting device 100. The figures are not necessarily drawn to scale. Device 100 may include a substrate 110, an anode 115, a hole injection layer 120, a hole transport layer 125, an electron blocking layer 130, an emissive layer 135, a hole blocking layer 140, an electron transport layer 145, an electron injection layer 150, a protective layer 155, a cathode 160, and a barrier layer 170. Cathode 160 is a compound cathode having a first conductive layer 162 and a second conductive layer 164. Device 100 may be fabricated by depositing the layers described, in order. The properties and functions of these various layers, as well as example materials, are described in more detail in US 7,279,704 at cols. 6-10, which are incorporated by reference.

More examples for each of these layers are available. For example, a flexible and transparent substrate-anode combination is disclosed in U.S. Pat. No. 5,844,363, which is incorporated by reference in its entirety. An example of a p-doped hole transport layer is m-MTDATA doped with $F_4$-TCNQ at a molar ratio of 50:1, as disclosed in U.S. Patent

Application Publication No. 2003/0230980, which is incorporated by reference in its entirety. Examples of emissive and host materials are disclosed in U.S. Pat. No. 6,303,238 to Thompson et al., which is incorporated by reference in its entirety. An example of an n-doped electron transport layer is BPhen doped with Li at a molar ratio of 1:1, as disclosed in U.S. Patent Application Publication No. 2003/0230980, which is incorporated by reference in its entirety. U.S. Pat. Nos. 5,703,436 and 5,707,745, which are incorporated by reference in their entireties, disclose examples of cathodes including compound cathodes having a thin layer of metal such as Mg:Ag with an overlying transparent, electrically-conductive, sputter-deposited ITO layer. The theory and use of blocking layers is described in more detail in U.S. Pat. No. 6,097,147 and U.S. Patent Application Publication No. 2003/0230980, which are incorporated by reference in their entireties. Examples of injection layers are provided in U.S. Patent Application Publication No. 2004/0174116, which is incorporated by reference in its entirety. A description of protective layers may be found in U.S. Patent Application Publication No. 2004/0174116, which is incorporated by reference in its entirety.

FIG. 2 shows an inverted OLED 200. The device includes a substrate 210, a cathode 215, an emissive layer 220, a hole transport layer 225, and an anode 230. Device 200 may be fabricated by depositing the layers described, in order. Because the most common OLED configuration has a cathode disposed over the anode, and device 200 has cathode 215 disposed under anode 230, device 200 may be referred to as an "inverted" OLED. Materials similar to those described with respect to device 100 may be used in the corresponding layers of device 200. FIG. 2 provides one example of how some layers may be omitted from the structure of device 100.

The simple layered structure illustrated in FIGS. 1 and 2 is provided by way of non-limiting example, and it is understood that embodiments of the present disclosure may be used in connection with a wide variety of other structures. The specific materials and structures described are exemplary in nature, and other materials and structures may be used. Functional OLEDs may be achieved by combining the various layers described in different ways, or layers may be omitted entirely, based on design, performance, and cost factors. Other layers not specifically described may also be included. Materials other than those specifically described may be used. Although many of the examples provided herein describe various layers as comprising a single material, it is understood that combinations of materials, such as a mixture of host and dopant, or more generally a mixture, may be used. Also, the layers may have various sublayers. The names given to the various layers herein are not intended to be strictly limiting. For example, in device 200, hole transport layer 225 transports holes and injects holes into emissive layer 220, and may be described as a hole transport layer or a hole injection layer. In one embodiment, an OLED may be described as having an "organic layer" disposed between a cathode and an anode. This organic layer may comprise a single layer, or may further comprise multiple layers of different organic materials as described, for example, with respect to FIGS. 1 and 2.

Structures and materials not specifically described may also be used, such as OLEDs comprised of polymeric materials (PLEDs) such as disclosed in U.S. Pat. No. 5,247,190 to Friend et al., which is incorporated by reference in its entirety. By way of further example, OLEDs having a single organic layer may be used. OLEDs may be stacked, for example as described in U.S. Pat. No. 5,707,745 to Forrest et al, which is incorporated by reference in its entirety. The OLED structure may deviate from the simple layered structure illustrated in FIGS. 1 and 2. For example, the substrate may include an angled reflective surface to improve outcoupling, such as a mesa structure as described in U.S. Pat. No. 6,091,195 to Forrest et al., and/or a pit structure as described in U.S. Pat. No. 5,834,893 to Bulovic et al., which are incorporated by reference in their entireties.

Unless otherwise specified, any of the layers of the various embodiments may be deposited by any suitable method. For the organic layers, preferred methods include thermal evaporation, ink-jet, such as described in U.S. Pat. Nos. 6,013,982 and 6,087,196, which are incorporated by reference in their entireties, organic vapor phase deposition (OVPD), such as described in U.S. Pat. No. 6,337,102 to Forrest et al., which is incorporated by reference in its entirety, and deposition by organic vapor jet printing (OVJP, also referred to as organic vapor jet deposition (OVJD)), such as described in U.S. Pat. No. 7,431,968, which is incorporated by reference in its entirety. Other suitable deposition methods include spin coating and other solution based processes. Solution based processes are preferably carried out in nitrogen or an inert atmosphere. For the other layers, preferred methods include thermal evaporation. Preferred patterning methods include deposition through a mask, cold welding such as described in U.S. Pat. Nos. 6,294,398 and 6,468,819, which are incorporated by reference in their entireties, and patterning associated with some of the deposition methods such as ink-jet and organic vapor jet printing (OVJP). Other methods may also be used. The materials to be deposited may be modified to make them compatible with a particular deposition method. For example, substituents such as alkyl and aryl groups, branched or unbranched, and preferably containing at least 3 carbons, may be used in small molecules to enhance their ability to undergo solution processing. Substituents having 20 carbons or more may be used, and 3-20 carbons are a preferred range. Materials with asymmetric structures may have better solution processability than those having symmetric structures, because asymmetric materials may have a lower tendency to recrystallize. Dendrimer substituents may be used to enhance the ability of small molecules to undergo solution processing.

Devices fabricated in accordance with embodiments of the present disclosure may further optionally comprise a barrier layer. One purpose of the barrier layer is to protect the electrodes and organic layers from damaging exposure to harmful species in the environment including moisture, vapor and/or gases, etc. The barrier

layer may be deposited over, under or next to a substrate, an electrode, or over any other parts of a device including an edge. The barrier layer may comprise a single layer, or multiple layers. The barrier layer may be formed by various known chemical vapor deposition techniques and may include compositions having a single phase as well as compositions having multiple phases. Any suitable material or combination of materials may be used for the barrier layer. The barrier layer may incorporate an inorganic or an organic compound or both. The preferred barrier layer comprises a mixture of a polymeric material and a non-polymeric material as described in U.S. Pat. No. 7,968,146, PCT Pat. Application Nos. PCT/US2007/023098 and PCT/US2009/042829, which are herein incorporated by reference in their entireties. To be considered a "mixture", the aforesaid polymeric and non-polymeric materials comprising the barrier layer should be deposited under the same reaction conditions and/or at the same time. The weight ratio of polymeric to non-polymeric material may be in the range of 95:5 to 5:95. The polymeric material and the non-polymeric material may be created from the same precursor material. In one example, the mixture of a polymeric material and a non-polymeric material consists essentially of polymeric silicon and inorganic silicon.

Devices fabricated in accordance with embodiments of the present disclosure can be incorporated into a wide variety of electronic component modules (or units) that can be incorporated into a variety of electronic products or intermediate components. Examples of such electronic products or intermediate components include display screens, lighting devices such as discrete light source devices or lighting panels, etc. that can be utilized by the end-user product manufacturers. Such electronic component modules can optionally include the driving electronics and/or power source(s). Devices fabricated in accordance with embodiments of the present disclosure can be incorporated into a wide variety of consumer products that have one or more of the electronic component modules (or units) incorporated therein. A consumer product comprising an OLED that includes the compound of the present disclosure in the organic layer in the OLED is disclosed. Such consumer products would include any kind of products that include one or more light source(s) and/or one or more of some type of visual displays. Some examples of such consumer products include flat panel displays, curved displays, computer monitors, medical monitors, televisions, billboards, lights for interior or exterior illumination and/or signaling, heads-up displays, fully or partially transparent displays, flexible displays, rollable displays, foldable displays, stretchable displays, laser printers, telephones, mobile phones, tablets, phablets, personal digital assistants (PDAs), wearable devices, laptop computers, digital cameras, camcorders, viewfinders, micro-displays (displays that are less than 2 inches diagonal), 3-D displays, virtual reality or augmented reality displays, vehicles, video walls comprising multiple displays tiled together, theater or stadium screen, a light therapy device, and a sign. Various control mechanisms may be used to control devices fabricated in accordance with the present disclosure, including passive matrix and active matrix. Many of the devices are intended for use in a temperature range comfortable to humans, such as 18 degrees C. to 30 degrees C., and more preferably at room temperature (20-25 °C), but could be used outside this temperature range, for example, from -40 degree C to + 80 °C.

More details on OLEDs, and the definitions described above, can be found in U.S. Pat. No. 7,279,704, which is incorporated herein by reference in its entirety.

The materials and structures described herein may have applications in devices other than OLEDs. For example, other optoelectronic devices such as organic solar cells and organic photodetectors may employ the materials and structures. More generally, organic devices, such as organic transistors, may employ the materials and structures.

In some embodiments, the OLED has one or more characteristics selected from the group consisting of being flexible, being rollable, being foldable, being stretchable, and being curved. In some embodiments, the OLED is transparent or semi-transparent. In some embodiments, the OLED further comprises a layer comprising carbon nanotubes.

In some embodiments, the OLED further comprises a layer comprising a delayed fluorescent emitter. In some embodiments, the OLED comprises a RGB pixel arrangement or white plus color filter pixel arrangement. In some embodiments, the OLED is a mobile device, a hand held device, or a wearable device. In some embodiments, the OLED is a display panel having less than 10 inch diagonal or 50 square inch area. In some embodiments, the OLED is a display panel having at least 10 inch diagonal or 50 square inch area. In some embodiments, the OLED is a lighting panel.

In some embodiments, the compound can be an emissive dopant. In some embodiments, the compound can produce emissions via phosphorescence, fluorescence, thermally activated delayed fluorescence, i.e., TADF (also referred to as E-type delayed fluorescence; *see, e.g.,* U.S. Application No. 15/700,352, which is hereby incorporated by reference in its entirety), triplet-triplet annihilation, or combinations of these processes. In some embodiments, the emissive dopant can be a racemic mixture, or can be enriched in one enantiomer. In some embodiments, the compound can be homoleptic (each ligand is the same). In some embodiments, the compound can be heteroleptic (at least one ligand is different from others). When there are more than one ligand coordinated to a metal, the ligands can all be the same in some embodiments. In some other embodiments, at least one ligand is different from the other ligands. In some embodiments, every ligand can be different from each other. This is also true in embodiments where a ligand being coordinated to a metal can be linked with other ligands being coordinated to that metal to form a tridentate, tetradentate, pentadentate, or hexadentate ligands. Thus, where the coordinating ligands are being linked together, all of the ligands can be the same in some embodiments, and at least one of the ligands being linked can be different from the other ligand(s) in some other embodiments.

In some embodiments, the compound can be used as a phosphorescent sensitizer in an OLED where one or multiple layers in the OLED contains an acceptor in the form of one or more fluorescent and/or delayed fluorescence emitters. In some embodiments, the compound can be used as one component of an exciplex to be used as a sensitizer. As a phosphorescent sensitizer, the compound must be capable of energy transfer to the acceptor and the acceptor will emit the energy or further transfer energy to a final emitter. The acceptor concentrations can range from 0.001% to 100%. The acceptor could be in either the same layer as the phosphorescent sensitizer or in one or more different layers. In some embodiments, the acceptor is a TADF emitter. In some embodiments, the acceptor is a fluorescent emitter. In some embodiments, the emission can arise from any or all of the sensitizer, acceptor, and final emitter.

According to another aspect, a formulation comprising the compound described herein is also disclosed.

The OLED disclosed herein can be incorporated into one or more of a consumer product, an electronic component module, and a lighting panel. The organic layer can be an emissive layer and the compound can be an emissive dopant in some embodiments, while the compound can be a non-emissive dopant in other embodiments.

In yet another aspect of the present disclosure, a formulation that comprises the novel compound disclosed herein is described. The formulation can include one or more components selected from the group consisting of a solvent, a host, a hole injection material, hole transport material, electron blocking material, hole blocking material, and an electron transport material, disclosed herein.

The present disclosure encompasses any chemical structure comprising the novel compound of the present disclosure, or a monovalent or polyvalent variant thereof. In other words, the inventive compound, or a monovalent or polyvalent variant thereof, can be a part of a larger chemical structure. Such chemical structure can be selected from the group consisting of a monomer, a polymer, a macromolecule, and a supramolecule (also known as supermolecule). As used herein, a "monovalent variant of a compound" refers to a moiety that is identical to the compound except that one hydrogen has been removed and replaced with a bond to the rest of the chemical structure. As used herein, a "polyvalent variant of a compound" refers to a moiety that is identical to the compound except that more than one hydrogen has been removed and replaced with a bond or bonds to the rest of the chemical structure. In the instance of a supramolecule, the inventive compound can also be incorporated into the supramolecule complex without covalent bonds.

It should be understood that the features/chacteristics of compound A1 in some embodiments can be equally applied to the features/chacteristics of compound A1 in some other embodiments so long as they are applicable. Likewise, the features/chacteristics of compounds S1, S2, H1, and H2 can be equally applied to the features/chacteristics of compound S1, S2, H1 and H2 in some other embodiments respectively so long as they are applicable. Similarly, the features/chacteristics of compounds S1 in some embodiments can be equally applied to the features/chacteristics of compound S2 in some other embodiments so long as they are applicable. The features/chacteristics of compounds H1 in some embodiments can be equally applied to the features/chacteristics of compound H2 in some other embodiments so long as they are applicable.

### F. Combination of the Compounds of the Present Disclosure with Other Materials

The materials described herein as useful for a particular layer in an organic light emitting device may be used in combination with a wide variety of other materials present in the device. For example, emissive dopants disclosed herein may be used in conjunction with a wide variety of hosts, transport layers, blocking layers, injection layers, electrodes and other layers that may be present. The materials described or referred to below are non-limiting examples of materials that may be useful in combination with the compounds disclosed herein, and one of skill in the art can readily consult the literature to identify other materials that may be useful in combination.

#### a) Conductivity Dopants:

A charge transport layer can be doped with conductivity dopants to substantially alter its density of charge carriers, which will in turn alter its conductivity. The conductivity is increased by generating charge carriers in the matrix material, and depending on the type of dopant, a change in the Fermi level of the semiconductor may also be achieved. Hole-transporting layer can be doped by p-type conductivity dopants and n-type conductivity dopants are used in the electron-transporting layer.

Non-limiting examples of the conductivity dopants that may be used in an OLED in combination with materials disclosed herein are exemplified below together with references that disclose those materials: EP01617493, EP01968131, EP2020694, EP2684932, US20050139810, US20070160905, US20090167167, US2010288362, WO06081780, WO2009003455, WO2009008277, WO2009011327, WO2014009310, US2007252140, US2015060804, US20150123047, and US2012146012.

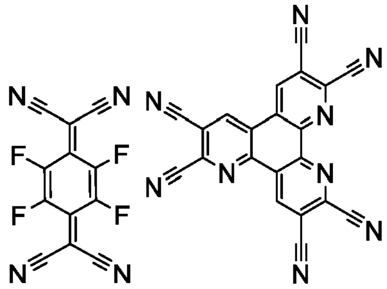 , 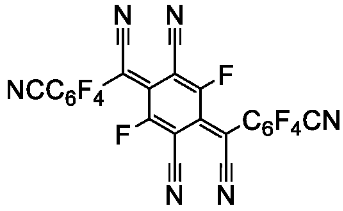 , 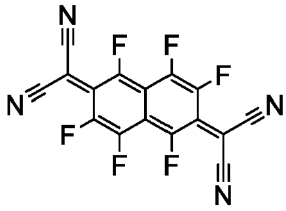 ,

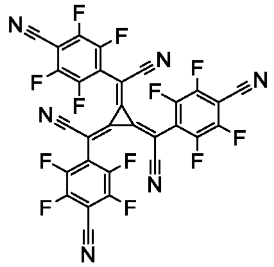 , 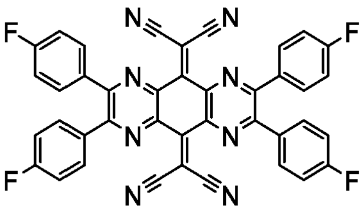 , 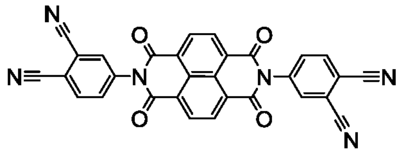 ,

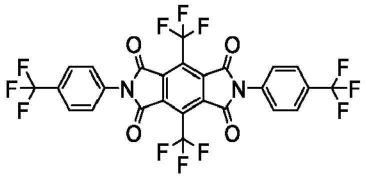 , 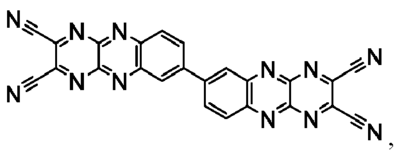 , 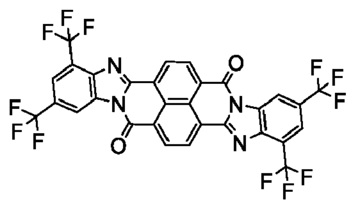 ,

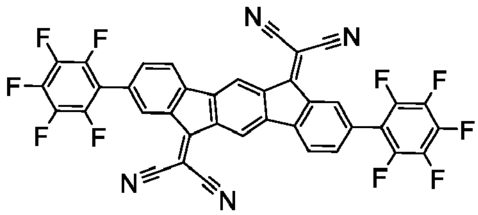 , 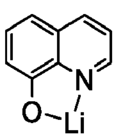 , 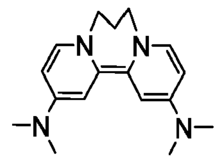 and 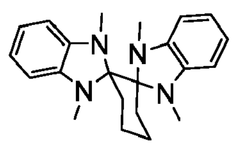 .

**b) HIL/HTL:**

A hole injecting/transporting material to be used in the present disclosure is not particularly limited, and any compound may be used as long as the compound is typically used as a hole injecting/transporting material. Examples of the material include, but are not limited to: a phthalocyanine or porphyrin derivative; an aromatic amine derivative; an indolocarbazole derivative; a polymer containing fluorohydrocarbon; a polymer with conductivity dopants; a conducting polymer, such as PEDOT/PSS; a self-assembly monomer derived from compounds such as phosphonic acid and silane derivatives; a metal oxide derivative, such as $MoO_x$; a p-type semiconducting organic compound, such as 1,4,5,8,9,12-Hexaazatriphenylenehexacarbonitrile; a metal complex, and a cross-linkable compounds.

Examples of aromatic amine derivatives used in HIL or HTL include, but not limit to the following general structures:

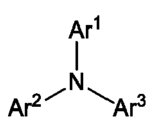 , 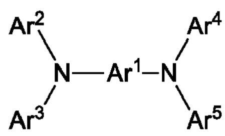 , 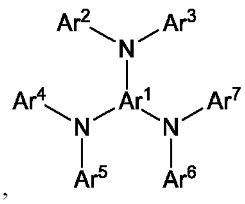 , 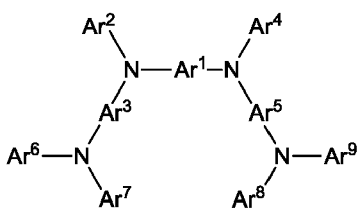 ,

and

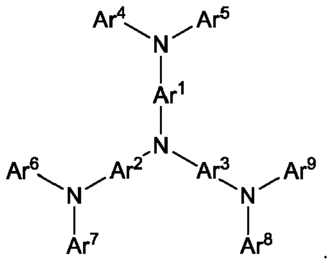

Each of $Ar^1$ to $Ar^9$ is selected from the group consisting of aromatic hydrocarbon cyclic compounds such as benzene, biphenyl, triphenyl, triphenylene, naphthalene, anthracene, phenalene, phenanthrene, fluorene, pyrene, chrysene, perylene, and azulene; the group consisting of aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and the group consisting of 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Each Ar may be unsubstituted or may be substituted by a substituent selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acids, ether, ester, nitrile, isonitrile, sulfanyl, sulfinyl, sulfonyl, phosphino, and combinations thereof.

In one aspect, $Ar^1$ to $Ar^9$ is independently selected from the group consisting of:

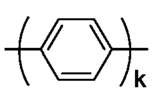 , 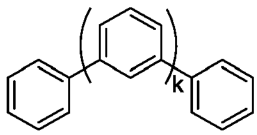 , 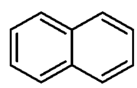 , 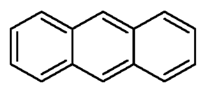 ,

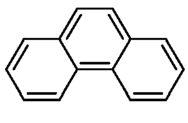 , 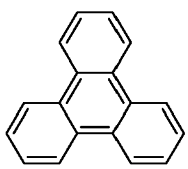 , 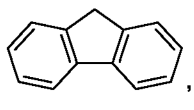 , and 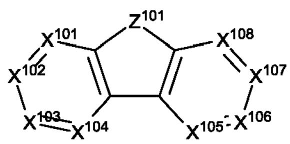 ,

wherein k is an integer from 1 to 20; $X^{101}$ to $X^{108}$ is C (including CH) or N; $Z^{101}$ is $NAr^1$, O, or S; $Ar^1$ has the same group defined above.

Examples of metal complexes used in HIL or HTL include, but are not limited to the following general formula:

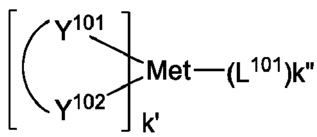

wherein Met is a metal, which can have an atomic weight greater than 40; ($Y^{101}$-$Y^{102}$) is a bidentate ligand, $Y^{101}$ and $Y^{102}$ are independently selected from C, N, O, P, and S; $L^{101}$ is an ancillary ligand; k' is an integer value from 1 to the maximum number of ligands that may be attached to the metal; and k'+k" is the maximum number of ligands that may be attached to the metal.

In one aspect, ($Y^{101}$-$Y^{102}$) is a 2-phenylpyridine derivative. In another aspect, ($Y^{101}$-$Y^{102}$) is a carbene ligand.

In another aspect, Met is selected from Ir, Pt, Os, and Zn. In a further aspect, the metal complex has a smallest oxidation potential in solution vs. $Fc^+/Fc$ couple less than about 0.6 V.

Non-limiting examples of the HIL and HTL materials that may be used in an OLED in combination with materials disclosed herein are exemplified below together with references that disclose those materials: CN102702075, DE102012005215, EP01624500, EP01698613, EP01806334, EP01930964, EP01972613, EP01997799, EP02011790, EP02055700, EP02055701, EP1725079, EP2085382, EP2660300, EP650955, JP07-073529, JP2005112765, JP2007091719, JP2008021687, JP2014-009196, KR20110088898, KR20130077473, TW201139402, US06517957, US20020158242, US20030162053, US20050123751, US20060182993, US20060240279, US20070145888, US20070181874, US20070278938, US20080014464, US20080091025, US20080106190, US20080124572, US20080145707, US20080220265, US20080233434, US20080303417, US2008107919, US20090115320, US20090167161, US2009066235, US2011007385, US20110163302, US2011240968, US2011278551, US2012205642, US2013241401, US20140117329, US2014183517, US5061569, US5639914, WO05075451, WO07125714, WO08023550, WO08023759, WO2009145016, WO2010061824, WO2011075644, WO2012177006, WO2013018530, WO2013039073, WO2013087142, WO2013118812, WO2013120577, WO2013157367, WO2013175747, WO2014002873, WO2014015935, WO2014015937, WO2014030872, WO2014030921, WO2014034791, WO2014104514, WO2014157018.

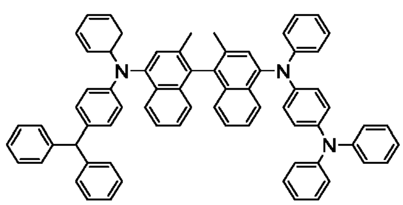
,
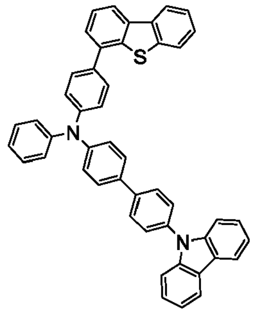
,
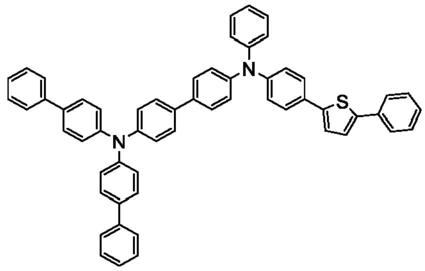
,

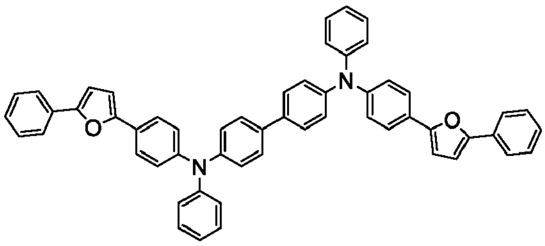
,
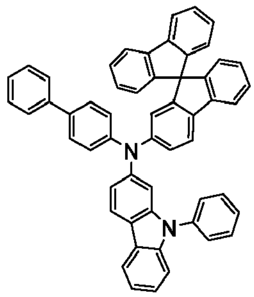
,

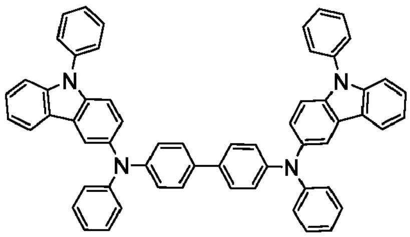
,

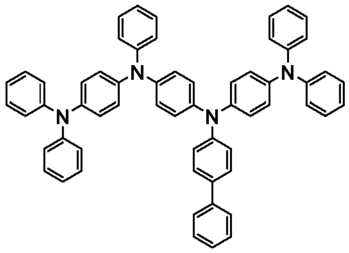 , 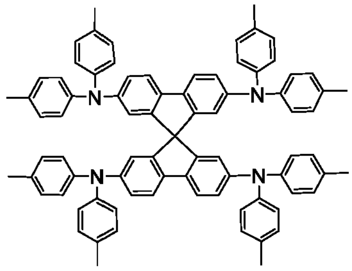 , 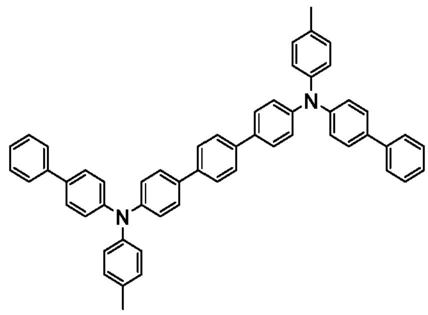 ,

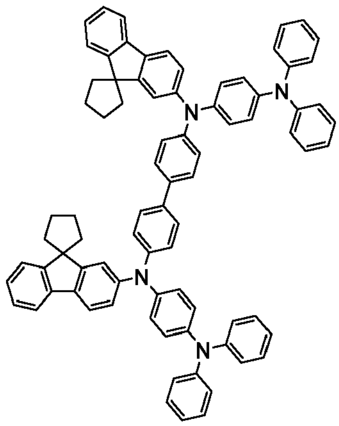 , 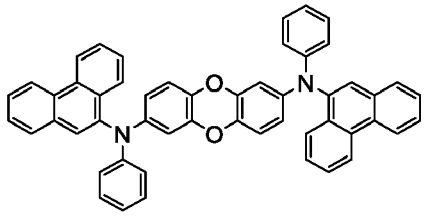 ,

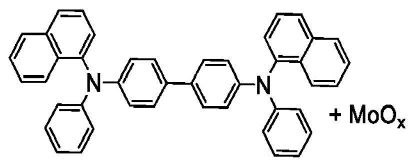 + $MoO_x$ , 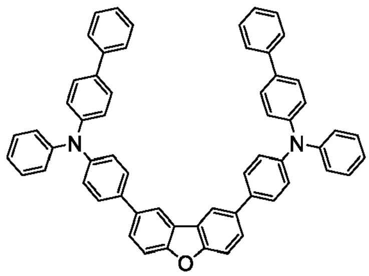 , 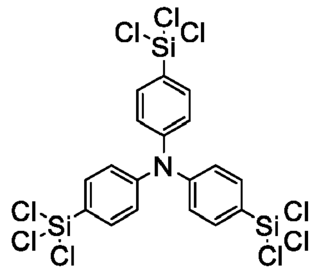 ,

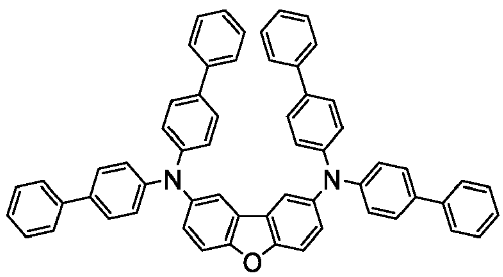 , 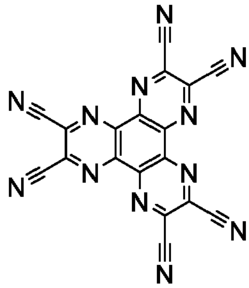 ,

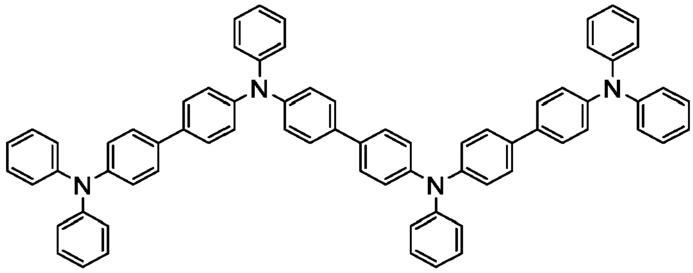,
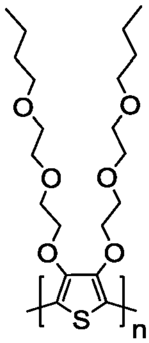,

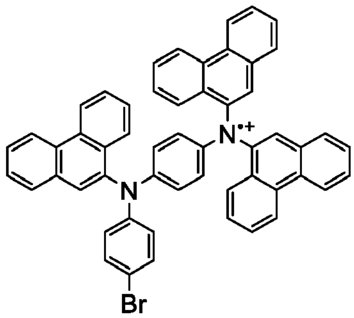
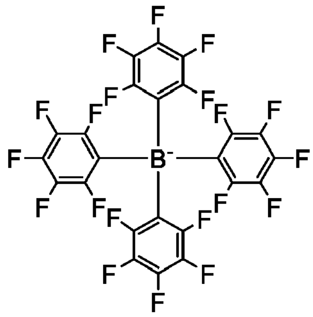,
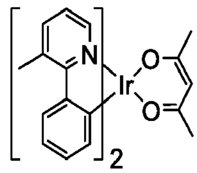,

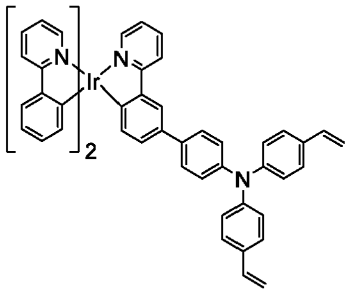,
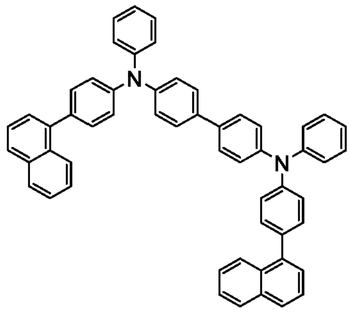,
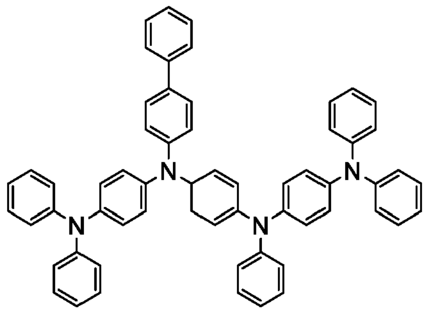,

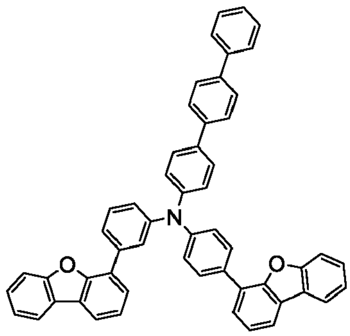,
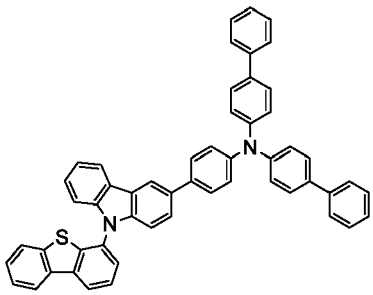,

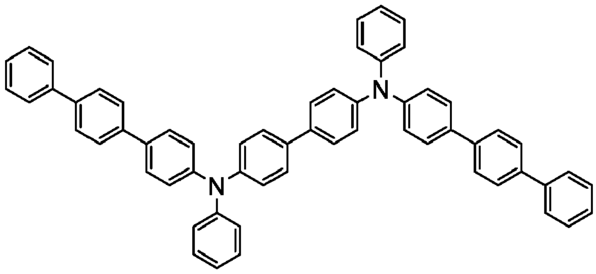 , 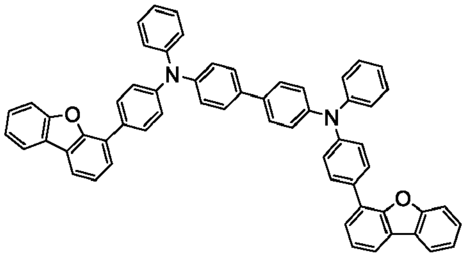 ,

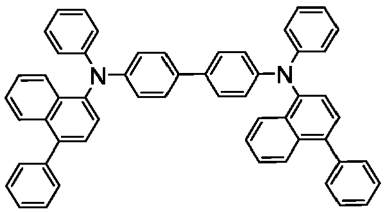 , 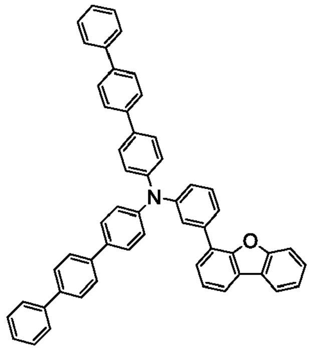 , 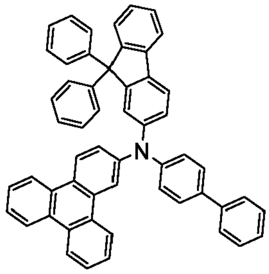 ,

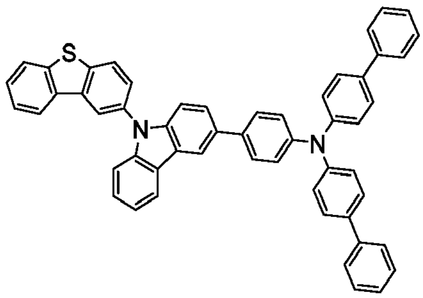 , 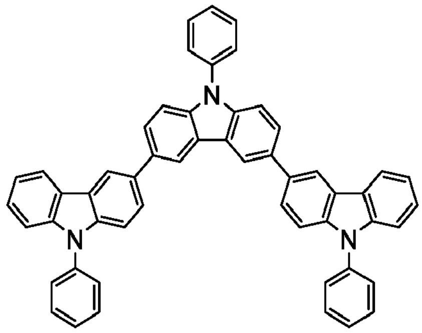 , 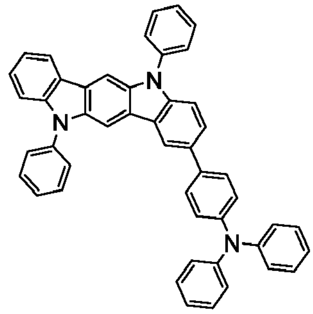 ,

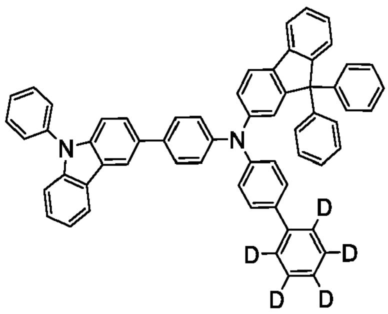 , 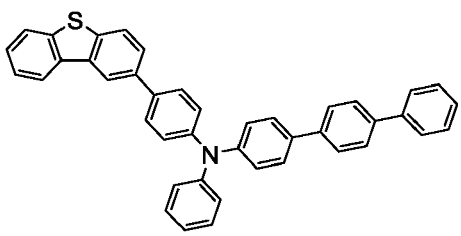 ,

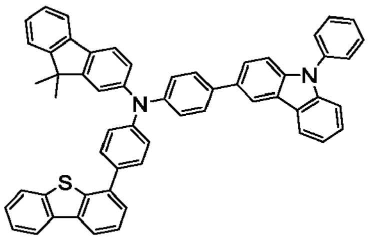 , 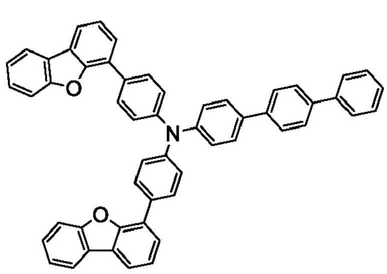 , 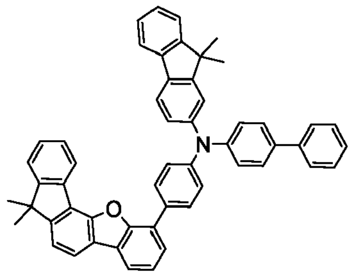 ,

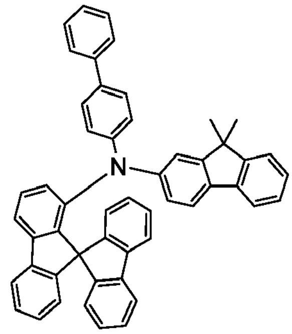 , 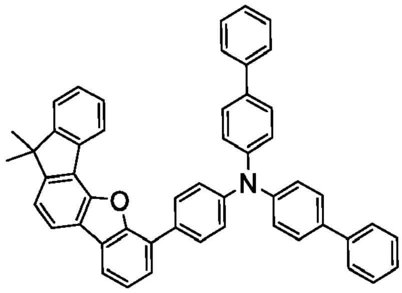 , 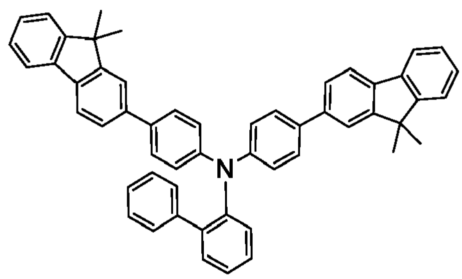 ,

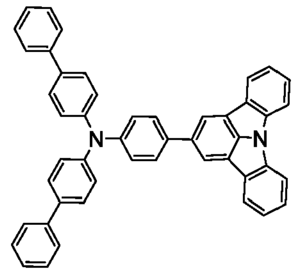 , 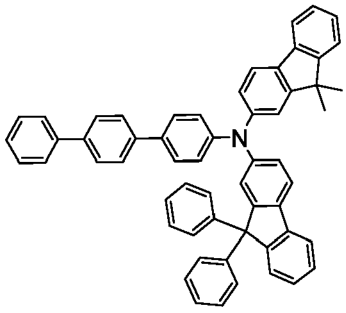 , 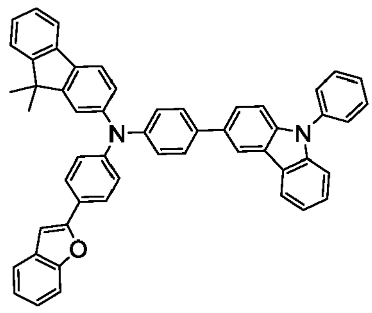 ,

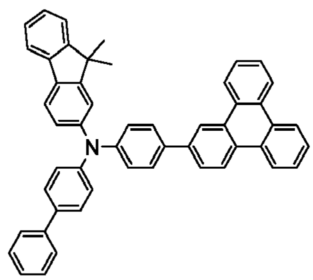 , 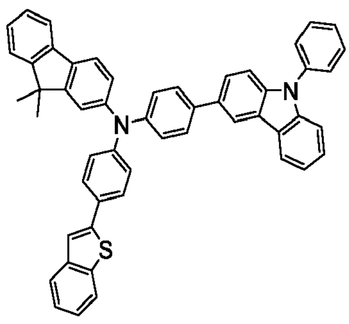 , 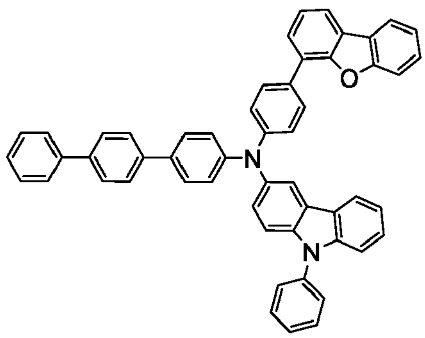 ,

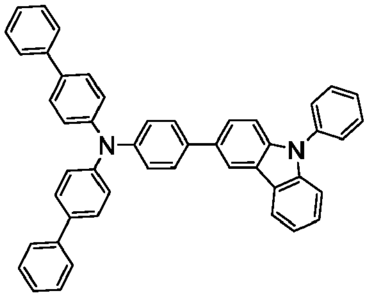, 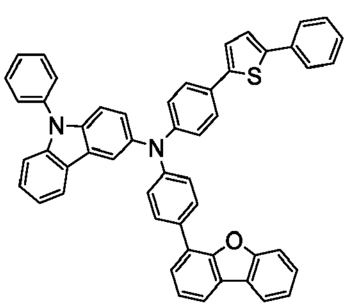, 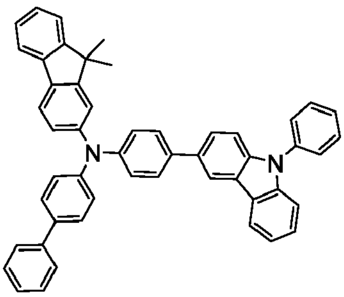,

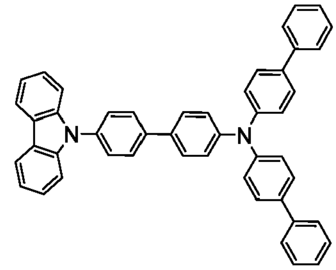, 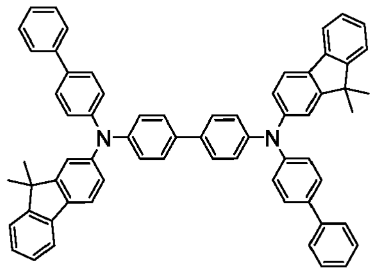, 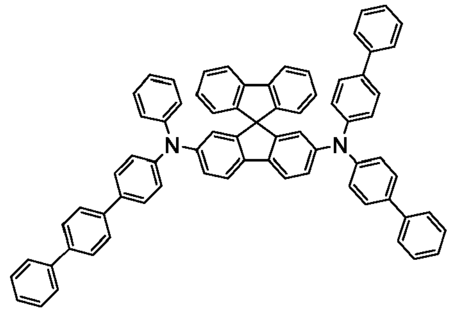,

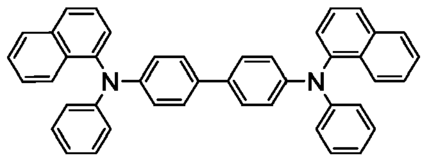, 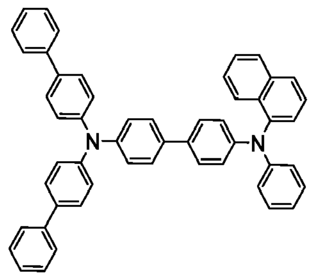, 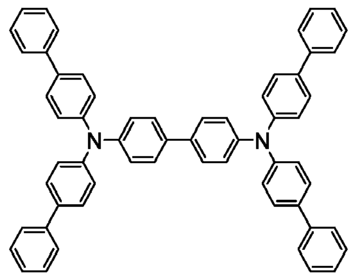,

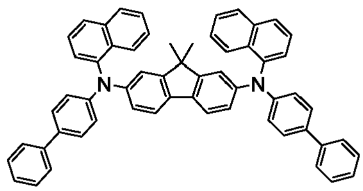, 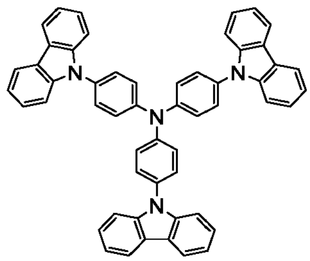, 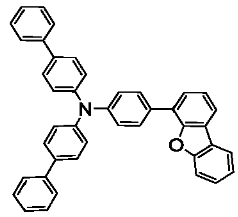,

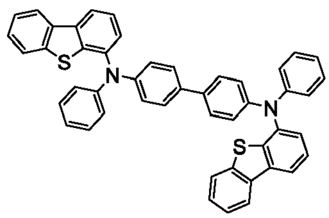,

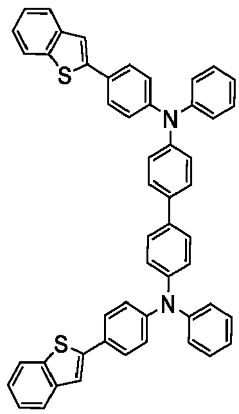

,

and

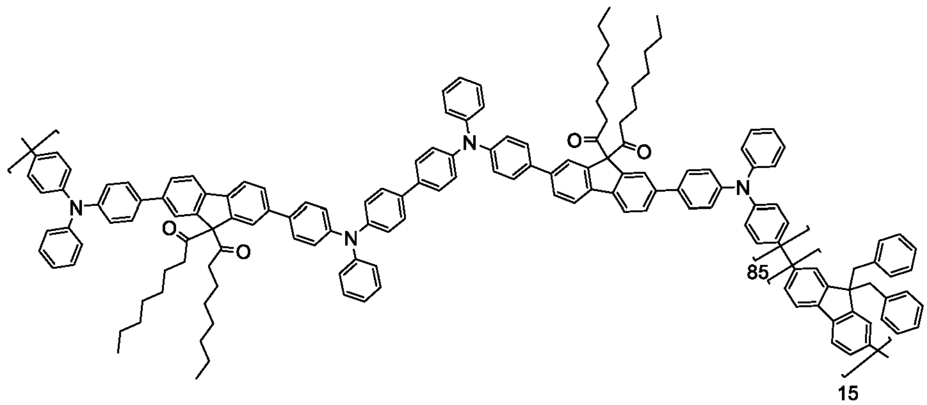

.

c) EBL:

An electron blocking layer (EBL) may be used to reduce the number of electrons and/or excitons that leave the emissive layer. The presence of such a blocking layer in a device may result in substantially higher efficiencies, and/or longer lifetime, as compared to a similar device lacking a blocking layer. Also, a blocking layer may be used to confine emission to a desired region of an OLED. In some embodiments, the EBL material has a higher LUMO (closer to the vacuum level) and/or higher triplet energy than the emitter closest to the EBL interface. In some embodiments, the EBL material has a higher LUMO (closer to the vacuum level) and/or higher triplet energy than one or more of the hosts closest to the EBL interface. In one aspect, the compound used in EBL contains the same molecule or the same functional groups used as one of the hosts described below.

**d) Hosts:**

The light emitting layer of the organic EL device of the present disclosure preferably contains at least a metal complex as light emitting material, and may contain a host material using the metal complex as a dopant material. Examples of the host material are not particularly limited, and any metal complexes or organic compounds may be used as long as the triplet energy of the host is larger than that of the dopant. Any host material may be used with any dopant so long as the triplet criteria is satisfied.

Examples of metal complexes used as host are preferred to have the following general formula:

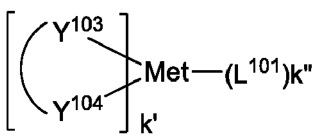

wherein Met is a metal; ($Y^{103}$-$Y^{104}$) is a bidentate ligand, $Y^{103}$ and $Y^{104}$ are independently selected from C, N, O, P, and S; $L^{101}$ is an another ligand; k' is an integer value from 1 to the maximum number of ligands that may be attached to the metal; and k'+k" is the maximum number of ligands that may be attached to the metal.

In one aspect, the metal complexes are:

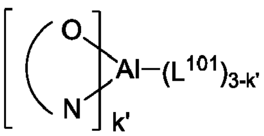 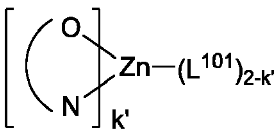

wherein (O-N) is a bidentate ligand, having metal coordinated to atoms O and N.

In another aspect, Met is selected from Ir and Pt. In a further aspect, ($Y^{103}$-$Y^{104}$) is a carbene ligand.

In one aspect, the host compound contains at least one of the following groups selected from the group consisting of aromatic hydrocarbon cyclic compounds such as benzene, biphenyl, triphenyl, triphenylene, tetraphenylene, naphthalene, anthracene, phenalene, phenanthrene, fluorene, pyrene, chrysene, perylene, and azulene; the group consisting of aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and the group consisting of 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Each option within each group may be unsubstituted or may be substituted by a substituent selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acids, ether, ester, nitrile, isonitrile, sulfanyl, sulfinyl, sulfonyl, phosphino, and combinations thereof.

In one aspect, the host compound contains at least one of the following groups in the molecule:

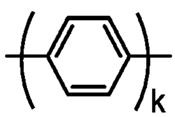, 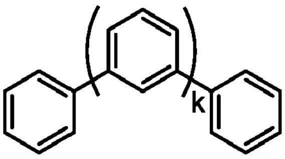, 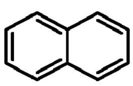, 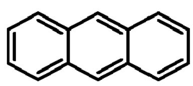, 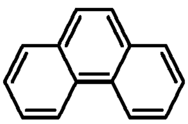,

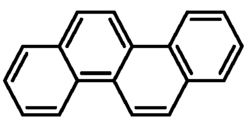, 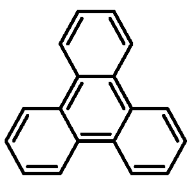, 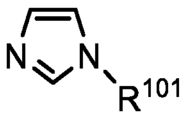, 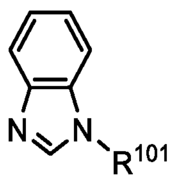, 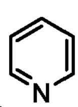, 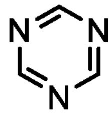,

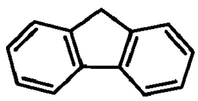,

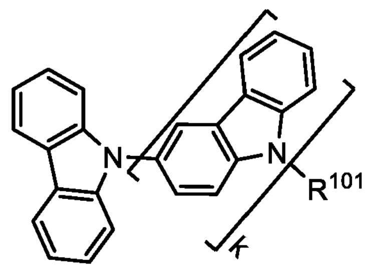, 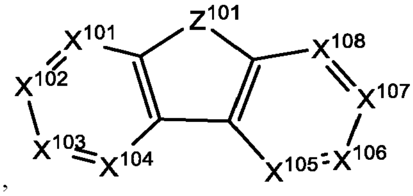, 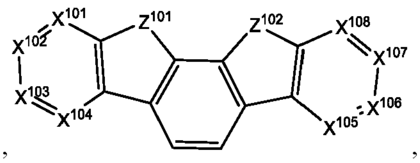,

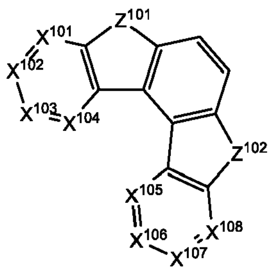, 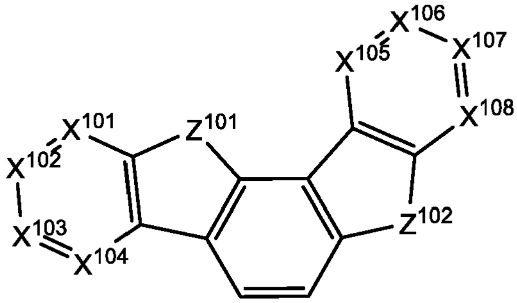,

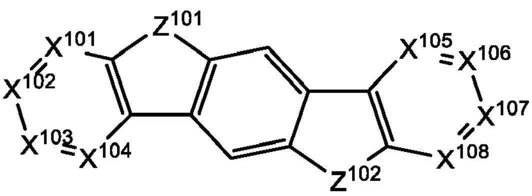, and 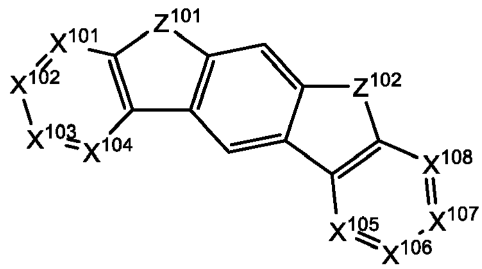,

wherein $R^{101}$ is selected from the group consisting of hydrogen, deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acids, ether, ester, nitrile, isonitrile, sulfanyl, sulfinyl, sulfonyl, phosphino, and combinations thereof, and when it is aryl or heteroaryl, it has the similar definition as Ar's mentioned above. k is an integer from 0 to 20 or 1 to 20. $X^{101}$ to $X^{108}$ are independently selected from C (including CH) or N. $Z^{101}$ and $Z^{102}$ are independently selected from $NR^{101}$, O, or S.

Non-limiting examples of the host materials that may be used in an OLED in combination with materials disclosed herein are exemplified below together with references that disclose those materials: EP2034538, EP2034538A, EP2757608, JP2007254297, KR20100079458, KR20120088644, KR20120129733, KR20130115564, TW201329200, US20030175553, US20050238919, US20060280965, US20090017330, US20090030202, US20090167162, US20090302743, US20090309488, US20100012931, US20100084966, US20100187984, US2010187984, US2012075273, US2012126221, US2013009543, US2013105787, US2013175519, US2014001446, US20140183503, US20140225088, US2014034914, US7154114, WO2001039234, WO2004093207, WO2005014551, WO2005089025, WO2006072002, WO2006114966, WO2007063754, WO2008056746, WO2009003898, WO2009021126, WO2009063833, WO2009066778, WO2009066779, WO2009086028, WO2010056066, WO2010107244, WO2011081423, WO2011081431, WO2011086863, WO2012128298, WO2012133644, WO2012133649, WO2013024872, WO2013035275, WO2013081315, WO2013191404, WO2014142472, US20170263869, US20160163995, US9466803,

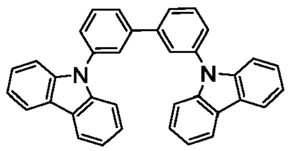 , 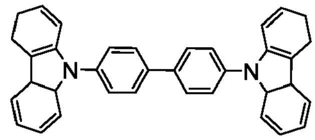 , 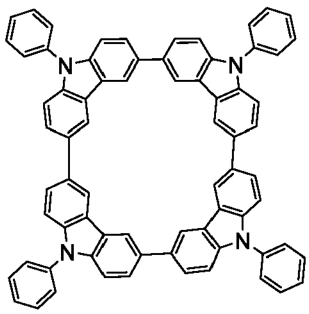 ,

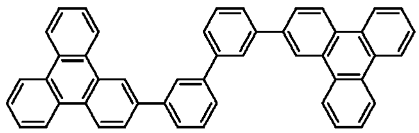 , 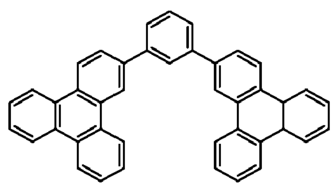 , 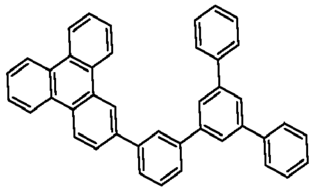 ,

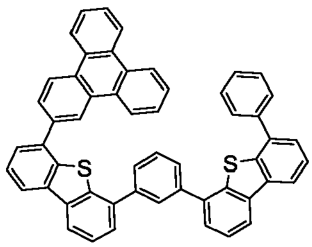 , 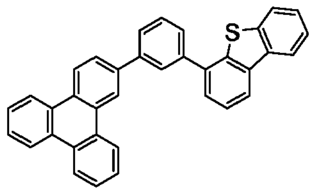 , 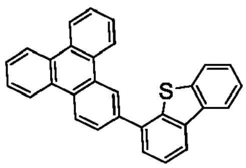 ,

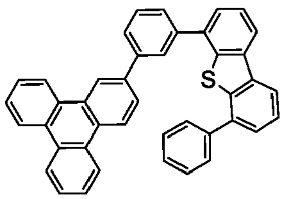 , 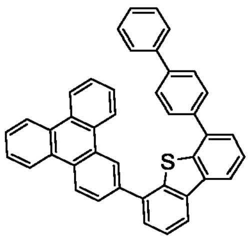 , 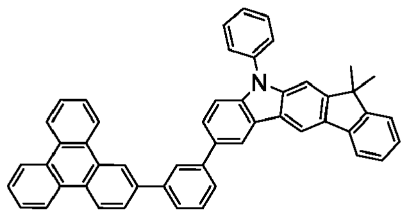 ,

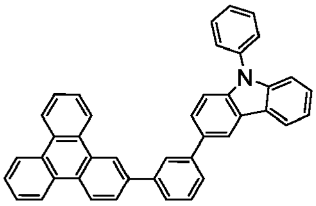 , 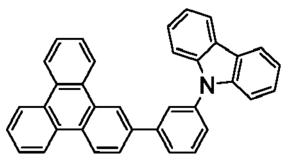 , 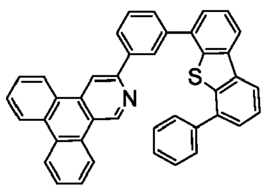 ,

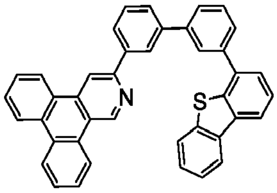 , 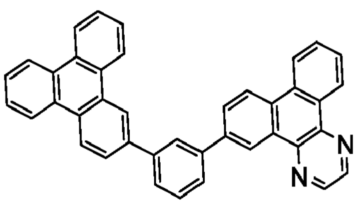 , 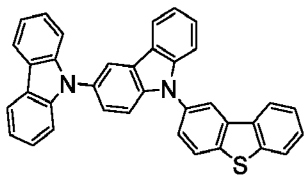 ,

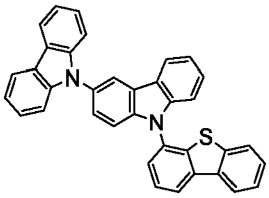, 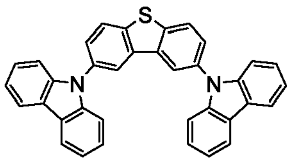, 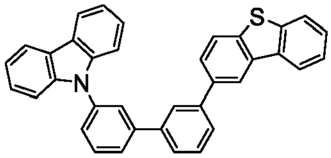,

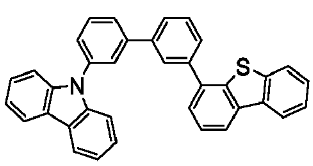, 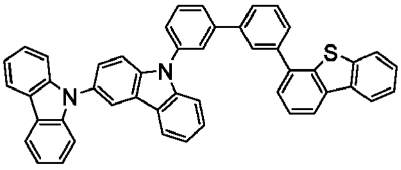, 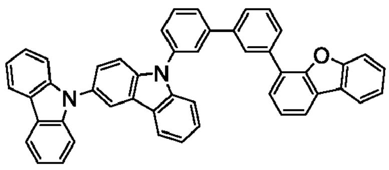,

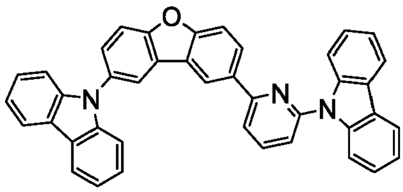, 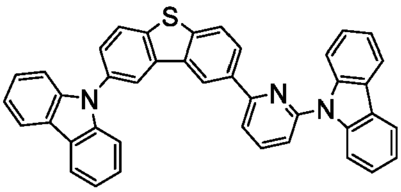,

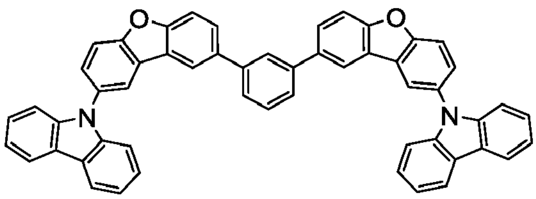, 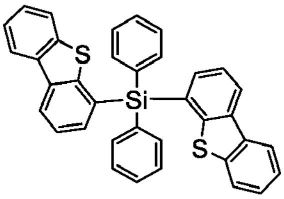,

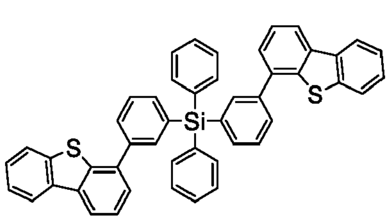, 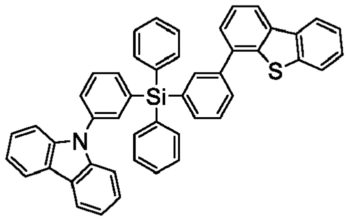,

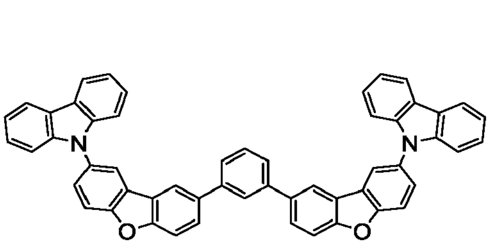, 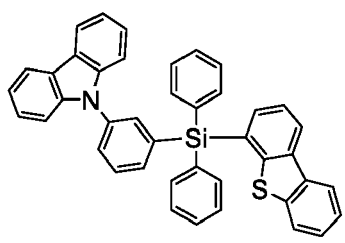,

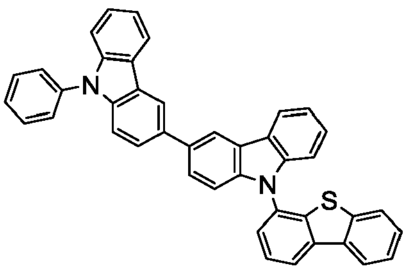, 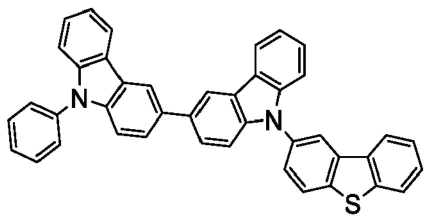,

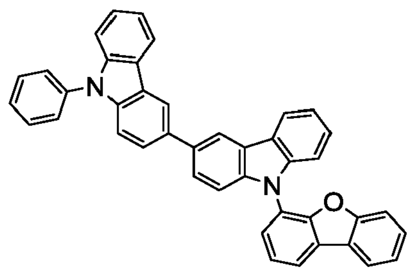,
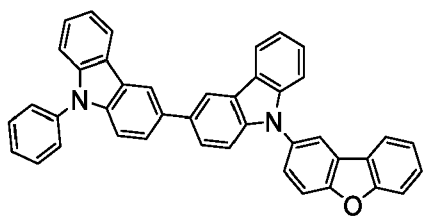,
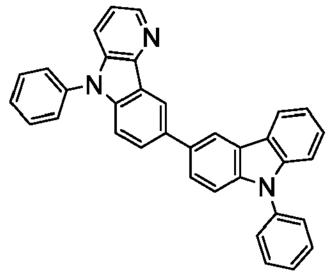,

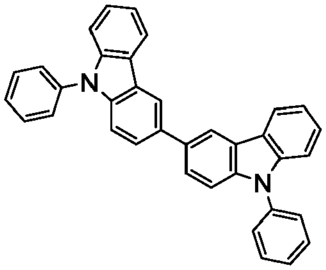,
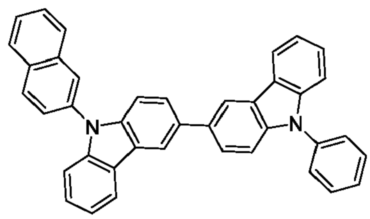,
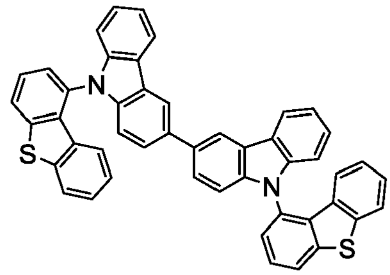,

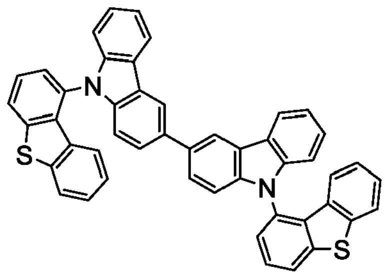,
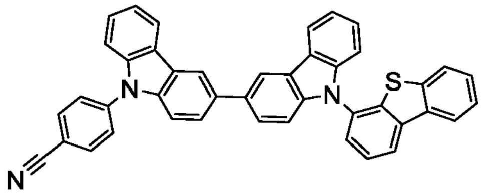,

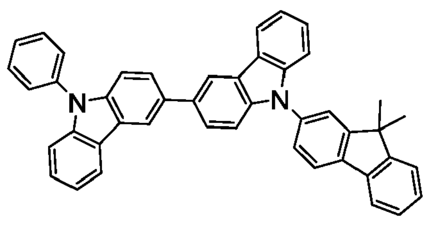,
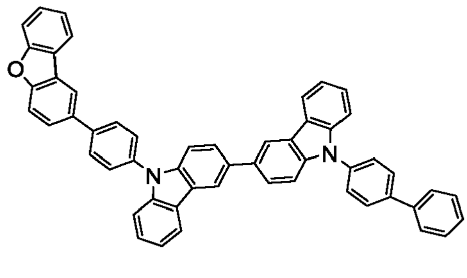,

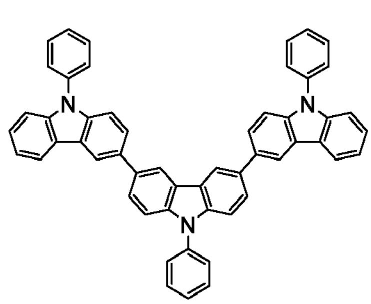,
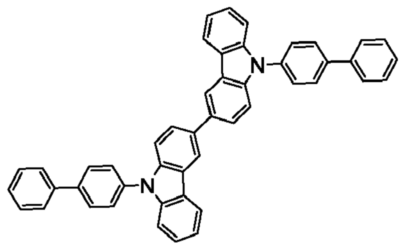,
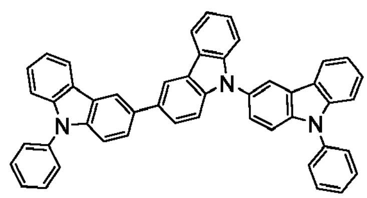,

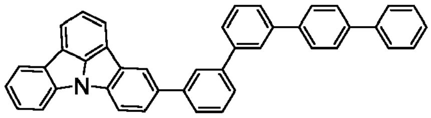,
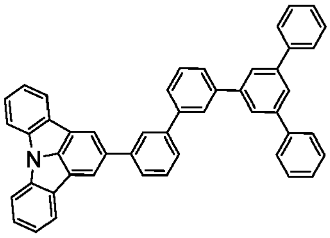,

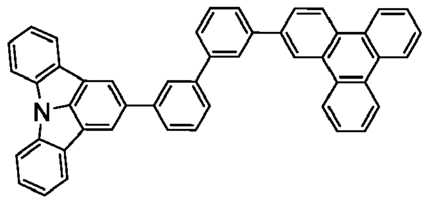,
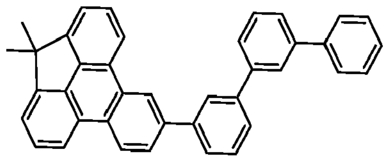,
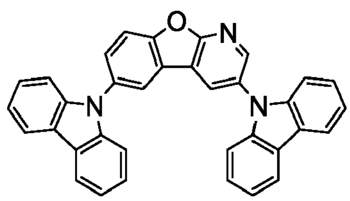,

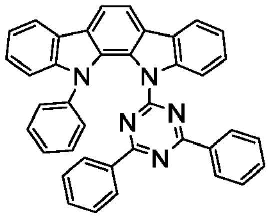,
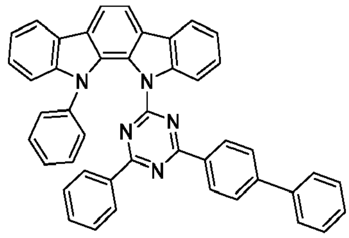,
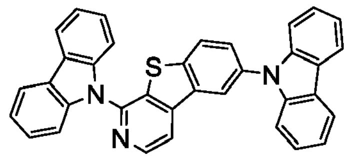,
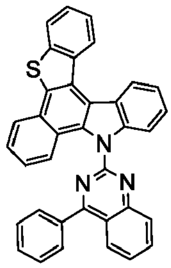,

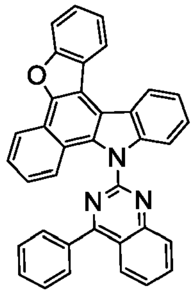,
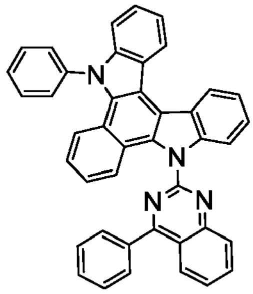,
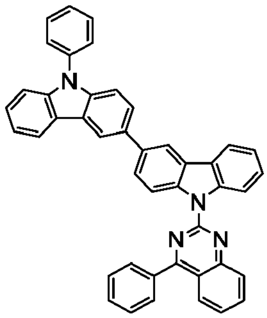,
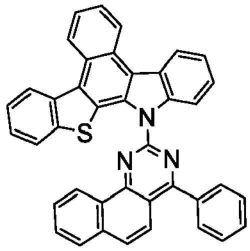,

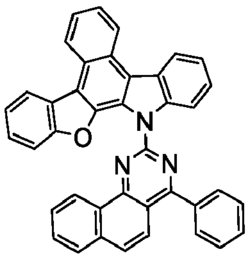,
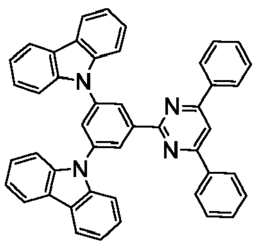,
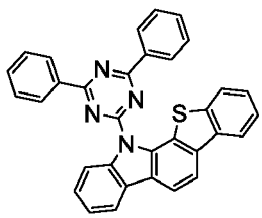,

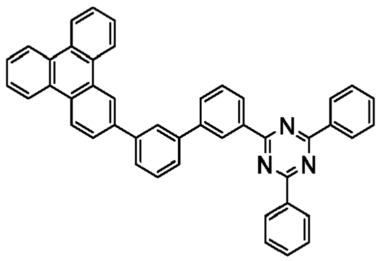,
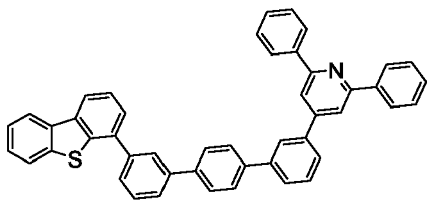,

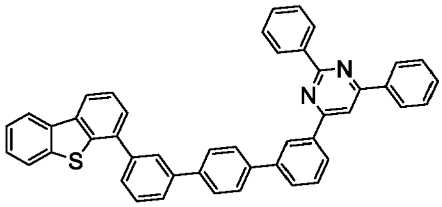,
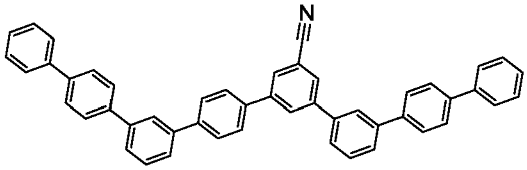,

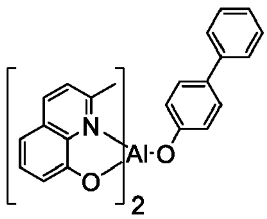, 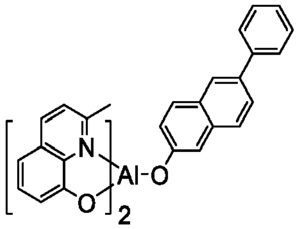, 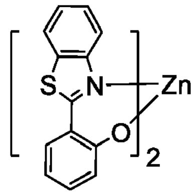, 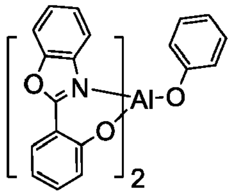,

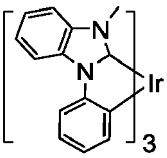, 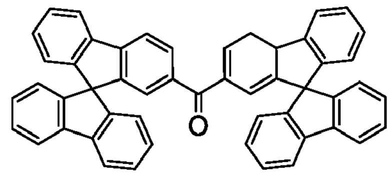, 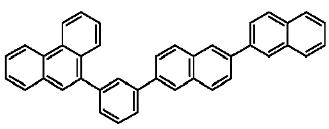,

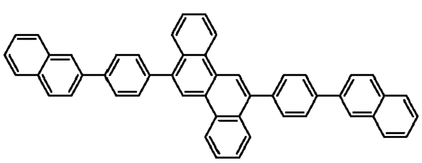, and 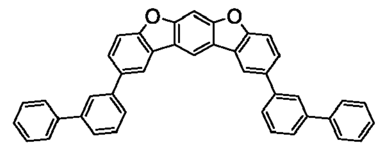.

**e) Additional Emitters:**

One or more additional emitter dopants may be used in conjunction with the compound of the present disclosure. Examples of the additional emitter dopants are not particularly limited, and any compounds may be used as long as the compounds are typically used as emitter materials. Examples of suitable emitter materials include, but are not limited to, compounds which can produce emissions via phosphorescence, fluorescence, thermally activated delayed fluorescence, i.e., TADF (also referred to as E-type delayed fluorescence), triplet-triplet annihilation, or combinations of these processes.

Non-limiting examples of the emitter materials that may be used in an OLED in combination with materials disclosed herein are exemplified below together with references that disclose those materials: CN103694277, CN1696137, EB01238981, EP01239526, EP01961743, EP1239526, EP1244155, EP1642951, EP1647554, EP1841834, EP1841834B, EP2062907, EP2730583, JP2012074444, JP2013110263, JP4478555, KR1020090133652, KR20120032054, KR20130043460, TW201332980, US06699599, US06916554, US20010019782, US20020034656, US20030068526, US20030072964, US20030138657, US20050123788, US20050244673, US2005123791, US2005260449, US20060008670, US20060065890, US20060127696, US20060134459, US20060134462, US20060202194, US20060251923, US20070034863, US20070087321, US20070103060, US20070111026, US20070190359, US20070231600, US2007034863, US2007104979, US2007104980, US2007138437, US2007224450, US2007278936, US20080020237, US20080233410, US20080261076, US20080297033, US200805851, US2008161567, US2008210930, US20090039776, US20090108737, US20090115322, US20090179555, US2009085476, US2009104472, US20100090591, US20100148663, US20100244004, US20100295032, US2010102716, US2010105902, US2010244004, US2010270916, US20110057559, US20110108822, US20110204333, US2011215710, US2011227049, US2011285275, US2012292601, US20130146848, US2013033172, US2013165653, US2013181190, US2013334521, US20140246656, US2014103305, US6303238, US6413656, US6653654, US6670645, US6687266, US6835469, US6921915, US7279704, US7332232, US7378162, US7534505, US7675228, US7728137, US7740957, US7759489, US7951947, US8067099, US8592586, US8871361, WO06081973, WO06121811, WO07018067, WO07108362, WO07115970, WO07115981, WO08035571, WO2002015645, WO2003040257, WO2005019373, WO2006056418, WO2008054584,

WO2008078800, WO2008096609, WO2008101842, WO2009000673, WO2009050281, WO2009100991, WO2010028151, WO2010054731, WO2010086089, WO2010118029, WO2011044988, WO2011051404, WO2011107491, WO2012020327, WO2012163471, WO2013094620, WO2013107487, WO2013174471, WO2014007565, WO2014008982, WO2014023377, WO2014024131, WO2014031977, WO2014038456, WO2014112450.

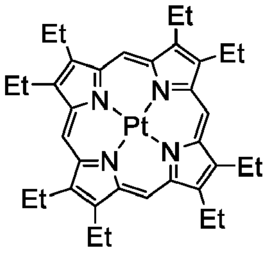,
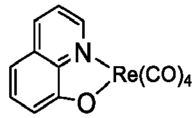,
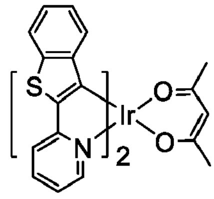,
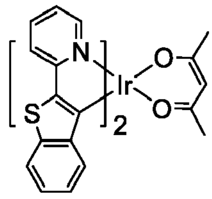,

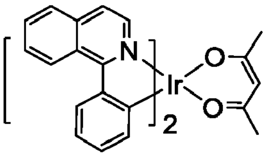,
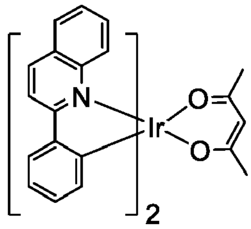,
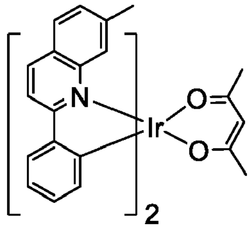,
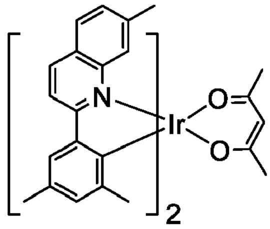,

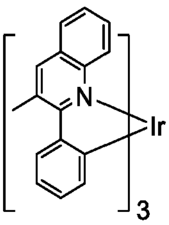,
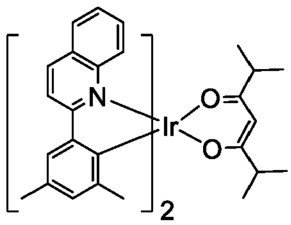,
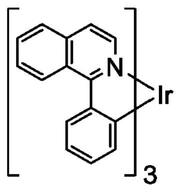,
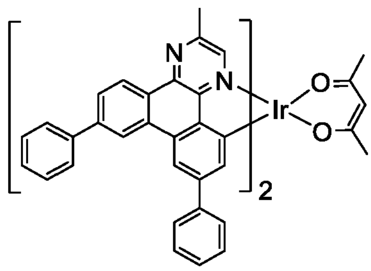,

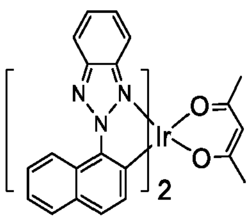,
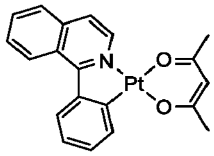,
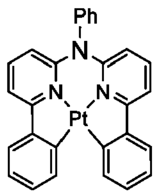,
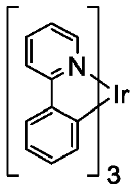,
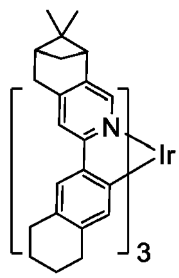,

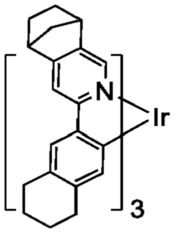,
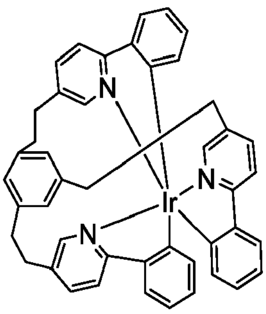,
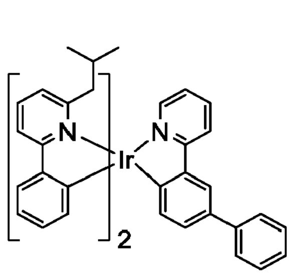,
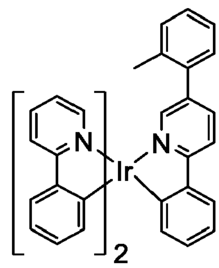,

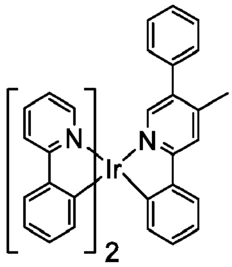,
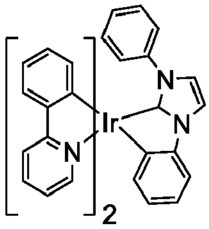,
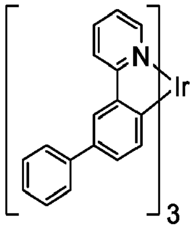,
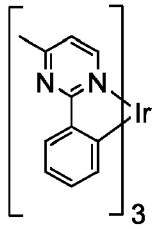,
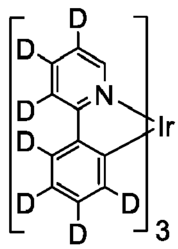,

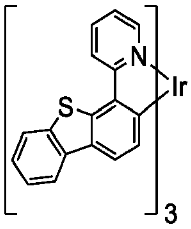,
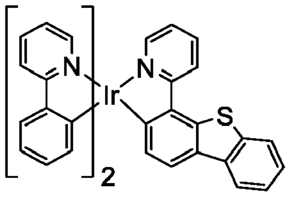,
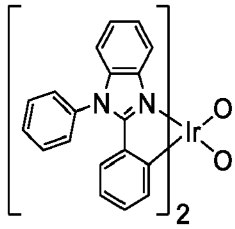,
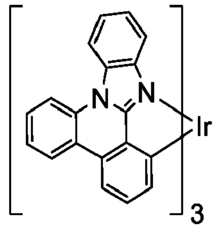,

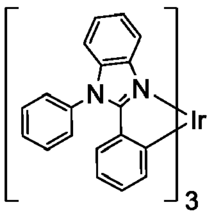,
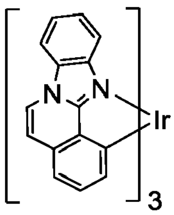,
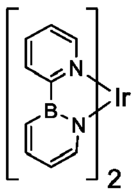,
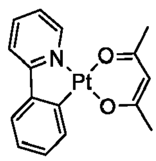,
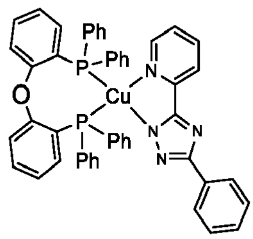,

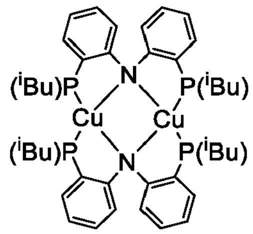,
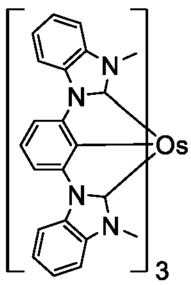,
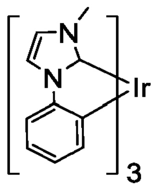,
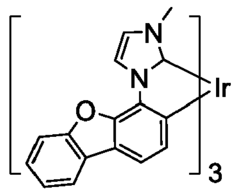,
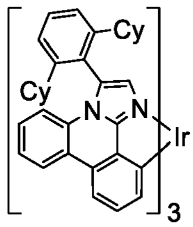,

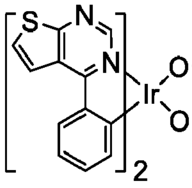,
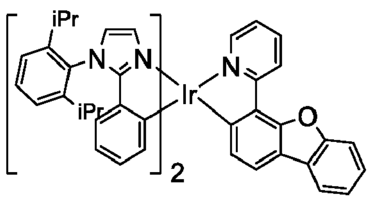,
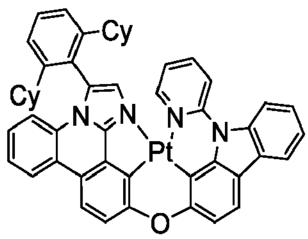,

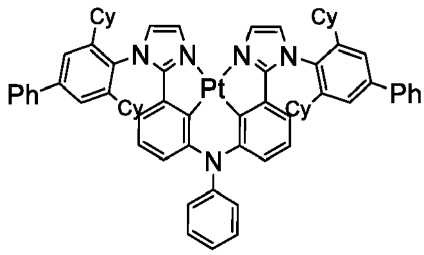,
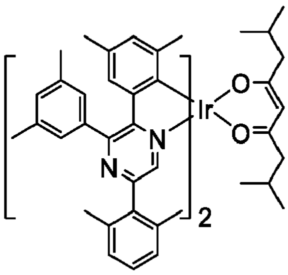,
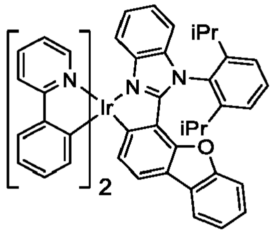,

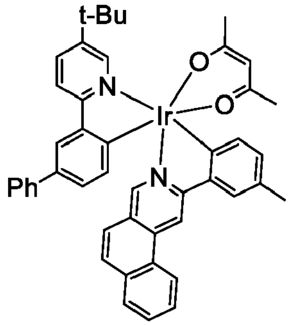,
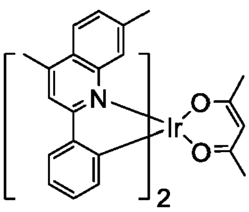,
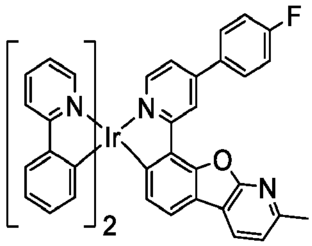,

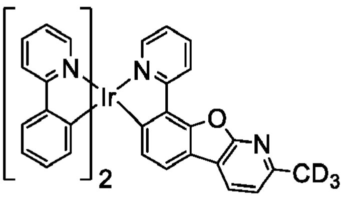,
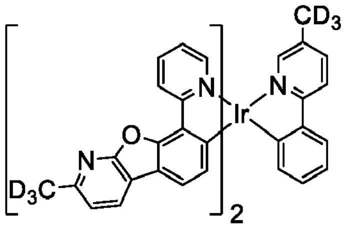,
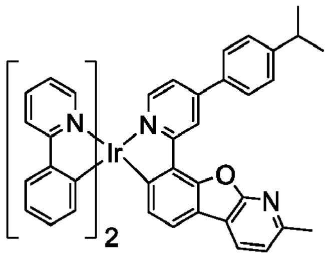,

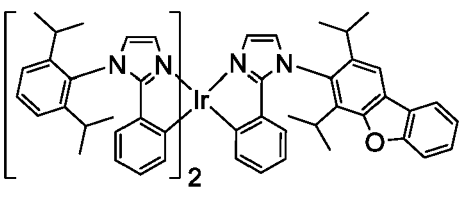,
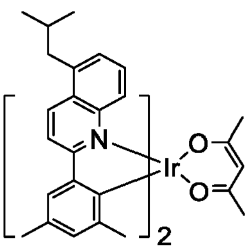,

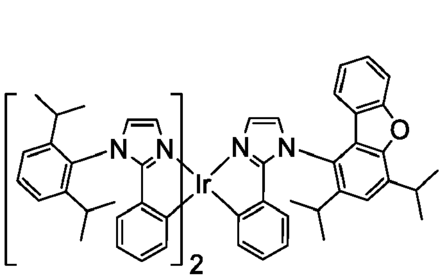,
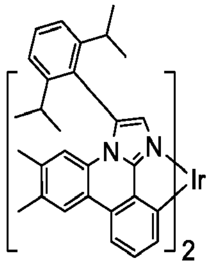,
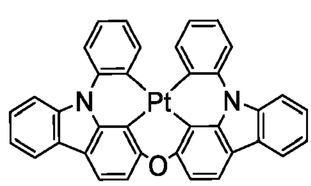,

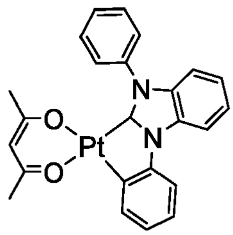 , 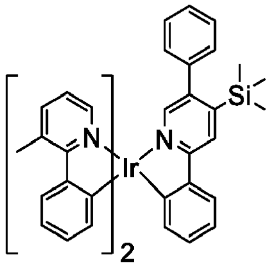 , 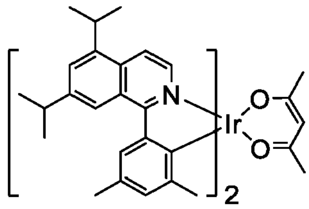 , 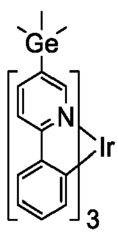 ,

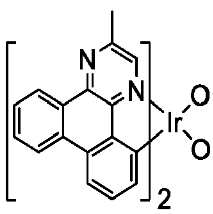 , 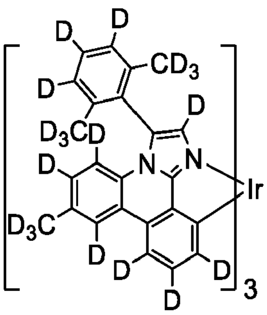 , 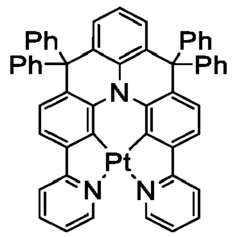 , 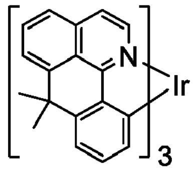 ,

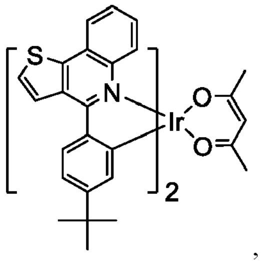 , 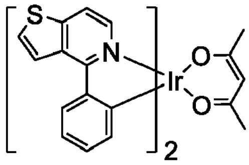 , 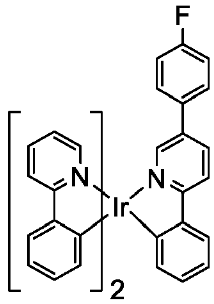 , 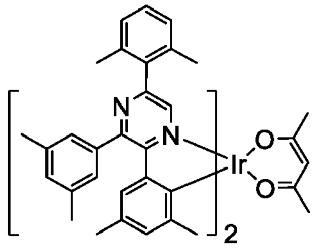 ,

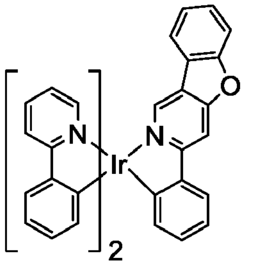 , 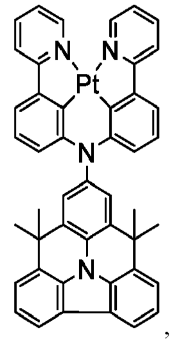 , 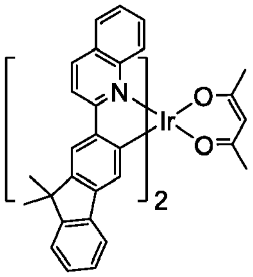 , 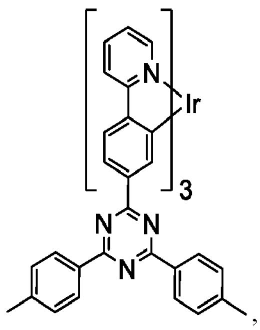 ,

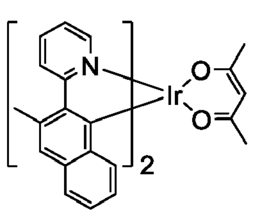 , 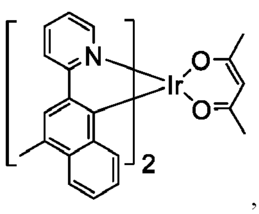 , 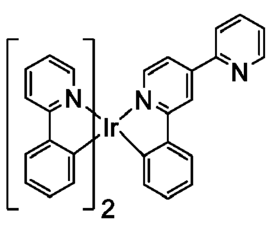 , 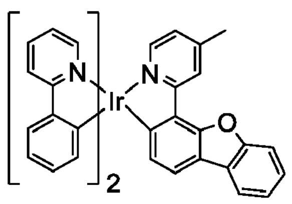 ,

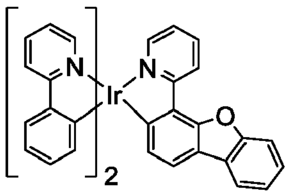, 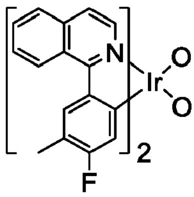, 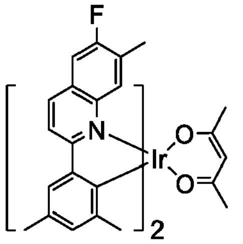, 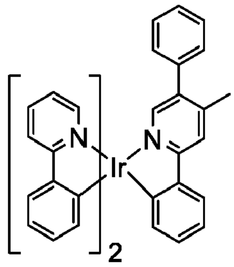,

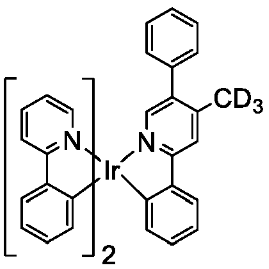, 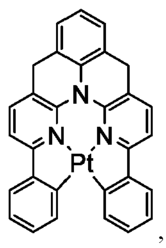, 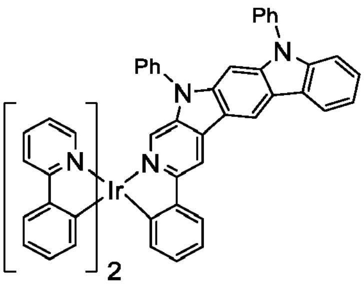, 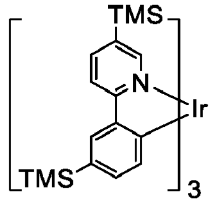,

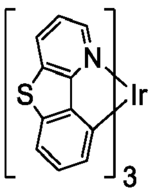, 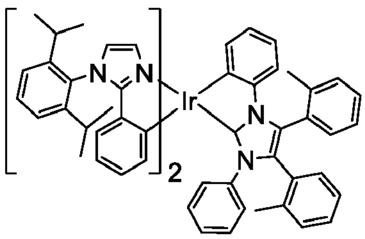, 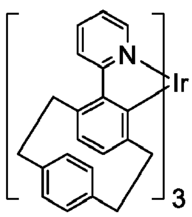, 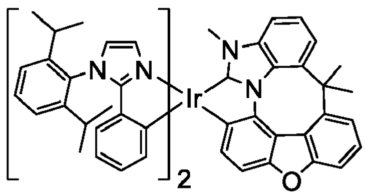,

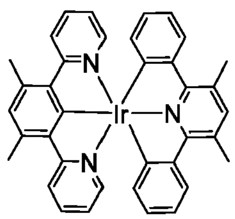, 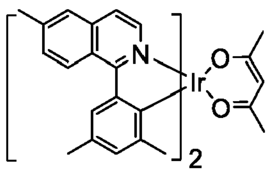, 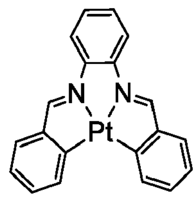, 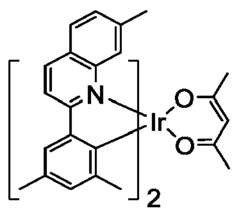,

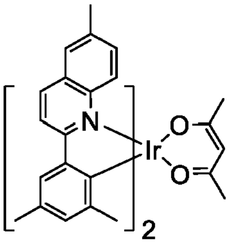, 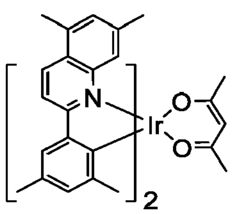, 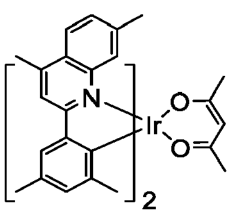, 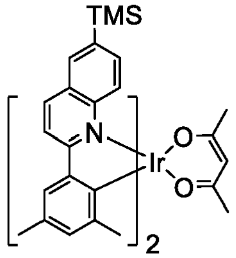,

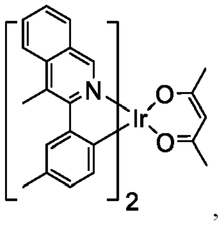 , 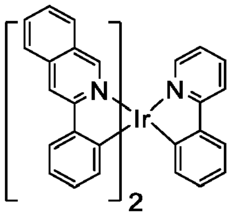 , 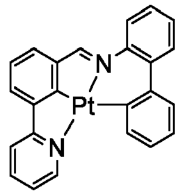 , 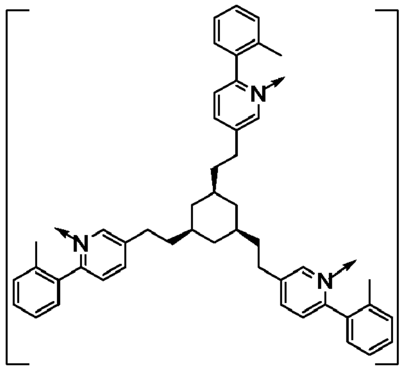 ,

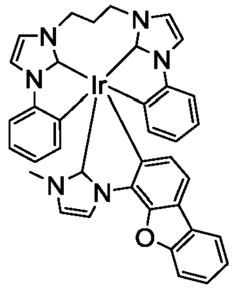 , 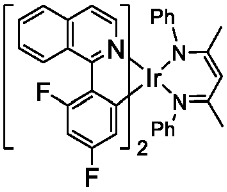 , 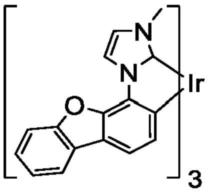 , 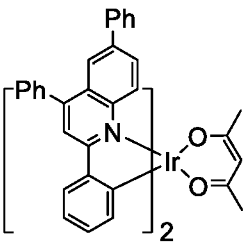 , 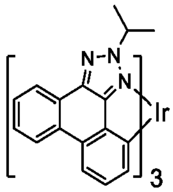 ,

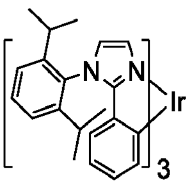 , 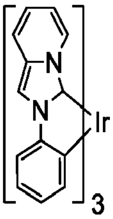 , 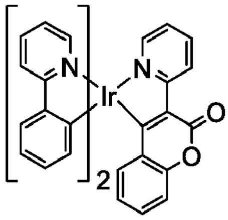 , 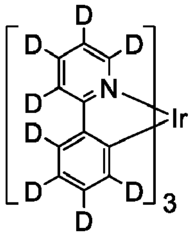 , 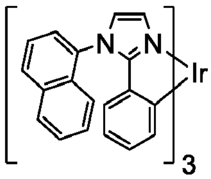 ,

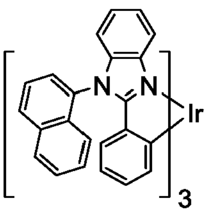 , 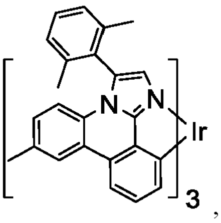 , 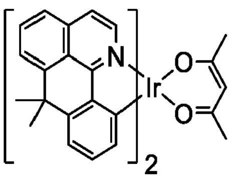 , 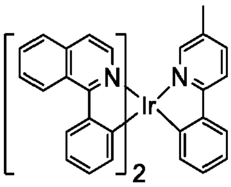 , 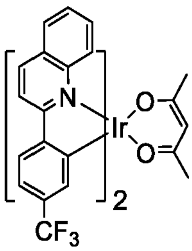 ,

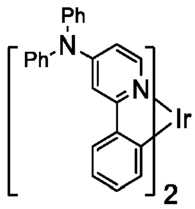 , and 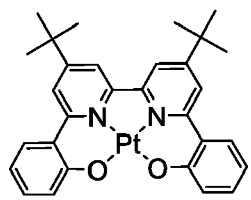 .

**f) HBL:**

A hole blocking layer (HBL) may be used to reduce the number of holes and/or excitons that leave the emissive layer. The presence of such a blocking layer in a device may result in substantially higher efficiencies and/or longer lifetime as compared to a similar device lacking a blocking layer. Also, a blocking layer may be used to confine emission

to a desired region of an OLED. In some embodiments, the HBL material has a lower HOMO (further from the vacuum level) and/or higher triplet energy than the emitter closest to the HBL interface. In some embodiments, the HBL material has a lower HOMO (further from the vacuum level) and/or higher triplet energy than one or more of the hosts closest to the HBL interface.

In one aspect, compound used in HBL contains the same molecule or the same functional groups used as host described above.

In another aspect, compound used in HBL contains at least one of the following groups in the molecule:

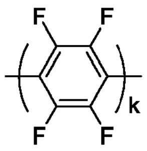
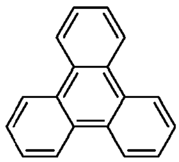
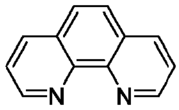
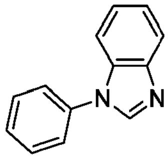
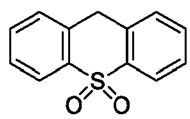
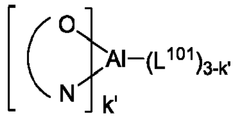

wherein k is an integer from 1 to 20; $L^{101}$ is another ligand, k' is an integer from 1 to 3.

g) ETL:

Electron transport layer (ETL) may include a material capable of transporting electrons. Electron transport layer may be intrinsic (undoped), or doped. Doping may be used to enhance conductivity. Examples of the ETL material are not particularly limited, and any metal complexes or organic compounds may be used as long as they are typically used to transport electrons.

In one aspect, compound used in ETL contains at least one of the following groups in the molecule:

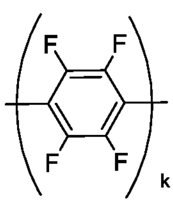
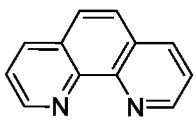
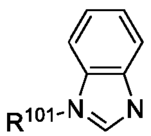
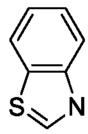
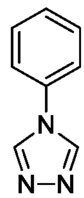
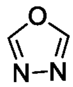
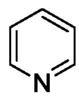
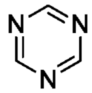

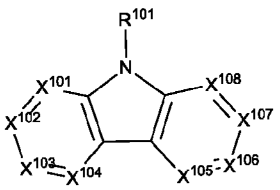
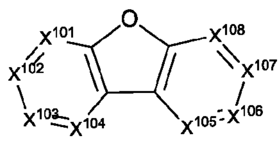
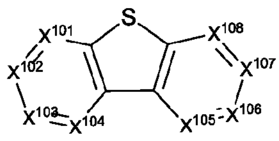
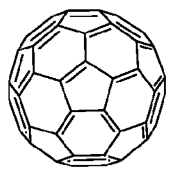
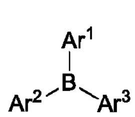

wherein $R^{101}$ is selected from the group consisting of hydrogen, deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acids, ether, ester, nitrile, isonitrile, sulfanyl, sulfinyl, sulfonyl, phosphino, and combinations thereof, when it is aryl or heteroaryl, it has the similar definition as Ar's mentioned above. $Ar^1$ to $Ar^3$ has the similar definition as Ar's mentioned above. k is an integer from 1 to 20. $X^{101}$ to $X^{108}$ is selected from C (including CH) or N.

In another aspect, the metal complexes used in ETL contains, but not limit to the following general formula:

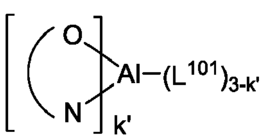
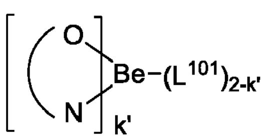
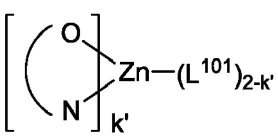
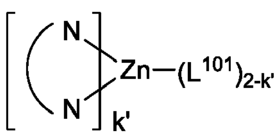

wherein (O-N) or (N-N) is a bidentate ligand, having metal coordinated to atoms O, N or N, N; $L^{101}$ is another ligand; k' is an integer value from 1 to the maximum number of ligands that may be attached to the metal.

Non-limiting examples of the ETL materials that may be used in an OLED in combination with materials disclosed herein are exemplified below together with references that disclose those materials: CN103508940, EP01602648,

EP01734038, EP01956007, JP2004-022334, JP2005149918, JP2005-268199, KR0117693, KR20130108183, US20040036077, US20070104977, US2007018155, US20090101870, US20090115316, US20090140637, US20090179554, US2009218940, US2010108990, US2011156017, US2011210320, US2012193612, US2012214993, US2014014925, US2014014927, US20140284580, US6656612, US8415031, WO2003060956, WO2007111263, WO2009148269, WO2010067894, WO2010072300, WO2011074770, WO2011105373, WO2013079217, WO2013145667, WO2013180376, WO2014104499, WO2014104535,

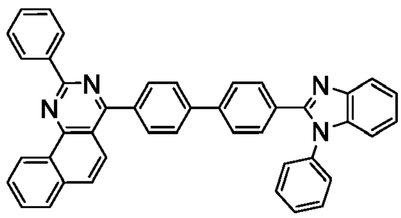,
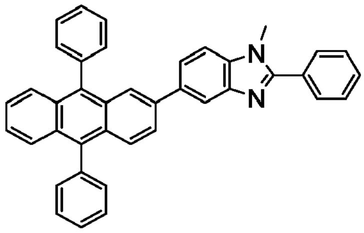,
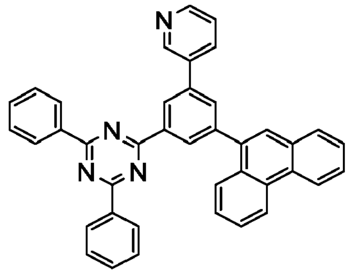,

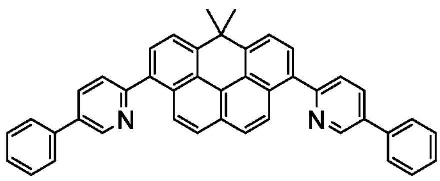,
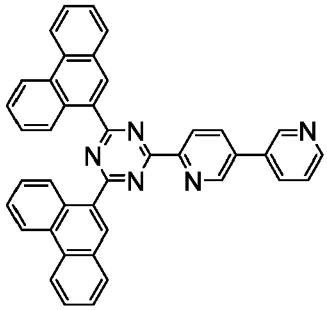,
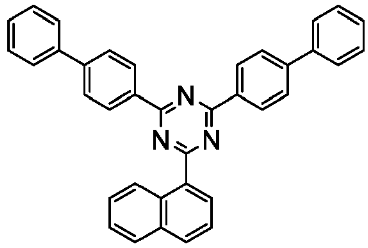,

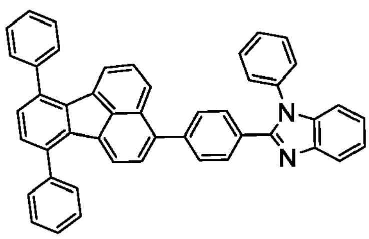,
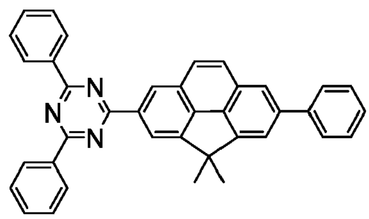,
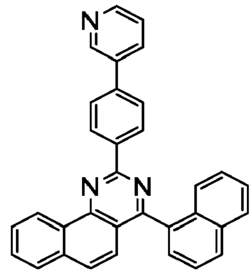,

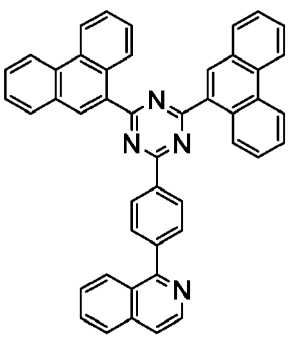,
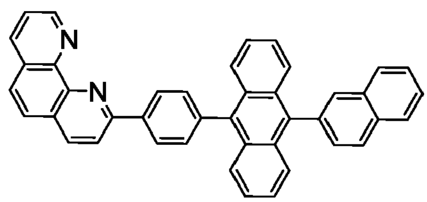,
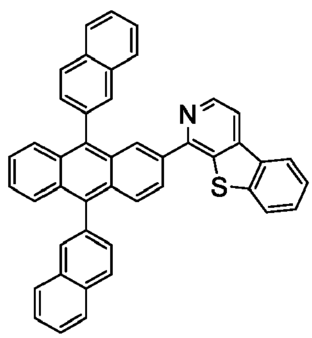,

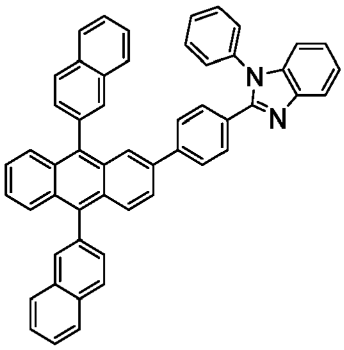,
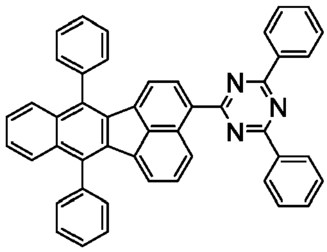,
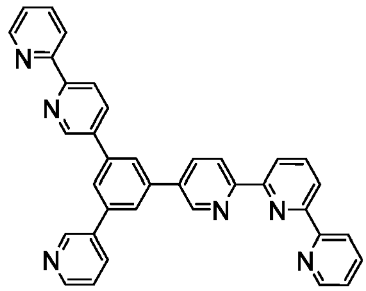,

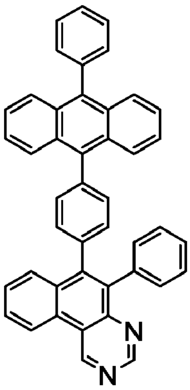,
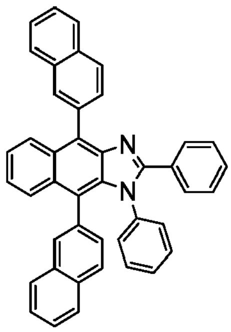,
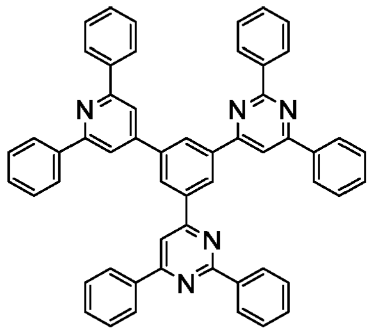,
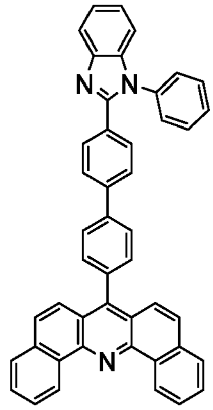,

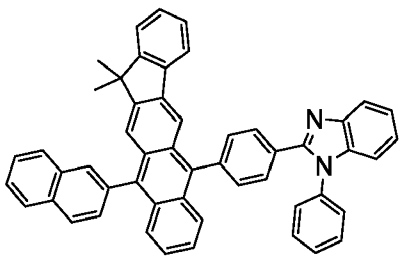,
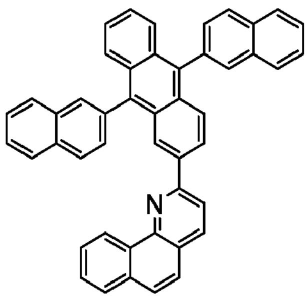,
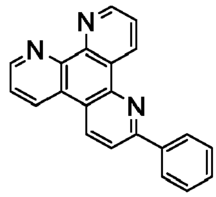,

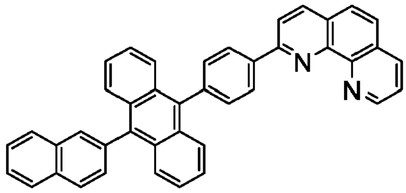,
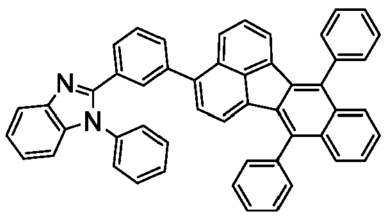,

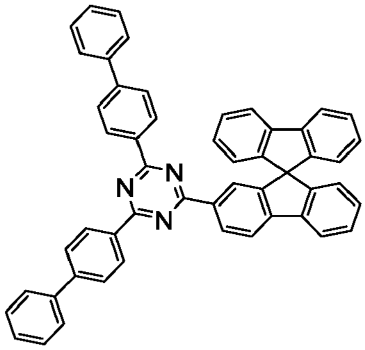, 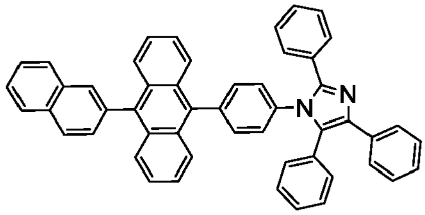,

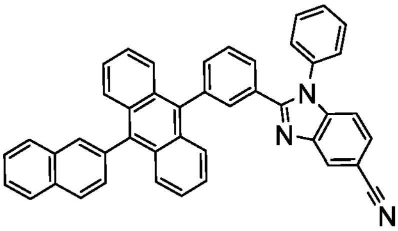, 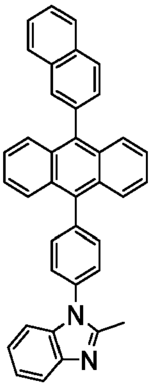, 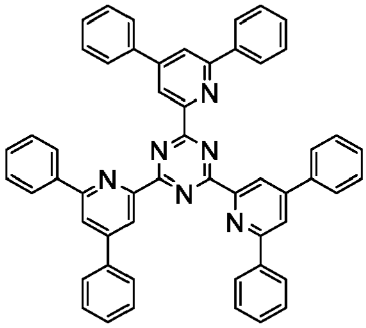,

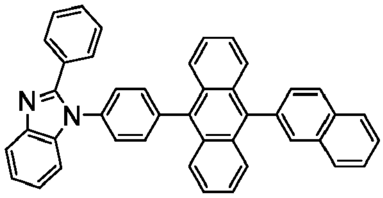, 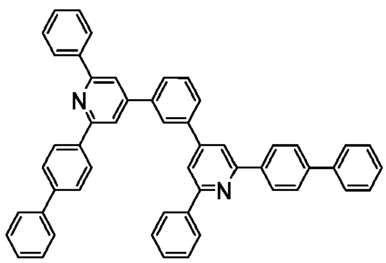,

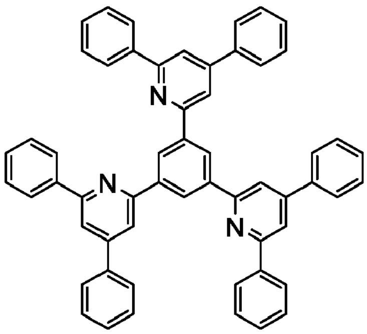, 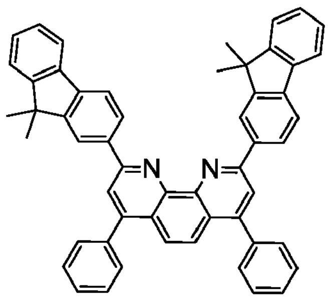, and 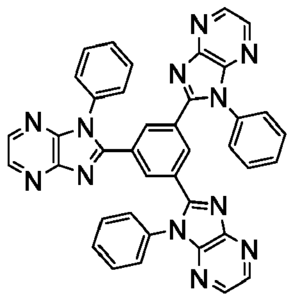.

**h) Charge generation layer (CGL)**

In tandem or stacked OLEDs, the CGL plays an essential role in the performance, which is composed of an n-doped layer and a p-doped layer for injection of electrons and holes, respectively. Electrons and holes are supplied from the CGL and electrodes. The consumed electrons and holes in the CGL are refilled by the electrons and holes injected from the cathode and anode, respectively; then, the bipolar currents reach a steady state gradually. Typical CGL materials include n and p conductivity dopants used in the transport layers.

In any above-mentioned compounds used in each layer of the OLED device, the hydrogen atoms can be

partially or fully deuterated. The minimum amount of hydrogen of the compound being deuterated is selected from the group consisting of 30%, 40%, 50%, 60%, 70%, 80%, 90%, 95%, 99%, and 100%. Thus, any specifically listed substituent, such as, but not limited to, methyl, phenyl, pyridyl, etc. may be undeuterated, partially deuterated, and fully deuterated versions thereof. Similarly, classes of substituents such as, but not limited to, alkyl, aryl, cycloalkyl, heteroaryl, etc. also may be undeuterated, partially deuterated, and fully deuterated versions thereof.

It is understood that the various embodiments described herein are by way of example only and are not intended to limit the scope of the invention. For example, many of the materials and structures described herein may be substituted with other materials and structures without deviating from the spirit of the invention. The present invention as claimed may therefore include variations from the particular examples and preferred embodiments described herein, as will be apparent to one of skill in the art. It is understood that various theories as to why the invention works are not intended to be limiting.

It should also be understood that embodiments of all the compounds and devices described herein may be interchangeable if those embodiments are also applicable under different aspects of the entire disclosure.

## Claims

1. A full-color pixel arrangement of a device comprising at least one pixel:
wherein the at least one pixel comprises:

a first subpixel comprising a first OLED comprising a first emissive region;
a second subpixel comprising a second OLED comprising a second emissive region;
wherein the first emissive region comprises:

a compound S1;
a compound A1; and
a compound H1;

wherein the second emissive region comprises:

a compound A2; and
a compound H2;

wherein the compound S1 is a sensitizer that transfers energy to the compound A1;
wherein the compound A1 is an acceptor that is an emitter;
wherein the compound H1 is a host, and at least one of the compounds S1 and A1 is doped with the compound H1;
wherein the compound A2 is an emitter;
wherein the compound H2 is a host, and the compound A2 is doped with the compound H2;
wherein at least one of the following conditions is true:

(1) the first emissive region is configured to emit a light having a peak wavelength $\lambda_{max1}$ in the visible spectrum of 400-500 nm; the second emissive region is configured to emit a light having a peak wavelength $\lambda_{max2}$ in the visible spectrum of 400-500 nm; wherein the difference between $\lambda_{max1}$ and $\lambda_{max2}$ is at least 4 nm;
(2) the first emissive region is configured to emit a light having a peak wavelength $\lambda_{max1}$; the second emissive region is configured to emit a light having a peak wavelength $\lambda_{max2}$; wherein the difference between $\lambda_{max1}$ and $\lambda_{max7}$ is at least 4 nm; wherein the at least one pixel consists of a total of *N* subpixels; wherein the *N* subpixels comprises the first subpixel and the second subpixel; wherein each of the N subpixels comprises an emissive region; wherein the total number of the emissive regions within the at least one pixel is equal or less than *N-1*;
(3) the first emissive region comprises a first number of emissive layers that is deposited one over the other if more than one; the second emissive region comprises a second number of emissive layers that is deposited one over the other if more than one; and the first number is different from the second number;
(4) the second emissive region is exactly the same as the first emissive region; each subpixel of the at least one pixel comprises exactly the same one emissive region as the first emissive region.

2. The full-color pixel arrangement of claim CLAIMS
1, wherein the compound S1 is capable of functioning as a phosphorescent emitter, a TADF emitter, or a doublet emitter in an OLED at room temperature; and/or wherein the compounds A1 is selected from the group consisting

of: a delayed-fluorescent compound functioning as a TADF emitter in the first OLED at room temperature, a fluorescent compound functioning as a fluorescent emitter in the first OLED at room temperature; and/or wherein the compounds A2 is selected from the group consisting of: a phosphorescent compound functioning as a phosphorescent emitter in the second OLED at room temperature, a delayed-fluorescent compound functioning as a TADF emitter in the second OLED at room temperature, a fluorescent compound functioning as a fluorescent emitter in the second OLED at room temperature; and/or wherein $S_1$-$T_1$ energy gap of the compound S1 is less than 300 meV; and/or wherein $S_1$-$T_1$ energy gap of the compound A1 is less than 300 meV.

**3.** The full-color pixel arrangement of claim CLAIMS
1, wherein the second OLED is not a sensitized device; or wherein the second OLED is a sensitized device; the second emissive region further comprises a compound S2; and wherein the compound S2 is a sensitizer that transfers energy to the compound A2.

**4.** The full-color pixel arrangement of claim CLAIMS
1, wherein the first emissive region is configured to emit a deep blue or light blue color; and/or wherein the second emissive region is configured to emit a color selected from the group consisting of blue, green, yellow, red, and NIR.

**5.** The full-color pixel arrangement of claim 1, wherein the first emissive region is configured to emit a light having a CIE y-coordinate less than 0.15; and the second emissive region is configured to emit a light having a CIE x-coordinate less than 0.2; and/or wherein the CIE coordinates of light emitted by the first emissive region and the CIE coordinates of light emitted by the second emissive region are sufficiently different that the difference in the CIE x-coordinates plus the difference in the CIE y-coordinates is at least > 0.01; and/or wherein the pixel arrangement further comprises a third subpixel and a fourth subpixel; wherein the third subpixel comprising a third OLED comprising a third emissive region that is configured to emit a light having a peak wavelength in the visible spectrum of 500-600 nm; and the fourth subpixel comprising a fourth OLED comprising a fourth emissive region that is configured to emit a light having a peak wavelength in the visible spectrum of 600-700 nm.

**6.** The full-color pixel arrangement of claim 1, wherein $\lambda_{max1}$ is 400-500 nm; $\lambda_{max2}$ is 500-600 nm; and/or wherein the pixel arrangement further comprises a third subpixel and a fourth subpixel; wherein each of the third subpixel and the fourth subpixel comprises exact the same second OLED comprising the second emissive region as in the second subpixel; and wherein each of the first to the fourth subpixels are configured to emit in a different color; and/or wherein the pixel arrangement further comprises a third subpixel and a fourth subpixel; wherein each of the third subpixel and the fourth subpixel comprises exact the same first OLED comprising the first emissive region as in the first subpixel; and wherein each of the first to the fourth subpixels are configured to emit in a different color; and/or wherein the $S_1$-$T_1$ energy gap of the compound A1 is less than 300 meV.

**7.** An organic light emitting device (OLED) comprising:

a first electrode;
a first emissive region disposed over the first electrode;
a first charge generation layer (CGL) disposed over the first emissive region;
a second emissive region disposed over the first CGL; and
a second electrode disposed over the second emissive region;
wherein the first emissive region comprises:

a compound S1;
a compound A1; and
a compound H1;

wherein the second emissive region comprises:

a compound A2; and
a compound H2;

wherein the compound S1 is a sensitizer that transfers energy to the compound A1;
wherein the compound A1 is an acceptor that is an emitter;
wherein the compound H1 is a host, and at least one of the compounds S1 and A1 is doped with the compound H1;
wherein the compound A2 is an emitter;

wherein the compound H2 is a host, and the compound A2 is doped with the compound H2;

wherein at least one of the following conditions is true:

(1) the first emissive region is configured to emit a light having a peak wavelength $\lambda_{max1}$ in the visible spectrum of 400-500 nm; the second emissive region is configured to emit a light having a peak wavelength $\lambda_{max2}$ in the visible spectrum of 400-500 nm.
(2) the first emissive region is configured to emit a light having a peak wavelength $\lambda_{max1}$ in one of the visible spectrum of 400-500 nm, 500-600 nm, 600-700 nm; the second emissive region is configured to emit a light having a peak wavelength $\lambda_{max2}$ in one of the remaining ones of the visible spectrum of 400-500 nm, 500-600 nm, 600-700 nm;
(3) the first emissive region comprises a first number of emissive layers that is deposited one over the other if more than one; the second emissive region comprises a second number of emissive layers that is deposited one over the other if more than one; and the first number is different from the second number.

**8.** The OLED of claim 7, wherein the compound S1 is capable of functioning as a phosphorescent emitter, a TADF emitter, or a doublet emitter in an OLED at room temperature; and/or wherein the compounds A1 is selected from the group consisting of: a delayed-fluorescent compound functioning as a TADF emitter in the first OLED at room temperature, a fluorescent compound functioning as a fluorescent emitter in the first OLED at room temperature; and/or wherein the compounds A2 is selected from the group consisting of: a phosphorescent compound functioning as a phosphorescent emitter in the second OLED at room temperature, a delayed-fluorescent compound functioning as a TADF emitter in the second OLED at room temperature, a fluorescent compound functioning as a fluorescent emitter in the second OLED at room temperature; and/or wherein $S_1$-$T_1$ energy gap of the compound S1 is less than 300 meV; and/or wherein $S_1$-$T_1$ energy gap of the compound A1 is less than 300 meV.

**9.** The OLED of claim 7, wherein the second emissive region does not comprise a sensitizer; or wherein the second emissive region further comprises a compound S2; and wherein the compound S2 is a sensitizer that transfers energy to the compound A2.

**10.** The OLED of claim 7, wherein the OLED comprises plurality of emissive regions disposed between the first and second electrodes, and separated by plurality of CGLs from each other; wherein each of the emissive regions is configured to emit in a different color selected from the group consisting of deep blue, light blue, green, yellow, red, and NIR.

**11.** The OLED of claim 7, wherein the first emissive region is configured to emit a deep blue or light blue color; and/or wherein the second emissive region is configured to emit a color selected from the group consisting of blue, green, yellow, red, and NIR.

**12.** The OLED of claim 7, wherein the first emissive region is configured to emit a light having a peak wavelength $\lambda_{max1}$ in the visible spectrum of 400-500 nm; the second emissive region is configured to emit a light having a peak wavelength $\lambda_{max2}$ in the visible spectrum of 500-700 nm; or wherein the second emissive region is configured to emit a light having a peak wavelength $\lambda_{max1}$ in the visible spectrum of 400-500 nm; the first emissive region is configured to emit a light having a peak wavelength $\lambda_{max2}$ in the visible spectrum of 500-700 nm; or wherein one of the first and second emissive regions is configured to emit a light having a peak wavelength $\lambda_{max1}$ in the visible spectrum of 400-500 nm; the other one of the first and second emissive regions comprises an emissive material of green and an emissive material of red, and is configured to emit a light having a peak wavelength $\lambda_{max1}$ in the visible spectrum of 500-700 nm; or wherein one of the first and second emissive regions is configured to emit a light having a peak wavelength $\lambda_{max1}$ in the visible spectrum of 400-500 nm; the other one of the first and second emissive regions comprises an emissive material of green, an emissive material of yellow, and an emissive material of red, and is configured to emit a light having a peak wavelength $\lambda_{max1}$ in the visible spectrum of 500-700 nm.

**13.** The OLED of claim 7, wherein the organic layer further comprises an additional host, wherein the additional host comprises at least one chemical moiety selected from the group consisting of triphenylene, carbazole, indolocarbazole, dibenzothiophene, dibenzofuran, dibenzoselenophene, 5$\lambda^2$ -benzo[d]benzo[4,5]imidazo[3,2-a]imidazole, 5,9-dioxa-13b-boranaphtho[3,2,1-de]anthracene, triazine, boryl, silyl, aza-triphenylene, aza-carbazole, aza-indolocarbazole, aza-dibenzothiophene, aza-dibenzofuran, aza-dibenzoselenophene, aza-5$\lambda^2$-benzo[d]benzo[4,5]imidazo[3,2-a]imidazole, and aza-(5,9-dioxa-13b-boranaphtho[3,2,1-de]anthracene).

**14.** The OLED of claim 7, wherein the organic layer further comprises an additional host, wherein the additional host is selected from the group consisting of

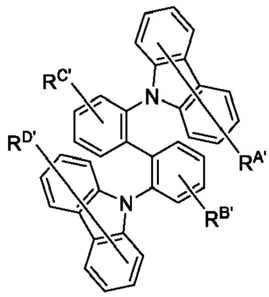,
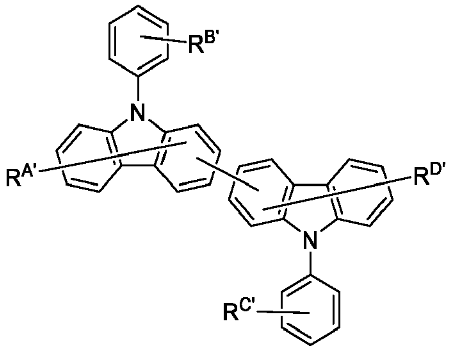,
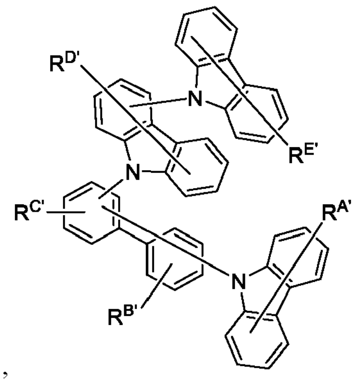,
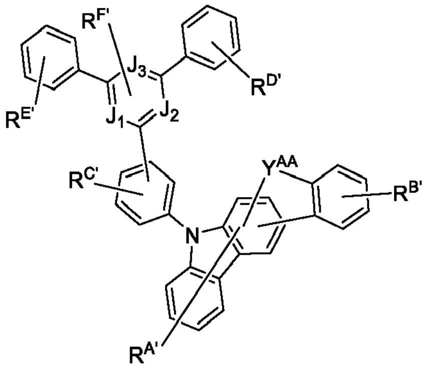,
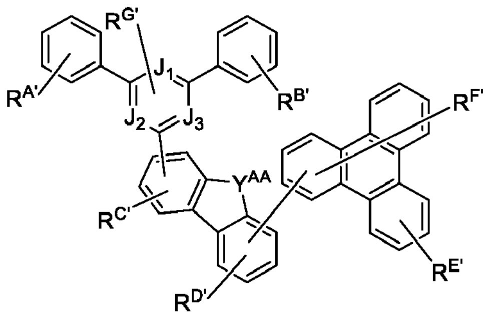,
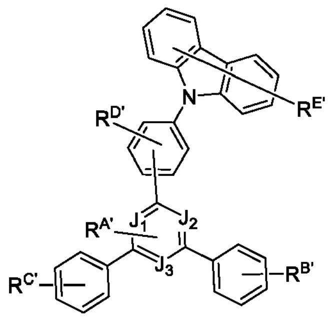,
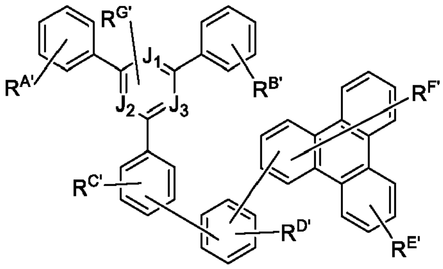,
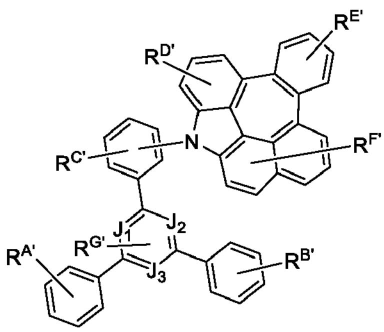,
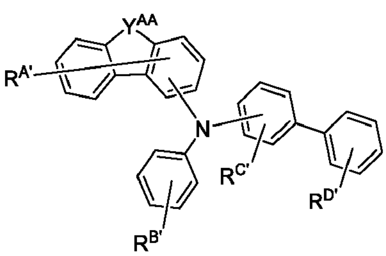,
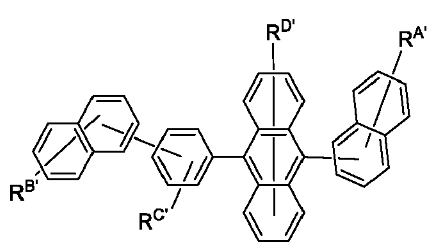,

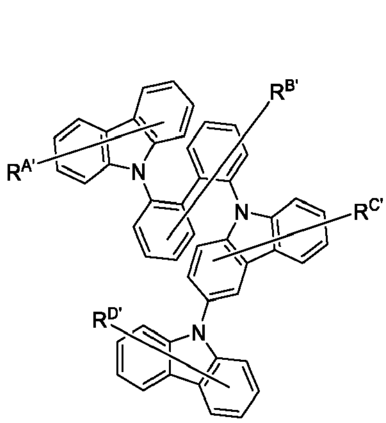

,

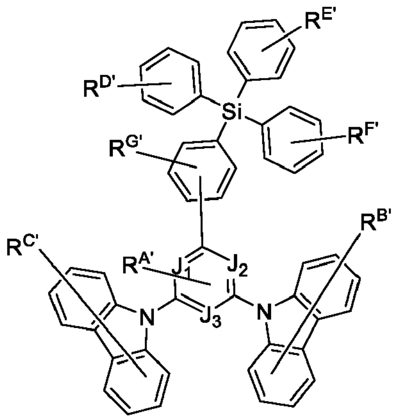

,

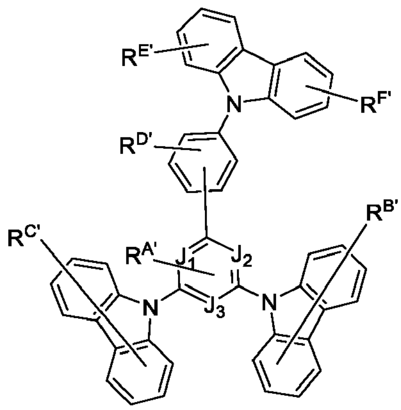

,

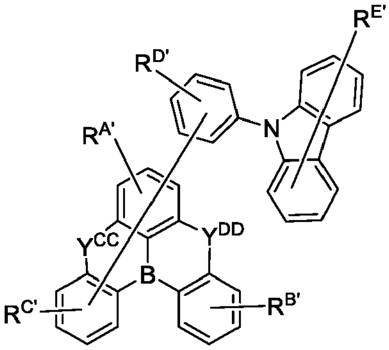

,

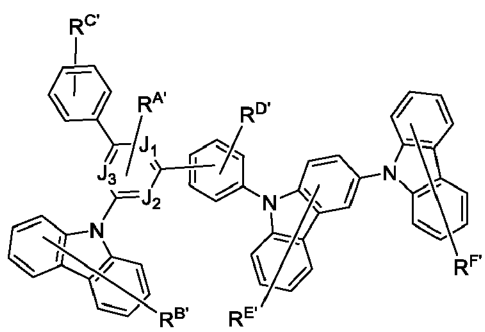

,

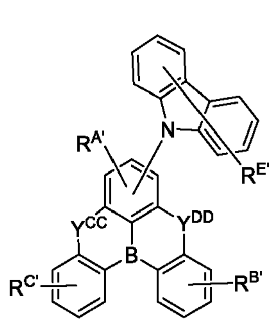

,

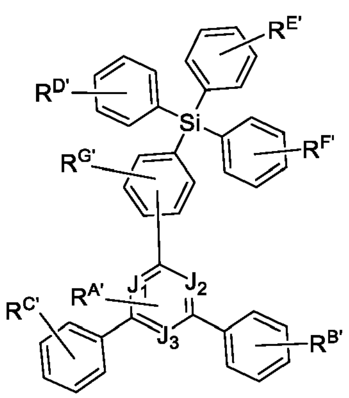

,

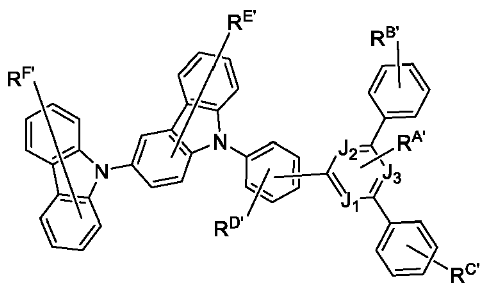

,

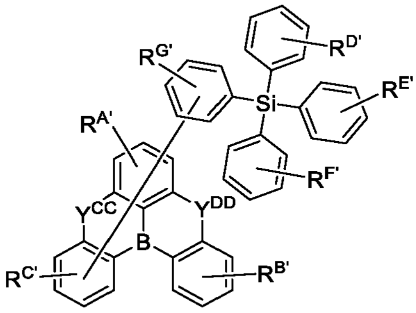

,

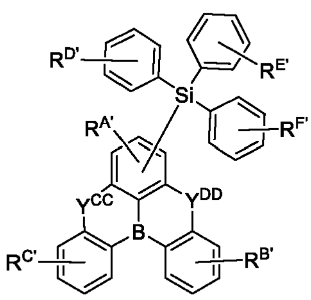

,

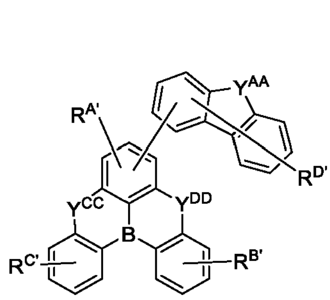

,

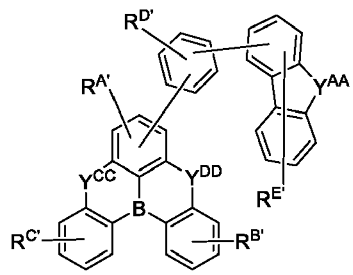
,
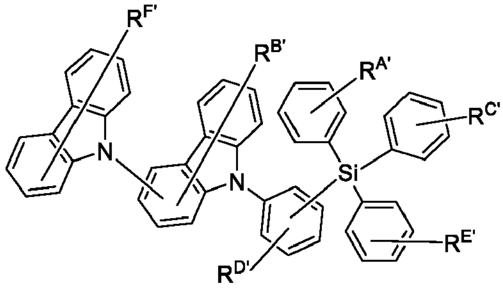
,
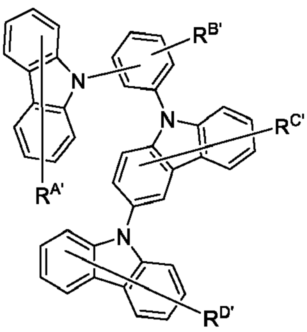
,

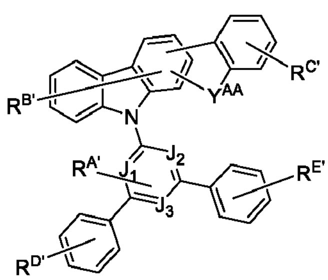
,
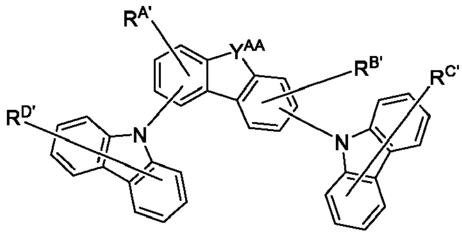
,
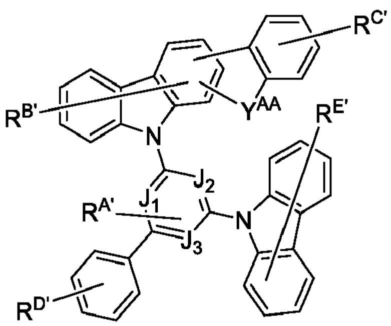

,
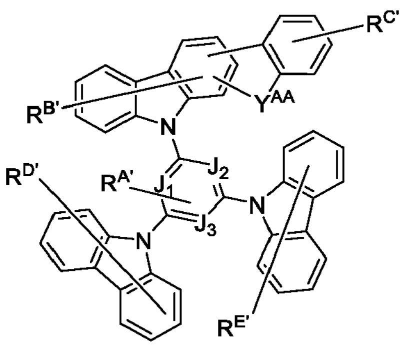
,
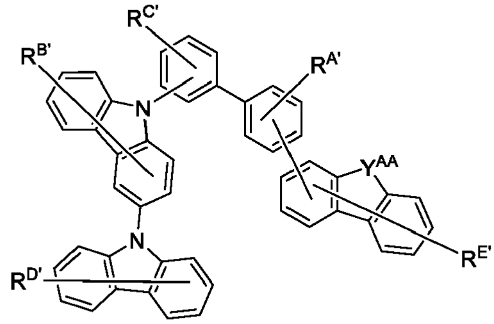
,

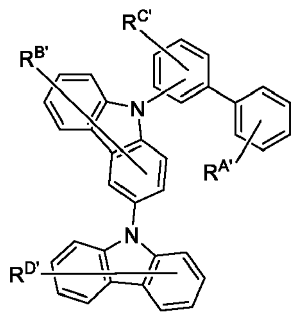
,
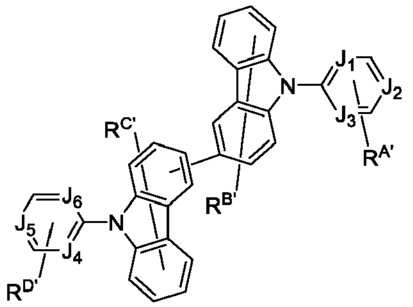
,
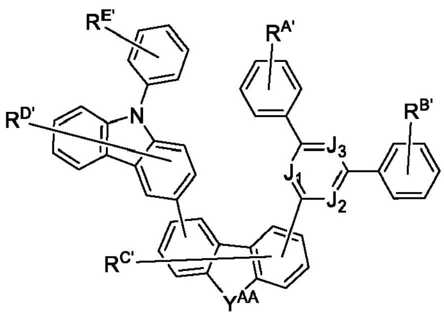
,

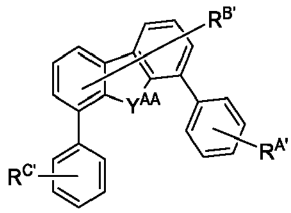,
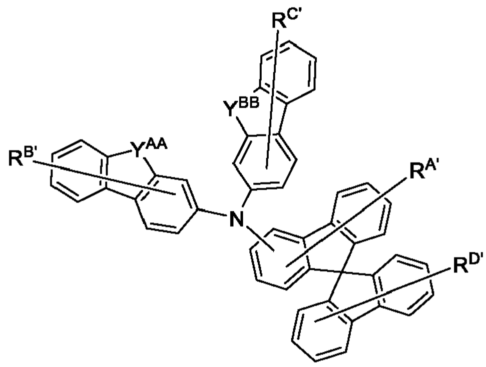,
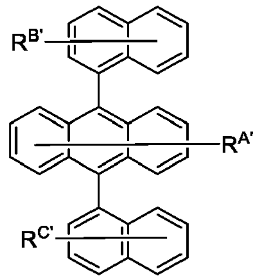,

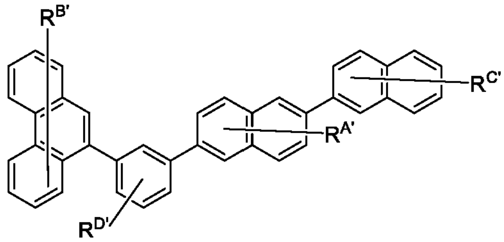,
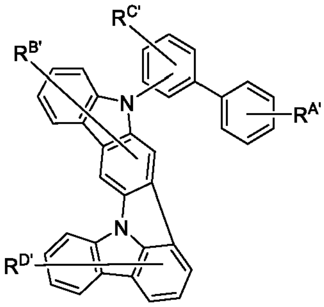,
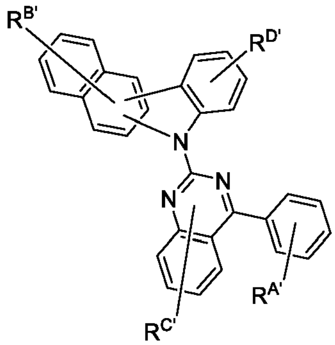,

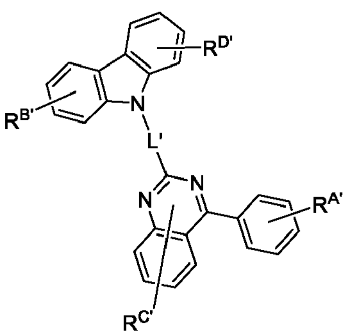,
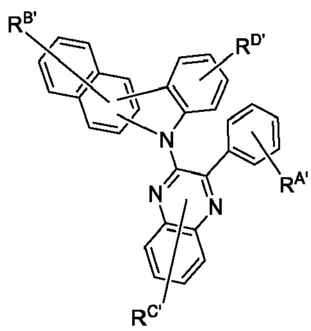,
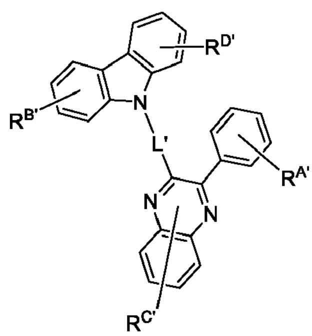,

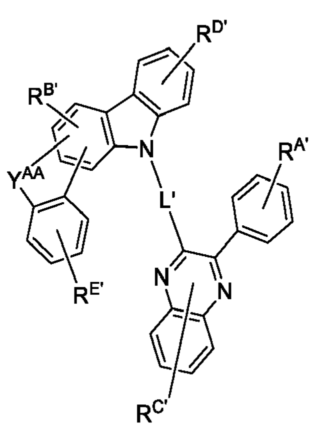,
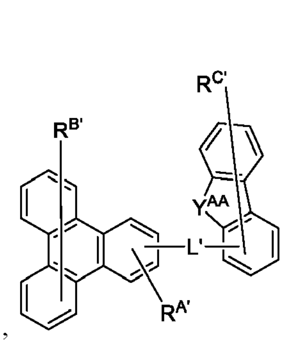,
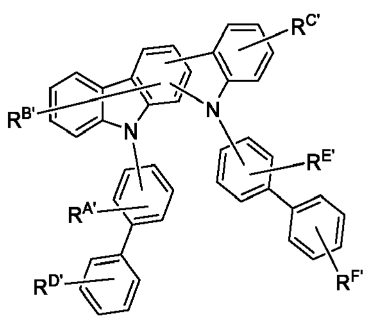,

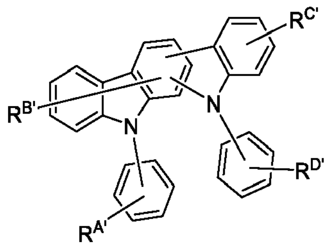,
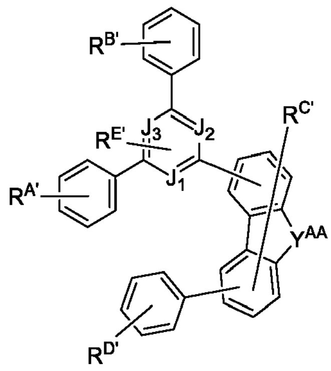,
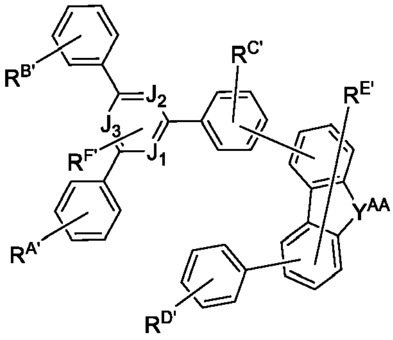,

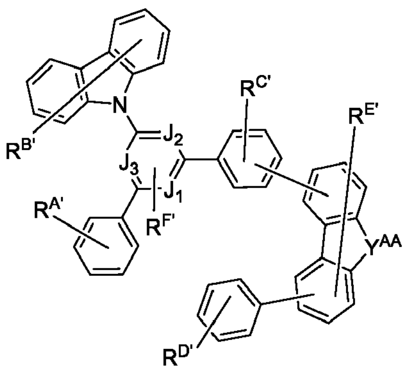,
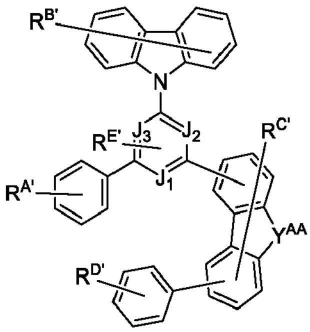,
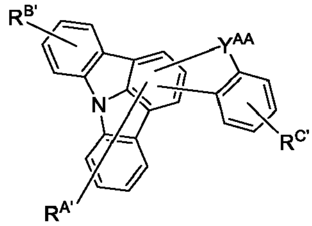,

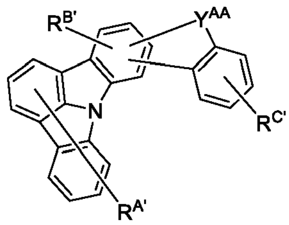,
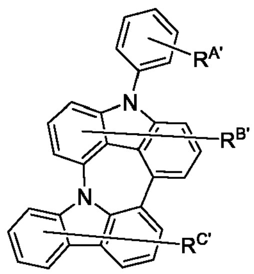,
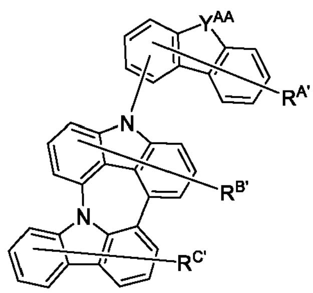,
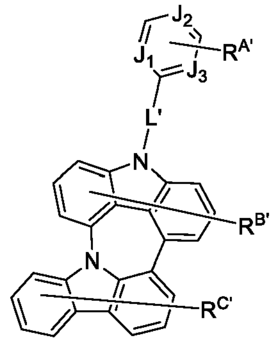,

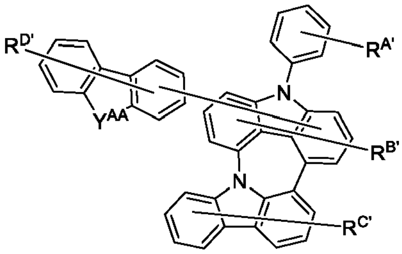,
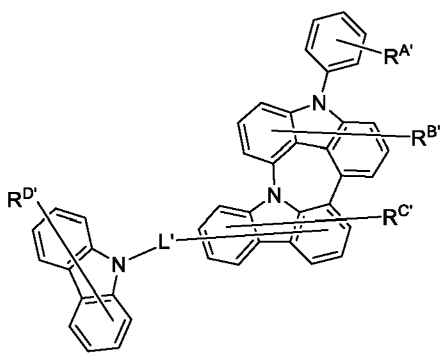,
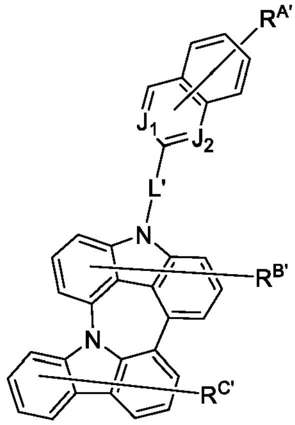,

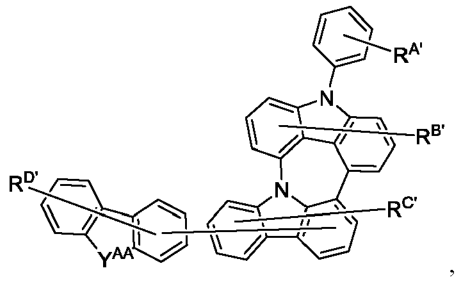
,
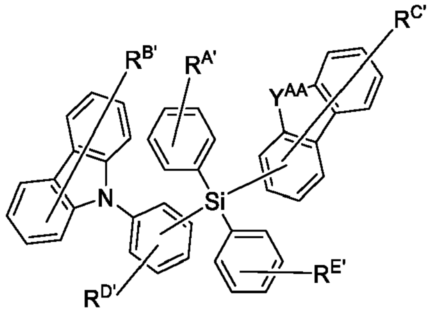
,

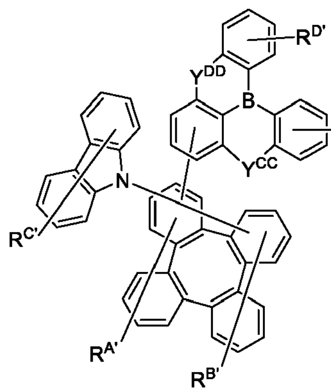
,
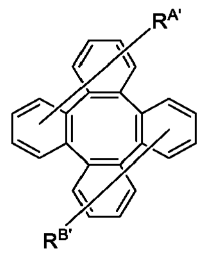
,
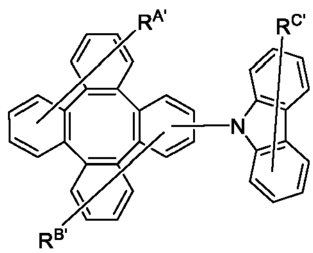
,

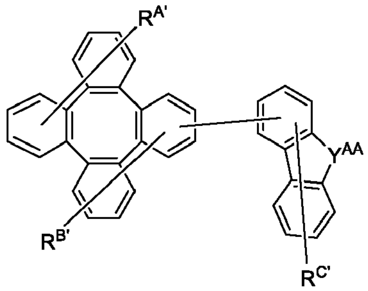
,
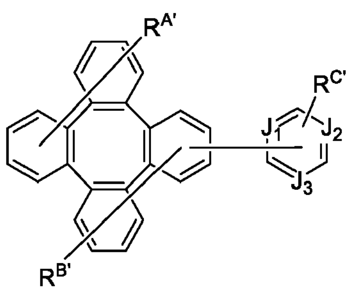
,
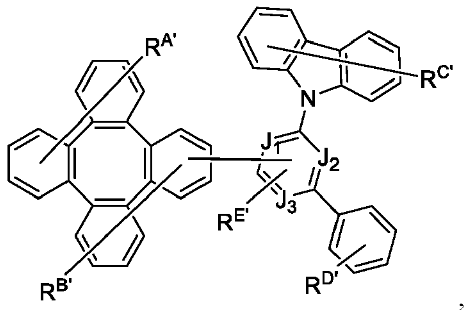
,

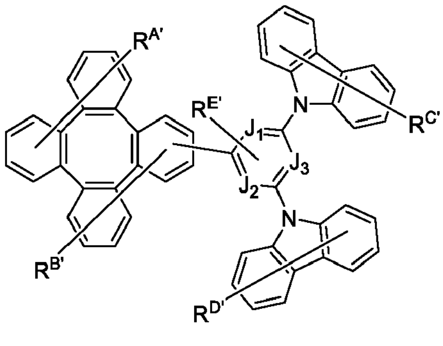
,
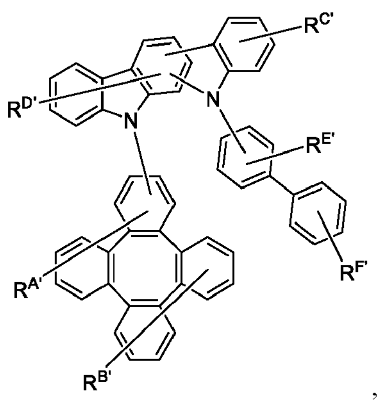
,

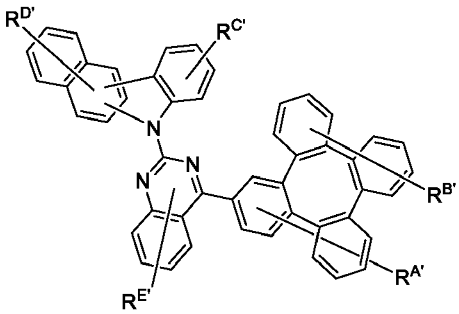,
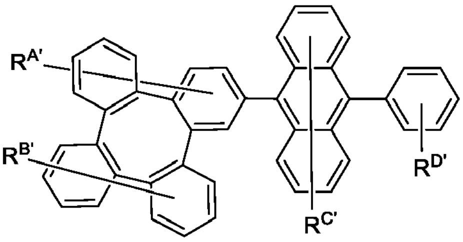,

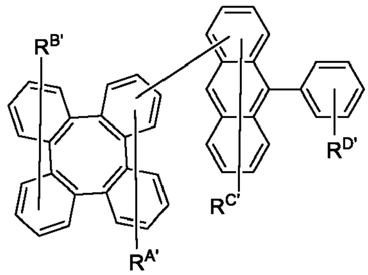,
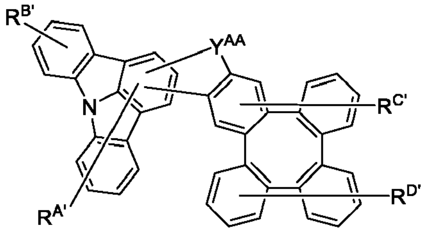,

and

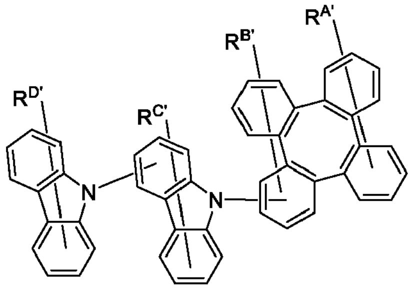,

wherein:

each of $J_1$ to $J_6$ is independently C or N;
L' is a direct bond or an organic linker;
each $Y^{AA}$, $Y^{BB}$, $Y^{CC}$, and $Y^{DD}$ is independently selected from the group consisting of absent a bond, direct bond, O, S, Se, CRR', SiRR', GeRR', NR, BR, BRR';
each of $R^{A'}$, $R^{B'}$, $R^{C'}$, $R^{D'}$, $R^{E'}$, $R^{F'}$, and $R^{G'}$ independently represents mono, up to the maximum substitutions, or no substitutions;
each R, R', $R^{A'}$, $R^{B'}$, $R^{C'}$, $R^{D'}$, $R^{E'}$, $R^{F'}$, and $R^{G'}$ is independently a hydrogen or a substituent selected from the group consisting of the general substituents as defined herein; any two substituents can be joined or fused to form a ring;
and where possible, each unsubstituted aromatic carbon atom is optionally replaced with N to form an aza-substituted ring.

**15.** An organic light emitting device (OLED) comprising:

an anode;
a cathode; and
an emissive region disposed between the anode and the cathode;
wherein the emissive region comprises:

a compound S1;

a compound A1;
a compound H1;

wherein the compound S1 is a sensitizer that transfers energy to the compound A1;
wherein the compound A1 is an acceptor that is an emitter;
wherein the compound H1 is a host, and at least one of the compounds S1 and A1 is doped with the compound H1;
wherein at least one of the following conditions is true:

(1) the emissive region consists of one or more organic layers, wherein at least one of the one or more organic layers has a minimum thickness selected from the group consisting of 250, 300, 350, 400, 450, 500, 550, 600, 650 and 700 Å;
(2) the OLED further comprises a layer comprising quantum dot;
(3) the compound S1 is capable of functioning as a doublet emitter in an OLED at room temperature, or the compound S1 has a first excited state energy that is less than its energy of the lowest excited triplet state $T_1$;
(4) the compound A1 is a doublet emitter; or the compound A1 has a first excited state energy that is less than its energy of the lowest excited triplet state $T_1$;
(5) at least one of the compounds S1 and A1 is a triplet-triplet annihilation upconversion (TTA-UC) material;
(6) at least one of the compounds S1 and A1 is chiral;
(7) the compound S1 is a metal coordination complex having at least one feature selected from the group consisting of at least two metals, three different bidentate ligands, three same bidentate ligands, a tetradentate or hexadentate ligand coordinating to Ir or Os, a Ir-carbene bond, Os-carbene bond, M-K bond wherein K is a non-ring atom and M is the metal, a ligand comprising a five-membered heteroaryl ring coordinating to the metal through M-N bond, a ligand comprising a six-membered heteroaryl ring having at least two heteroatoms with one of them coordinating to the metal, a ligand comprising a fused ring system having at least four rings, at least 25% deuterated of the metal complex, and combinations thereof;
(8) the compound S1 is a Au(III) coordination complex having a bidentate, tridentate, or tetradentate ligand and capable of functioning as a phosphorescent or delayed fluorescent emitter in an OLED at room temperature;
(9) the compound S1 is a Zn(II) coordination complex having a bidentate ligand and capable of functioning as a phosphorescent or delayed fluorescence emitter in an OLED at room temperature;
(10) the compound S1 comprises at least one electron-withdrawing group (EWG);
(11) the compound A1 comprises at least one electron-withdrawing group;
(12) any combination of two or more conditions of (1) through (11) listed above.

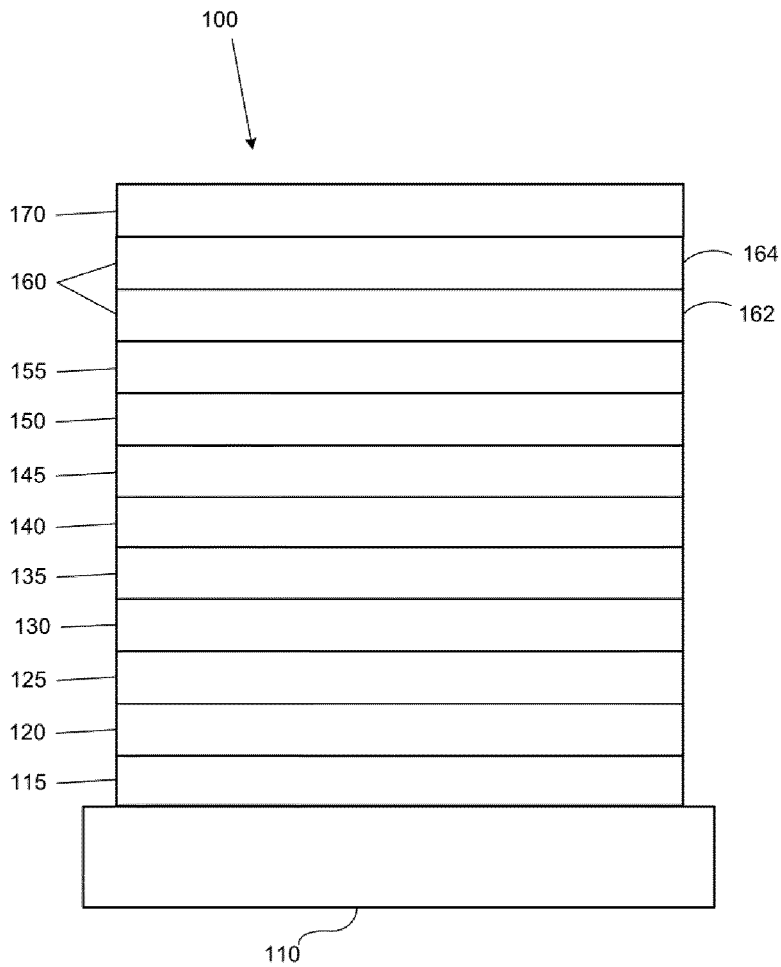


**Figure 1**

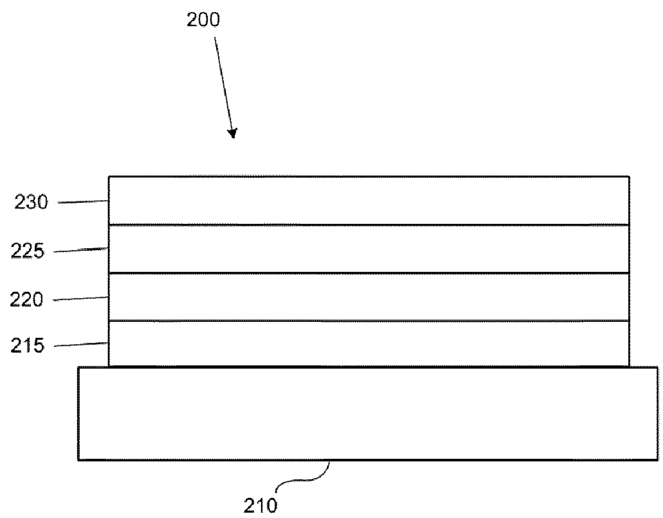


**Figure 2**

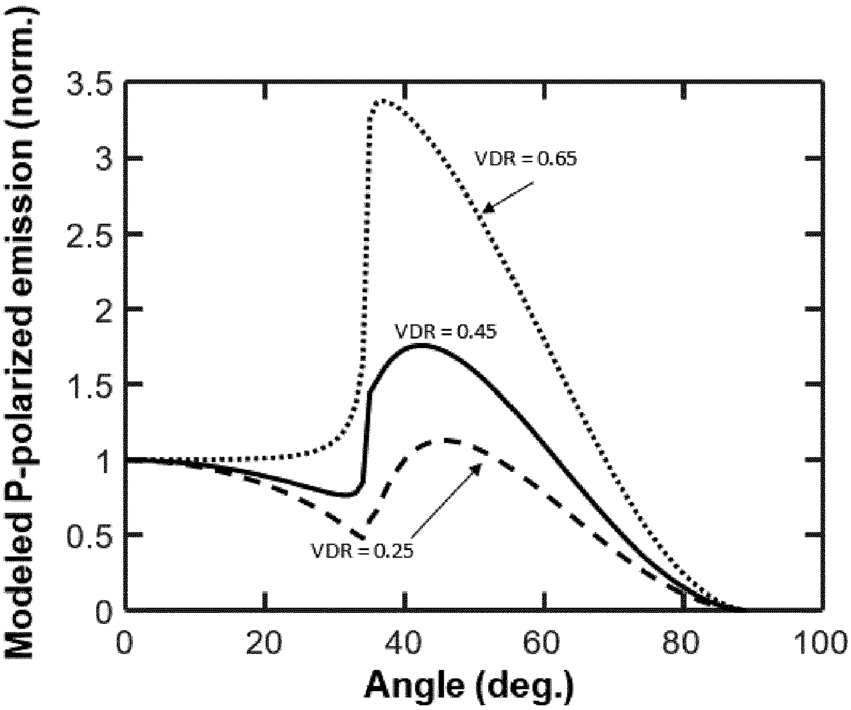
Modeled P-polarized emission (norm.)
Angle (deg.)
3.5
3
2.5
2
1.5
1
0.5
0
0
20
40
60
80
100
VDR = 0.65
VDR = 0.45
VDR = 0.25

Figure 3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 31918223
- US 63419782
- US 63421804 B
- US 63387166 B
- US 63483647 B
- US 63487055 B
- US 63459091 B
- US 63434161 B
- US 63484757 B
- US 63484786 B
- US 63490065 B
- US 8557400 B
- WO 2006095951 A
- US 20110037057 A
- US 7279704 B
- US 6013982 A
- US 6087196 A
- US 6337102 B, Forrest
- US 7431968 B
- US 6294398 B
- US 6468819 B
- US 7968146 W
- US 2007023098 W
- US 2009042829 W
- US 20200373510 A1
- US 18062110 B
- US 18177174 B
- US 5844363 A
- US 6303238 B
- US 5707745 A
- US 4769292 A
- US 20030230980
- US 5703436 A
- US 6097147 A
- US 20040174116
- US 5247190 A, Friend
- US 6091195 A, Forrest
- US 5834893 A, Bulovic
- US 700352
- EP 01617493 A
- EP 01968131 A
- EP 2020694 A
- EP 2684932 A
- US 20050139810 A
- US 20070160905 A
- US 20090167167 A
- US 2010288362 A
- WO 06081780 A
- WO 2009003455 A
- WO 2009008277 A
- WO 2009011327 A
- WO 2014009310 A
- US 2007252140 A
- US 2015060804 A
- US 20150123047 A
- US 2012146012 A
- CN 102702075
- DE 102012005215
- EP 01624500 A
- EP 01698613 A
- EP 01806334 A
- EP 01930964 A
- EP 01972613 A
- EP 01997799 A
- EP 02011790 A
- EP 02055700 A
- EP 02055701 A
- EP 1725079 A
- EP 2085382 A
- EP 2660300 A
- EP 650955 A
- JP 7073529 A
- JP 2005112765 B
- JP 2007091719 B
- JP 2008021687 B
- JP 2014009196 A
- KR 20110088898
- KR 20130077473
- TW 201139402
- US 06517957 B
- US 20020158242 A
- US 20030162053 A
- US 20050123751 A
- US 20060182993 A
- US 20060240279 A
- US 20070145888 A
- US 20070181874 A
- US 20070278938 A
- US 20080014464 A
- US 20080091025 A
- US 20080106190 A
- US 20080124572 A
- US 20080145707 A
- US 20080220265 A
- US 20080233434 A
- US 20080303417 A
- US 2008107919 A
- US 20090115320 A

- US 20090167161 A
- US 2009066235 A
- US 2011007385 A
- US 20110163302 A
- US 2011240968 A
- US 2011278551 A
- US 2012205642 A
- US 2013241401 A
- US 20140117329 A
- US 2014183517 A
- US 5061569 A
- US 5639914 A
- WO 05075451 A
- WO 07125714 A
- WO 08023550 A
- WO 08023759 A
- WO 2009145016 A
- WO 2010061824 A
- WO 2011075644 A
- WO 2012177006 A
- WO 2013018530 A
- WO 2013039073 A
- WO 2013087142 A
- WO 2013118812 A
- WO 2013120577 A
- WO 2013157367 A
- WO 2013175747 A
- WO 2014002873 A
- WO 2014015935 A
- WO 2014015937 A
- WO 2014030872 A
- WO 2014030921 A
- WO 2014034791 A
- WO 2014104514 A
- WO 2014157018 A
- EP 2034538 A
- EP 2757608 A
- JP 2007254297 B
- KR 20100079458
- KR 20120088644
- KR 20120129733
- KR 20130115564
- TW 201329200
- US 20030175553 A
- US 20050238919 A
- US 20060280965 A
- US 20090017330 A
- US 20090030202 A
- US 20090167162 A
- US 20090302743 A
- US 20090309488 A
- US 20100012931 A
- US 20100084966 A
- US 20100187984 A
- US 2010187984 A
- US 2012075273 A
- US 2012126221 A
- US 2013009543 A
- US 2013105787 A
- US 2013175519 A
- US 2014001446 A
- US 20140183503 A
- US 20140225088 A
- US 2014034914 A
- US 7154114 B
- WO 2001039234 A
- WO 2004093207 A
- WO 2005014551 A
- WO 2005089025 A
- WO 2006072002 A
- WO 2006114966 A
- WO 2007063754 A
- WO 2008056746 A
- WO 2009003898 A
- WO 2009021126 A
- WO 2009063833 A
- WO 2009066778 A
- WO 2009066779 A
- WO 2009086028 A
- WO 2010056066 A
- WO 2010107244 A
- WO 2011081423 A
- WO 2011081431 A
- WO 2011086863 A
- WO 2012128298 A
- WO 2012133644 A
- WO 2012133649 A
- WO 2013024872 A
- WO 2013035275 A
- WO 2013081315 A
- WO 2013191404 A
- WO 2014142472 A
- US 20170263869 A
- US 20160163995 A
- US 9466803 B
- CN 103694277
- CN 1696137
- EP 01239526 A
- EP 01961743 A
- EP 1239526 A
- EP 1244155 A
- EP 1642951 A
- EP 1647554 A
- EP 1841834 A
- EP 1841834 B
- EP 2062907 A
- EP 2730583 A
- JP 2012074444 B
- JP 2013110263 B
- JP 4478555 B
- KR 1020090133652
- KR 20120032054
- KR 20130043460
- TW 201332980
- US 06699599 B
- US 06916554 B

- US 20010019782 A
- US 20020034656 A
- US 20030068526 A
- US 20030072964 A
- US 20030138657 A
- US 20050123788 A
- US 20050244673 A
- US 2005123791 A
- US 2005260449 A
- US 20060008670 A
- US 20060065890 A
- US 20060127696 A
- US 20060134459 A
- US 20060134462 A
- US 20060202194 A
- US 20060251923 A
- US 20070034863 A
- US 20070087321 A
- US 20070103060 A
- US 20070111026 A
- US 20070190359 A
- US 20070231600 A
- US 2007034863 A
- US 2007104979 A
- US 2007104980 A
- US 2007138437 A
- US 2007224450 A
- US 2007278936 A
- US 20080020237 A
- US 20080233410 A
- US 20080261076 A
- US 20080297033 A
- US 200805851 B
- US 2008161567 A
- US 2008210930 A
- US 20090039776 A
- US 20090108737 A
- US 20090115322 A
- US 20090179555 A
- US 2009085476 A
- US 2009104472 A
- US 20100090591 A
- US 20100148663 A
- US 20100244004 A
- US 20100295032 A
- US 2010102716 A
- US 2010105902 A
- US 2010244004 A
- US 2010270916 A
- US 20110057559 A
- US 20110108822 A
- US 20110204333 A
- US 2011215710 A
- US 2011227049 A
- US 2011285275 A
- US 2012292601 A
- US 20130146848 A
- US 2013033172 A
- US 2013165653 A
- US 2013181190 A
- US 2013334521 A
- US 20140246656 A
- US 2014103305 A
- US 6413656 B
- US 6653654 B
- US 6670645 B
- US 6687266 B
- US 6835469 B
- US 6921915 B
- US 7332232 B
- US 7378162 B
- US 7534505 B
- US 7675228 B
- US 7728137 B
- US 7740957 B
- US 7759489 B
- US 7951947 B
- US 8067099 B
- US 8592586 B
- US 8871361 B
- WO 06081973 A
- WO 06121811 A
- WO 07018067 A
- WO 07108362 A
- WO 07115970 A
- WO 07115981 A
- WO 08035571 A
- WO 2002015645 A
- WO 2003040257 A
- WO 2005019373 A
- WO 2006056418 A
- WO 2008054584 A
- WO 2008078800 A
- WO 2008096609 A
- WO 2008101842 A
- WO 2009000673 A
- WO 2009050281 A
- WO 2009100991 A
- WO 2010028151 A
- WO 2010054731 A
- WO 2010086089 A
- WO 2010118029 A
- WO 2011044988 A
- WO 2011051404 A
- WO 2011107491 A
- WO 2012020327 A
- WO 2012163471 A
- WO 2013094620 A
- WO 2013107487 A
- WO 2013174471 A
- WO 2014007565 A
- WO 2014008982 A
- WO 2014023377 A
- WO 2014024131 A
- WO 2014031977 A
- WO 2014038456 A

- WO 2014112450 A
- CN 103508940
- EP 01602648 A
- EP 01734038 A
- EP 01956007 A
- JP 2004022334 A
- JP 2005149918 B
- JP 2005268199 A
- KR 0117693
- KR 20130108183
- US 20040036077 A
- US 20070104977 A
- US 2007018155 A
- US 20090101870 A
- US 20090115316 A
- US 20090140637 A
- US 20090179554 A
- US 2009218940 A
- US 2010108990 A
- US 2011156017 A
- US 2011210320 A
- US 2012193612 A
- US 2012214993 A
- US 2014014925 A
- US 2014014927 A
- US 20140284580 A
- US 6656612 B
- US 8415031 B
- WO 2003060956 A
- WO 2007111263 A
- WO 2009148269 A
- WO 2010067894 A
- WO 2010072300 A
- WO 2011074770 A
- WO 2011105373 A
- WO 2013079217 A
- WO 2013145667 A
- WO 2013180376 A
- WO 2014104499 A
- WO 2014104535 A

**Non-patent literature cited in the description**


- **MING YAN et al.** *Tetrahedron,* 2015, vol. 71, 1425-30
- **ATZRODT et al.** *Angew. Chem. Int. Ed. (Reviews),* 2007, vol. 46, 7744-65
- **BALDO et al.** Highly Efficient Phosphorescent Emission from Organic Electroluminescent Devices. *Nature,* 1998, vol. 395, 151-154
- **BALDO et al.** Very high-efficiency green organic light-emitting devices based on electrophosphorescence. *Appl. Phys. Lett.,* 1999, vol. 75 (3), 4-6